# EUROPEAN PATENT SPECIFICATION

(11) **EP 3 185 332 B1**
(45) Date of publication and mention of the grant of the patent: **01.05.2024**
(21) Application number: 16195460.7
(22) Date of filing: 25.10.2016
(51) Int. Cl.: H10K 85/60, C09K 11/02, C09K 11/06, H10K 50/15, H10K 50/16, H10K 101/10

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 22.12.2015 KR 20150184074
(43) Date of publication of application: 28.06.2017
(73) Proprietor: Samsung Display Co., Ltd., Gyeonggi-do (KR)
(72) Inventor: LIM, Jino, Gyeonggi-do (KR); KIM, Seulong, Gyeonggi-do (KR); KIM, Younsun, Gyeonggi-do (KR); SHIN, Dongwoo, Gyeonggi-do (KR); LEE, Jungsub, Gyeonggi-do (KR); ITO, Naoyuki, Gyeonggi-do (KR); JEONG, Hyein, Gyeonggi-do (KR)
(74) Representative: Russell, Tim

(56) References cited:
- WO-A1-00/33617
- WO-A1-2015/099481
- WO-A2-2015/082046
- KR-A- 20150 077 284
- KR-A- 20150 103 945

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and/or excellent brightness, driving voltage, and/or response speed characteristics, and may produce full-color images.

An organic light-emitting device may comprise a first electrode on a substrate, and a hole transport region, an emission layer, an electron transport region, and a second electrode sequentially positioned on the first electrode. Holes provided from the first electrode may move toward the emission layer through the hole transport region, and electrons provided from the second electrode may move toward the emission layer through the electron transport region. Carriers (such as holes and electrons) may recombine in the emission layer to produce excitons. These excitons may transition (e.g., radiatively decay) from an excited state to the ground state to thereby generate light.

KR 2015 0077284 A describes OLED devices including one or more organic material layers. A lifetime enhancement layer is included between the light emitting layer and the electron transporting layer. The lifetime enhancement layer includes a bipolar compound having an electron withdrawing group and an electron donor group.

WO2015/099481 also describes OLED devices including one or more organic material layers. A lifetime enhancement layer is included between the light emitting layer and the electron transporting layer. The lifetime enhancement layer includes a bipolar compound having an electron withdrawing group and an electron donor group.

WO2015/082046A2 describes a class of compounds, compositions and formulations comprising these and the preparation thereof and optoelectronic devices comprising the compounds.

WO00/33617 describes organic light emitting devices comprising a heterostructure for producing electroluminescence having a hole transporting layer with a glass structure.

KR 2015 0103945 A describes organic light emitting devices with an electron transport layer comprising dibenzo azepine derivatives condensed with indole moieties.

### SUMMARY OF THE INVENTION

The present invention provides an organic light-emitting device having a low driving voltage and high efficiency.

The organic light-emitting device of the present inveition comprises:
a first electrode;
a second electrode facing the first electrode;
an emission layer between the first electrode and the second electrode;
a hole transport region between the first electrode and the emission layer; and
an electron transport region between the emission layer and the second electrode,
wherein the hole transport region comprises a first compound,
the electron transport region comprises a second compound,
the first compound is represented by Formula 1A or 1B, and
the second compound is represented by Formula 2A or 2B:

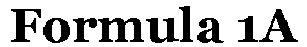

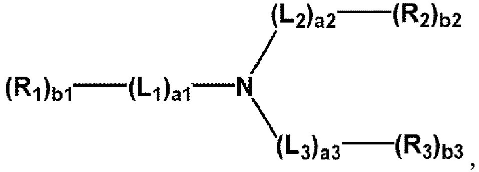

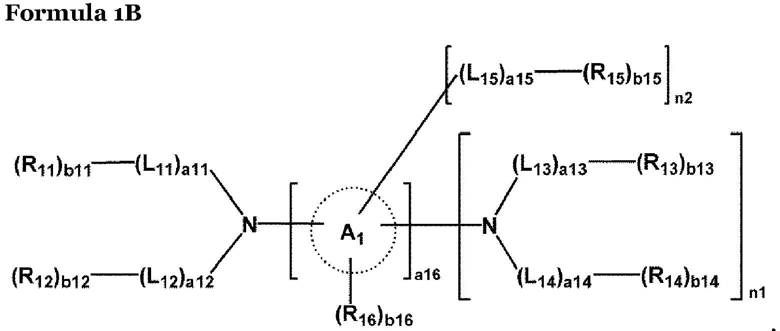

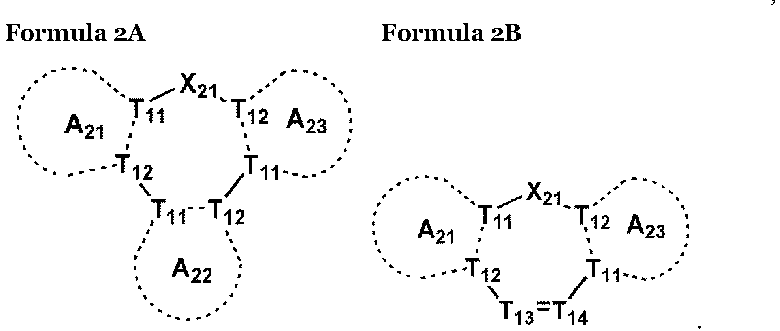

In Formulae 1A, 1B, 2A, and 2B,
rings A₂₁, A₂₂, and A₂₃ may each independently be a C₅-C₃₀ carbocyclic group or a C₁-C₃₀ heterocyclic group, each substituted with at least one *-[(L₂₂)ₐ₂₂-(R₂₂)_{b22}], in which * is a bonding site to the A₂₁, A₂₂, or A₂₃ ring,
each T₁₁ is independently carbon (C) or nitrogen (N),
each T₁₂ is independently carbon (C) or nitrogen (N),
T₁₃ is N or C(R₂₇),
T₁₄ is N or C(R₂₈),
each bond between T₁₁ and T₁₂ represented as a dashed line in formulae 2A and 2B is a single bond or a double bond; wherein the six atoms represented by the three T₁₁(s) and the three T₁₂(s) in Formula 2A are not all nitrogen, and the six atoms represented by the two T₁₁(s), the two T₁₂(s), T₁₃, and T₁₄ in Formula 2B are not all nitrogen,
rings A₂₁, A₂₂, and A₂₃ are each condensed to (e.g., fused with) the central 7-membered ring in Formulae 2A and 2B, such that they each share a T₁₁ and a T₁₂ with the central 7-membered ring,
X₂₁ is selected from S, Se, C(R₂₃)(R₂₄), Si(R₂₃)(R₂₄), and N-[(L₂₁)ₐ₂₁-(R₂₁)_{b21}],
L₁ to L₃, L₁₁ to L₁₅, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
ring A₁ is a C₅-C₃₀ carbocyclic group or a C₁-C₃₀ heterocyclic group,
a₁ to a₃, an to a₁₅, a₂₁, and a₂₂ are each independently an integer selected from 0 to 5,
a₁₆ is an integer selected from 1 to 10, and when a16 is 2 or greater, a plurality of ring A₁(s) may be bound (e.g., coupled) to each other via one or more single bonds,
R₁ to R₃ and R₁₅ are each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
R₁₁ and R₁₂ are each independently as defined for R₁, or when a₁₁ and a₁₂ are both 0, may optionally be bound (e.g., coupled) to form a C₁-C₃₀ heterocyclic group together with the nitrogen atom to which they are attached, and R₁₃ and R₁₄ are each independently as defined for R₁, or when a13 and a14 are both 0, may optionally be bound (e.g., coupled) to form a C₁-C₃₀ heterocyclic group together with the nitrogen atom to which they are attached,
R₁₆, R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁₋C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
b1 to b3, b11 to b15, b21, and b22 are each independently an integer selected from 1 to 5, provided that each of b1 to b3, b11 to b15, b21, and b22 is 1 when each respective a1 to a3, an to a15, a21, a22 or a31 to a33 is zero
b16 is an integer selected from 0 to 5,
n1 is an integer selected from 1 to 4,
n2 is an integer selected from 0 to 4, and
the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is each independently substituted with one or more substituents selected from the group consisting of:
   deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁₋C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
   a C₃-C₁₀ cycloalkyl group, a C₁-C₁₀ heterocycloalkyl group, a C₃-C₁₀ cycloalkenyl group, a C₁₋C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
   a C₃-C₁₀ cycloalkyl group, a C₁-C₁₀ heterocycloalkyl group, a C₃-C₁₀ cycloalkenyl group, a C₁₋C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁₋C₁₀ heterocycloalkyl group, a C₃-C₁₀ cycloalkenyl group, a C₁₋C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), and -P(=O)(Q₂₁)(Q₂₂); and
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
   wherein Q₁ to Q₃, Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁₋C₁₀ heterocycloalkyl group, a C₃-C₁₀ cycloalkenyl group, a C₁₋C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed polycyclic group, and a monovalent non-aromatic condensed heteropolycyclic group,
   provided that the first compound is not: 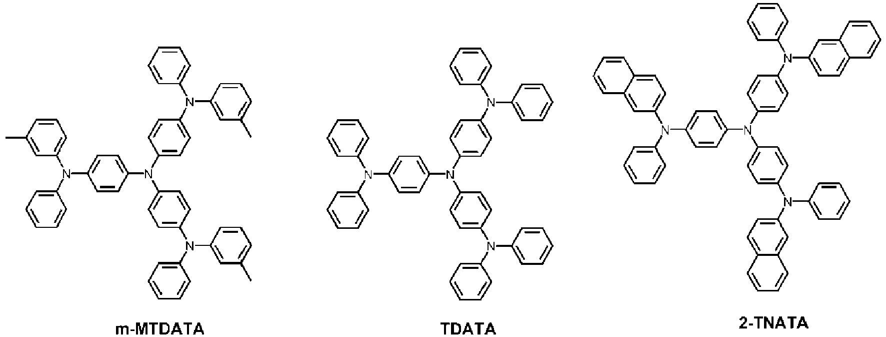 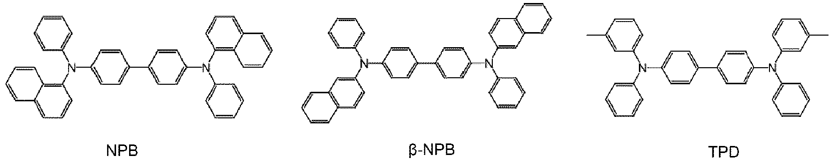 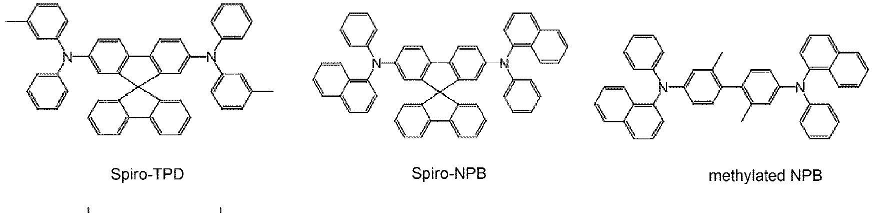 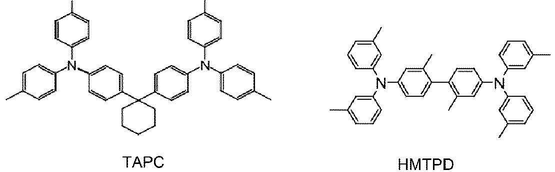 or 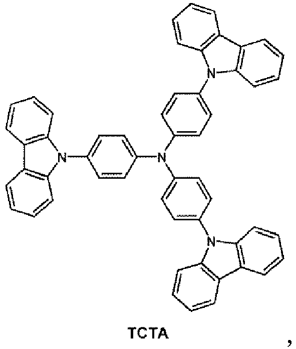
   and provided that, in Formula 2A, when
      i) ring A₂₂ is a benzofuran group, a benzothiophene group, a benzoselenophene group, an indene group, a benzosilole group, or an indole group, each substituted with at least one *-[(L₂₂)ₐ₂₂-(R₂₂)_{b22}],
      ii) the 5-membered ring of the benzofuran group, the benzothiophene group, the benzoselenophene group, the indene group, the benzosilole group, and the indole group is condensed to a central 7-membered ring in Formula 2A, and
      iii) all of T₁₁ and T₁₂ are carbon,
   then rings A₂₁ and A₂₃ in Formula 2A are not simultaneously benzene groups.

### BRIEF DESCRIPTION OF THE DRAWINGS

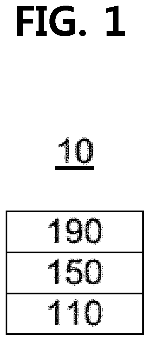

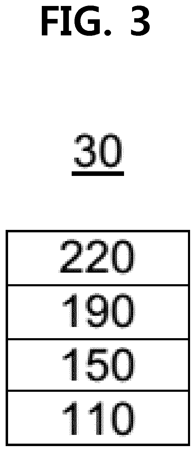

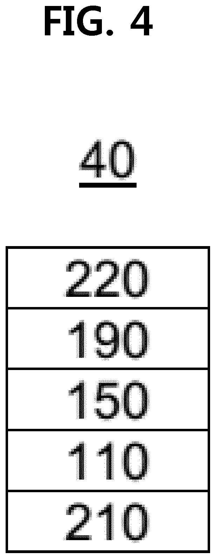

FIGS. 1 to 6 are schematic views of an organic light-emitting device according to one or more embodiments of the present disclosure.

### DETAILED DESCRIPTION OF THE INVENTION

Expressions such as "at least one of", "one of", and "selected from", when preceding a list of elements, modify the entire list of elements and do not modify the individual elements of the list.

The thicknesses of layers, films, panels, regions, etc., may be exaggerated in the drawings for clarity. It will be understood that when an element such as a layer, film, region, or substrate is referred to as being "on" another element, it can be directly on the other element or intervening element(s) may also be present. In contrast, when an element is referred to as being "directly on" another element, no intervening elements are present.

An organic light-emitting device according to an embodiment of the present disclosure comprises a first electrode, a second electrode facing the first electrode, an emission layer between the first electrode and the second electrode, a hole transport region between the first electrode and the emission layer, and an electron transport region between the emission layer and the second electrode, wherein the hole transport region comprises a first compound and the electron transport region comprises a second compound.

The first electrode may be an anode. The second electrode may be a cathode. The first electrode and the second electrode may each be the same as described herein.

The first compound is represented by Formula 1A or 1B, and the second compound is represented by Formula 2A or 2B:

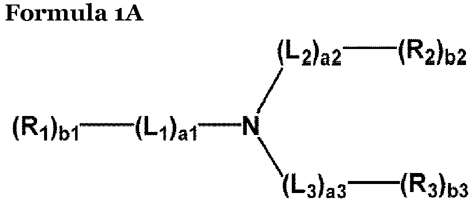

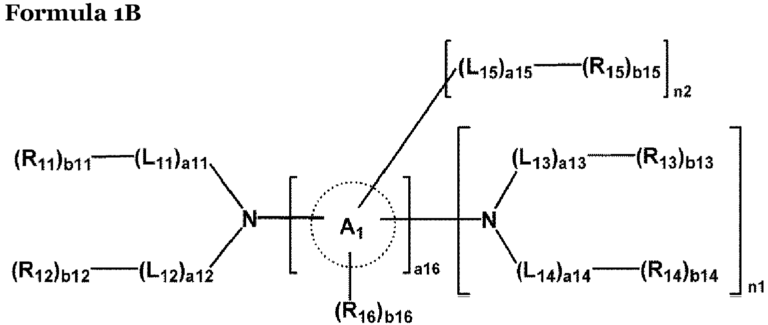

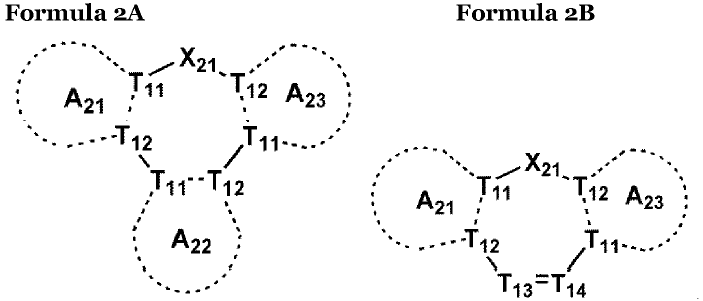

In Formulae 2A and 2B, rings A₂₁, A₂₂, and A₂₃ are each independently a C₅-C₆₀ carbocyclic group or a C₁-C₆₀ heterocyclic group, each substituted with at least one *-[(L₂₂)ₐ₂₂-(R₂₂)_{b22}], in which * is a bonding site to the A₂₁, A₂₂, or A₂₃ ring. L₂₂, a₂₂, R₂₂, and b22 are described below.

In Formulae 2A and 2B, each T₁₁ and each T₁₂ are independently carbon or nitrogen. Any one of the three T11s in formula 2A may be different from each of the other two T11s, identical to each of the other two T11s, or identical to one of the other two T11s and different from one of the other two T11s. Any one of the three T12s in formula 2A may be different from each of the other two T12s, identical to each of the other two T12s, or identical to one of the other two T12s and different from one of the other two T12s. Any one of the two T11s in Formula 2B may be different from the other T11 or identical to the other T11. Any one of the two T12s in Formula 2B may be different from the other T12 or identical to the other T12. T13 is N or C(R₂₇), T₁₄ is N or C(R₂₈). Each bond between T₁₁ and T₁₂ represented as a dashed line in formulae 2A and 2B may be a single bond or a double bond. The six atoms represented by the three T₁₁(s) and the three T₁₂(s) in Formula 2A are not all nitrogen, and the six atoms represented by the two T₁₁(s), the two T₁₂(s), T₁₃, and T₁₄ in Formula 2B are not all nitrogen. Rings A₂₁, A₂₂, and A₂₃ may each be condensed to (e.g., fused with) the central 7-membered ring (i.e. the 7-membered ring formed by the three T11s, three T12s and X21 in formula 2A; and the 7-membered ring formed by the two T11s, two T12s, T₁₃, T14 and X21 in formula 2B), such that rings A₂₁, A₂₂, and A₂₃ each share a T₁₁ and a T₁₂ with the central 7-membered ring.

Each *-[(L₂₂)ₐ₂₂-(R₂₂)_{b22}] substituted in ring A₂₁, *-[(L₂₂)ₐ₂₂-(R₂₂)_{b22}] substituted in ring A₂₂, and *-[(L₂₂)ₐ₂₂-(R₂₂)_{b22}] substituted in ring A₂₃ may be identical to or different from each other.

In some embodiments, when the number of *-[(L₂₂)ₐ₂₂-(R₂₂)_{b22}] substituted in ring A₂₁ is 2 or greater, a plurality of *-[(L₂₂)ₐ₂₂-(R₂₂)_{b22}] (s) may be identical to or different from each other; when the number of *-[(L₂₂)ₐ₂₂-(R₂₂)_{b22}] substituted in ring A₂₂ is 2 or greater, a plurality of *-[(L₂₂)ₐ₂₂-(R₂₂)_{b22}] (s) may be identical to or different from each other; and when the number of *-[(L₂₂)ₐ₂₂-(R₂₂)_{b22}] substituted in ring A₂₃ is 2 or greater, a plurality of *-[(L₂₂)ₐ₂₂-(R₂₂)_{b22}](s) may be identical to or different from each other.

In one embodiment, in Formulae 2A and 2B, rings A₂₁, A₂₂, and A₂₃ may each independently be selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenothiophene group, a naphthofuran group, a naphthothiophene group, a pyrroloquinoline group, a cyclopentaquinoline group, a siloloquinoline group, a selenophenoquinoline group, a furoquinoline group, a thienoquinoline group, an pyrroloisoquinoline group, an cyclopentaisoquinoline group, an siloloisoquinoline group, an selenophenoisoquinoline group, an furoisoquinoline group, an thienoisoquinoline group, an azacarbazole group, an azafluorene group, an azadibenzosilole group, an azadibenzoselenophene group, an azadibenzofuran group, an azadibenzothiophene group, an indenoquinoline group, an isoindenoquinoline group, an indenoquinoxaline group, a phenanthroline group, and a naphthoindole group, each substituted with at least one *-[(L₂₂)ₐ₂₂-(R₂₂)_{b22}].

In one or more embodiments, in the second compound represented by Formula 2A or 2B, the case that rings A₂₁, A₂₂, and A₂₃ are all (e.g., simultaneously) benzene groups substituted with at least one *-[(L₂₂)ₐ₂₂-(R₂₂)_{b22}] is excluded.

In Formula 2A, when i) ring A₂₂ is a benzofuran group, a benzothiophene group, a benzoselenophene group, an indene group, a benzosilole group, or an indole group, each substituted with at least one *-[(L₂₂)ₐ₂₂-(R₂₂)_{b22}], ii) the 5-membered ring of the benzofuran group, the benzothiophene group, the benzoselenophene group, the indene group, the benzosilole group, and the indole group is condensed to the central 7-membered ring in Formula 2A, and iii) all of T₁₁ and T₁₂ are carbon, rings A₂₁ and A₂₃ in Formula 2A are not benzene groups at the same time. In some embodiments, the second compound is not represented by Formula 2-301A (Table 3).

In one or more embodiments, in Formulae 2A and 2B, rings A₂₁, A₂₂, and A₂₃ may each independently be selected from groups represented by Formulae 2-1 to 2-36, each substituted with at least one *-[(L₂₂)ₐ₂₂-(R₂₂)_{b22}]:

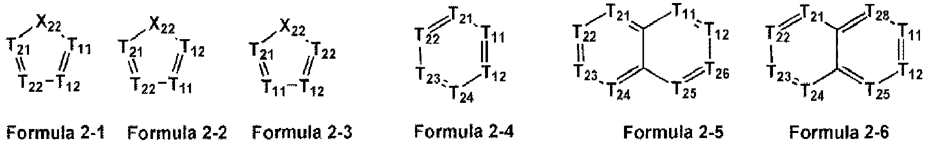

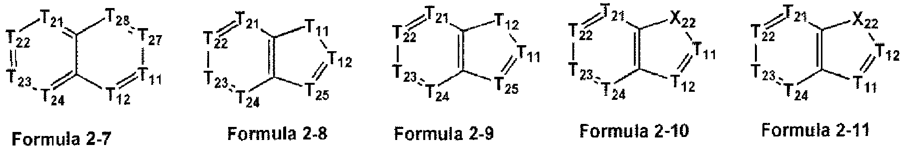

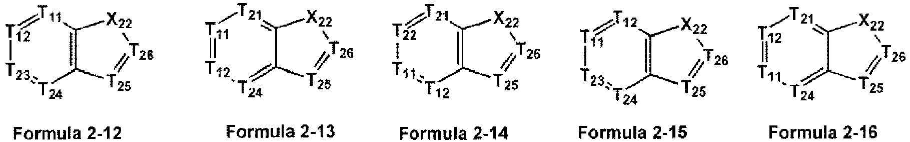

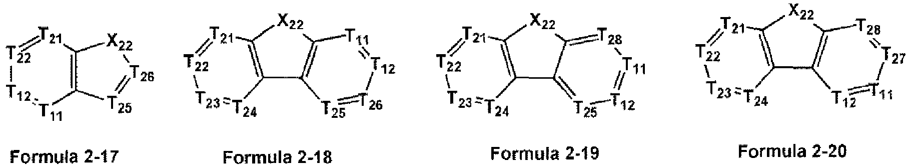

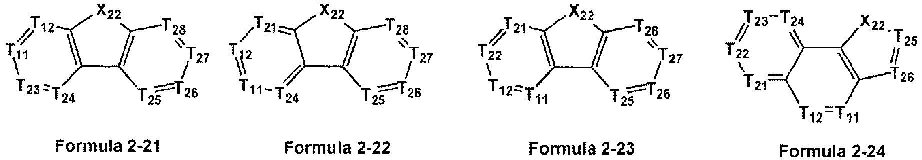

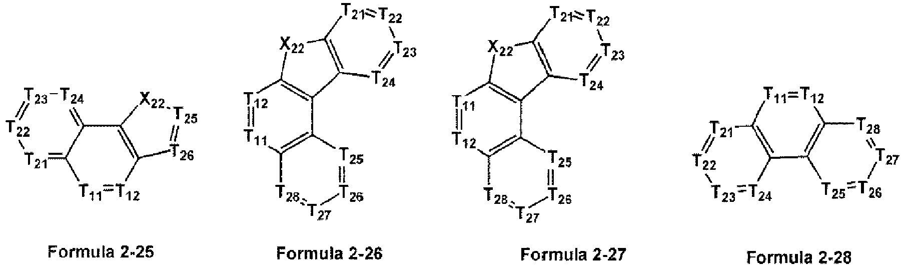

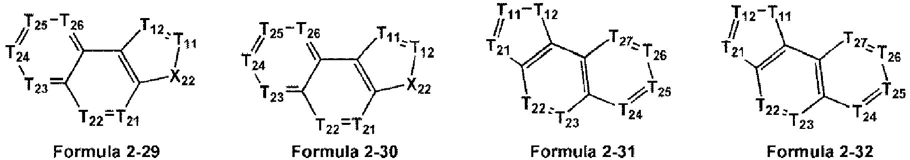

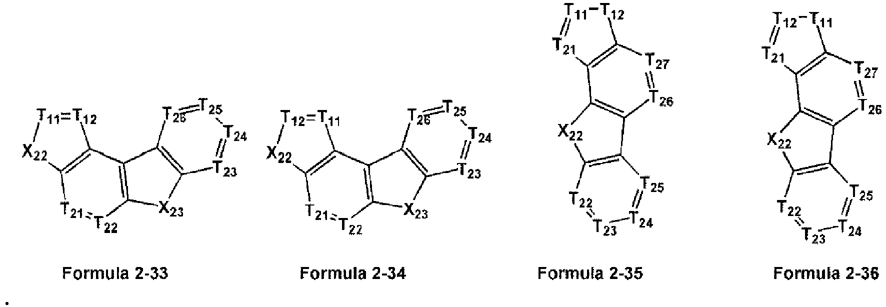

In Formulae 2-1 to 2-36,
T₁₁ and T₁₂ may each independently be the same as described herein,
X₂₂ and X₂₃ may each independently be selected from oxygen (O), sulfur (S), selenium (Se), and a moiety comprising C, N, and/or silicon (Si), and
T₂₁ to T₂₈ may each independently be N or a moiety comprising C.

In some embodiments, in Formulae 2-1 to 2-36, X₂₂ and X₂₃ may each independently be selected from O, S, Se, C(R₂₅)(R₂₆), N-[(L₂₂)ₐ₂₂-(R₂₂)_{b22}], and Si(R₂₅)(R₂₆), and T₂₁ to T₂₈ may each independently be N or C-[(L₂₂)ₐ₂₂-(R₂₂)_{b22}]. R₂₅, R₂₆, and R₃₀ may each independently be selected from groups represented by *-[(L₂₂)ₐ₂₂-(R₂₂)_{b22})] used herein.

In one or more embodiments, in Formulae 2A and 2B, rings A₂₁, A₂₂, and A₂₃ may each independently be selected from groups represented by Formulae 2-101 to 2-229:

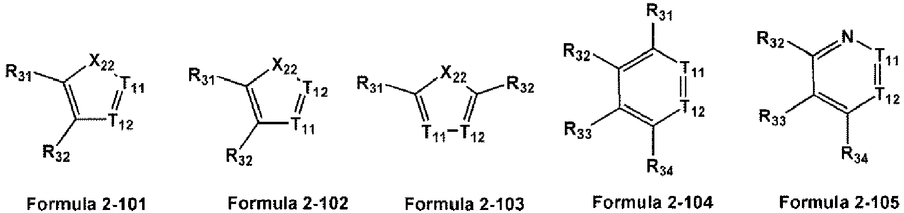

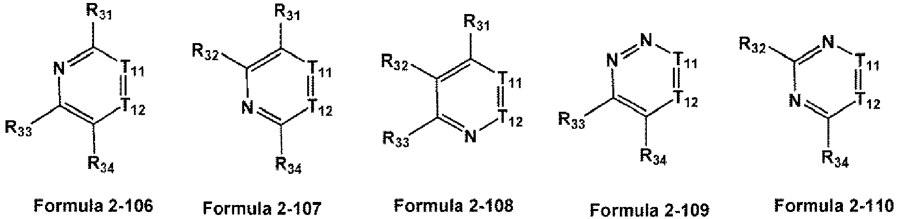

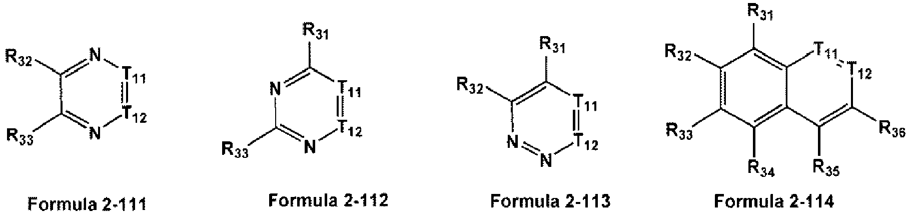

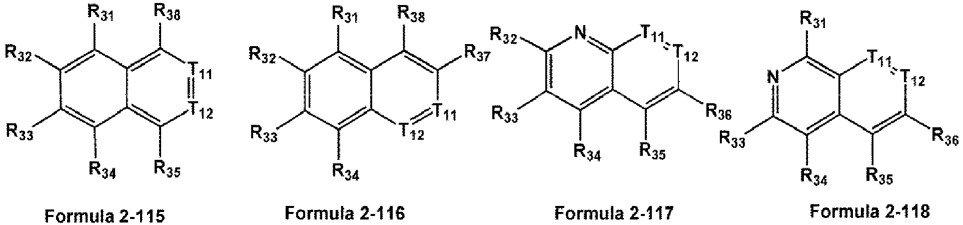

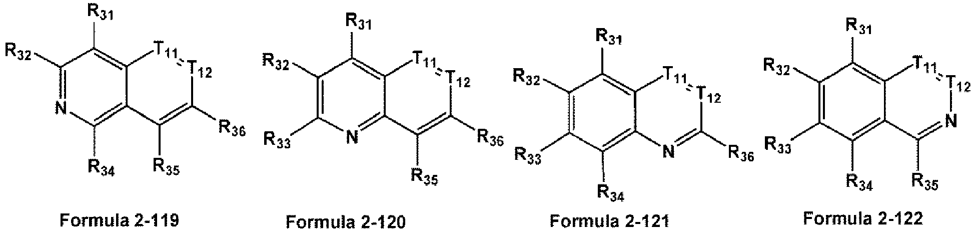

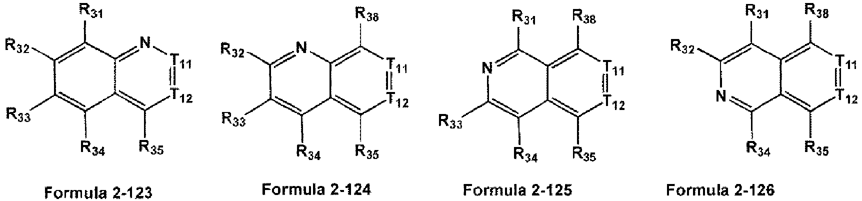

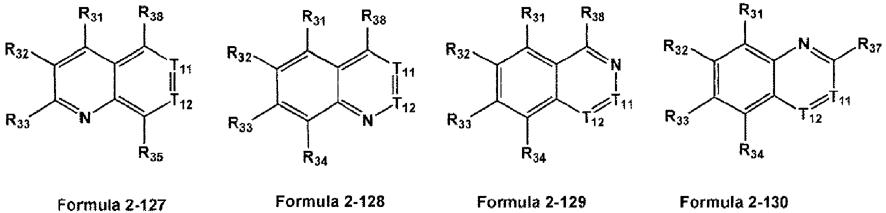

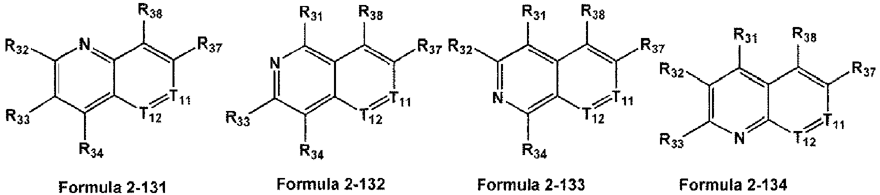

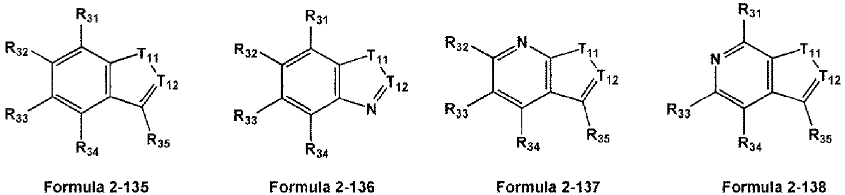

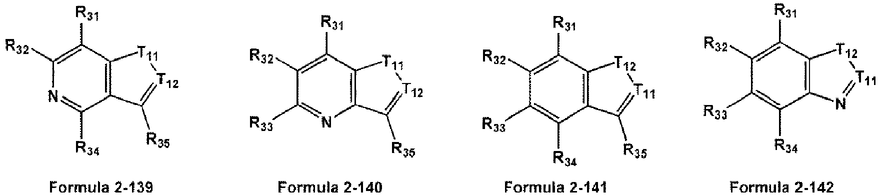

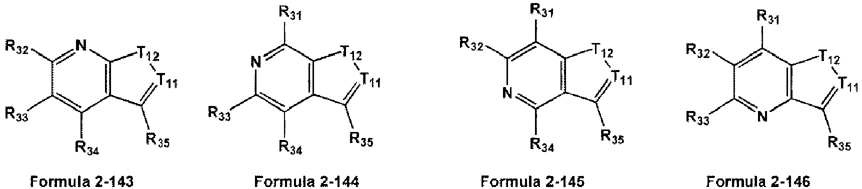

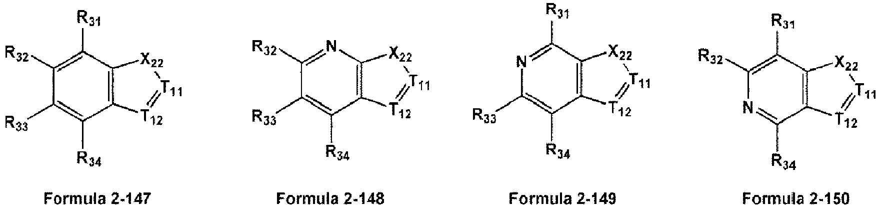

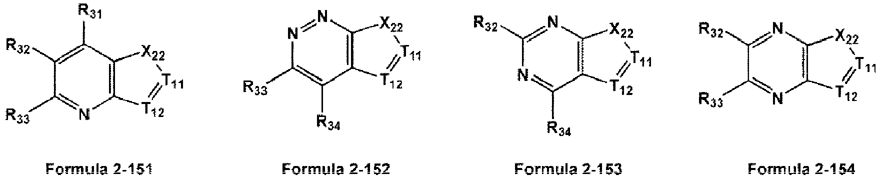

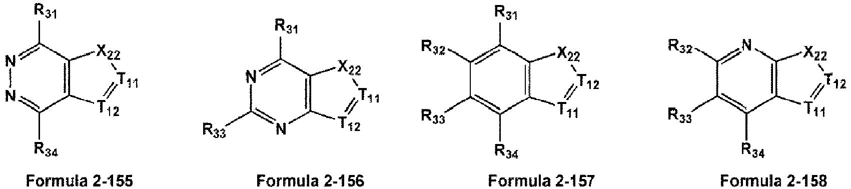

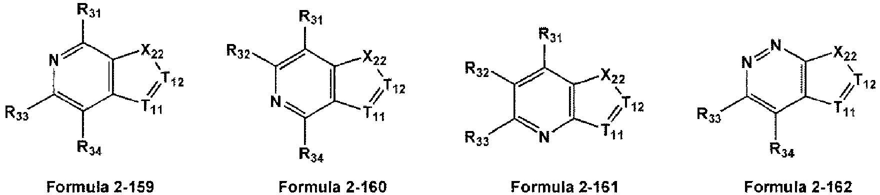

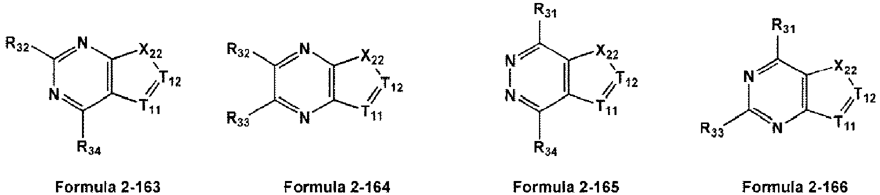

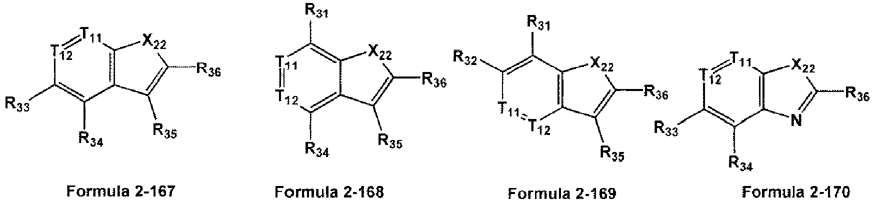

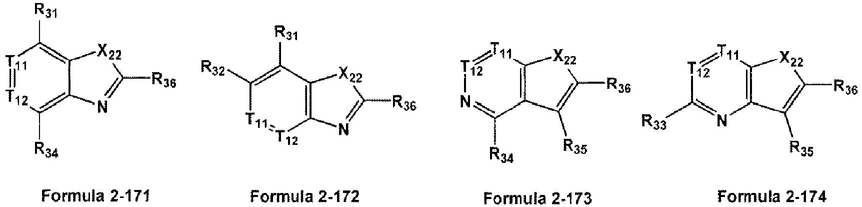

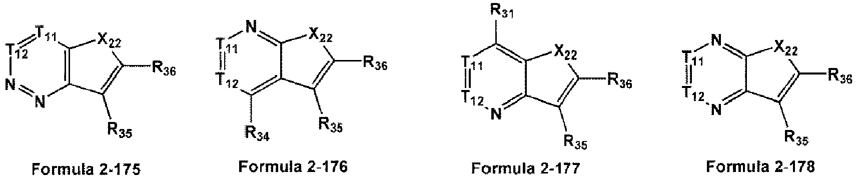

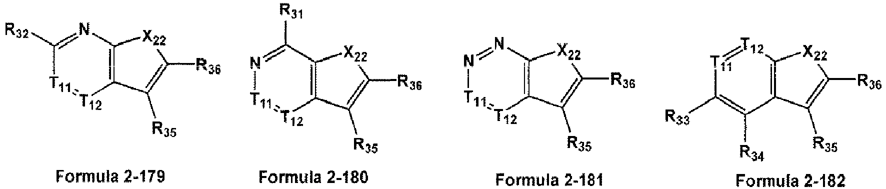

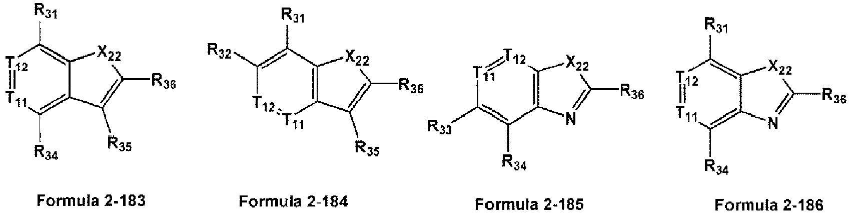

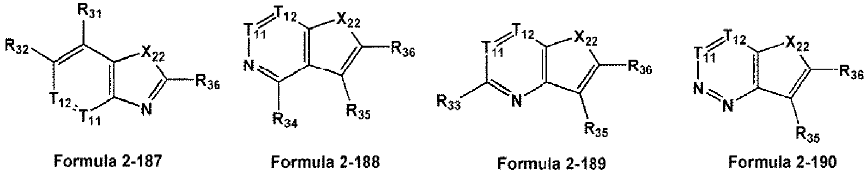

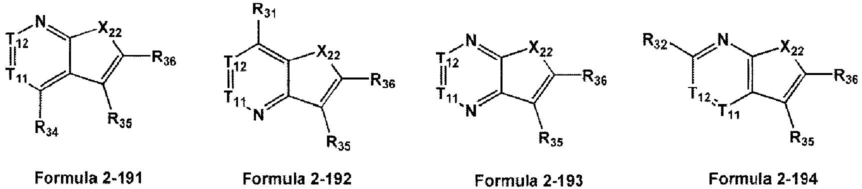

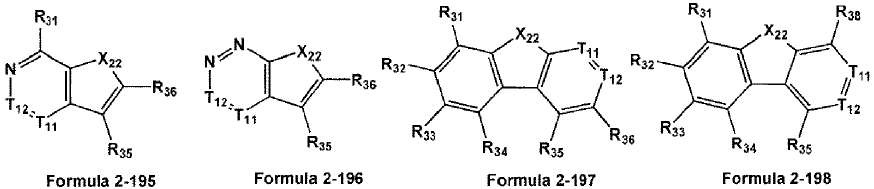

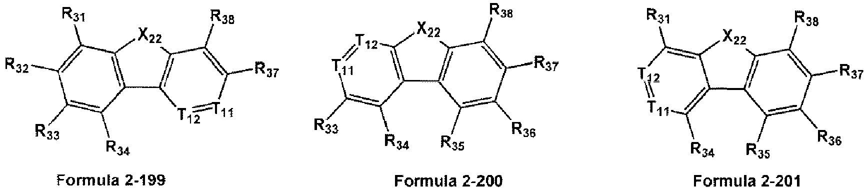

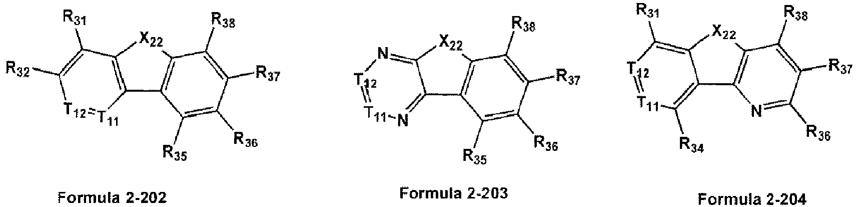

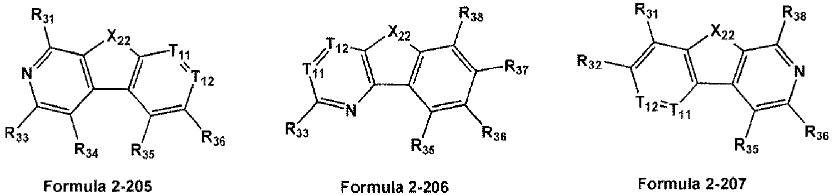

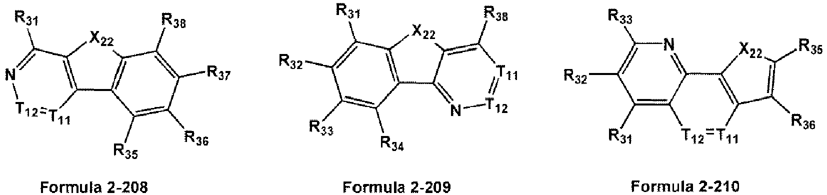

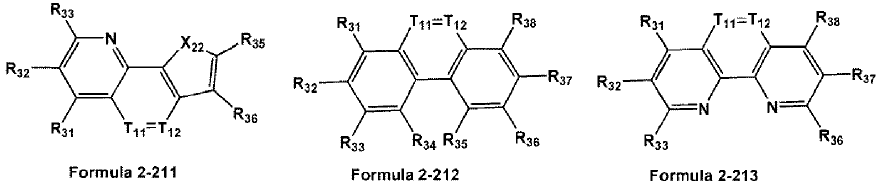

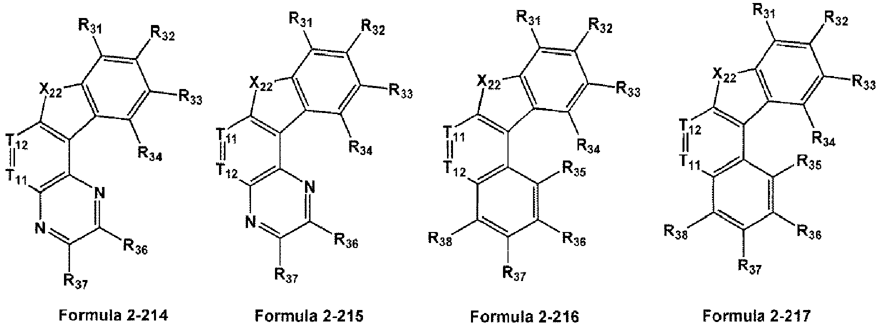

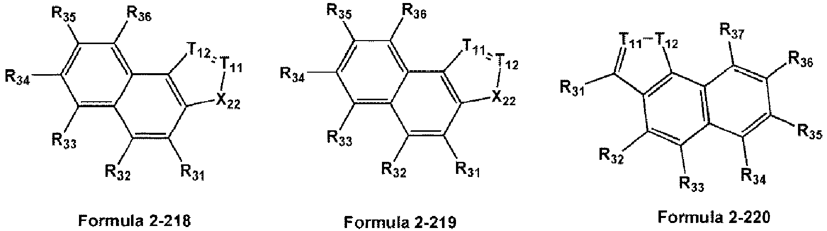

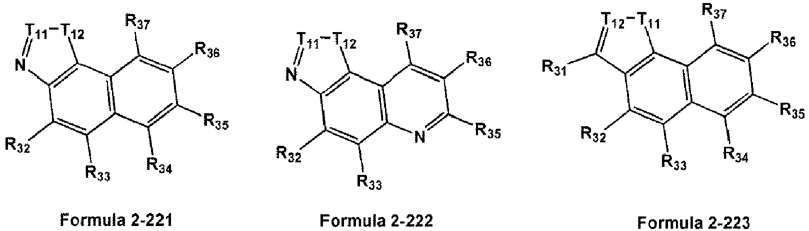

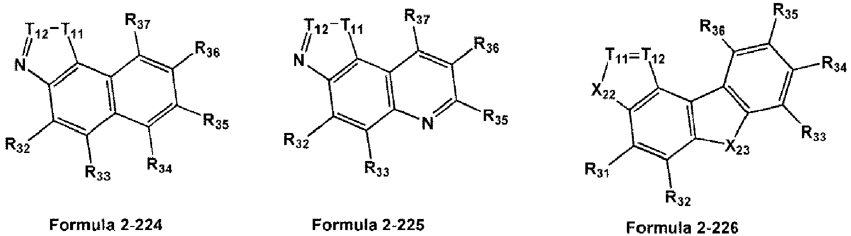

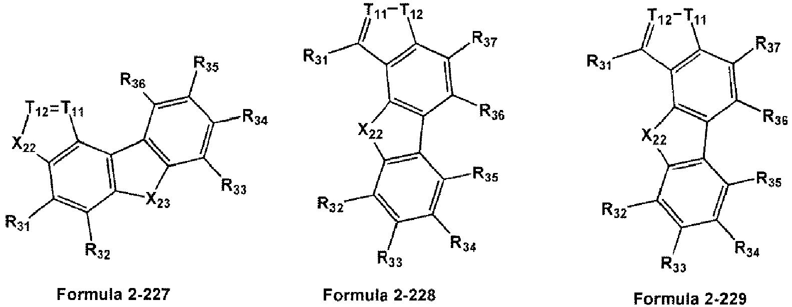

In Formulae 2-101 to 2-229,
T₁₁ and T₁₂ may each independently be the same as described herein in connection with Formulae 2A and 2B,
X₂₂ and X₂₃ may each independently be selected from O, S, Se, and a moiety comprising C, N, and/or Si, and
R₃₁ to R₃₈ may each independently be selected from substituents represented by *-[(L₂₂)ₐ₂₂-(R₂₂)_{b22}] used herein.

In some embodiments, when the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) is a cyclic group or contains a cyclic group. In some embodiments, when the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] is a cyclic group or contains a cyclic group. In some embodiments, when the number of *-[(L₂₂)ₐ₂₂-(R₂₂)_{b22}](s) in R₃₁ to R₃₈ is 2 or more, no more than 2 *-[(L₂₂)ₐ₂₂-(R₂₂)_{b22}](s) is other than hydrogen. In some embodiments, when the number of *-[(L₂₂)ₐ₂₂-(R₂₂)_{b22}](s) in R₃₁ to R₃₈ is 2 or more, no more than 1 *-[(L₂₂)ₐ₂₂-(R₂₂)_{b22}] is other than hydrogen.

In one or more embodiments, the second compound represented by Formula 2A or 2B may be represented by one selected from Formulae 2-201A to 2-269A (denoting a formula based on Formula 2A), wherein rings A₂₁, A₂₂, and A₂₃ in Formulae 2-201A to 2-269A are each selected from the formulae shown in Table 1:

**Table 1**

| Formula No. | Formula No. of ring A₂₁ | Formula No. of ring A₂₂ | Formula No. of ring A₂₃ |
|---|---|---|---|
| 2-201A | 2-2 | 2-4 | 2-4 |
| 2-202A | 2-4 | 2-4 | 2-1 |
| 2-203A | 2-4 | 2-4 | 2-2 |
| 2-204A | 2-4 | 2-4 | 2-3 |
| 2-205A | 2-4 | 2-1 | 2-4 |
| 2-206A | 2-4 | 2-2 | 2-4 |
| 2-207A | 2-4 | 2-4 | 2-10 |
| 2-208A | 2-11 | 2-4 | 2-4 |
| 2-209A | 2-4 | 2-4 | 2-11 |
| 2-210A | 2-4 | 2-10 | 2-4 |
| 2-211A | 2-4 | 2-4 | 2-8 |
| 2-212A | 2-4 | 2-9 | 2-4 |
| 2-213A | 2-4 | 2-4 | 2-14 |
| 2-214A | 2-17 | 2-4 | 2-4 |
| 2-215A | 2-4 | 2-4 | 2-15 |
| 2-216A | 2-13 | 2-4 | 2-4 |
| 2-217A | 2-4 | 2-4 | 2-16 |
| 2-218A | 2-4 | 2-4 | 2-13 |
| 2-219A | 2-16 | 2-4 | 2-4 |
| 2-220A | 2-4 | 2-4 | 2-12 |
| 2-221A | 2-4 | 2-4 | 2-17 |
| 2-222A | 2-4 | 2-16 | 2-4 |
| 2-223A | 2-4 | 2-15 | 2-4 |
| 2-224A | 2-4 | 2-14 | 2-4 |
| 2-225A | 2-4 | 2-17 | 2-4 |
| 2-226A | 2-19 | 2-4 | 2-4 |
| 2-227A | 2-22 | 2-4 | 2-4 |
| 2-228A | 2-18 | 2-4 | 2-4 |
| 2-229A | 2-23 | 2-4 | 2-4 |
| 2-230A | 2-21 | 2-4 | 2-4 |
| 2-231A | 2-20 | 2-4 | 2-4 |
| 2-232A | 2-4 | 2-23 | 2-4 |
| 2-233A | 2-4 | 2-18 | 2-4 |
| 2-234A | 2-4 | 2-21 | 2-4 |
| 2-235A | 2-4 | 2-19 | 2-4 |
| 2-236A | 2-5 | 2-2 | 2-4 |
| 2-237A | 2-5 | 2-1 | 2-4 |
| 2-238A | 2-2 | 2-2 | 2-4 |
| 2-239A | 2-4 | 2-23 | 2-1 |
| 2-240A | 2-6 | 2-10 | 2-4 |
| 2-241A | 2-4 | 2-4 | 2-29 |
| 2-242A | 2-7 | 2-4 | 2-10 |
| 2-243A | 2-11 | 2-4 | 2-10 |
| 2-244A | 2-4 | 2-10 | 2-6 |
| 2-245A | 2-11 | 2-11 | 2-4 |
| 2-246A | 2-11 | 2-11 | 2-5 |
| 2-247A | 2-11 | 2-11 | 2-10 |
| 2-248A | 2-7 | 2-9 | 2-4 |
| 2-249A | 2-4 | 2-4 | 2-25 |
| 2-250A | 2-11 | 2-15 | 2-4 |
| 2-251A | 2-18 | 2-28 | 2-4 |
| 2-252A | 2-23 | 2-10 | 2-4 |
| 2-253A | 2-4 | 2-27 | 2-4 |
| 2-254A | 2-6 | 2-18 | 2-4 |
| 2-255A | 2-4 | 2-23 | 2-5 |
| 2-256A | 2-23 | 2-4 | 2-14 |
| 2-257A | 2-17 | 2-4 | 2-14 |
| 2-258A | 2-14 | 2-4 | 2-12 |
| 2-259A | 2-17 | 2-4 | 2-12 |
| 2-260A | 2-14 | 2-16 | 2-2 |
| 2-261A | 2-17 | 2-5 | 2-14 |
| 2-262A | 2-17 | 2-13 | 2-17 |
| 2-263A | 2-17 | 2-14 | 2-12 |
| 2-264A | 2-17 | 2-12 | 2-12 |
| 2-265A | 2-5 | 2-1 | 2-18 |
| 2-266A | 2-4 | 2-29 | 2-4 |
| 2-267A | 2-4 | 2-31 | 2-4 |
| 2-268A | 2-4 | 2-33 | 2-4 |
| 2-269A | 2-4 | 2-35 | 2-4 |

For example, the compound represented by Formula 2-210A, wherein all of T₂₁ to T₂₄ are a moiety comprising C, may not be the second compound.

In one or more embodiments, the second compound represented by Formula 2A or 2B may be represented by one selected from Formulae 2-201B to 2-215B (denoting a formula based on Formulae 2B), wherein rings A₂₁ and A₂₃ in Formulae 2-201B to 2-215B are each selected from the formulae shown in Table 2:

**Table 2**

| Formula No. | Formula No. of ring A₂₁ | Formula No. of ring A₂₂ | Formula No. of ring A₂₃ |
|---|---|---|---|
| 2-201B | 2-4 | - | 2-19 |
| 2-202B | 2-4 | - | 2-22 |
| 2-203B | 2-4 | - | 2-18 |
| 2-204B | 2-4 | - | 2-23 |
| 2-205B | 2-4 | - | 2-21 |
| 2-206B | 2-4 | - | 2-20 |
| 2-207B | 2-5 | - | 2-23 |
| 2-208B | 2-7 | - | 2-23 |
| 2-209B | 2-4 | - | 2-26 |
| 2-210B | 2-7 | - | 2-22 |
| 2-211B | 2-13 | - | 2-16 |
| 2-212B | 2-5 | - | 2-19 |
| 2-213B | 2-7 | - | 2-20 |
| 2-214B | 2-19 | - | 2-18 |
| 2-215B | 2-18 | - | 2-18 |

In one or more embodiments, the second compound represented by Formula 2A or 2B may be represented by one selected from Formulae 2-301A to 2-419A and 2-421A to 2-431A (denoting a formula based on Formulae 2A), wherein rings A₂₁, A₂₂, and A₂₃ in Formulae 2-301A to 2-419A and 2-421A to 2-431A are each selected from the formulae shown in Table 3:

**Table 3**

| Formula No. | Formula No. of ring A₂₁ | Formula No. of ring A₂₂ | Formula No. of ring A₂₃ |
|---|---|---|---|
| 2-301A | 2-104 | 2-147 | 2-104 |
| 2-302A | 2-102 | 2-104 | 2-104 |
| 2-303A | 2-104 | 2-104 | 2-101 |
| 2-304A | 2-104 | 2-104 | 2-102 |
| 2-305A | 2-104 | 2-104 | 2-103 |
| 2-306A | 2-104 | 2-101 | 2-104 |
| 2-307A | 2-104 | 2-102 | 2-104 |
| 2-308A | 2-104 | 2-104 | 2-147 |
| 2-309A | 2-157 | 2-104 | 2-104 |
| 2-310A | 2-104 | 2-104 | 2-157 |
| 2-311A | 2-104 | 2-147 | 2-107 |
| 2-312A | 2-104 | 2-149 | 2-104 |
| 2-313A | 2-104 | 2-156 | 2-104 |
| 2-314A | 2-107 | 2-147 | 2-106 |
| 2-315A | 2-104 | 2-151 | 2-104 |
| 2-316A | 2-104 | 2-147 | 2-106 |
| 2-317A | 2-104 | 2-148 | 2-104 |
| 2-318A | 2-104 | 2-150 | 2-104 |
| 2-319A | 2-106 | 2-147 | 2-104 |
| 2-320A | 2-104 | 2-106 | 2-147 |
| 2-321A | 2-157 | 2-107 | 2-104 |
| 2-322A | 2-106 | 2-104 | 2-147 |
| 2-323A | 2-104 | 2-107 | 2-147 |
| 2-324A | 2-107 | 2-104 | 2-147 |
| 2-325A | 2-104 | 2-104 | 2-160 |
| 2-326A | 2-104 | 2-111 | 2-157 |
| 2-327A | 2-108 | 2-104 | 2-158 |
| 2-328A | 2-111 | 2-104 | 2-157 |
| 2-329A | 2-107 | 2-147 | 2-104 |
| 2-330A | 2-104 | 2-104 | 2-135 |
| 2-331A | 2-104 | 2-141 | 2-104 |
| 2-332A | 2-104 | 2-142 | 2-104 |
| 2-333A | 2-107 | 2-104 | 2-135 |
| 2-334A | 2-104 | 2-111 | 2-135 |
| 2-335A | 2-104 | 2-143 | 2-104 |
| 2-336A | 2-106 | 2-142 | 2-104 |
| 2-337A | 2-107 | 2-142 | 2-106 |
| 2-338A | 2-104 | 2-104 | 2-169 |
| 2-339A | 2-184 | 2-104 | 2-104 |
| 2-340A | 2-104 | 2-104 | 2-182 |
| 2-341A | 2-168 | 2-104 | 2-104 |
| 2-342A | 2-104 | 2-104 | 2-183 |
| 2-343A | 2-104 | 2-104 | 2-168 |
| 2-344A | 2-183 | 2-104 | 2-104 |
| 2-345A | 2-104 | 2-104 | 2-167 |
| 2-346A | 2-104 | 2-104 | 2-184 |
| 2-347A | 2-104 | 2-183 | 2-104 |
| 2-348A | 2-104 | 2-182 | 2-104 |
| 2-349A | 2-104 | 2-169 | 2-104 |
| 2-350A | 2-104 | 2-184 | 2-104 |
| 2-351A | 2-107 | 2-104 | 2-179 |
| 2-352A | 2-111 | 2-104 | 2-169 |
| 2-353A | 2-104 | 2-111 | 2-182 |
| 2-354A | 2-106 | 2-104 | 2-185 |
| 2-355A | 2-171 | 2-104 | 2-104 |
| 2-356A | 2-104 | 2-104 | 2-115 |
| 2-357A | 2-104 | 2-104 | 2-178 |
| 2-358A | 2-104 | 2-106 | 2-167 |
| 2-359A | 2-108 | 2-105 | 2-167 |
| 2-360A | 2-105 | 2-104 | 2-167 |
| 2-361A | 2-112 | 2-104 | 2-184 |
| 2-362A | 2-104 | 2-192 | 2-104 |
| 2-363A | 2-107 | 2-182 | 2-106 |
| 2-364A | 2-104 | 2-169 | 2-105 |
| 2-365A | 2-105 | 2-184 | 2-104 |
| 2-366A | 2-105 | 2-169 | 2-105 |
| 2-367A | 2-198 | 2-104 | 2-104 |
| 2-368A | 2-201 | 2-104 | 2-104 |
| 2-369A | 2-197 | 2-104 | 2-104 |
| 2-370A | 2-202 | 2-104 | 2-104 |
| 2-371A | 2-200 | 2-104 | 2-104 |
| 2-372A | 2-199 | 2-104 | 2-104 |
| 2-373A | 2-104 | 2-202 | 2-104 |
| 2-374A | 2-104 | 2-197 | 2-104 |
| 2-375A | 2-104 | 2-200 | 2-104 |
| 2-376A | 2-104 | 2-198 | 2-104 |
| 2-377A | 2-209 | 2-104 | 2-104 |
| 2-378A | 2-207 | 2-104 | 2-104 |
| 2-379A | 2-200 | 2-106 | 2-104 |
| 2-380A | 2-104 | 2-208 | 2-104 |
| 2-381A | 2-105 | 2-198 | 2-108 |
| 2-382A | 2-202 | 2-102 | 2-104 |
| 2-383A | 2-202 | 2-101 | 2-106 |
| 2-384A | 2-102 | 2-102 | 2-107 |
| 2-385A | 2-104 | 2-202 | 2-101 |
| 2-386A | 2-123 | 2-147 | 2-104 |
| 2-387A | 2-104 | 2-104 | 2-218 |
| 2-388A | 2-116 | 2-104 | 2-147 |
| 2-389A | 2-157 | 2-104 | 2-147 |
| 2-390A | 2-107 | 2-147 | 2-115 |
| 2-391A | 2-157 | 2-157 | 2-104 |
| 2-392A | 2-157 | 2-157 | 2-114 |
| 2-393A | 2-157 | 2-157 | 2-147 |
| 2-394A | 2-116 | 2-147 | 2-104 |
| 2-395A | 2-104 | 2-104 | 2-210 |
| 2-396A | 2-157 | 2-182 | 2-104 |
| 2-397A | 2-197 | 2-213 | 2-104 |
| 2-398A | 2-202 | 2-167 | 2-104 |
| 2-399A | 2-104 | 2-216 | 2-104 |
| 2-400A | 2-124 | 2-197 | 2-104 |
| 2-401A | 2-104 | 2-202 | 2-114 |
| 2-402A | 2-168 | 2-104 | 2-169 |
| 2-403A | 2-184 | 2-104 | 2-169 |
| 2-404A | 2-169 | 2-104 | 2-167 |
| 2-405A | 2-184 | 2-106 | 2-167 |
| 2-406A | 2-169 | 2-183 | 2-102 |
| 2-407A | 2-184 | 2-114 | 2-169 |
| 2-408A | 2-184 | 2-168 | 2-184 |
| 2-409A | 2-184 | 2-104 | 2-167 |
| 2-410A | 2-184 | 2-167 | 2-167 |
| 2-411A | 2-114 | 2-101 | 2-197 |
| 2-412A | 2-104 | 2-149 | 2-104 |
| 2-413A | 2-106 | 2-104 | 2-147 |
| 2-414A | 2-104 | 2-104 | 2-168 |
| 2-415A | 2-200 | 2-106 | 2-104 |
| 2-416A | 2-104 | 2-104 | 2-183 |
| 2-417A | 2-104 | 2-104 | 2-101 |
| 2-418A | 2-105 | 2-169 | 2-105 |
| 2-419A | 2-104 | 2-147 | 2-107 |
| 2-421A | 2-104 | 2-218 | 2-104 |
| 2-422A | 2-104 | 2-226 | 2-104 |
| 2-423A | 2-104 | 2-222 | 2-104 |
| 2-424A | 2-104 | 2-228 | 2-104 |
| 2-425A | 2-104 | 2-151 | 2-104 |
| 2-426A | 2-106 | 2-147 | 2-107 |
| 2-427A | 2-104 | 2-147 | 2-106 |
| 2-428A | 2-107 | 2-150 | 2-104 |
| 2-429A | 2-104 | 2-143 | 2-104 |
| 2-430A | 2-107 | 2-142 | 2-106 |
| 2-431A | 2-104 | 2-142 | 2-104 |

In one or more embodiments, the second compound represented by Formula 2A or 2B may be represented by one selected from Formulae 2-301B to 2-320B (denoting a formula based on Formulae 2B), and rings A₂₁ and A₂₃ in Formulae 2-301B to 2-320B are each selected from the formulae shown in Table 4:

**Table 4**

| Formula No. | Formula No. of ring A₂₁ | Formula No. of ring A₂₂ | Formula No. of ring A₂₃ |
|---|---|---|---|
| 2-301B | 2-104 | - | 2-198 |
| 2-302B | 2-104 | - | 2-201 |
| 2-303B | 2-104 | - | 2-197 |
| 2-304B | 2-104 | - | 2-202 |
| 2-305B | 2-104 | - | 2-200 |
| 2-306B | 2-104 | - | 2-199 |
| 2-307B | 2-104 | - | 2-203 |
| 2-308B | 2-104 | - | 2-204 |
| 2-309B | 2-106 | - | 2-205 |
| 2-310B | 2-104 | - | 2-206 |
| 2-311B | 2-112 | - | 2-199 |
| 2-312B | 2-114 | - | 2-202 |
| 2-313B | 2-116 | - | 2-202 |
| 2-314B | 2-104 | - | 2-214 |
| 2-315B | 2-130 | - | 2-201 |
| 2-316B | 2-168 | - | 2-183 |
| 2-317B | 2-114 | - | 2-198 |
| 2-318B | 2-116 | - | 2-199 |
| 2-319B | 2-198 | - | 2-197 |
| 2-320B | 2-197 | - | 2-197 |

In Formulae 2A and 2B, X₂₁ is selected from S, Sc, C(R₂₃)(R₂₄), Si(R₂₃)(R₂₄), and N-[(L₂₁)ₐ₂₁-(R₂₁)_{b21}].

In one embodiment, in Formulae 2A and 2B, X₂₁ may be N[(L₂₁)ₐ₂₁-(R₂₁)_{b21}].

In one or more embodiments, in Formulae 2A and 2B, X₂₁ may be selected from S, Se, C(R₂₃)(R₂₄), and Si(R₂₃)(R₂₄), and
at least one selected from rings A₂₁, A₂₂, and A₂₃ in Formula 2A and at least one selected from rings A₂₁ and A₂₃ in Formula 2B may each independently be selected from groups represented by Formulae 2-1 to 2-3, 2-10 to 2-27, and 2-33 to 2-36, and X₂₂ or X₂₃ in Formulae 2-1 to 2-3, 2-10 to 2-27, and 2-33 to 2-36 may be N-[(L₂₂)ₐ₂₂-(R₂₂)_{b22}].

In one or more embodiments, X₂₁ in Formulae 2A and 2B may be selected from S, Se, C(R₂₃)(R₂₄), and Si(R₂₃)(R₂₄), and
at least one selected from rings A₂₁, A₂₂, and A₂₃ in Formula 2A and at least one selected from rings A₂₁ and A₂₃ in Formula 2B may each independently be selected from groups represented by Formulae 2-101 to 2-103, 2-147 to 2-211, 2-214 to 2-219, and 2-226 to 2-229, and X₂₂ or X₂₃ in Formulae 2-101 to 2-103, 2-147 to 2-211, 2-214 to 2-219, and 2-226 to 2-229 may be N-[(L₂₂)ₐ₂₂-(R₂₂)_{b22}], but embodiments of the present disclosure are not limited thereto.

In Formulae 2A and 2B, X21 may be selected from S, Se, C(R₂₃)(R₂₄), Si(R₂₃)(R₂₄), and N-[(L₂₁)ₐ₂₁-(R₂₁)_{b21}], and X₂₂ and X₂₃ may each independently be selected from O, S, Se, C(R₂₅)(R₂₆), Si(R₂₅)(R₂₆), and N-[(L₂₂)ₐ₂₂-(R₂₂)_{b22}]. L₂₁, L₂₂, a21, a22, R₂₁ to R₂₄, b21, and b22 may each independently be the same as described herein, and R₂₅ and R₂₆ may each independently be the same in described herein in connection with R₂₃.

In Formulae 1A, 1B, 2A, and 2B, L₁ to L₃, L₁₁ to L₁₅, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group, wherein ring A₁ may be a C₅-C₃₀ carbocyclic group or a C₁-C₃₀ heterocyclic group.

For example, L₁ to L₃, L₁₁ to L₁₅, and ring A₁ in Formulae 1A and 1B may each independently be selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, a pyridinylene group, an indolylene group, an isoindolylene group, a purinylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, and a dibenzocarbazolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, a pyridinylene group, an indolylene group, an isoindolylene group, a purinylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, and a dibenzocarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), - N(Q₃₁)(Q₃₂), and -B(Q₃₁)(Q₃₂), and
L₂₁ and L₂₂ in Formulae 2A and 2B may each independently be selected from the group consisting of:
   a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
   a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂),
   wherein Q₁ to Q₃ and Q₃₁ to Q₃₃ may each independently be selected from the group consisting of:
      a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
      a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group, but embodiments of the present disclosure are not limited thereto.

In one embodiment, L₁ to L₃, L₁₁ to L₁₅, and ring A₁ in Formulae 1A and 1B may each independently be selected from groups represented by Formulae 3-1 to 3-30, and
L₂₁ and L₂₂ in Formulae 2A and 2B may each independently be selected from groups represented by Formulae 3-1 to 3-100:

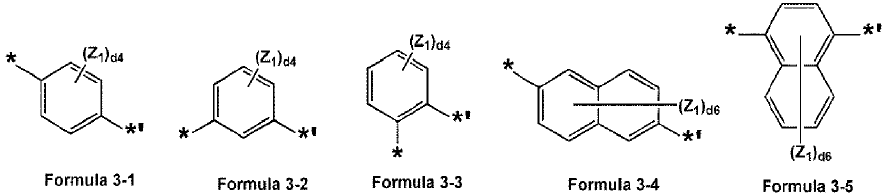

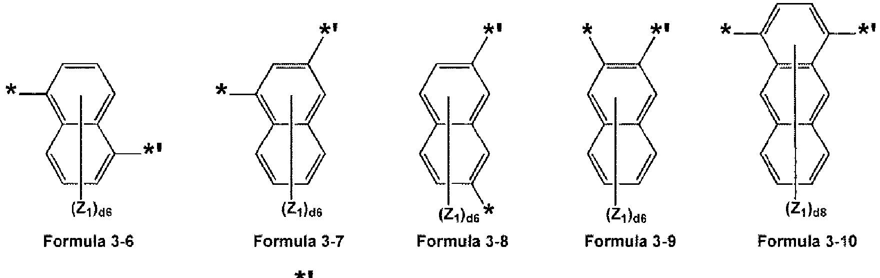

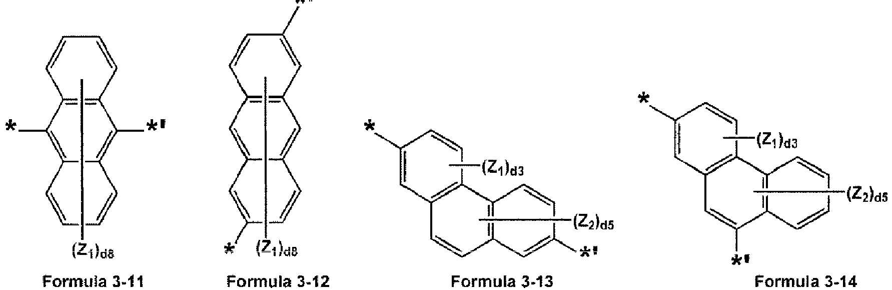

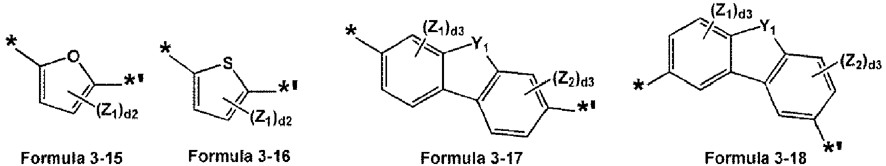

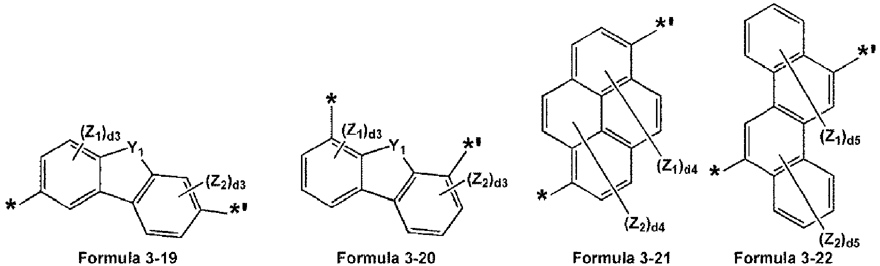

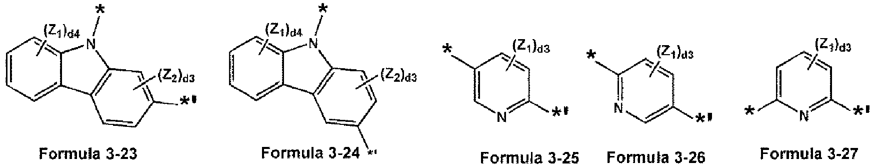

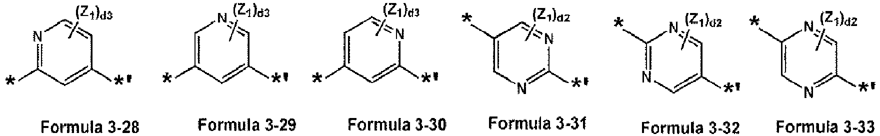

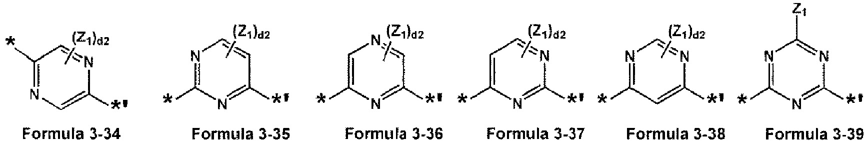

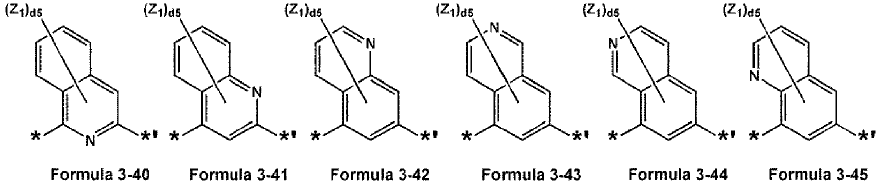

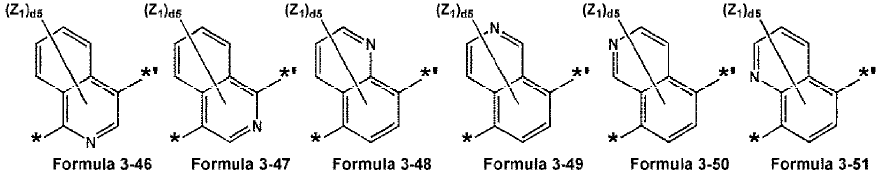

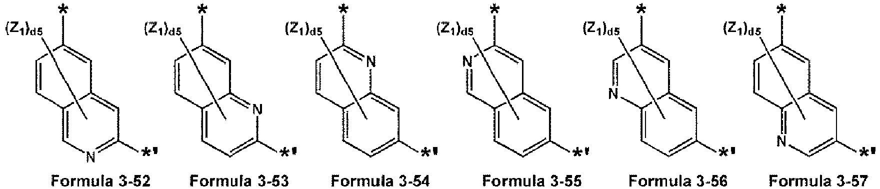

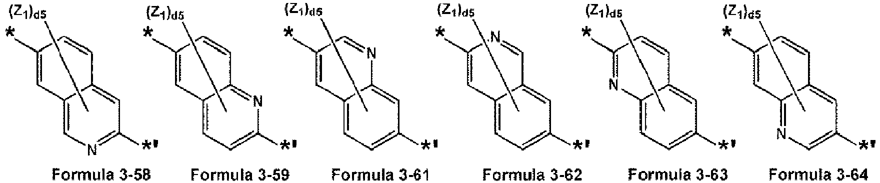

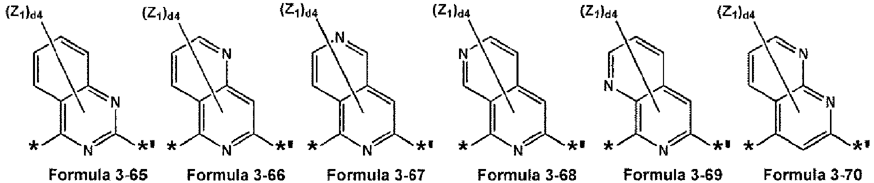

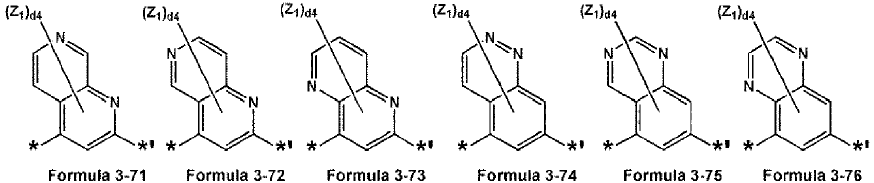

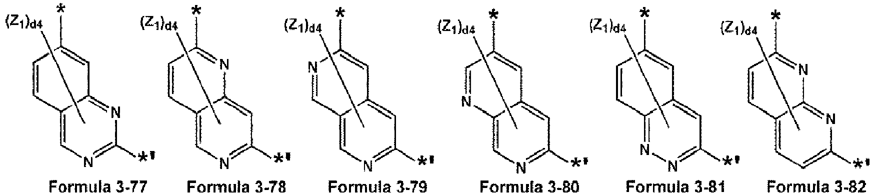

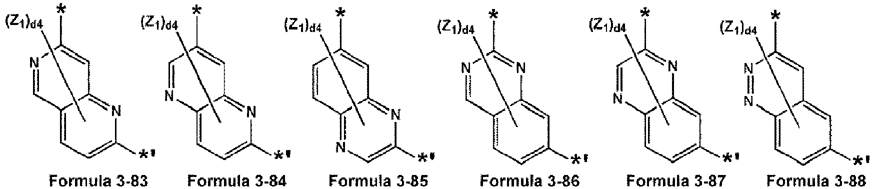

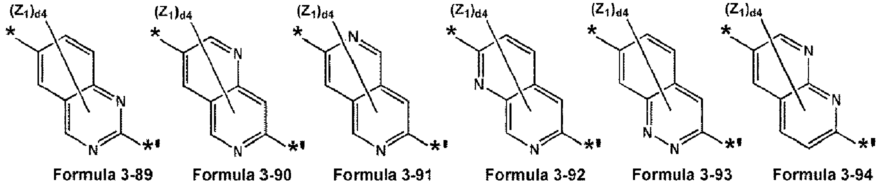

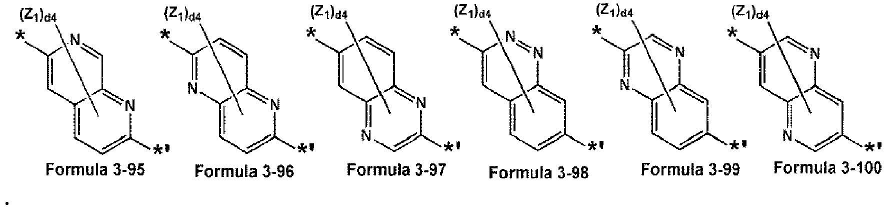

In Formulae 3-1 to 3-100,
Y₁ may be selected from O, S, C(Z₃)(Z₄), N(Z₅), and Si(Z₆)(Z₇),
Z₁ to Z₇ may each independently be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be the same as described herein,
d₂ may be an integer selected from 0 to 2,
d₃ may be an integer selected from 0 to 3,
d₄ may be an integer selected from 0 to 4,
d₅ may be an integer selected from 0 to 5,
d6 may be an integer selected from 0 to 6,
d8 may be an integer selected from 0 to 8, and
* and *' may each indicate a binding site to an adjacent atom.

For example, L₁ to L₃, L₁₁ to L₁₅, and ring A₁ in Formulae 1A and 1B may each independently be a group represented by one selected from Formulae 3-1 to 3-30,
wherein Z₁ to Z₇ in Formulae 3-1 to 3-30 may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenylene group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, an isoindolyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, and a pyridinyl group, but embodiments of the present disclosure are not limited thereto.
a1 to a3, an to a15, a21, and a22 in Formulae 1A, 1B, 2A, and 2B are each independently an integer selected from 0 to 5. a1 indicates the number of L₁(s). When a1 is 0, *-(L₁)ₐ₁-*' may be a single bond. When a1 is 2 or greater, a plurality of L₁(s) may be identical to or different from each other. a2, a3, a11 to a15, a21, and a22 may each independently be the same as described herein in connection with a1 and Formulae 1A, 1B, 2A, and 2B.

When a1 to a3, an to a15, a21, or a22 is zero, each respective b1 to b3, b11 to b15, b21, and b22 is 1. Thus, in any single incidence of a group *-[(L₁)ₐ₁-(R₁)_{b1}], when a1 is zero, b1 is 1. In any single incidence of a group *-[(L₂)ₐ₂-(R₂)_{b2}], when a2 is zero, b2 is 1. In any single incidence of a group *-(L₃)ₐ₃-(R₃)_{b3}, when a₃ is zero, b₃ is 1. In any single incidence of a group *-[(L₁₁)ₐ₁₁-(R₁₁)_{b11}], when an is zero, b11 is 1. In any single incidence of a group *-[(L₁₂)ₐ₁₂-(R₁₂)_{b12}], when a12 is zero, b12 is 1. In any single incidence of a group *-(L₁₃)ₐ₁₃-(R₁₃)_{b13}, when a13 is zero, b13 is 1. In any single incidence of a group *-(L₁₄)ₐ₁₄-(R₁₄)_{b14}, when a14 is zero, b14 is 1. In any single incidence of a group *-(L₁₅)ₐ₁₅-(R₁₅)_{b15}, when a15 is zero, b15 is 1. In any single incidence of a group *-[(L₂₁)ₐ₂₁-(R₂₁)_{b21}], when a21 is zero, b21 is 1. In any single incidence of a group *-[(L₂₂)ₐ₂₂-(R₂₂)_{b22}], when a22 is zero, b22 is 1.

In one embodiment, a1 to a3, a11 to a15, a21, and a22 in Formulae 1A, 1B, 2A, and 2B may each independently be selected from 0, 1, 2, and 3 (or 0, 1, and 2), but embodiments of the present disclosure are not limited thereto.

a16 in Formula 2 indicates the number of ring A₁(s). When a16 is 2 or greater, a plurality of ring A₁(s) may be identical to or different from each other. A plurality of ring A₁(s) may be bound (e.g., coupled) via one or more single bonds. Typically, when a plurality of A1s are present, adjacent A1s are coupled via only one single bond. a16 may be an integer selected from 1 to 10, and in some embodiments, an integer selected from 1 to 6.

In one or more embodiments, a16 in Formula 1B may be 1, ring A1 may be a benzene group, and n2 may be 1 or 2.

In one or more embodiments, a16 in Formula 1B may be 1, ring A₁ may be a benzene group, and n2 may be 1.

In one or more embodiments, when a16 in Formula 1B is 2, at least one selected from two ring A₁(s) may be a group represented by one selected from Formulae 3-2 to 3-30.

In one or more embodiments, a16 in Formula 1B may be selected from 3, 4, 5, and 6.

In one or more embodiments, 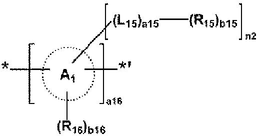 in Formula 1B may be a group represented by one selected from Formulae A-1 to A-12, B-1 to B-20, C-1 to C-29, D-1 to D-25, and E-1 to E-4:

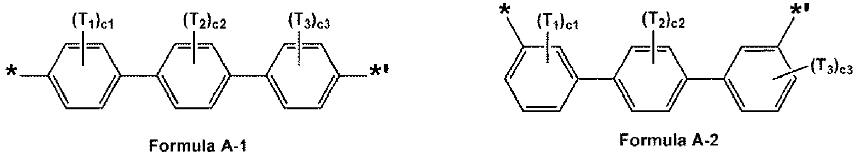

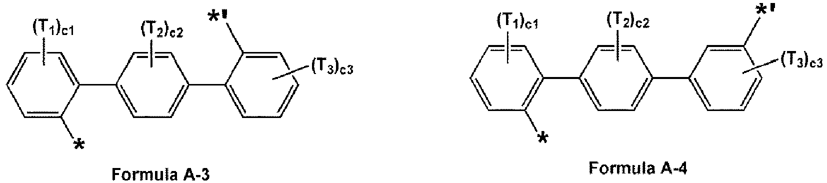

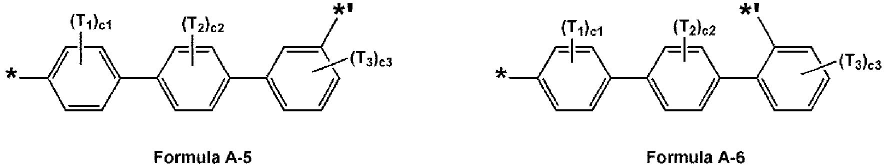

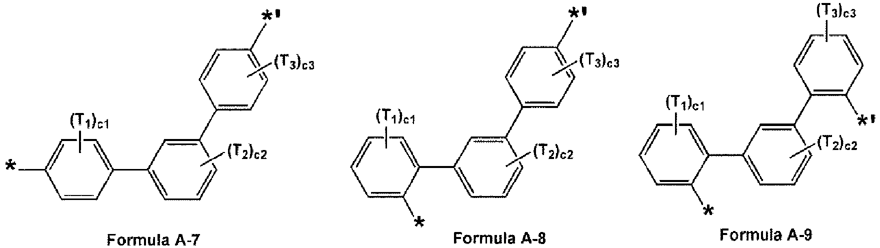

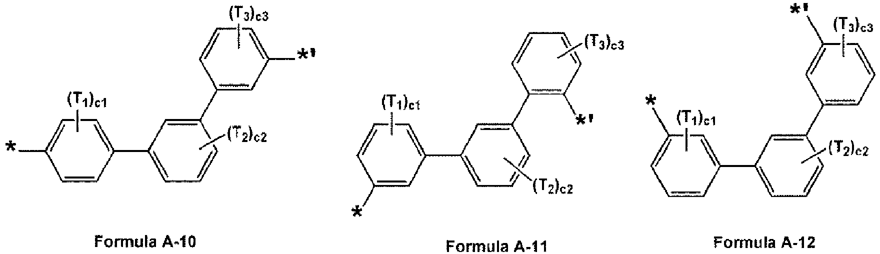

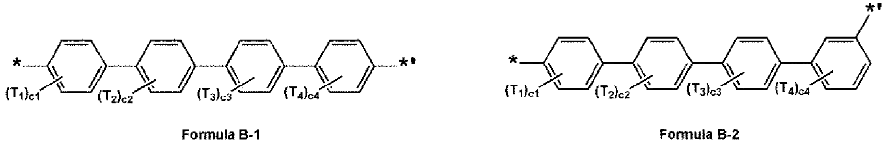

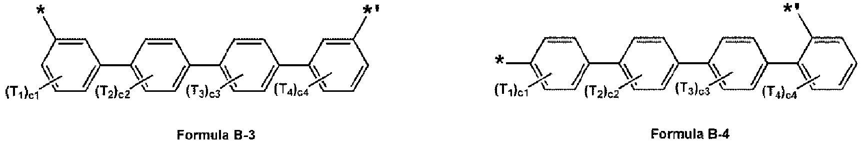

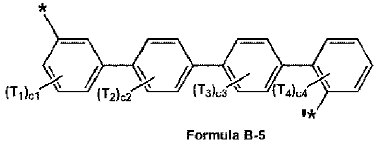

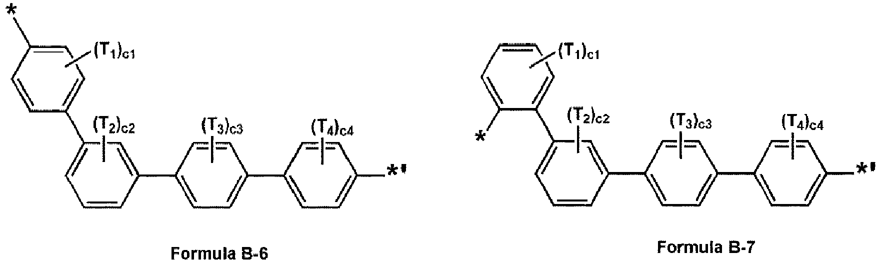

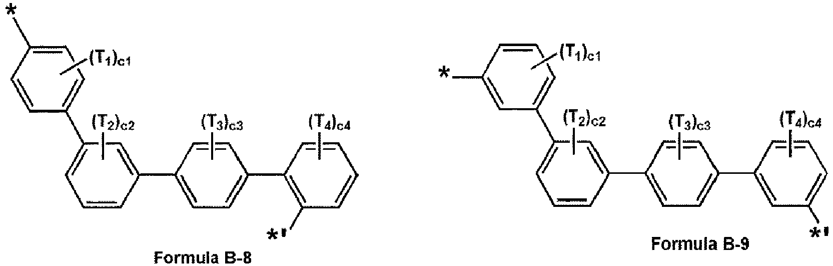

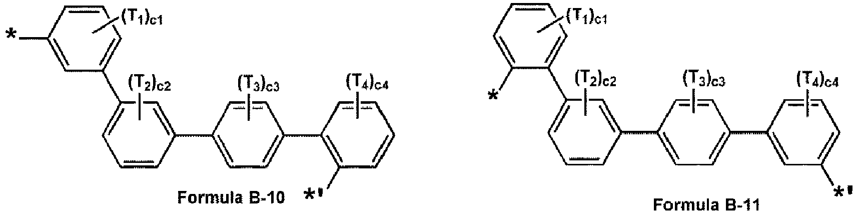

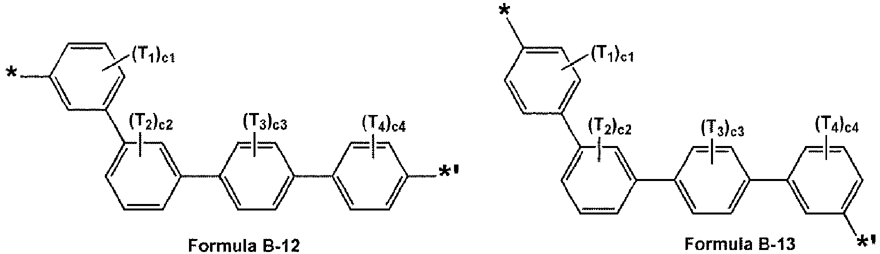

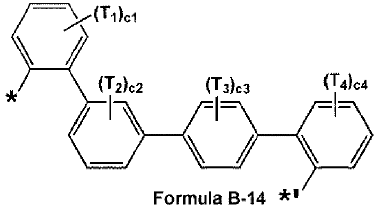

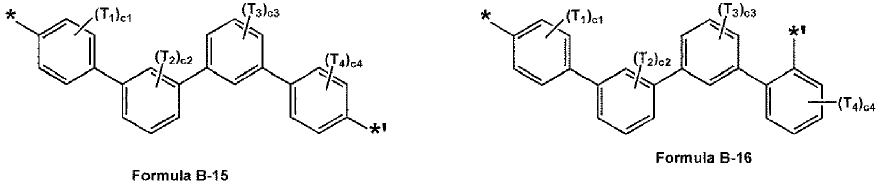

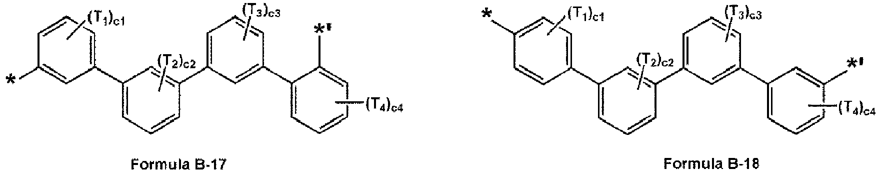

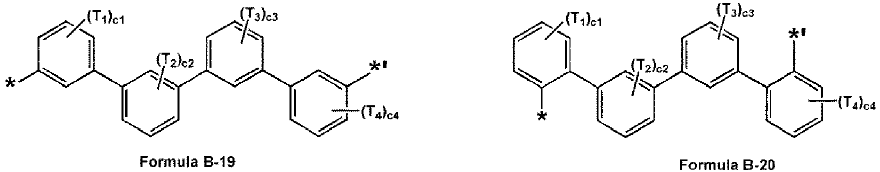

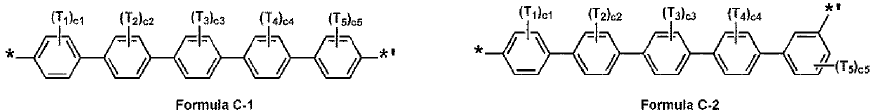

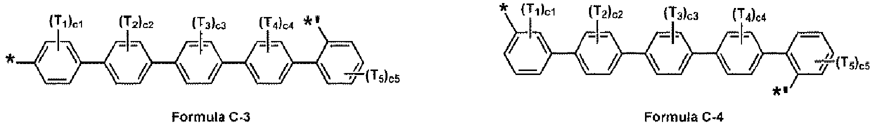

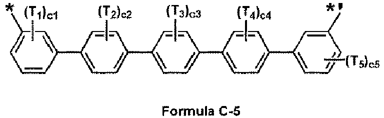

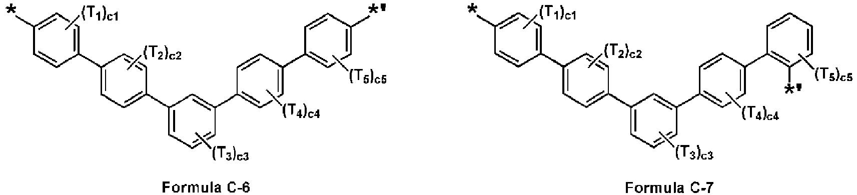

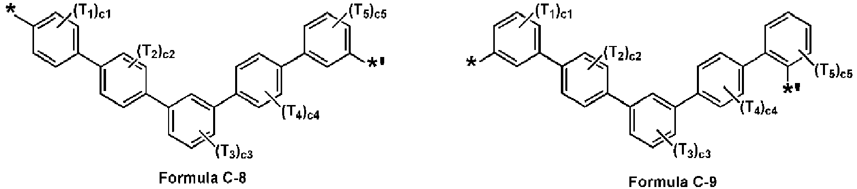

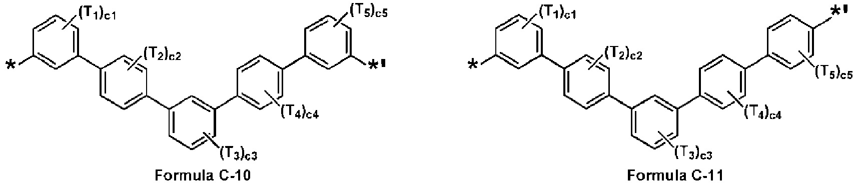

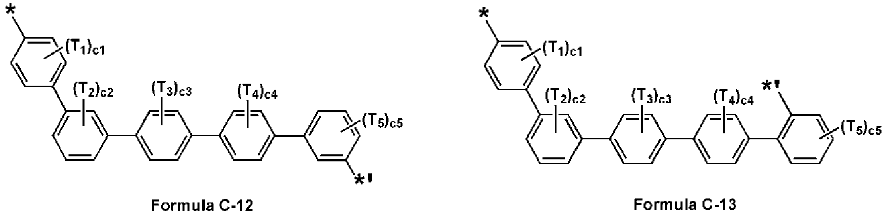

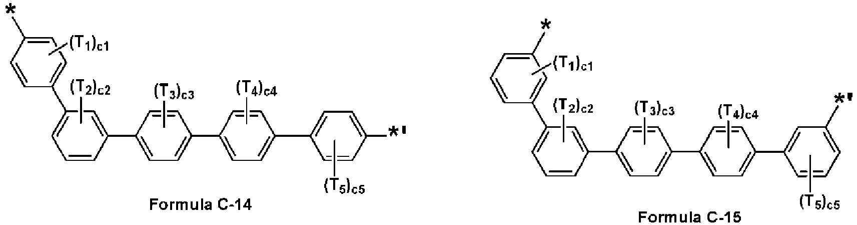

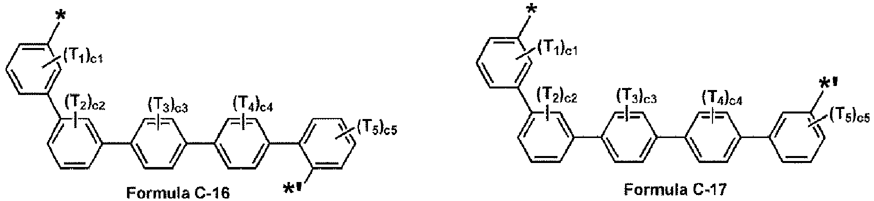

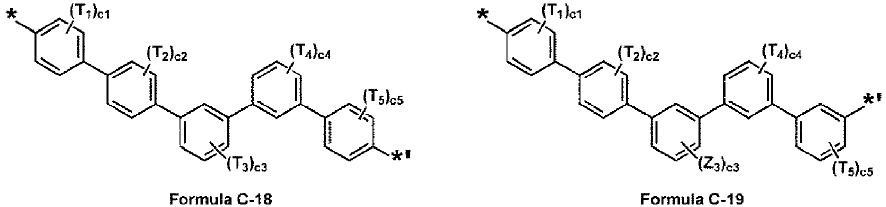

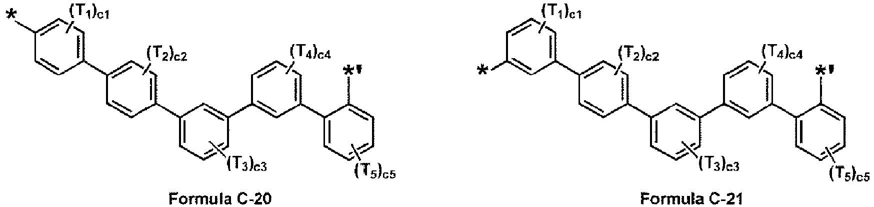

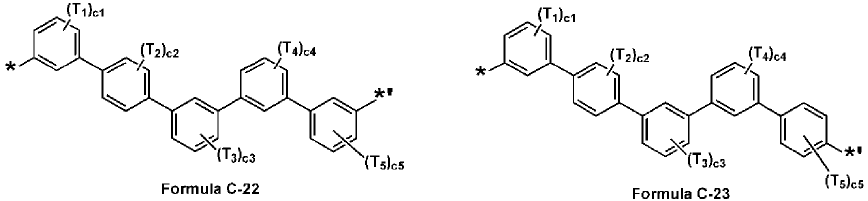

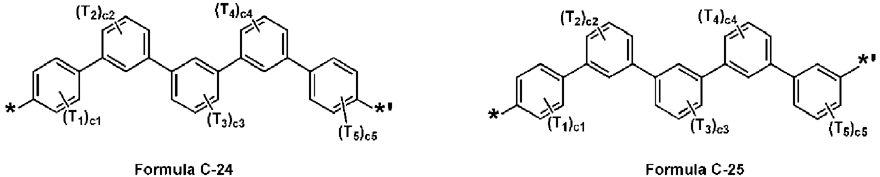

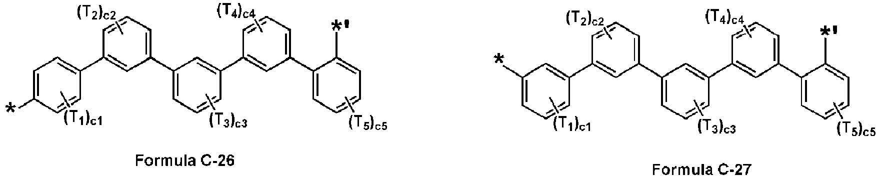

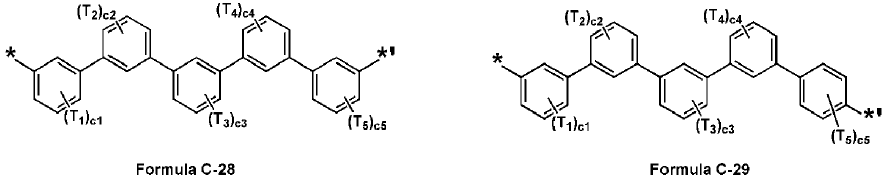

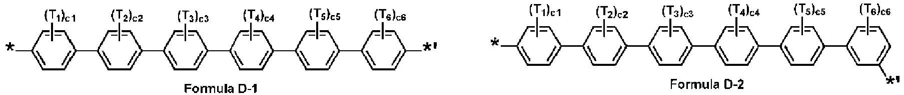

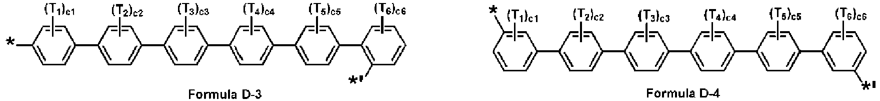

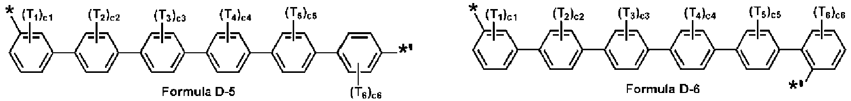

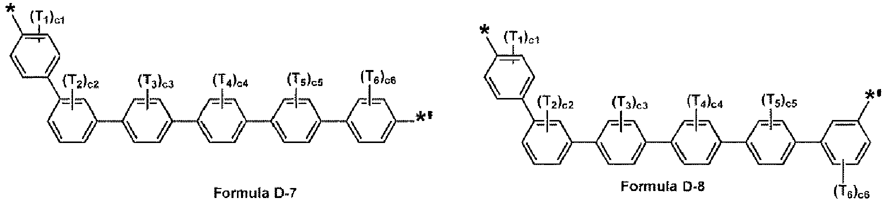

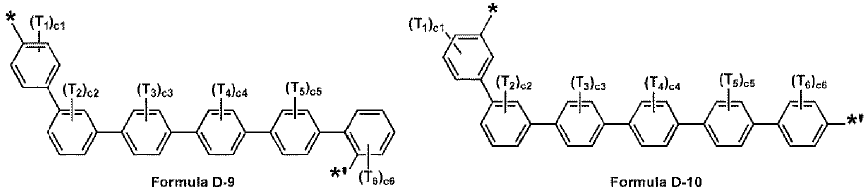

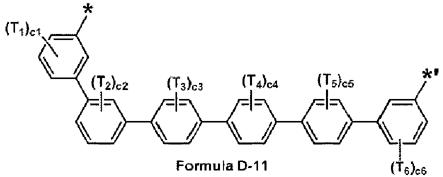

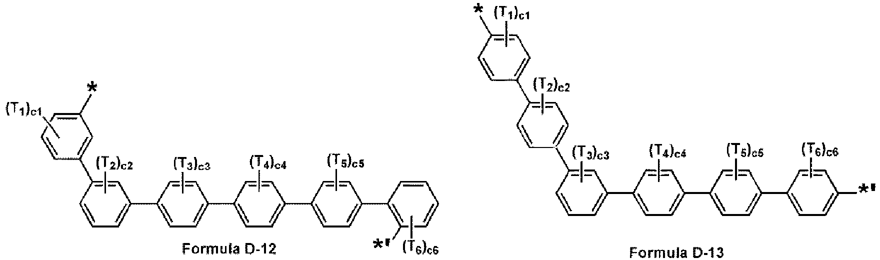

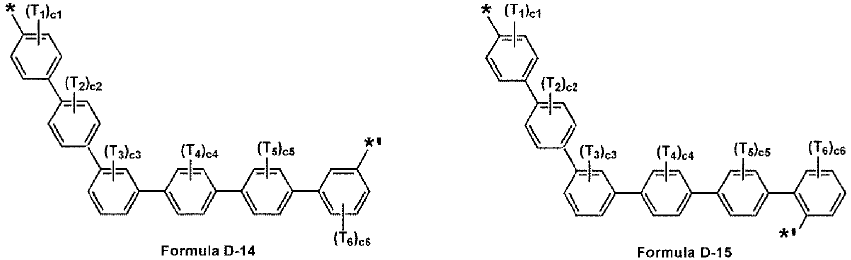

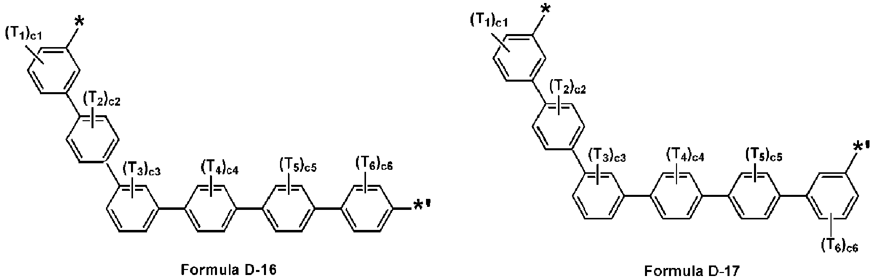

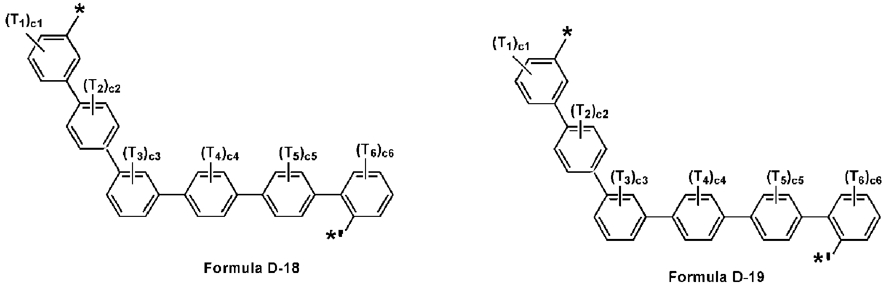

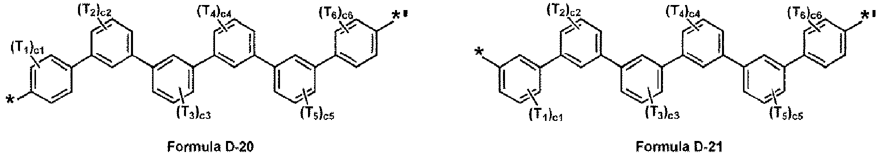

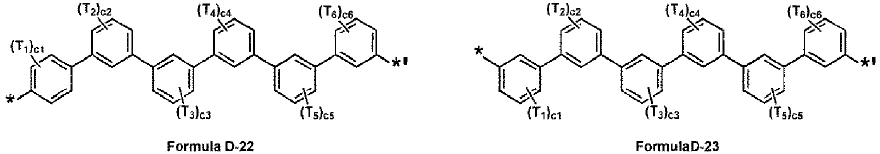

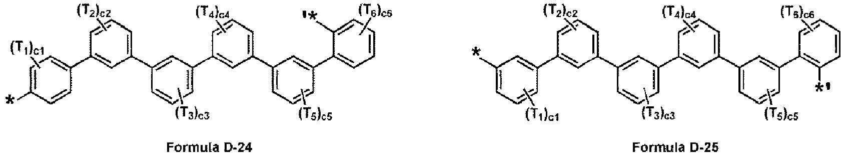

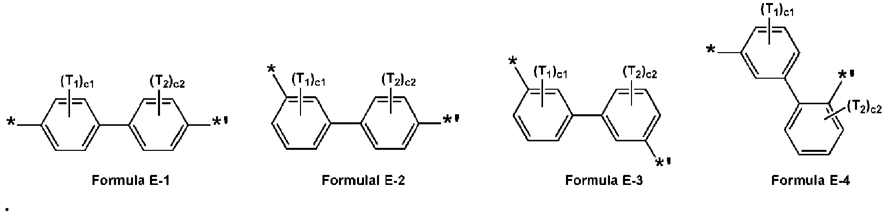

In Formulae A-1 to A-12, B-1 to B-20, C-1 to C-29, D-1 to D-25, and E-1 to E-4,
T₁ to T₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenylene group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, an isoindolyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, and a pyridinyl group,
c₁ to c6 may each independently be an integer selected from 0 to 4, and
* and *' may each independently indicate a binding site to an adjacent atom.
R₁ to R₃ and R₁₁ to R₁₅ are each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
in addition to which, when a11 and a12 are both 0, R₁₁ and R₁₂ may optionally be bound (e.g., coupled) to form a C₁-C₃₀ heterocyclic group together with the nitrogen atom to which they are attached, and when a13 and a14 are both 0, R₁₃ and R₁₄ may optionally be bound (e.g., coupled) to form a C₁-C₃₀ heterocyclic group together with the nitrogen atom to which they are attached, and
R₁₆, R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂).

For example, R₁ to R₃ and R₁₁ to R₁₅ in Formulae 1A and 1B may each independently be selected from the group consisting of:
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, and a dibenzocarbazolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, and a dibenzocarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), - N(Q₃₁)(Q₃₂), and -B(Q₃₁)(Q₃₂), and
R₂₁ and R₂₂ in Formulae 2A and 2B may each independently be selected from the group consisting of:
   a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group; and
   a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), or
   R₂₂ may be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₁)(Q₂)(Q₃), -S(=O)₂(Q₁), and - P(=O)(Q₁)(Q₂),
   wherein Q₁ to Q₃ and Q₃₁ to Q₃₃ may each independently be the same as described herein.

In one embodiment, R₁ to R₃ and R₁₁ to R₁₅ in Formulae 1A and 1B may each independently be selected from groups represented by Formulae 5-1 to 5-45,
R₂₁ in Formulae 2A and 2B may be selected from groups represented by Formulae 5-1 to 5-45 and 6-1 to 6-124, and
R₂₂ in Formulae 2A and 2B may be selected from hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 5-1 to 5-45 and 6-1 to 6-124, -Si(Q₁)(Q₂)(Q₃), - S(=O)₂(Q₁), and -P(=O)(Q₁)(Q₂), but embodiments of the present disclosure are not limited thereto:

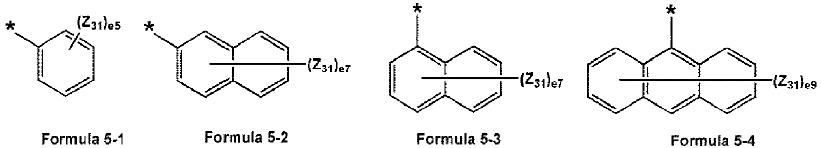

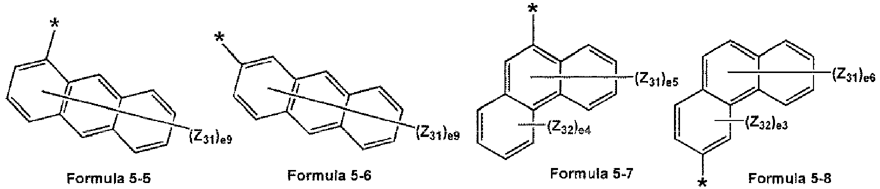

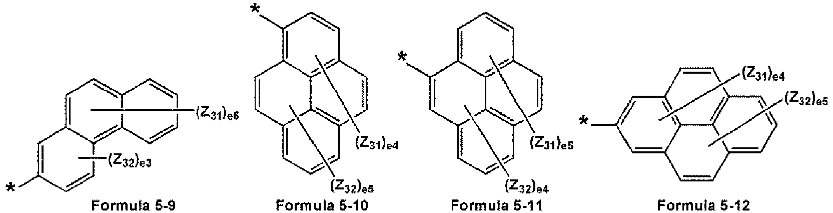

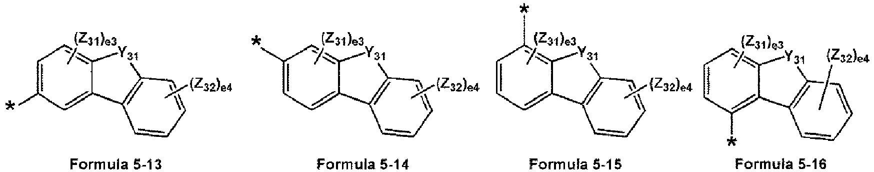

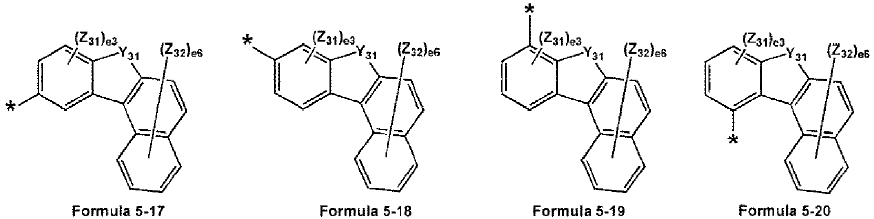

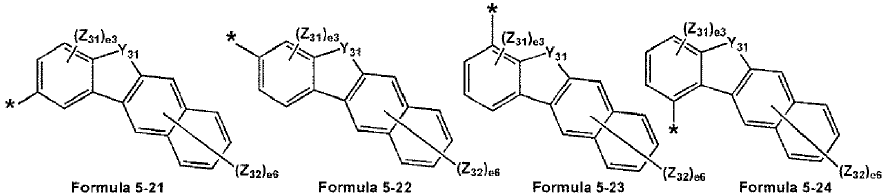

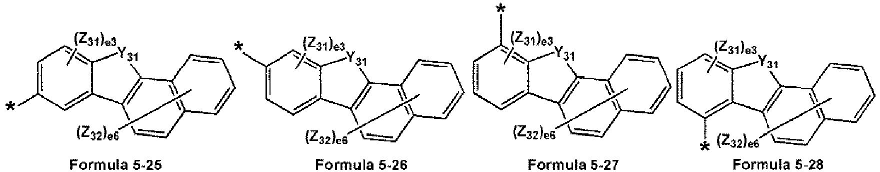

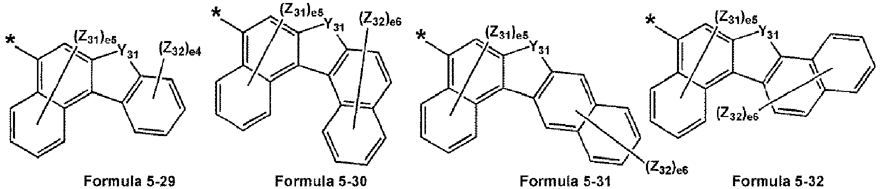

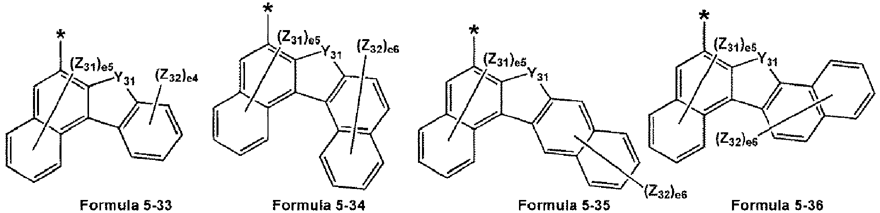

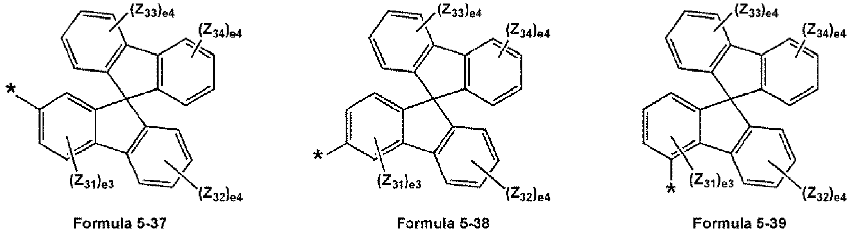

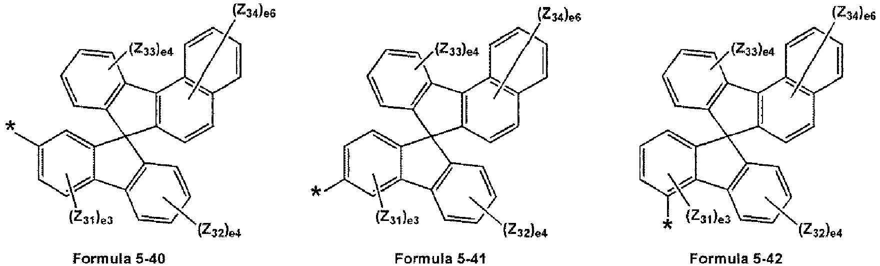

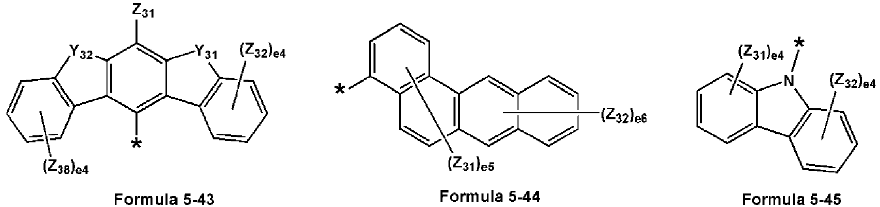

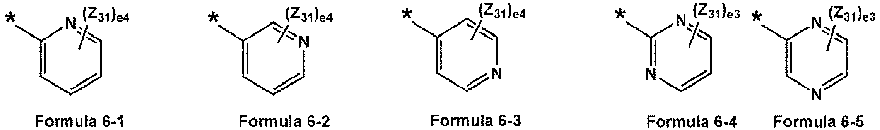

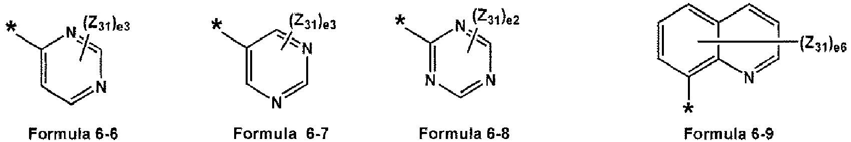

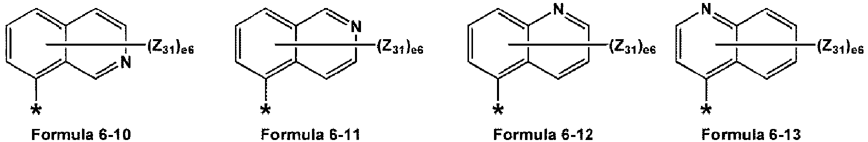

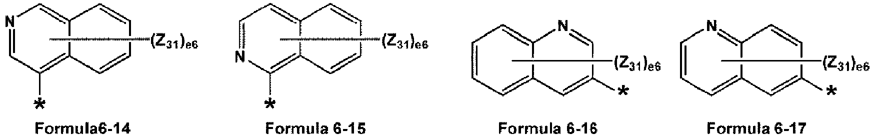

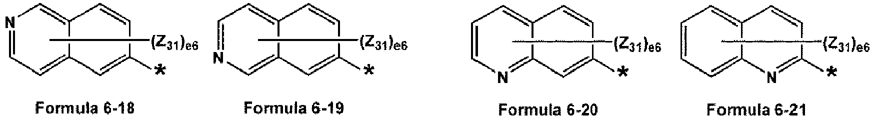

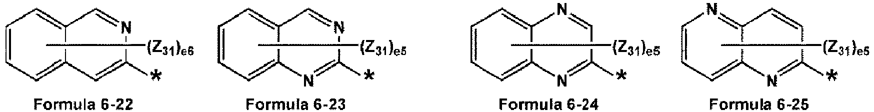

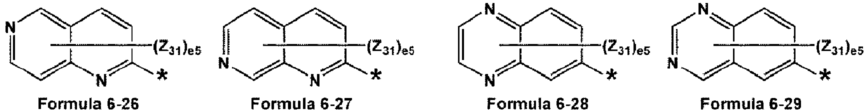

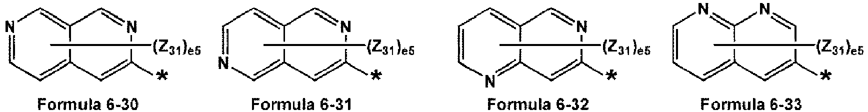

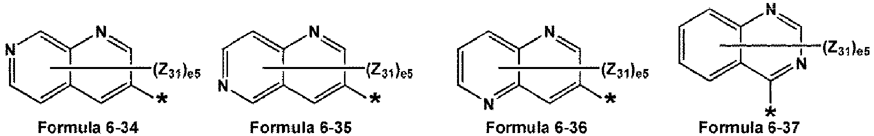

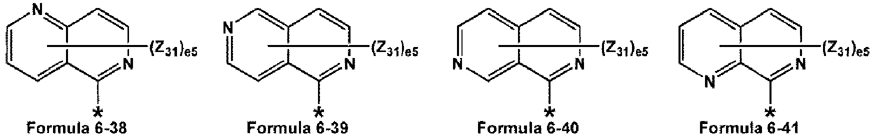

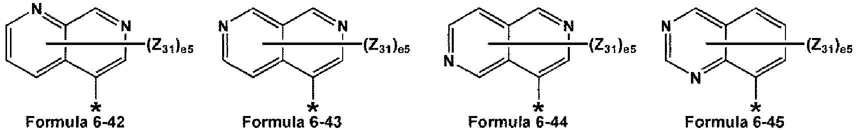

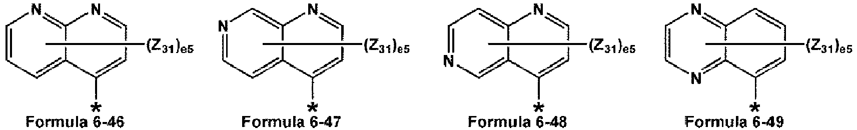

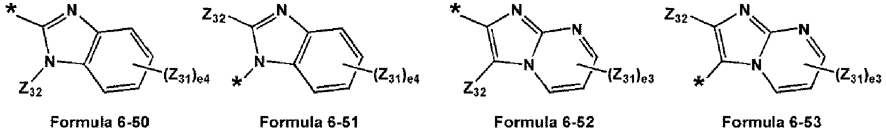

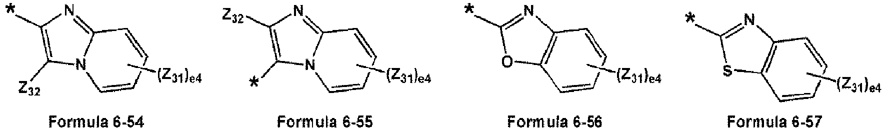

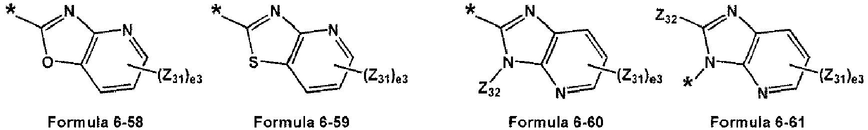

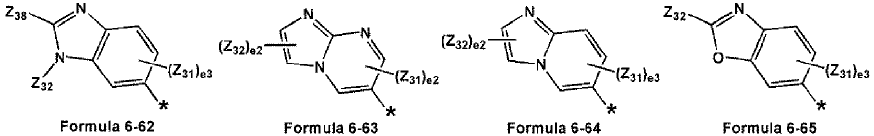

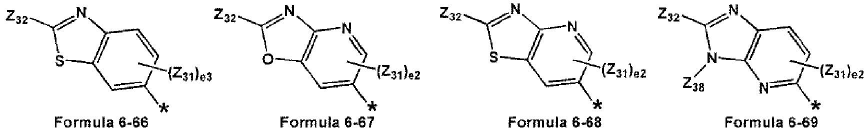

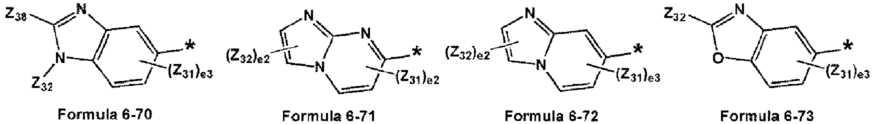

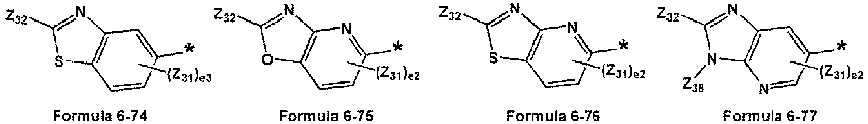

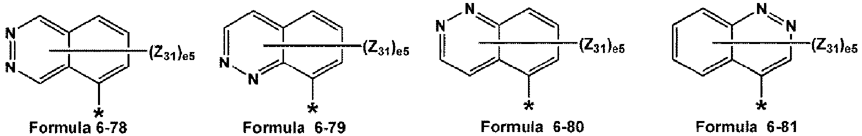

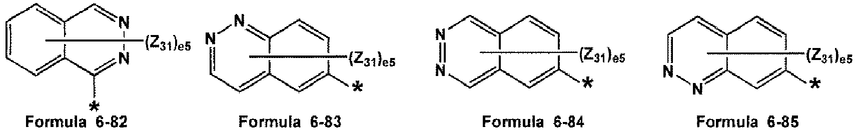

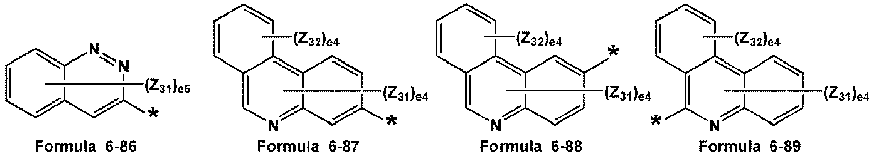

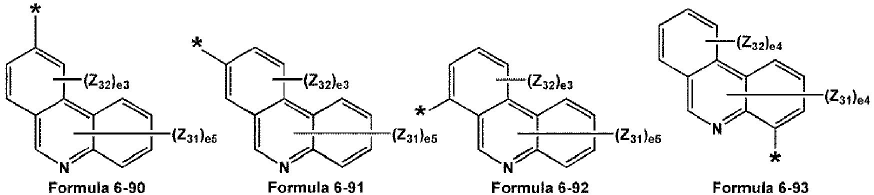

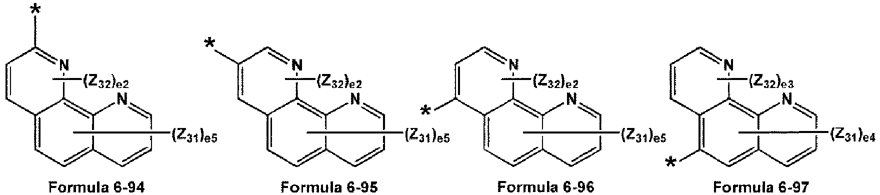

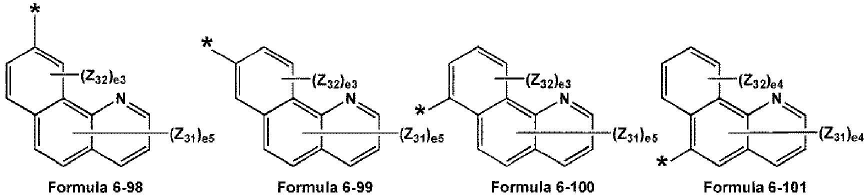

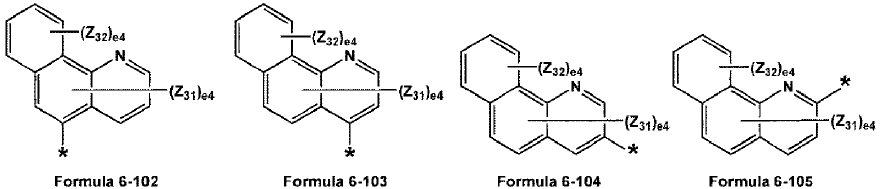

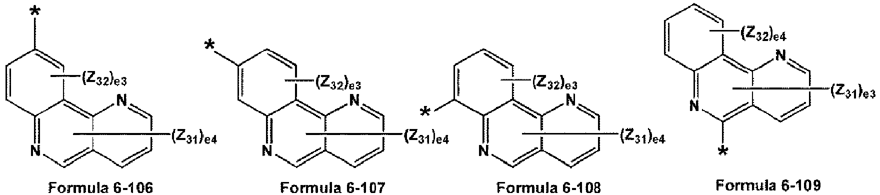

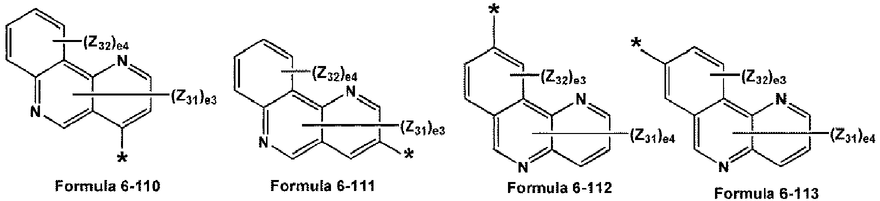

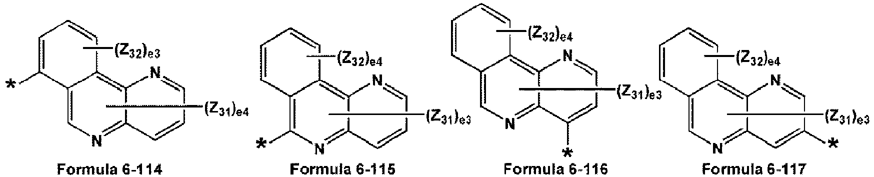

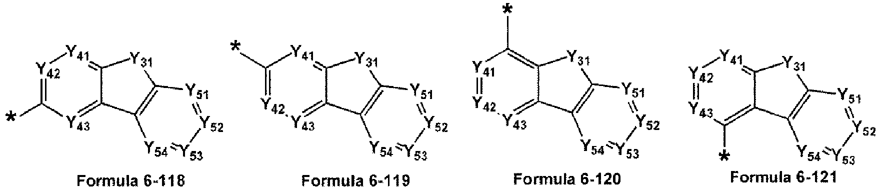

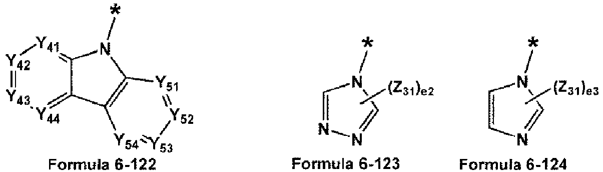

In Formulae 5-1 to 5-45 and 6-1 to 6-124,
Y₃₁ and Y₃₂ may each independently be selected from O, S, C(Z₃₃)(Z₃₄), N(Z₃₅), and Si(Z₃₆)(Z₃₇),
Y₄₁ may be N or C(Z₄₁), Y₄₂ may be N or C(Z₄₂), Y₄₃ may be N or C(Z₄₃), Y₄₄ may be N or C(Z₄₄), Y₅₁ may be N or C(Z₅₁), Y₅₂ may be N or C(Z₅₂), Y₅₃ may be N or C(Z₅₃), Y₅₄ may be N or C(Z₅₄), at least one selected from Y₄₁ to Y₄₃ and Y₅₁ to Y₅₄ in Formulae 6-118 to 6-121 may be N, and at least one selected from Y₄₁ to Y₄₄ and Y₅₁ to Y₅₄ in Formula 6-122 may be N,
Z₃₁ to Z₃₈, Z₄₁ to Z₄₄, and Z₅₁ to Z₅₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and -Si(Q₃₁)(Q₃₂)(Q₃₃),
wherein Q₁ to Q₃ and Q₃₁ to Q₃₃ may each independently be the same as described herein,
e2 may be an integer selected from 0 to 2,
e3 may be an integer selected from 0 to 3,
e4 may be an integer selected from 0 to 4,
e5 may be an integer selected from 0 to 5,
e6 may be an integer selected from 0 to 6,
e7 may be an integer selected from 0 to 7,
e9 may be an integer selected from 0 to 9, and
* may indicate a binding site to an adjacent atom.

For example, R₁ to R₃ and R₁₁ to R₁₅ in Formulae 1A and 1B may each independently be a group represented by one selected from Formulae 5-1 to 5-45,
wherein Z₃₁ to Z₃₇ in Formulae 5-1 to 5-45 may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenylene group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an indolyl group, an isoindolyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, and a pyridinyl group.

In one or more embodiments, R₁ to R₃ and R₁₁ to R₁₅ in Formulae 1A and 1B may each independently be selected from groups represented by Formulae 9-1 to 9-100,
R₂₁ in Formulae 2A and 2B may be selected from groups represented by Formulae 9-1 to 9-100 and 10-1 to 10-121, and
R₂₂ in Formulae 2A and 2B may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 9-1 to 9-100 and 10-1 to 10-121, - Si(Q₁)(Q₂)(Q₃), -S(=O)₂(Q₁), and -P(=O)(Q₁)(Q₂), wherein Q₁ to Q₃ may each independently be the same as described herein, but embodiments of the present disclosure are not limited thereto:

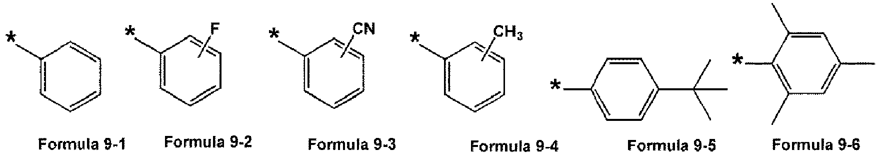

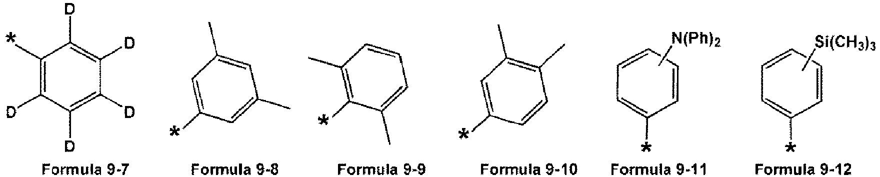

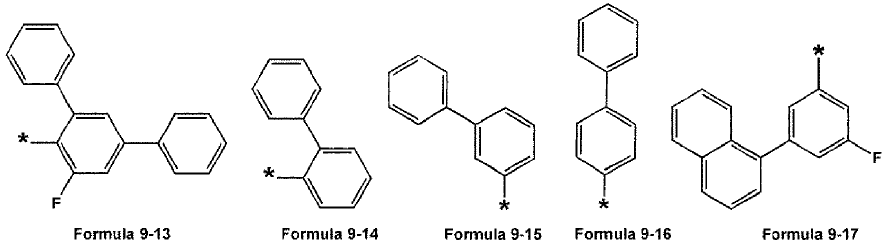

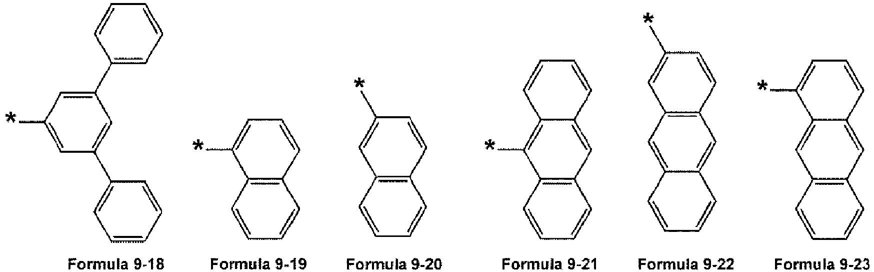

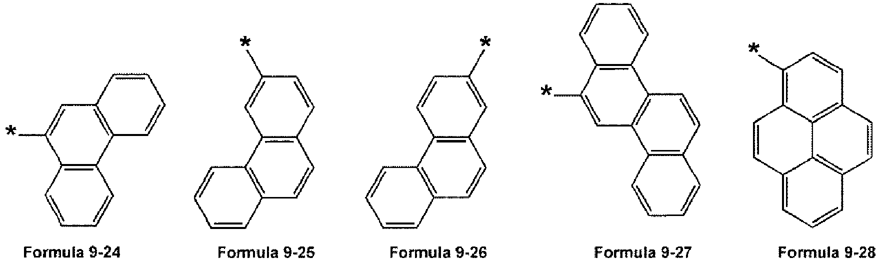

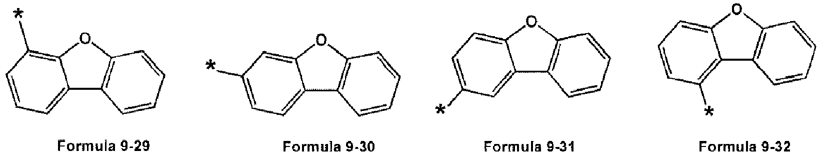

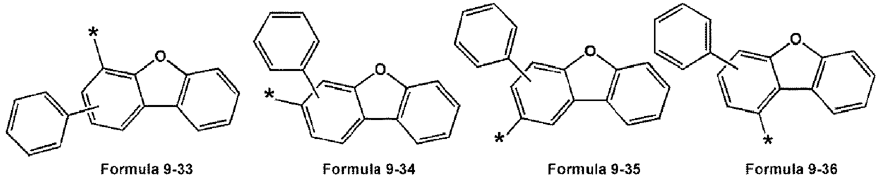

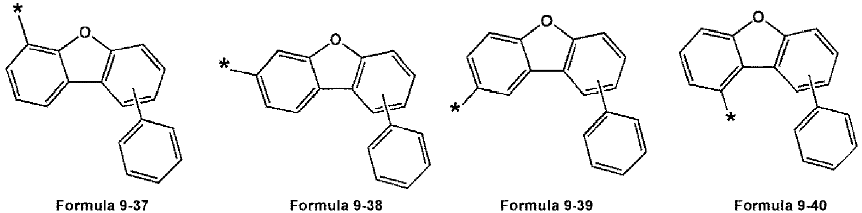

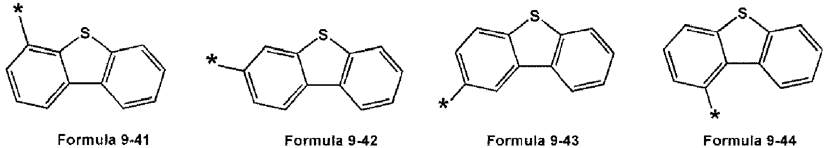

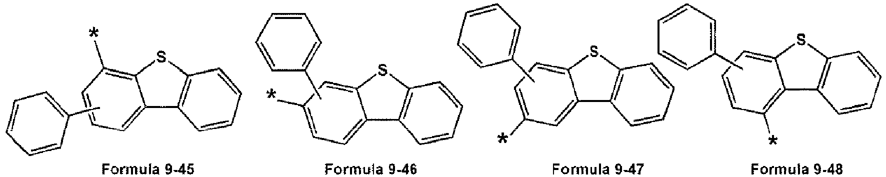

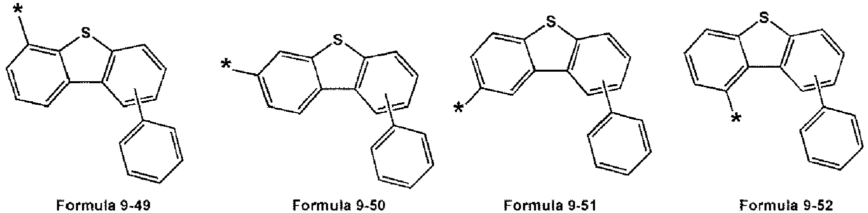

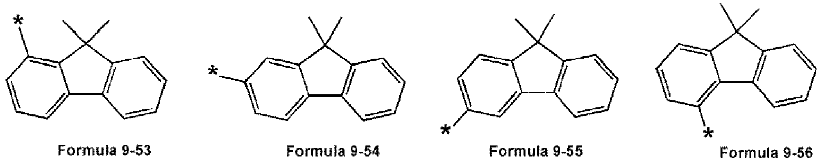

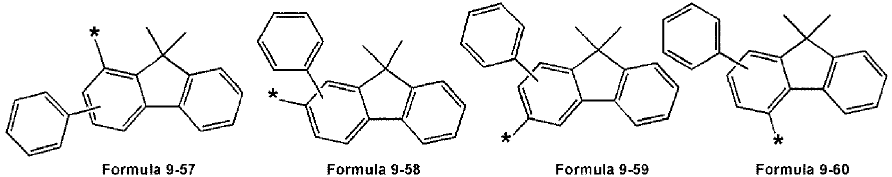

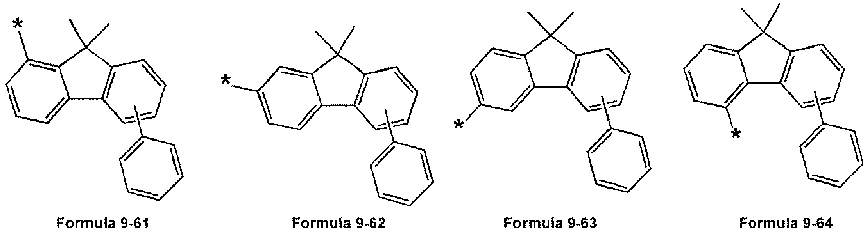

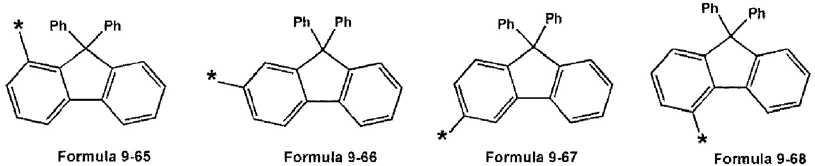

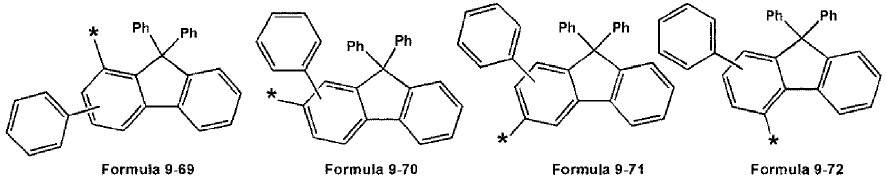

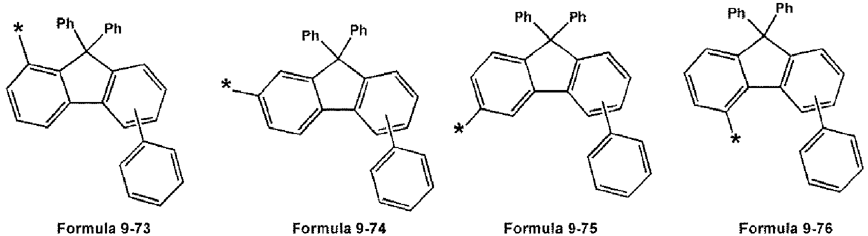

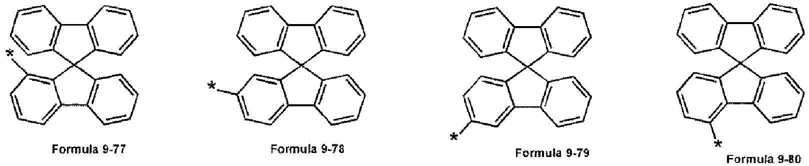

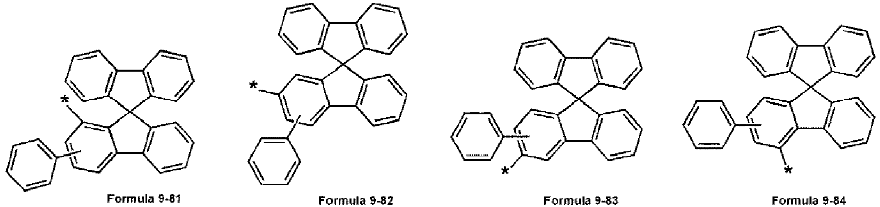

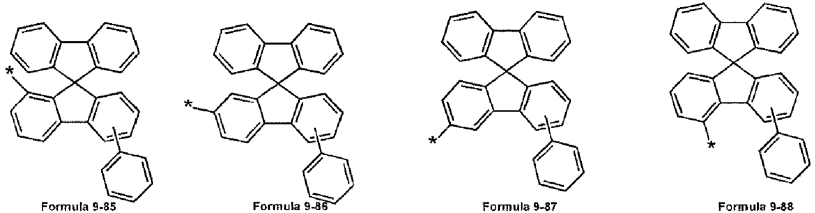

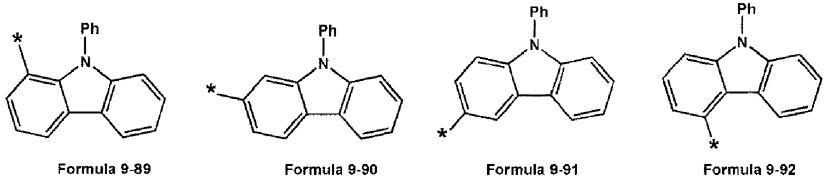

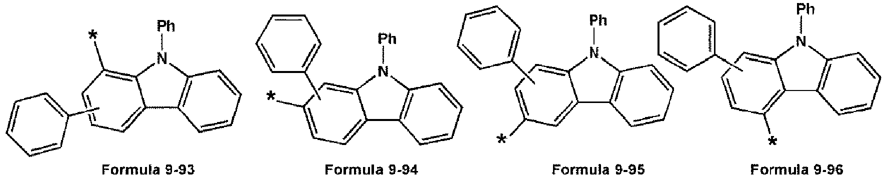

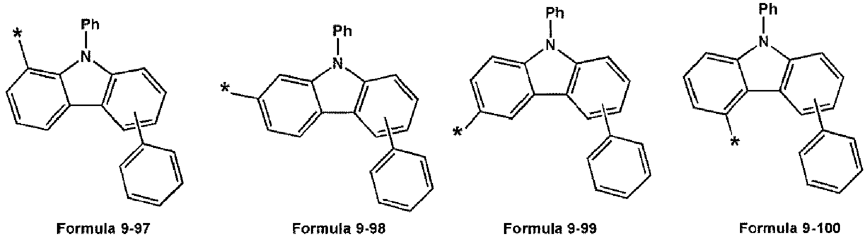

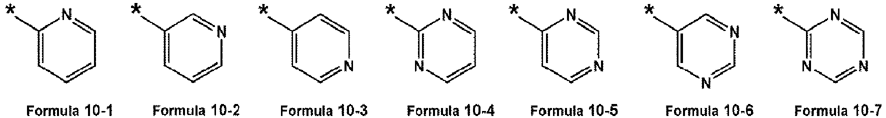

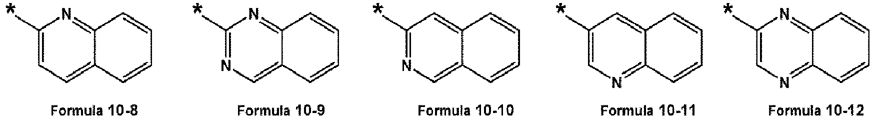

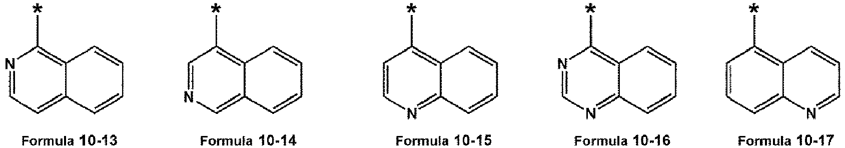

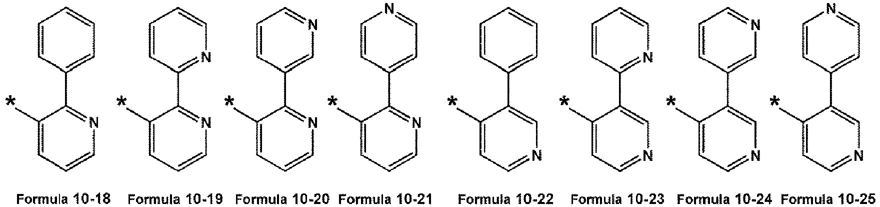

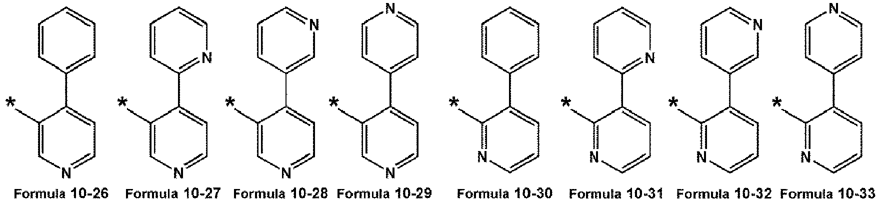

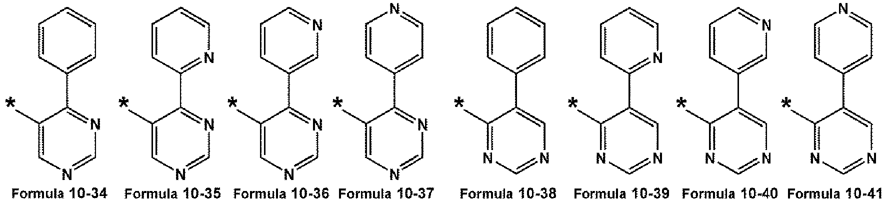

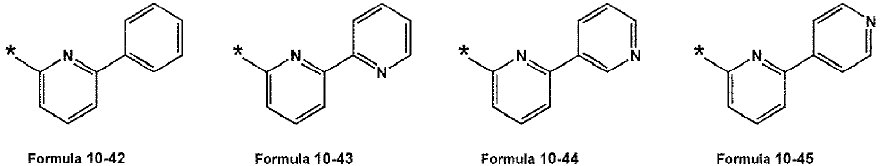

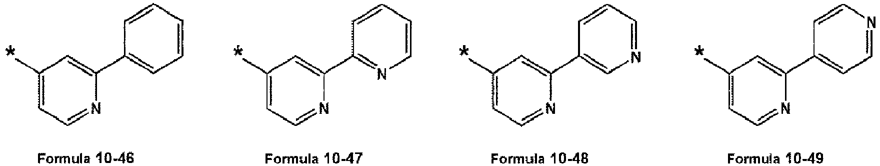

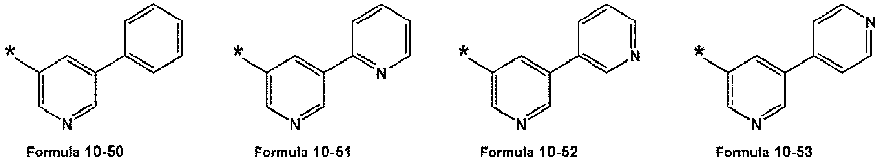

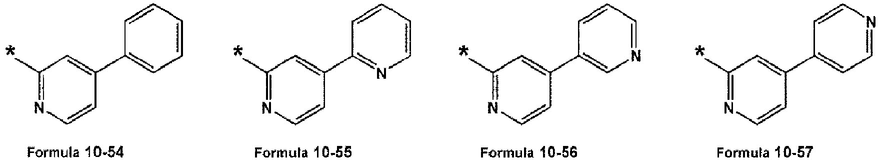

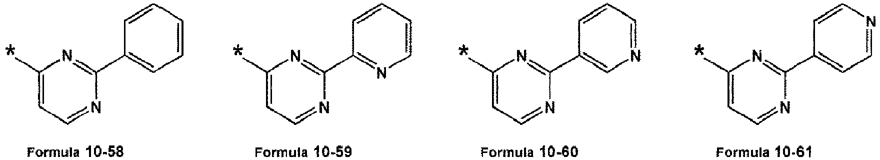

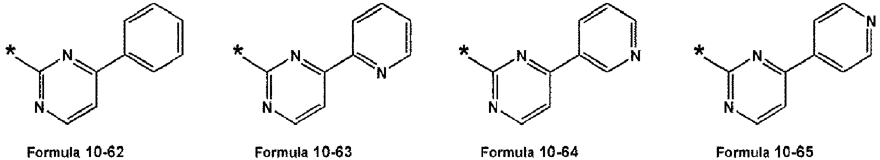

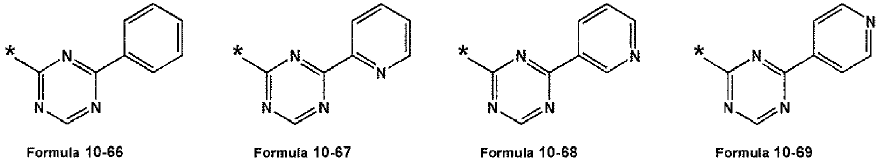

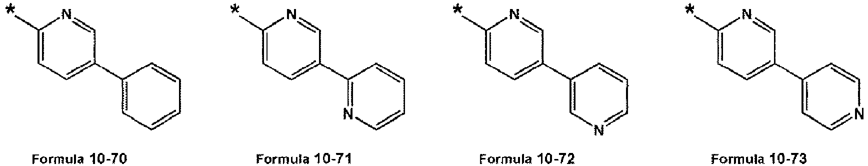

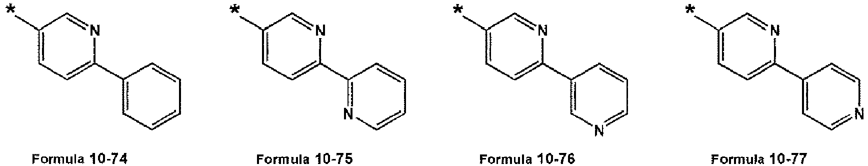

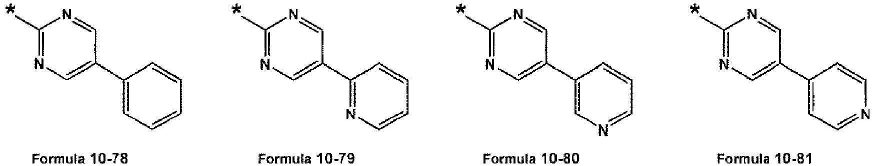

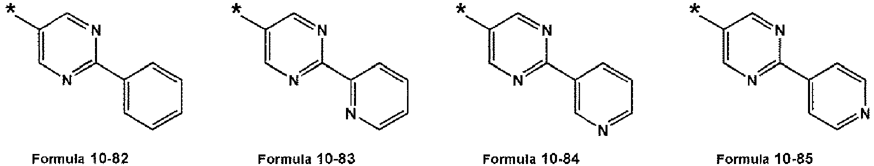

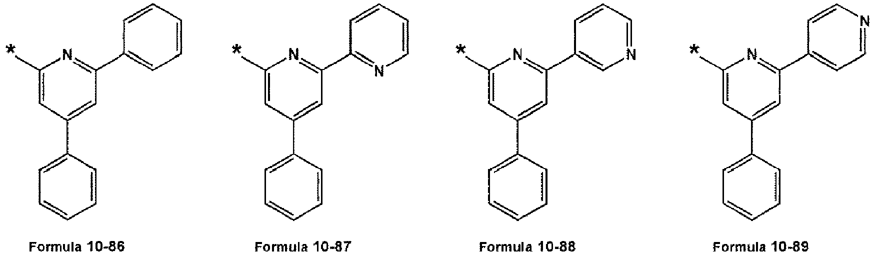

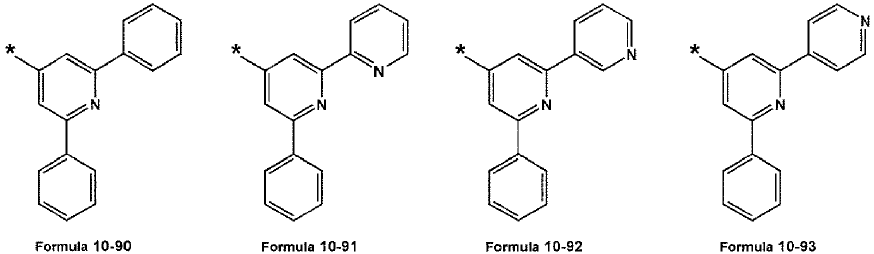

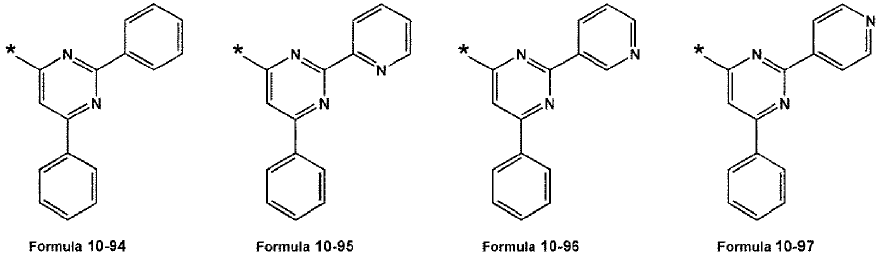

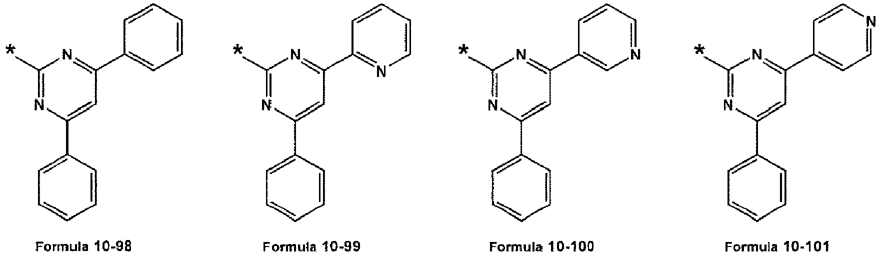

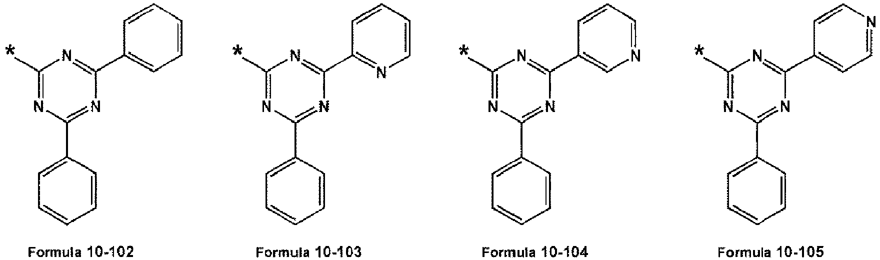

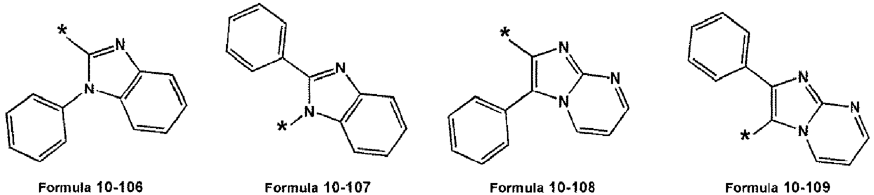

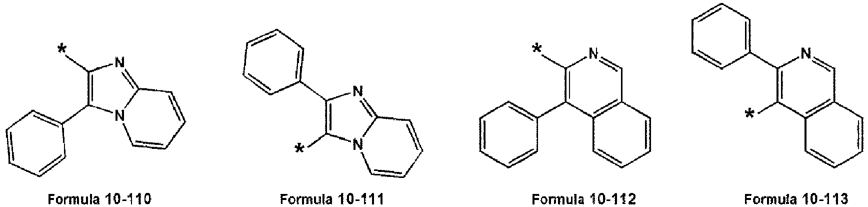

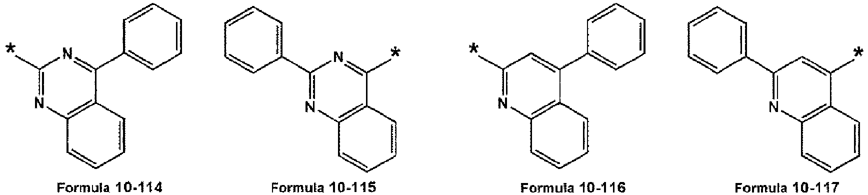

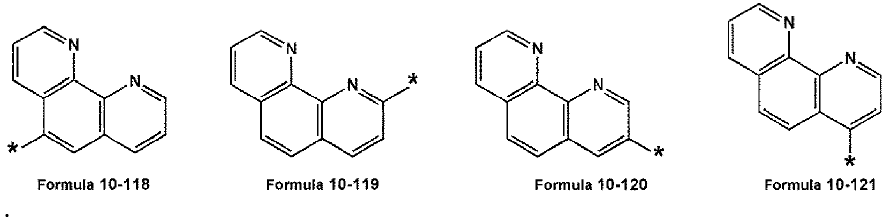

In Formulae 9-1 to 9-100 and 10-1 to 10-121, "Ph" represents a phenyl group and * indicates a binding site to an adjacent atom.

In one embodiment, at least one selected from R₁ to R₃ in Formula 1A and at least one selected from R₁₁ to R₁₄ in Formula 1B may each independently be represented by one selected from Formulae 5-13 to 5-42 and 5-45.

In one or more embodiments, R₁ in Formula 1A may be represented by one selected from Formulae 5-13 to 5-36 and 5-45, provided that Y₃₁ in Formulae 5-13 to 5-36 is N(Z₃₅).

In one or more embodiments, R₁ in Formula 1A may be represented by one selected from Formulae 5-13 to 5-36 and 5-45, provided that Y₃₁ in Formulae 5-13 to 5-36 is N(Z₃₅), and
R₂ in Formula 1A may be represented by one selected from Formulae 5-13 to 5-42, provided that Y₃₁ in Formulae 5-13 to 5-36 is C(Z₃₃)(Z₃₄).

In one or more embodiments, at least one selected from R₁ to R₃ in Formulae 1A may be represented by one selected from Formulae 5-13 to 5-36, provided that Y₃₁ in Formulae 5-13 to 5-36 is O or S.

In one or more embodiments, at least one selected from R₁ to R₃ in Formula 1A may be represented by one selected from Formulae 5-13 to 5-42, provided that Y₃₁ in Formulae 5-13 to 5-42 is O, S or C(Z₃₃)(Z₃₄), and Formula 1A does not comprise a carbazole ring.

In one or more embodiments, R₁₁ and R₁₂ in Formula 1B may be bound (e.g., coupled) via a single bond, or R₁₃ and R₁₄ may be bound (e.g., coupled) via a single bond.

R₁₆, R₂₃, and R₂₄ in Formulae 1A, 1B, 2A, and 2B may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a phenyl group, a biphenyl group, a terphenyl group, a naphthyl group, and a pyridinyl group; and
a phenyl group, a biphenyl group, a terphenyl group, a naphthyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, and a pyridinyl group, but embodiments of the present disclosure are not limited thereto.

In Formulae 1A, 1B, 2A, and 2B,
b1 to b3, b11 to b15, b21, and b22 are each independently an integer selected from 1 to 5 (e.g., 1 or 2), provided that each of b1 to b3, b11 to b15, b21, and b22 is 1 when each respective a1 to a3, a11 to a15, a21, a22 or a31 to a33 is zero
b16, is an integer selected from 0 to 5 (e.g., 0, 1, or 2),
n1 is an integer selected from 1 to 4 (e.g., 1), and
n2 is an integer selected from 0 to 4 (e.g., 1 or 2).
b1 indicates the number of R₁(s). When b1 is 2 or greater, a plurality of R₁(s) may be identical to or different from each other. b2 to b3, b11 to b15, b21, b22, n1, and n2 may each independently be the same as described herein in connection with b1 and the structures of Formulae 1A, 1B, 2A, and 2B.

In one embodiment, in Formula 1B,
when i) 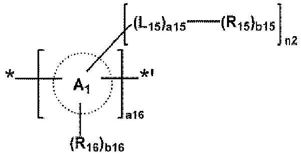 is selected from the Formulae below: 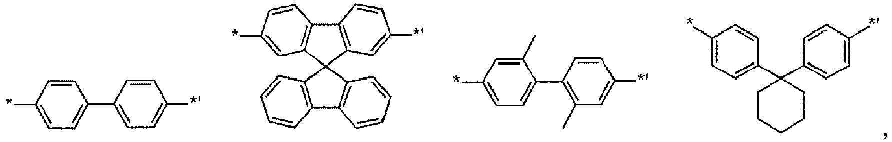
ii) an to a14 are all 0,
iii) b11 to b14 are all 1, and
iv) R₁₁ and R₁₄ are each independently selected from a phenyl group and a phenyl group substituted with a methyl group,
then R₁₂ and R₁₃ are each not a phenyl group; a naphthyl group; or a phenyl group substituted with a methyl group.

In one or more embodiments, when 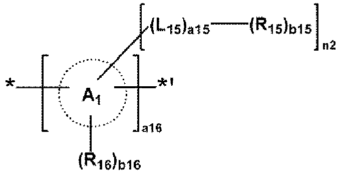 in Formula 1B is represented by Formula E-1,
R₁₁ and R₁₄ in Formula 1B may each independently be selected from the group consisting of:
a phenyl group, a naphthyl group, a fluorenyl group, a spiro-bifluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, and a terphenyl group; and
a phenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, and a terphenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, a terphenyl group, and - Si(Q₃₁)(Q₃₂)(Q₃₃), and
R₁₂ and R₁₃ may each independently be selected from the group consisting of:
   a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, and a terphenyl group; and
   a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, and a terphenyl group, each substituted with at least one selected from deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, a terphenyl group, and -Si(Q₃₁)(Q₃₂)(Q₃₃),
   wherein Q₃₁ to Q₃₃ may each independently be selected from a C₁-C₁₀ alkyl group, a C₁-C₁₀ alkoxy group, a phenyl group, a naphthyl group, a fluorenyl group, a spiro-fluorenyl group, a phenalenyl group, a phenanthrenyl group, an anthracenyl group, a fluoranthenyl group, a triphenylenyl group, a pyrenyl group, a chrysenyl group, a pyrrolyl group, a furanyl group, a thiophenyl group, an indolyl group, an isoindolyl group, a benzofuranyl group, a benzothiophenyl group, a carbazolyl group, a dibenzofuranyl group, a dibenzothiophenyl group, a benzocarbazolyl group, a dibenzosilolyl group, a pyridinyl group, a biphenyl group, and a terphenyl group.

The compounds shown below are excluded from being the first compound represented by Formula 1A or 1B:

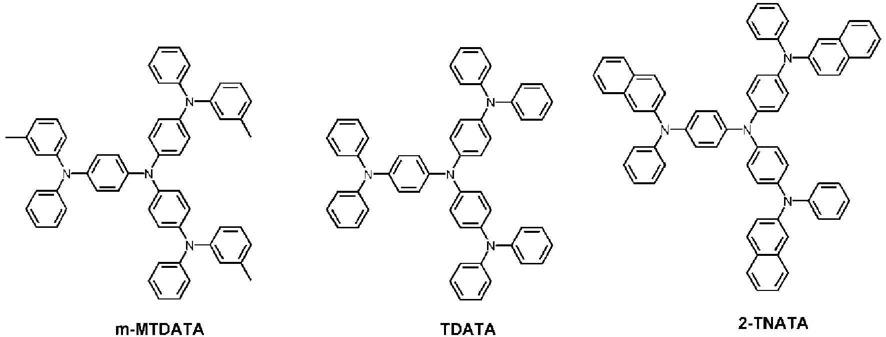

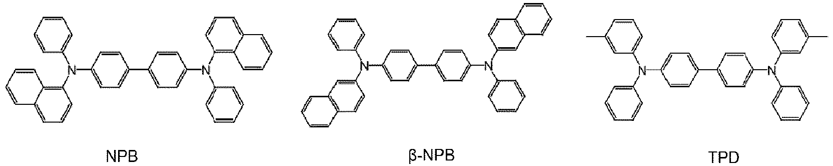

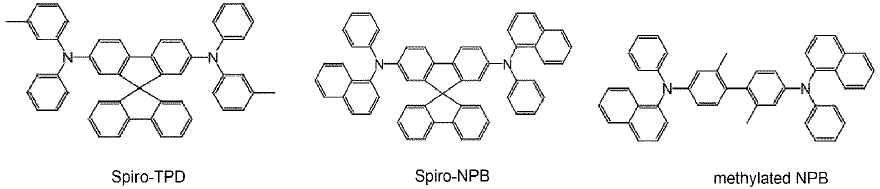

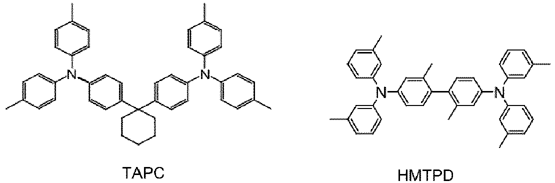

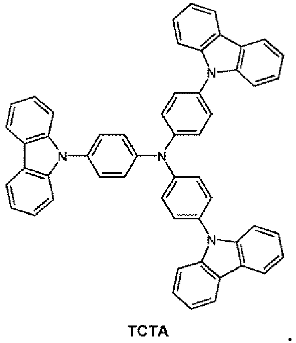

In one embodiment, the first compound represented by Formula 1A or 1B may be selected from Compounds 1-1A to 1-97A and 1-1B to 1-108B:

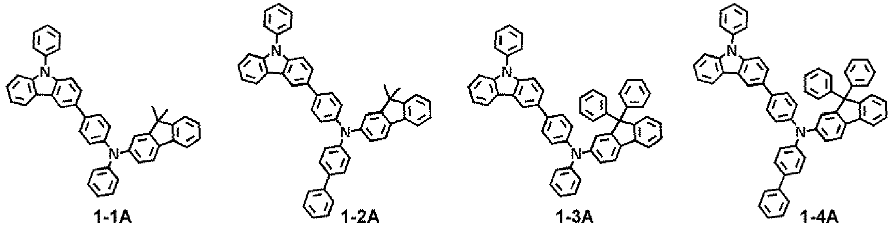

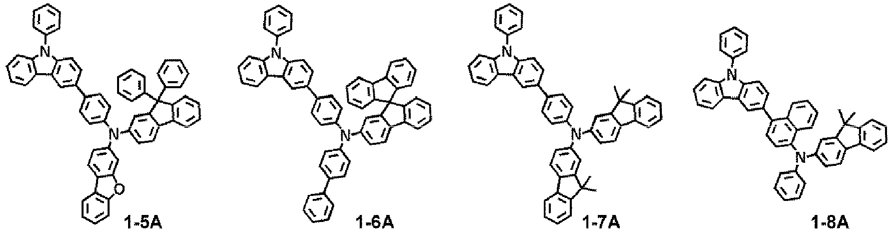

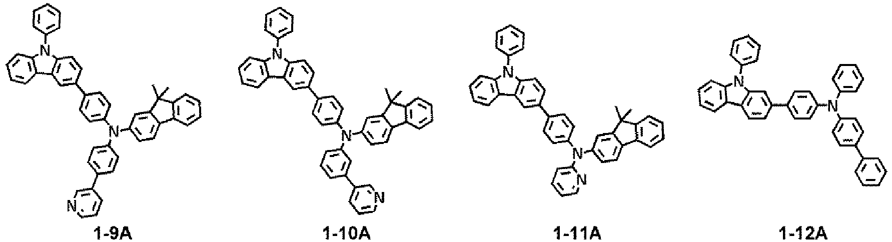

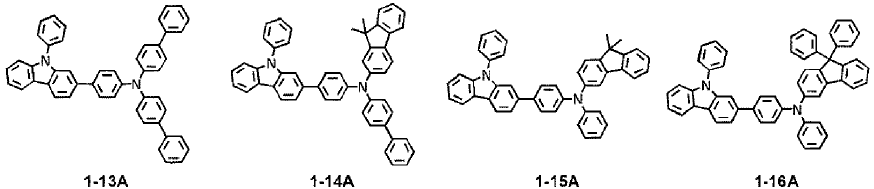

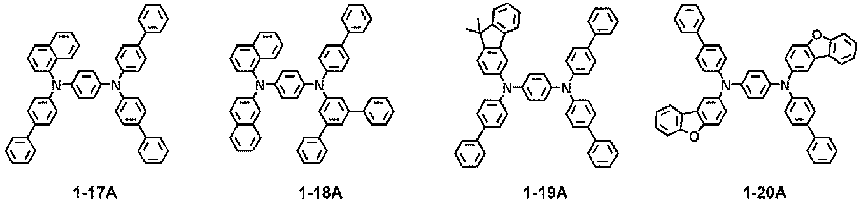

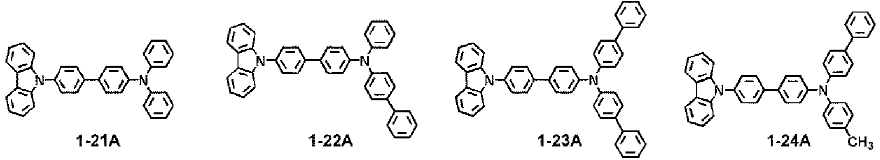

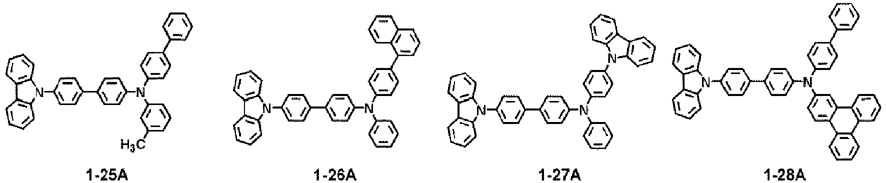

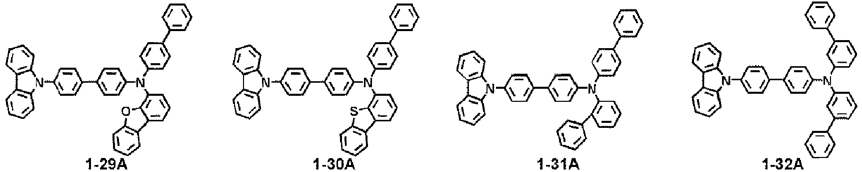

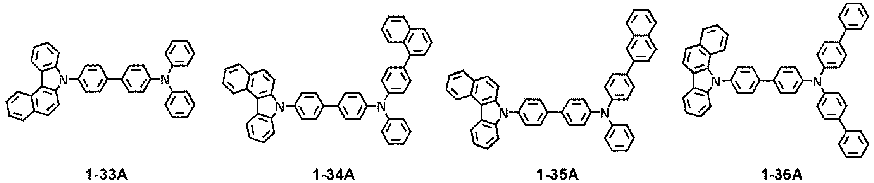

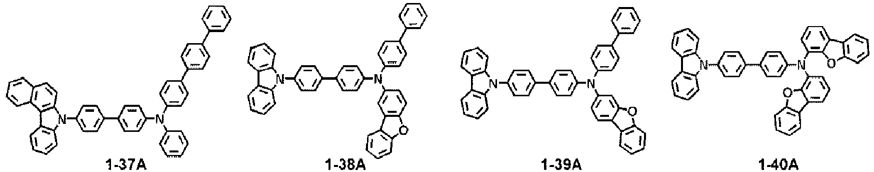

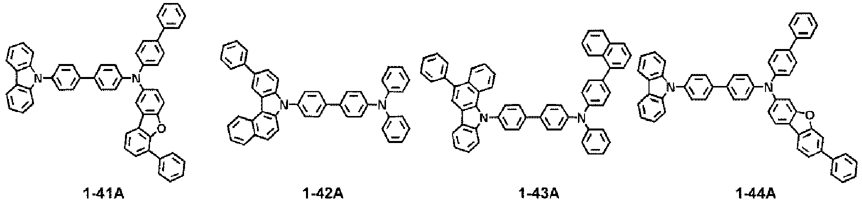

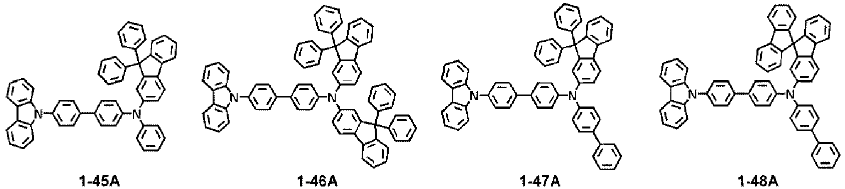

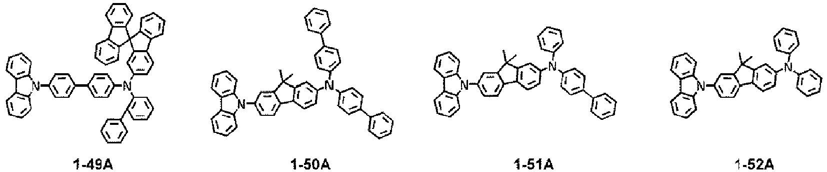

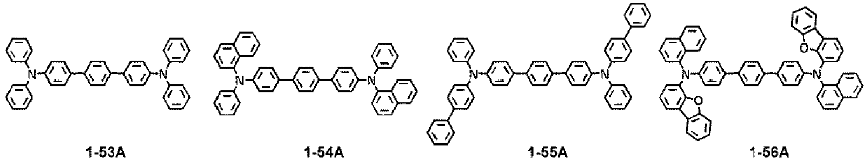

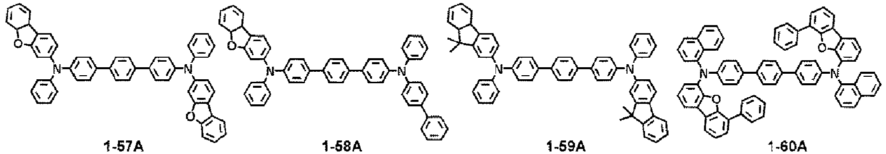

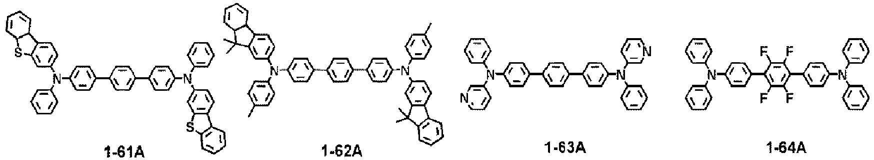

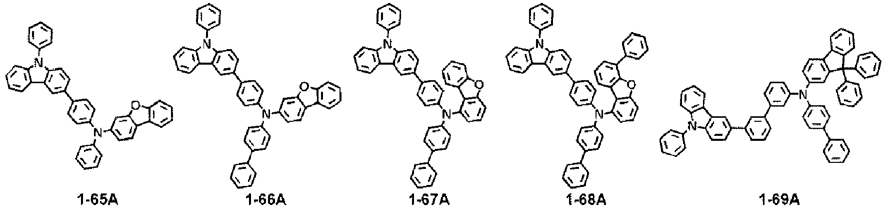

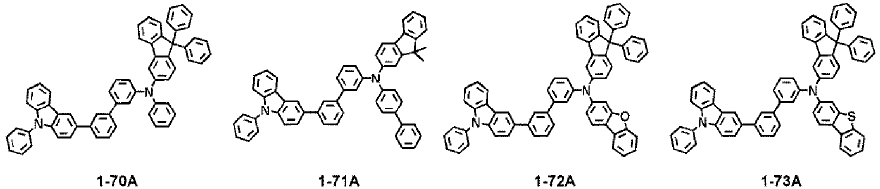

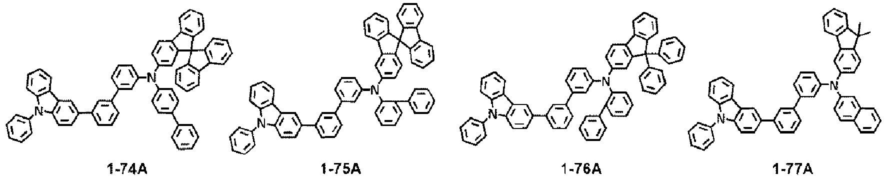

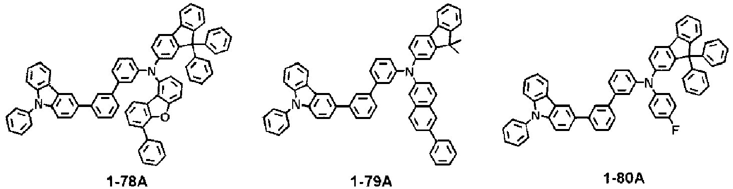

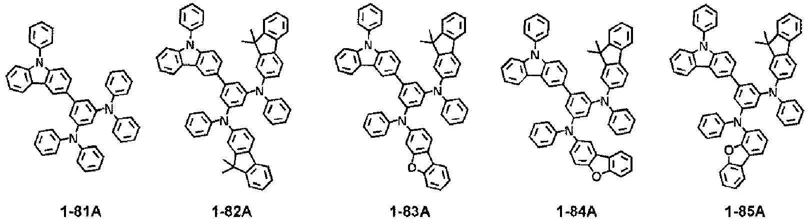

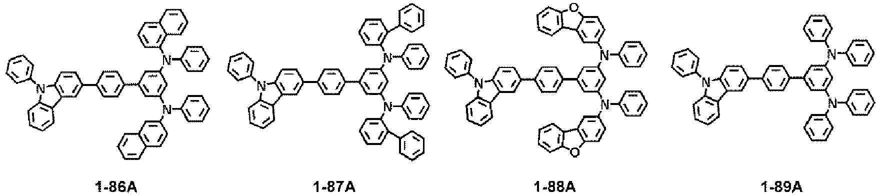

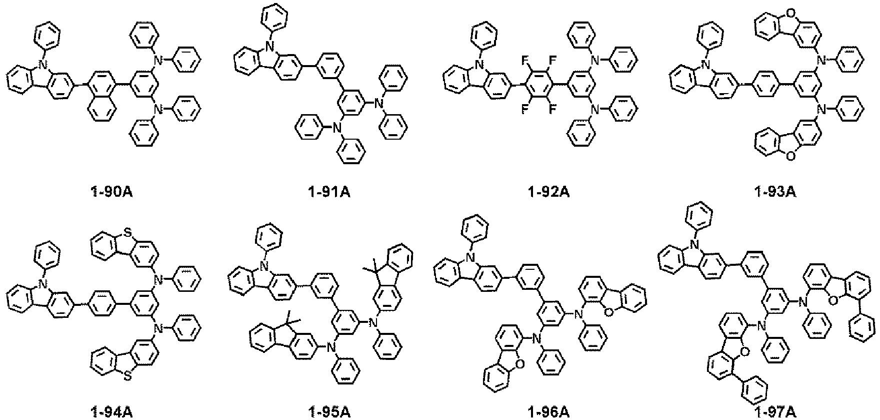

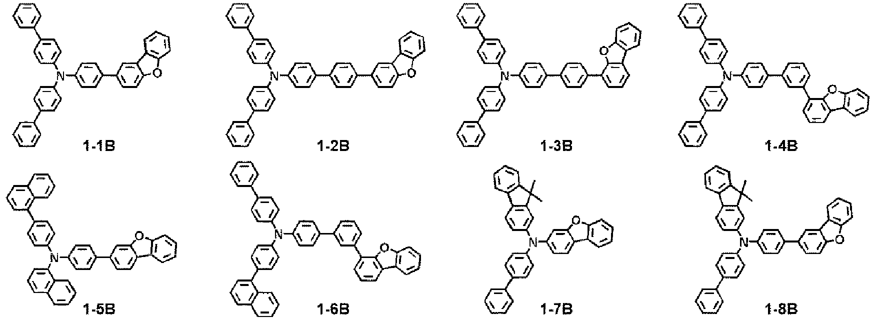

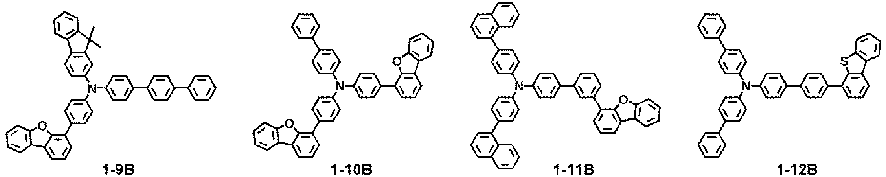

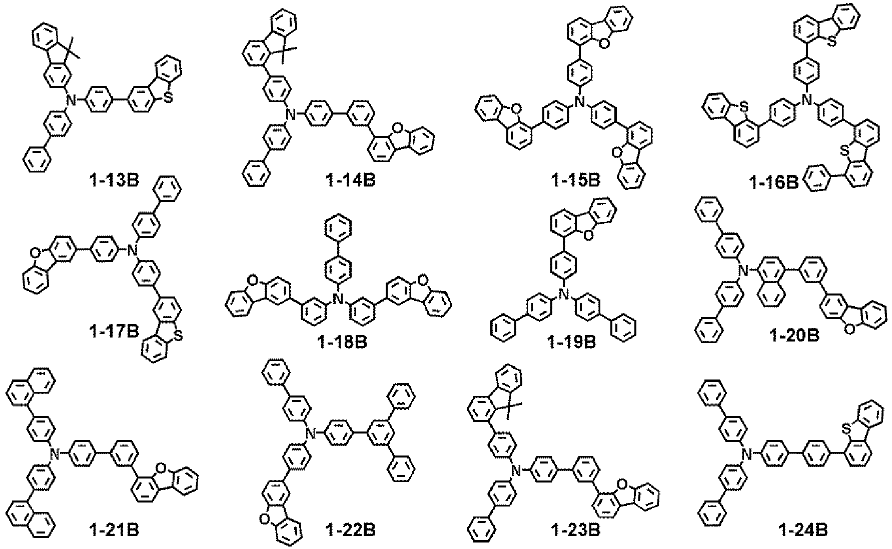

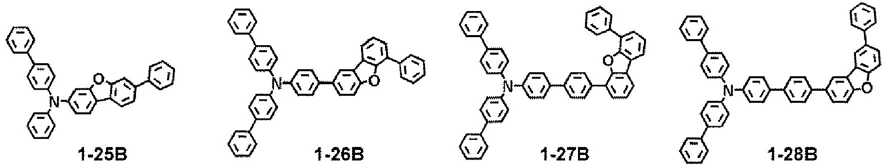

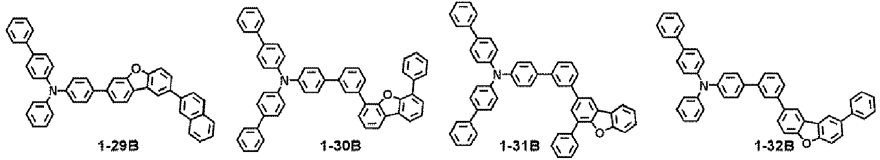

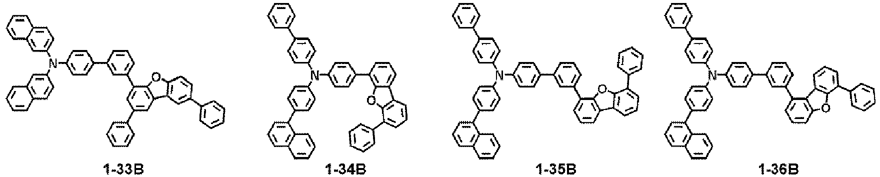

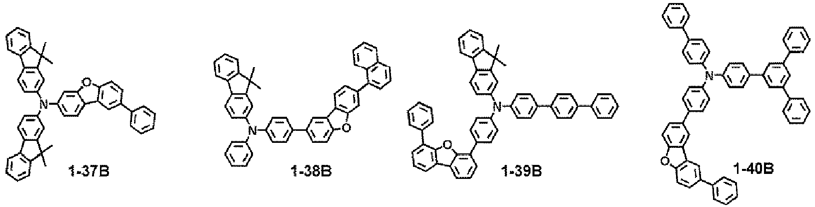

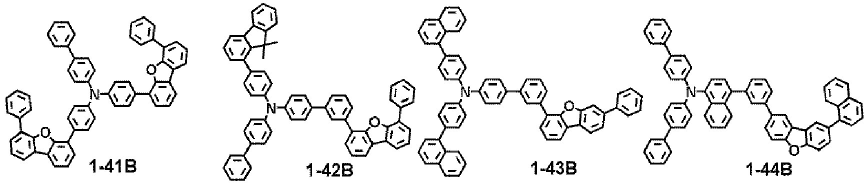

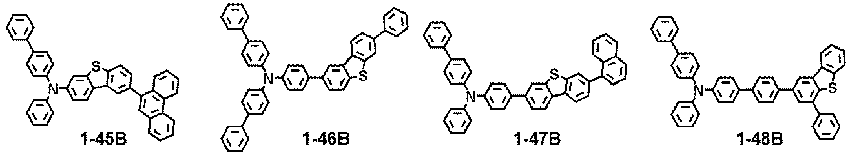

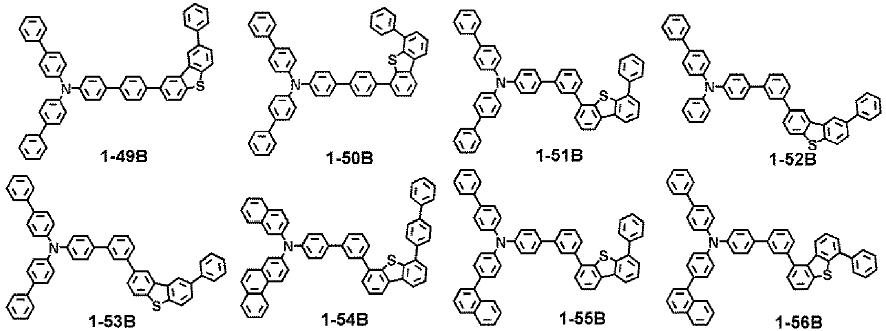

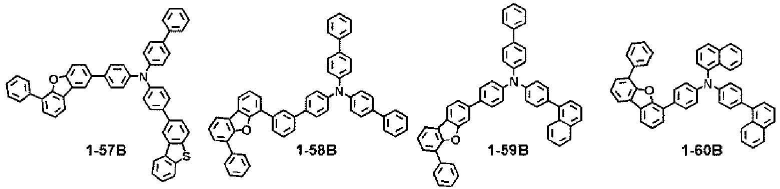

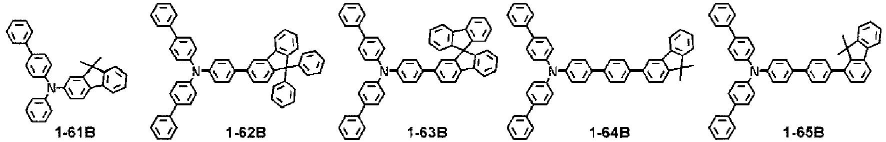

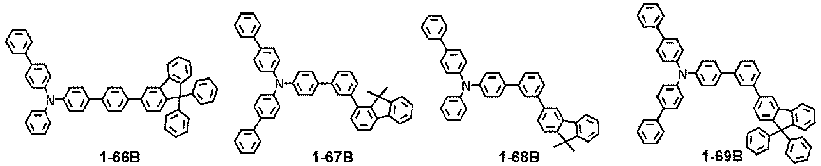

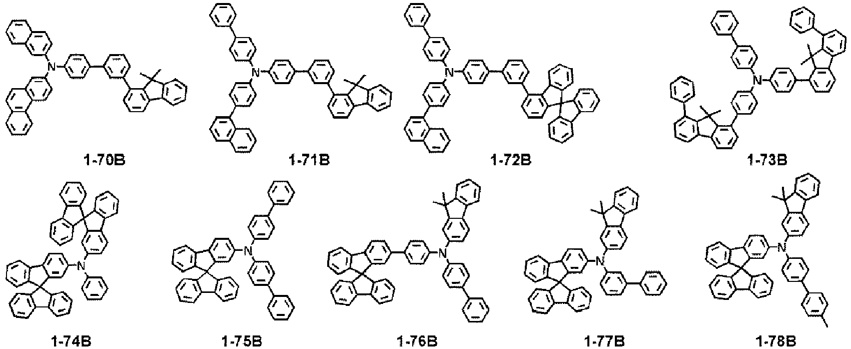

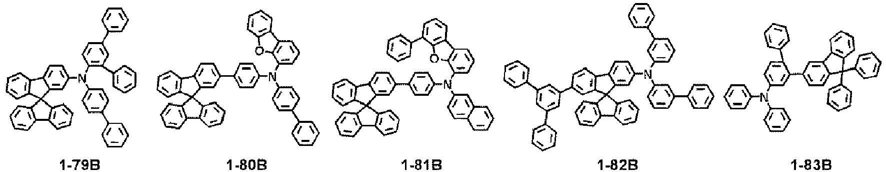

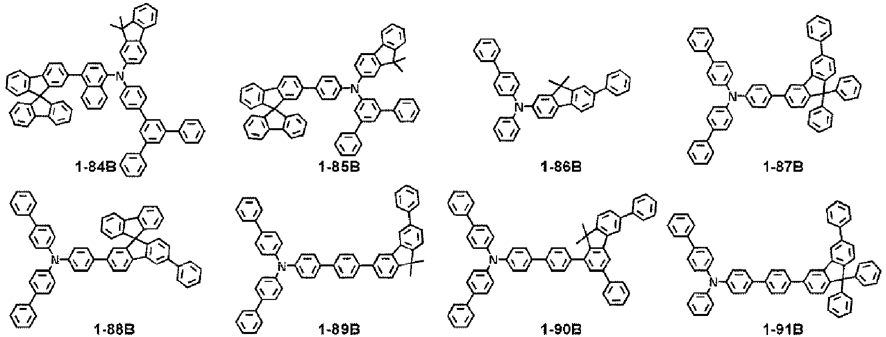

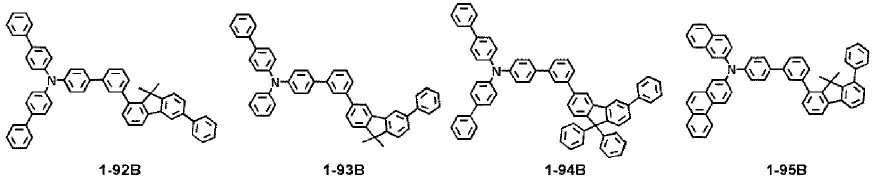

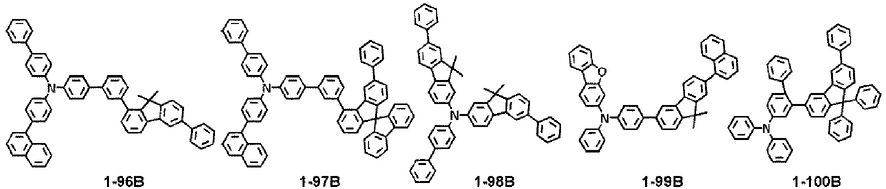

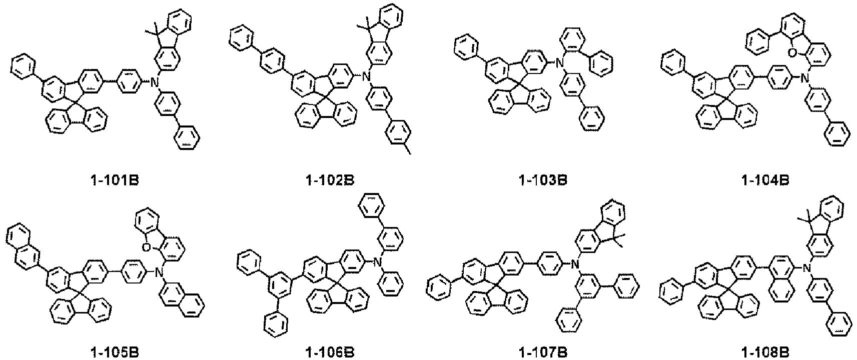

In one or more embodiments, the second compound represented by Formula 2A or 2B may be selected from Compounds 2-1 to 2-262, but embodiments of the present disclosure are not limited thereto (compounds 2-11, 2-19, 2-24, 2-25, 2-34, 2-40, 2-45, 2-50, 2-54, 2-61, 2-63, 2-69, 2-73, 2-83, 2-94, 2-95, 2-106, 2-109, 2-110, 2-129, 2-130, 2-135, 2-141, 2-146, 2-148, 2-152, 2-155, 2-165, 2-169, 2-173, 2-177, 2-191, 2-196, 2-208, 2-228, 2-233, 2-239, 2-242, 2-244, 2-257 and 2-262 do not form part of the claimed invention):

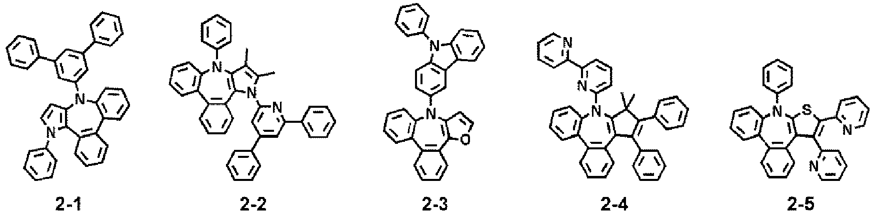

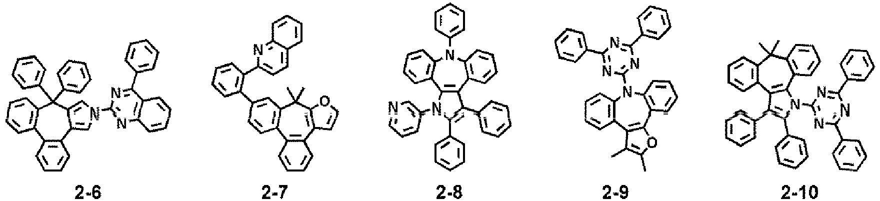

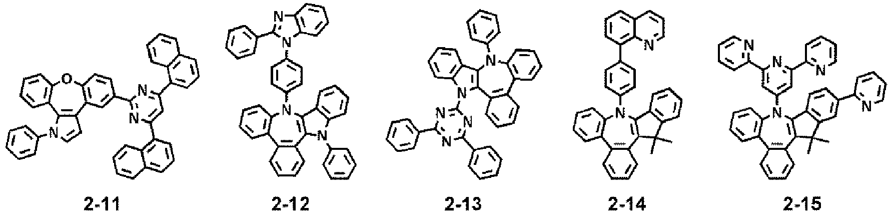

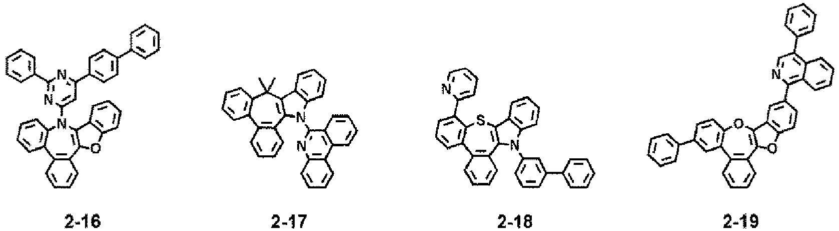

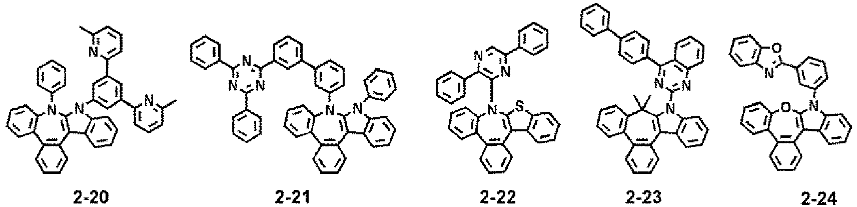

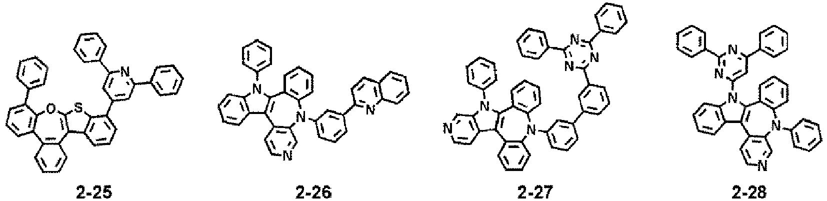

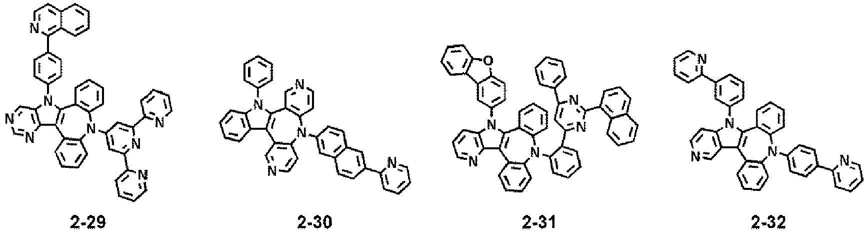

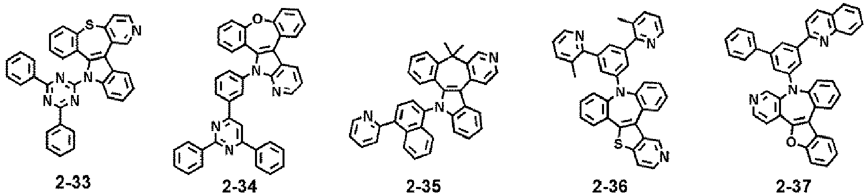

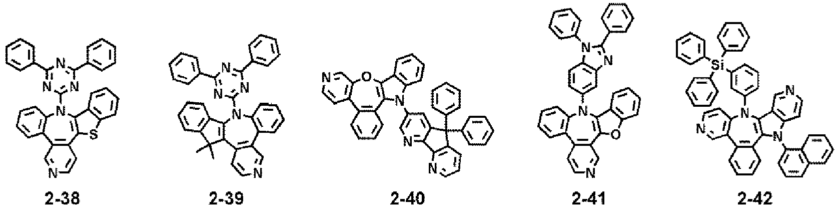

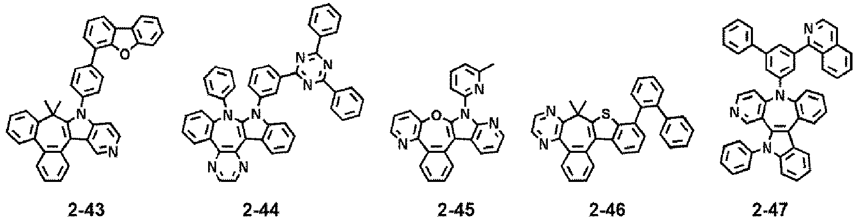

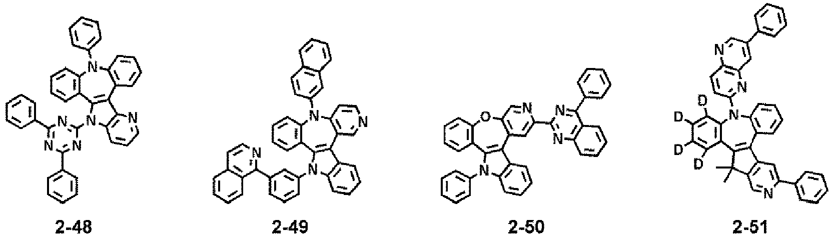

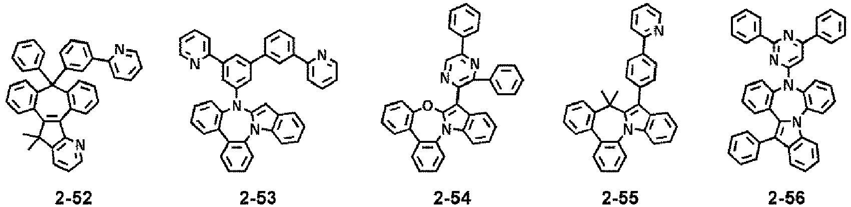

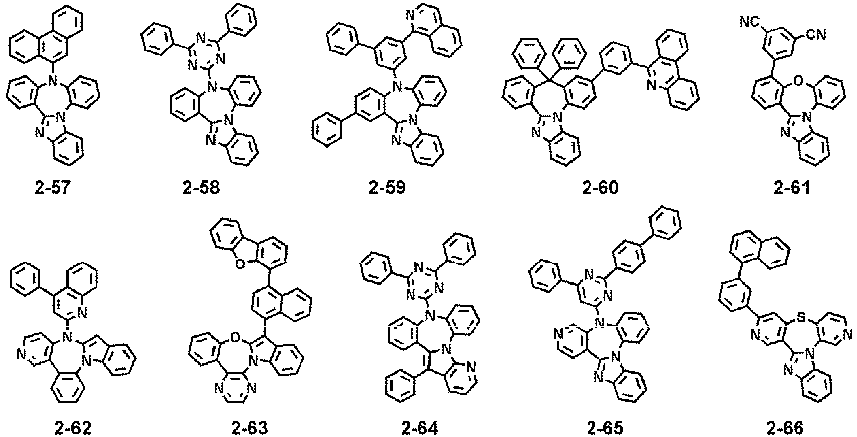

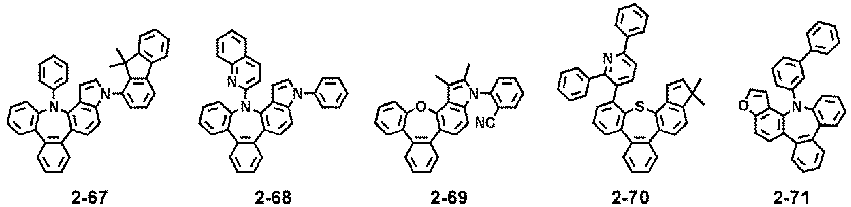

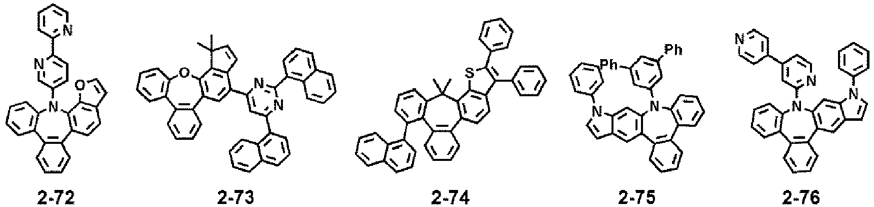

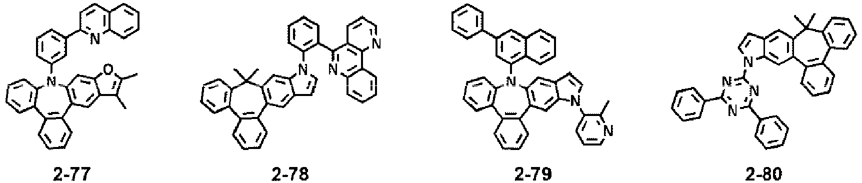

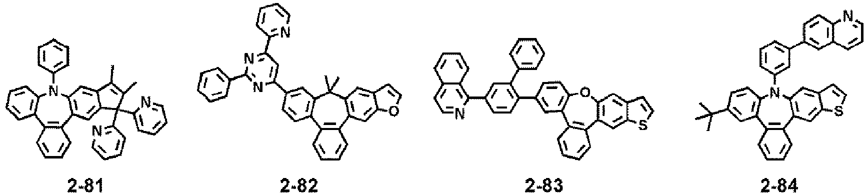

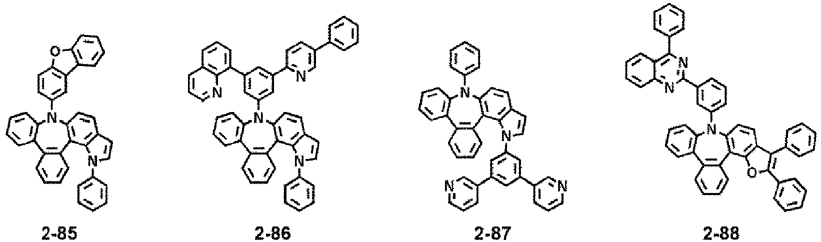

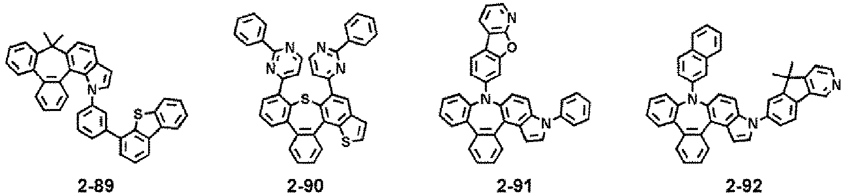

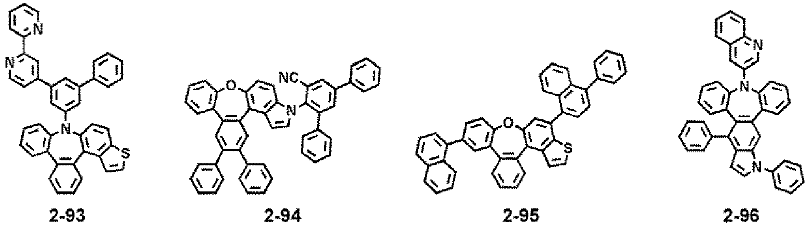

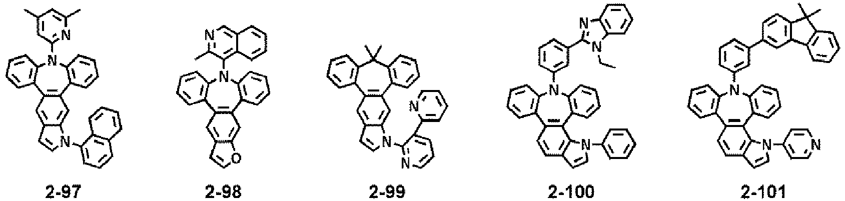

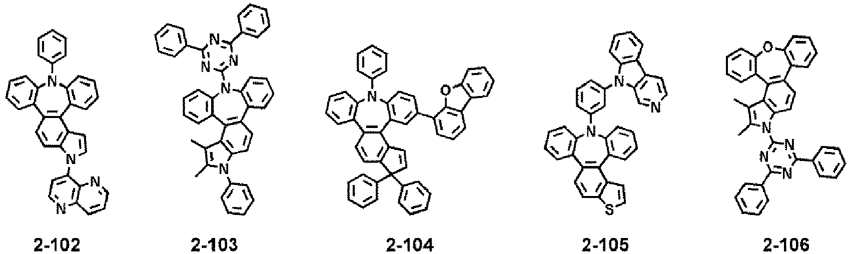

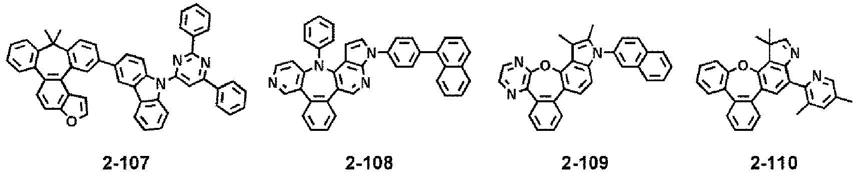

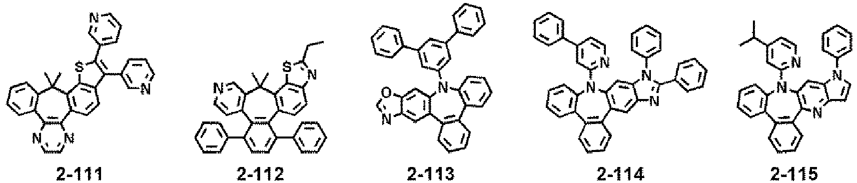

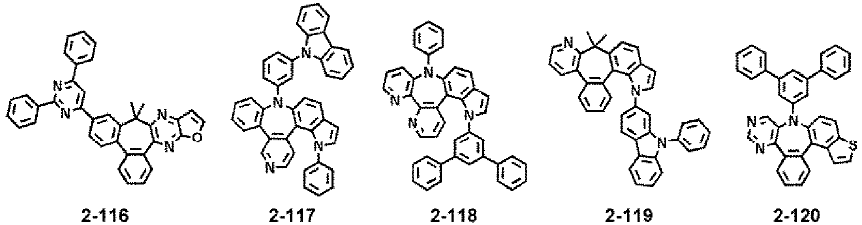

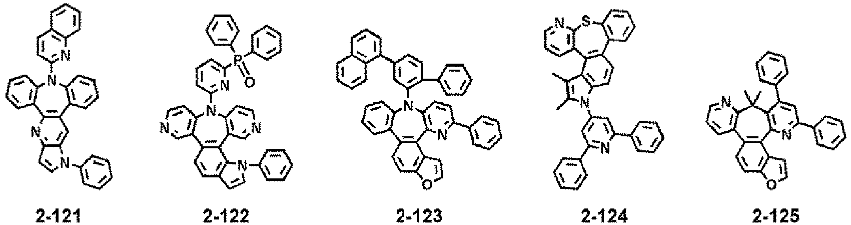

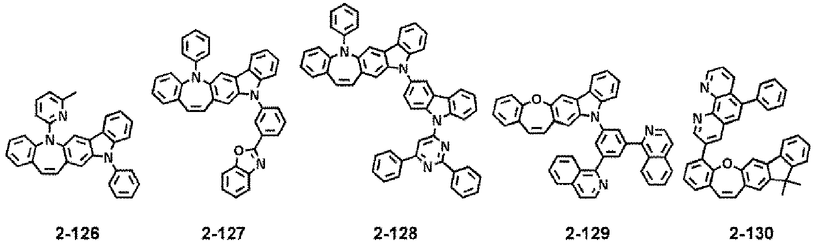

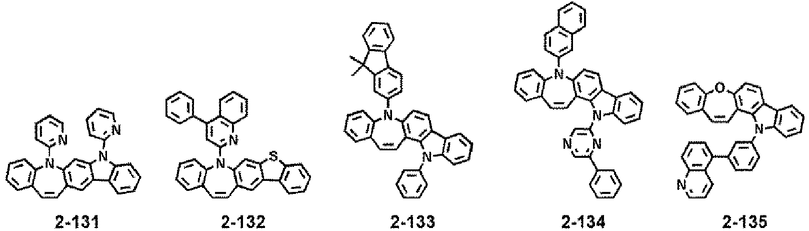

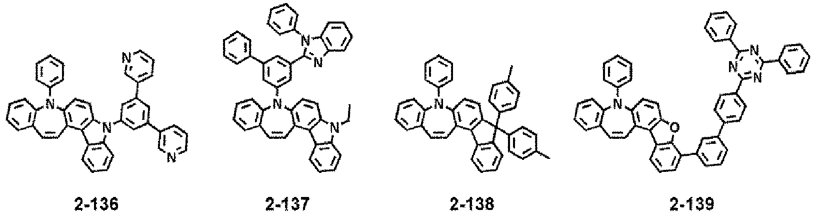

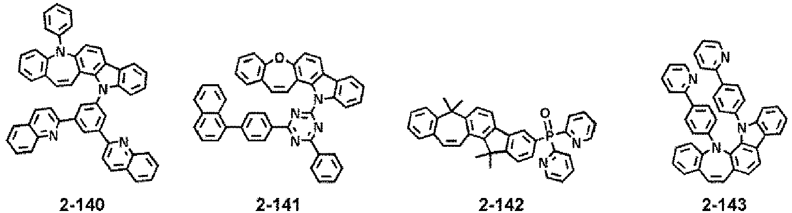

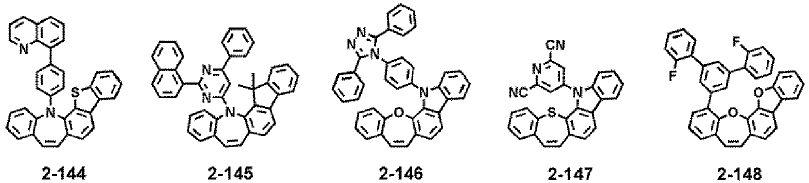

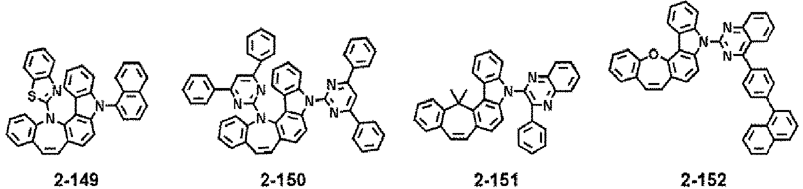

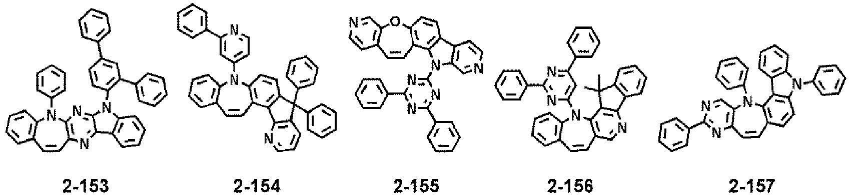

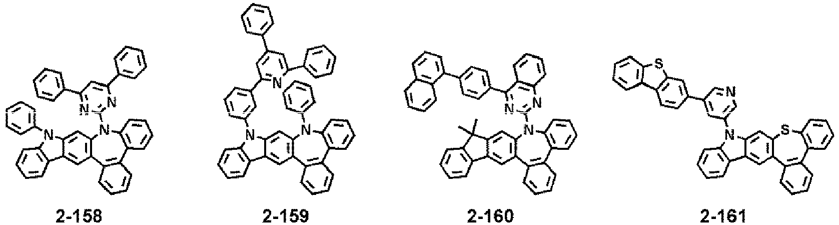

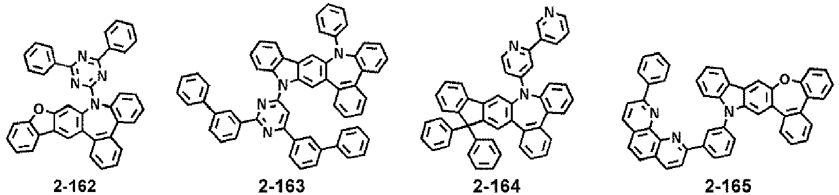

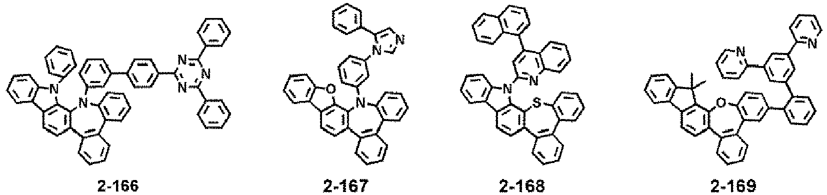

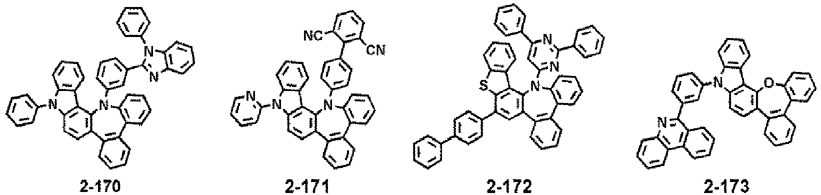

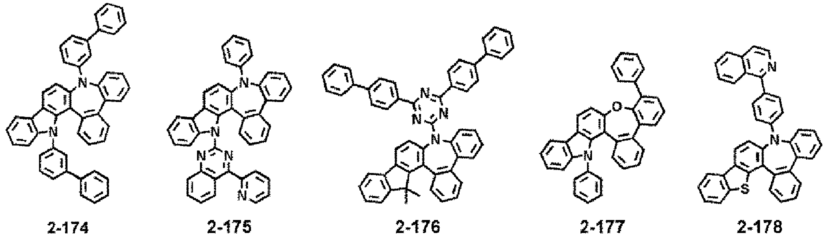

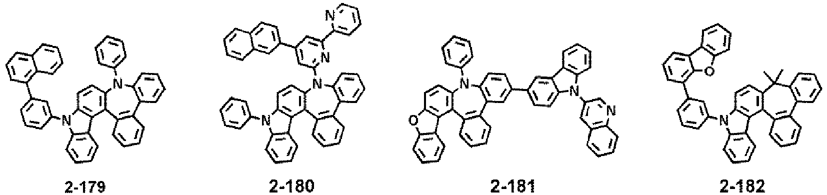

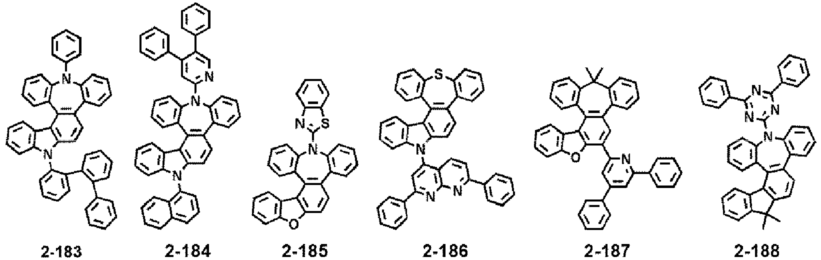

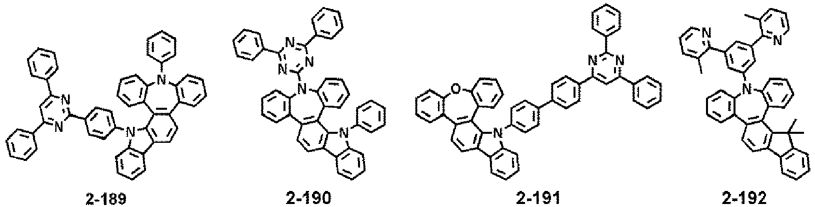

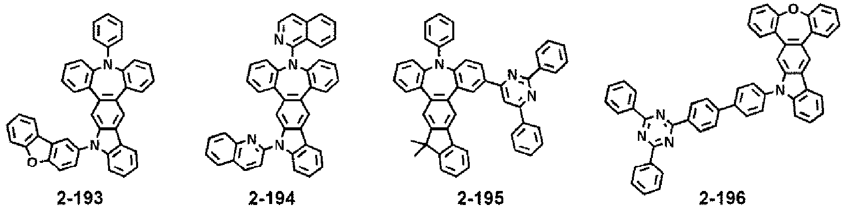

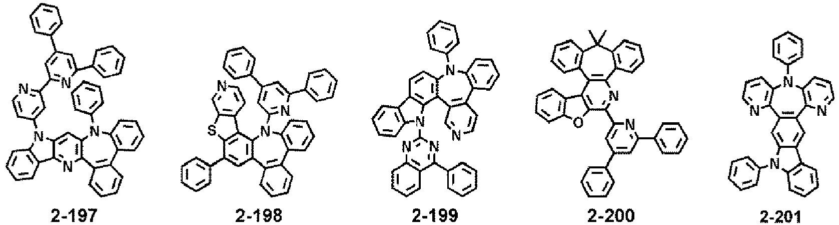

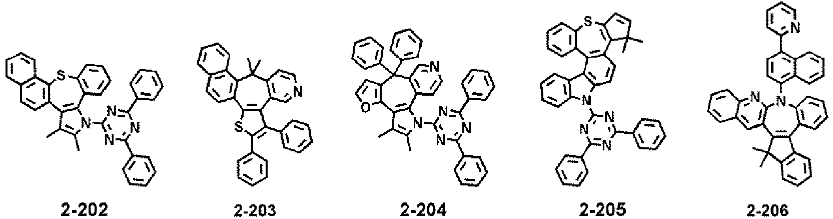

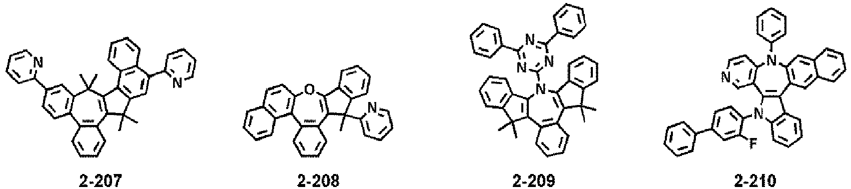

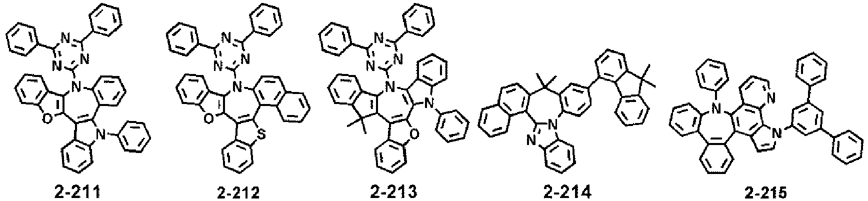

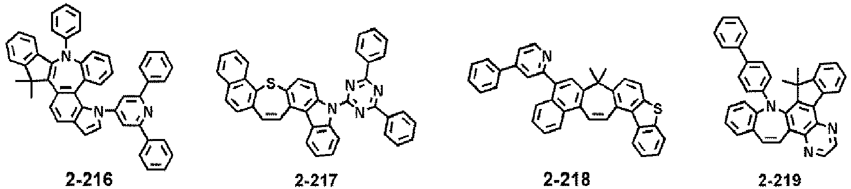

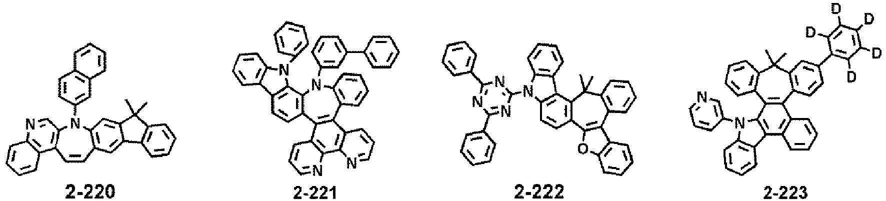

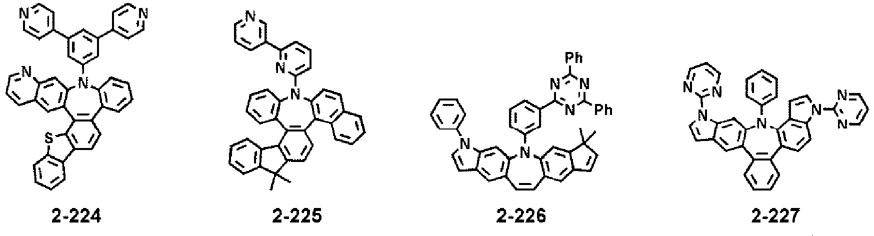

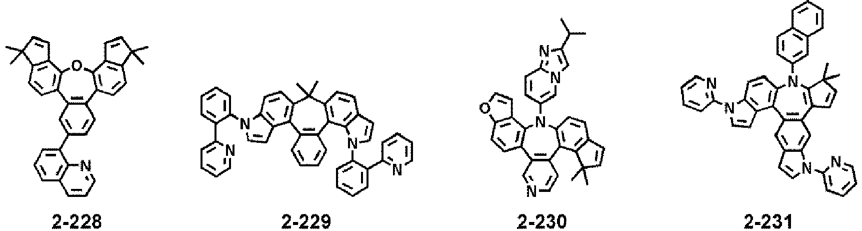

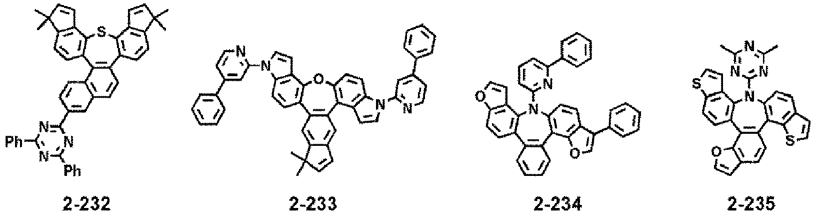

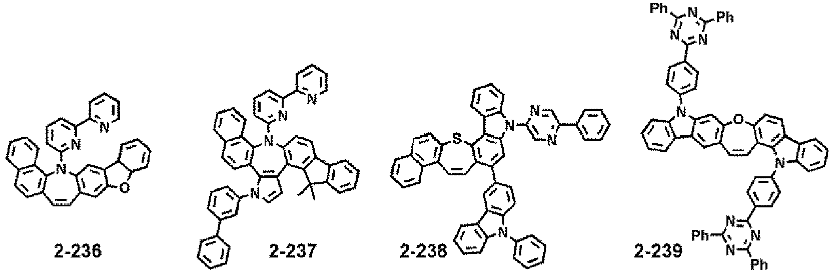

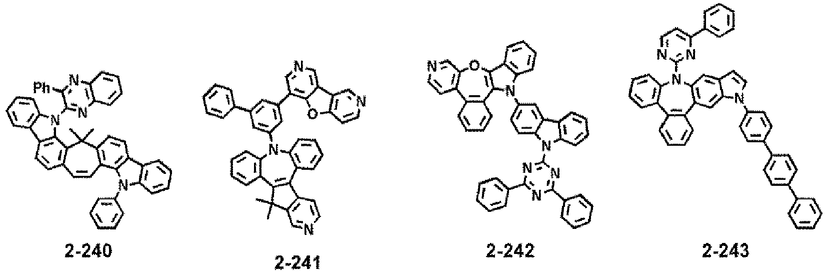

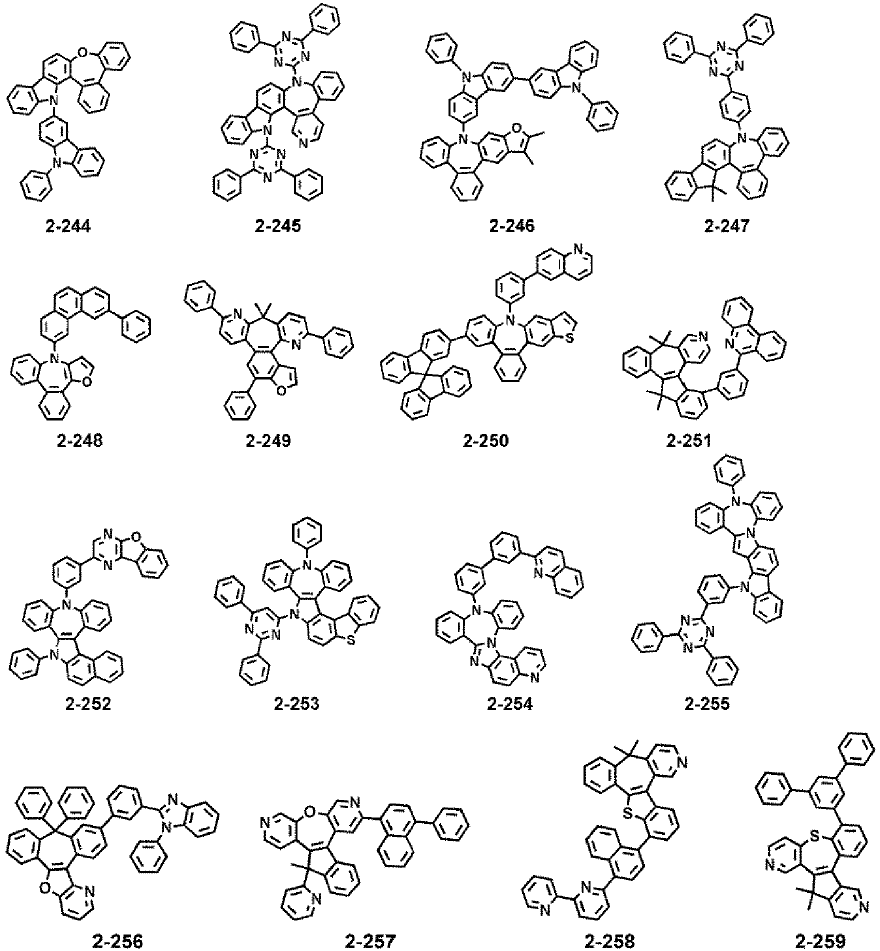

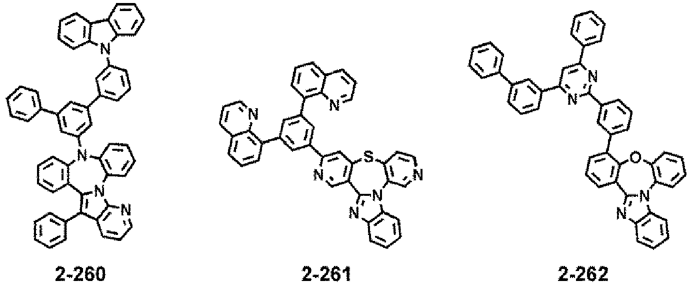

In Formulae 1A and 1B, any suitable combinations of L₁ to L₃, L₁₁ to L₁₅, a1 to a3, an to a15, R₁ to R₃, R₁₁ to R₁₆, b1 to b3, b11 to b16, a16, n1, and n2 may be used within the scopes described herein.

In Formulae 2A and 2B, any suitable combinations of ring A₂₁, ring A₂₂, ring A₂₃, X₂₁, and T₁₁ to T₁₄ may be used within the scopes described herein.

Regarding *-[(L₂₂)ₐ₂₂-(R₂₂)_{b22}], C(R₂₃)(R₂₄), Si(R₂₃)(R₂₄), and N-[(L₂₁)ₐ₂₁-(R₂₁)_{b21}], any suitable combinations of L₂₁, L₂₂, a21, a22, R₂₁ to R₂₄, b21, and b22 may be used within the scopes described herein.

The organic light-emitting device may comprise the first compound represented by Formula 1A or 1B and the second compound represented by Formula 2A or 2B, thus having a low driving voltage, high efficiency, and long lifespan.

In accordance with the invention, the hole transport region comprises the above-described first compound.

For example, the hole transport region may comprise a hole injection layer and a hole transport layer, wherein the hole transport layer may be between the hole injection layer and the emission layer and may comprise the first compound represented by Formula 1A or 1B, but embodiments of the present disclosure are not limited thereto.

In one or more embodiments, the emission layer may comprise the first compound.

In some embodiments, the emission layer may comprise a host and a dopant, and the host may comprise the first compound. The host may comprise any suitable host available in the related art, in addition to the first compound represented by Formula 1A or 1B.

In one embodiment, the hole transport region may comprise an emission auxiliary layer, wherein the emission auxiliary layer may directly contact the emission layer and comprise the second compound represented by Formula 2A or 2B.

In one or more embodiments, the electron transport region may comprise a buffer layer, wherein the buffer layer may directly contact the emission layer and comprise the second compound represented by Formula 2A or 2B, but embodiments of the present disclosure are not limited thereto.

When the hole transport region and the electron transport region of the organic light-emitting device both (e.g., simultaneously) comprise a second compound represented by Formula 1A or 1B, the second compound comprised in the hole transport region may be identical to or different from the second compound comprised in the electron transport region.

### Description of FIG. 1

FIG. 1 is a schematic view of an organic light-emitting device 10 according to an embodiment of the present disclosure. The organic light-emitting device 10 comprises a first electrode 110, an organic layer 150, and a second electrode 190.

Hereinafter, the structure of the organic light-emitting device 10 according to an embodiment of the present disclosure and a method of manufacturing the organic light-emitting device 10 will be described in connection with FIG. 1.

### First electrode 110

In FIG. 1, a substrate may be under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by depositing and/or sputtering a material for the first electrode 110 on the substrate. When the first electrode 110 is an anode, the material for forming the first electrode 110 may be selected from materials with a high work function in order to facilitate hole injection.

The first electrode 110 may be a reflective electrode, a semi-transmissive electrode, or a transmissive electrode. When the first electrode 110 is a transmissive electrode, the material for the first electrode 110 may be selected from indium tin oxide (ITO), indium zinc oxide (IZO), tin oxide (SnO₂), zinc oxide (ZnO), and combinations thereof, but embodiments of the present disclosure are not limited thereto. In one or more embodiments, when the first electrode 110 is a semi-transmissive electrode or a reflective electrode, the material for forming the first electrode 110 may be selected from magnesium (Mg), silver (Ag), aluminum (Al), aluminum-lithium (Al-Li), calcium (Ca), magnesium-indium (Mg-In), magnesium-silver (Mg-Ag), and combinations thereof, but embodiments of the present disclosure are not limited thereto. As used herein, the terms "combination", "combination thereof", and "combinations thereof' may refer to a chemical combination (e.g., an alloy or chemical compound), a mixture, or a laminated structure of components.

The first electrode 110 may have a single-layer structure, or a multi-layer structure comprising two or more layers. For example, the first electrode 110 may have a three-layered structure of ITO/Ag/ITO, but embodiments of the structure of the first electrode 110 are not limited thereto.

### Organic layer 150

The organic layer 150 may be on the first electrode 110. The organic layer 150 may comprise an emission layer.

The organic layer 150 may comprise a hole transport region between the first electrode 110 and the emission layer, and an electron transport region between the emission layer and the second electrode 190.

### Hole transport region in organic layer 150

The hole transport region may have i) a single-layered structure including (e.g., consisting of) a single layer including (e.g., consisting of) a single material, ii) a single-layered structure including (e.g., consisting of) a single layer comprising a plurality of different materials, or iii) a multi-layered structure having a plurality of layers comprising a plurality of different materials.

The hole transport region may comprise a hole injection layer, a hole transport layer, an emission auxiliary layer, an electron blocking layer, or a combination thereof.

For example, the hole transport region may have a single-layer structure including (e.g., consisting of) a single layer comprising a plurality of different materials, or a multi-layer structure having a structure of hole injection layer/hole transport layer, hole injection layer/hole transport layer/emission auxiliary layer, hole injection layer/emission auxiliary layer, hole transport layer/emission auxiliary layer or hole injection layer/hole transport layer/electron blocking layer, wherein layers of each structure are stacked on the first electrode 110 in each stated order, but embodiments of the structure of the hole transport region are not limited thereto.

For example, the hole transport layer may comprise the above-described first compound represented by Formula 1A or 1B.

In some embodiments, the hole transport region may comprise the above-described first compound, and at least one compound selected from m-MTDATA, TDATA, 2-TNATA, NPB (NPD), β-NPB, TPD, spiro-TPD, spiro-NPB, methylated NPB, TAPC, HMTPD, 4,4',4"-tris(*N*-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), and polyaniline/poly(4-styrenesulfonate) (PANI/PSS), but embodiments of the present disclosure are not limited thereto:

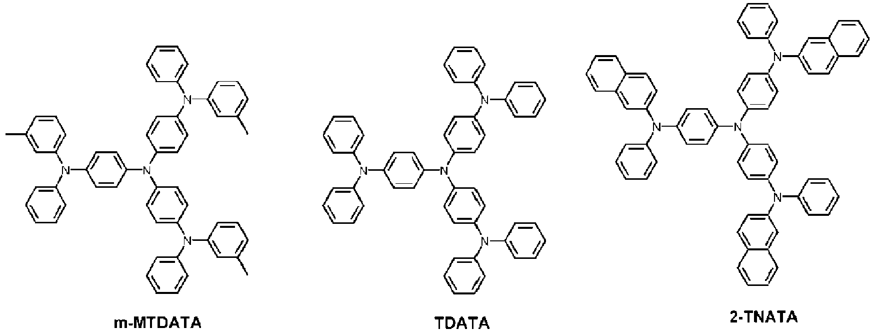

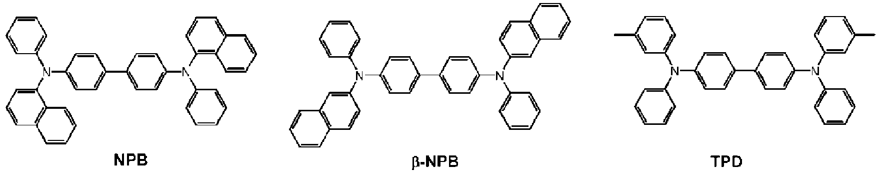

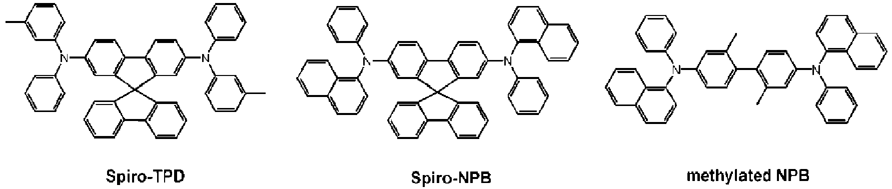

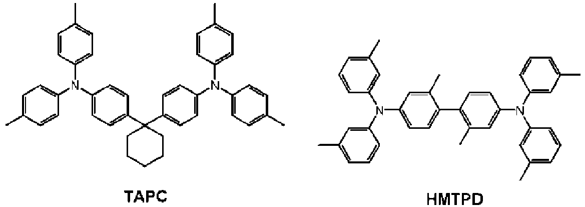

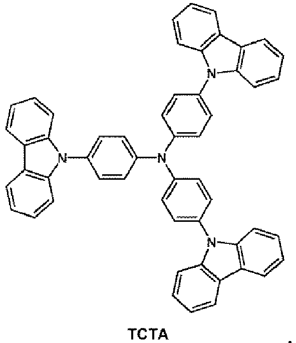

The thickness of the hole transport region may be about 100 Å to about 10,000 Å, and in some embodiments, about 100 Å to about 1,000 Å. When the hole transport region comprises at least one selected from a hole injection layer and a hole transport layer, the thickness of the hole injection layer may be about 100 Å to about 9,000 Å, and in some embodiments, about 100 Å to about 1,000 Å; the thickness of the hole transport layer may be about 50 Å to about 2,000 Å, and in some embodiments, about 100 Å to about 1,500 Å. When the thicknesses of the hole transport region, the hole injection layer, and the hole transport layer are each within these ranges, satisfactory hole transporting characteristics may be obtained without a substantial increase in driving voltage.

The emission auxiliary layer may increase the light-emission efficiency of the device by compensating for an optical resonance distance according to the wavelength of light emitted by an emission layer (e.g., by adjusting the optical resonance distance to match the wavelength of light emitted from the emission layer), and the electron blocking layer may block or reduce the flow of electrons from an electron transport region. The emission auxiliary layer and the electron blocking layer may comprise those materials as described above.

### p-dopant

The hole transport region may further comprise, in addition to these materials, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a lowest unoccupied molecular orbital (LUMO) energy level of -3.5 eV or less.

The p-dopant may comprise at least one selected from a quinone derivative, a metal oxide, and a cyano group-containing compound, but embodiments of the present disclosure are not limited thereto.

For example, the p-dopant may comprise at least one selected from the group consisting of:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as a tungsten oxide and/or a molybdenum oxide);
1,4,5,8,9,11-hexaazatriphenylene-hexacarbonitrile (HAT-CN); and
a compound represented by Formula 221, but embodiments of the present disclosure are not limited thereto:

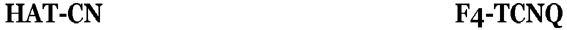

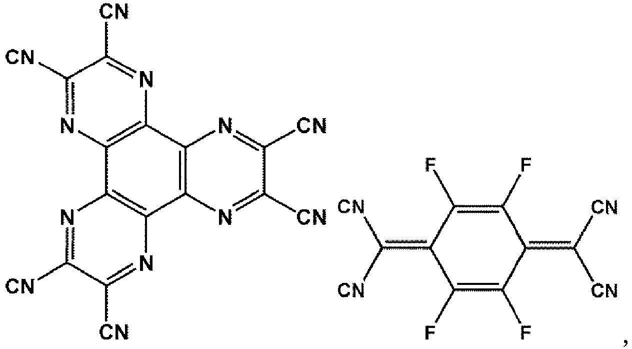

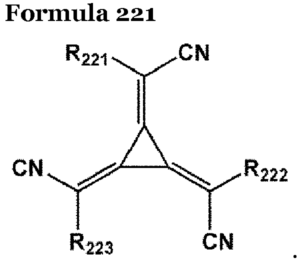

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, wherein at least one selected from R₂₂₁ to R₂₂₃ has at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with - Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, and/or a blue emission layer, according to a sub-pixel. In one or more embodiments, the emission layer may have a stacked structure of two or more layers selected from a red emission layer, a green emission layer, and a blue emission layer, in which the two or more layers may contact each other or may be separated from each other. In one or more embodiments, the emission layer may comprise two or more materials selected from a red-light emission material, a green-light emission material, and a blue-light emission material, in which the two or more materials may be mixed together in a single layer to thereby emit white light.

In one embodiment, the emission layer of the organic light-emitting device 10 may be a first-color-light emission layer,
the organic light-emitting device 10 may further comprise i) at least one second-color-light emission layer or ii) at least one second-color-light emission layer and at least one third-color-light emission layer, each between the first electrode 110 and the second electrode 190,
a maximum emission wavelength of the first-color-light emission layer, a maximum emission wavelength of the second-color-light emission layer, and a maximum emission wavelength of the third-color-light emission layer may be identical to or different from each other, and
the organic light-emitting device 10 may emit a mixed light comprising a first-color-light and a second-color-light, or a mixed light comprising the first-color-light, the second-color-light, and a third-color-light, but embodiments of the present disclosure are not limited thereto.

In some embodiments, the maximum emission wavelength of the first-color-light emission layer may be different from the maximum emission wavelength of the second-color-light emission layer, and the mixed light comprising the first-color-light and the second-color-light may be white light, but embodiments of the present disclosure are not limited thereto.

In one or more embodiments, the maximum emission wavelength of the first-color-light emission layer, the maximum emission wavelength of the second-color-light emission layer, and the maximum emission wavelength of the third-color-light emission layer may be different from one another, and the mixed light comprising the first-color-light, the second-color-light, and the third-color-light may be white light. However, embodiments of the present disclosure are not limited thereto.

As used herein the maximum emission wavelength of an emission layer is the wavelength of light emitted by the emission layer with maximum intensity.

The emission layer may comprise a host and a dopant. The dopant may comprise at least one selected from a phosphorescent dopant and a fluorescent dopant.

The amount of the dopant in the emission layer may be about 0.01 to about 15 parts by weight based on 100 parts by weight of the host, but embodiments of the present disclosure are not limited thereto.

The thickness of the emission layer may be about 100 Å to about 1,000 Å, and in some embodiments, about 200 Å to about 600 Å. When the thickness of the emission layer is within these ranges, excellent light-emission characteristics may be obtained without a substantial increase in driving voltage.

### Host in emission layer

The host may comprise the above-described second compound.

In one or more embodiments, the host may comprise a compound represented by Formula 301:

**Formula 301** [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer selected from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂), and
xb21 may be an integer selected from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

In some embodiments, Ar₃₀₁ in Formula 301 may be selected from the group consisting of:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, naphthacene group, a picene group, a perylene group, a pentaphene group, an indenoanthracene group, a dibenzofuran group, and a dibenzothiophene group, each substituted with at least one selected from deuterium,-F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group,-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

When xb11 in Formula 301 is 2 or greater, a plurality of Ar₃₀₁(s) may be bound (e.g., coupled) via one or more single bonds.

In one or more embodiments, the compound represented by Formula 301 may be represented by Formula 301-1 or 301-2:

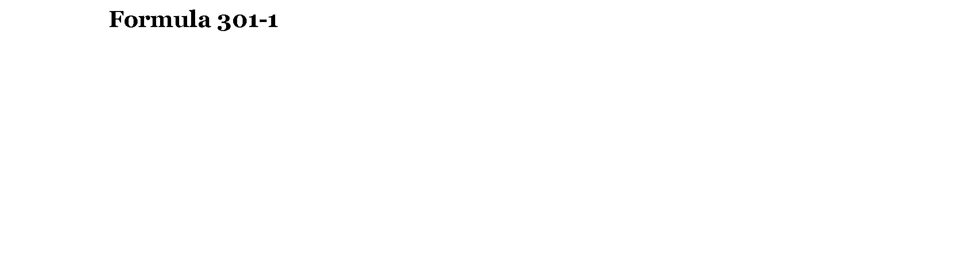

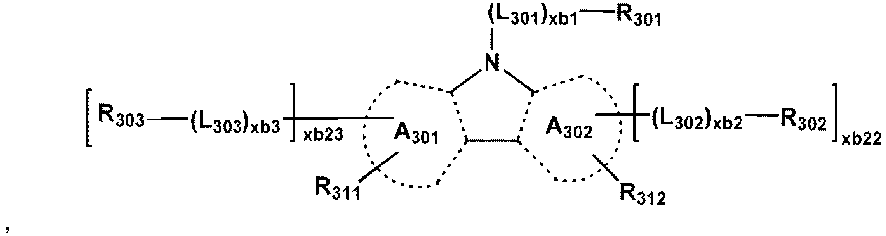

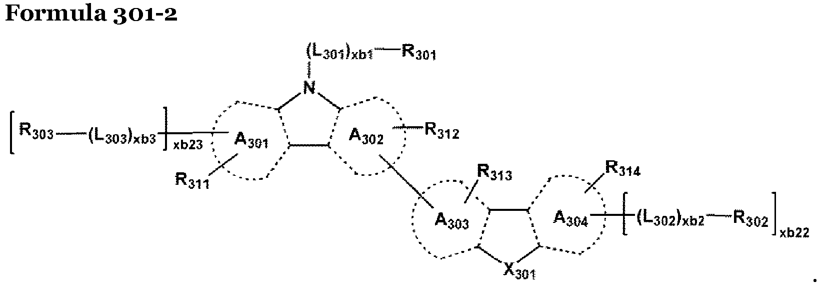

In Formulae 301-1 and 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ may each independently be the same as described herein,
L₃₀₂ to L₃₀₄ may each independently be the same as described herein in connection with L₃₀₁,
xb2 to xb4 may each independently be the same as described herein in connection with xb1, and
R₃₀₂ to R₃₀₄ may each independently be the same as described herein in connection with R₃₀₁.

For example, L₃₀₁ to L₃₀₄ in Formulae 301, 301-1, and 301-2 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group,-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₃₁ to Q₃₃ may each independently be the same as described herein.

In some embodiments, R₃₀₁ to R₃₀₄ in Formulae 301, 301-1, and 301-2 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂),-B(Q₃₁)(Q₃₂), -C(=O)(Q₃₁), -S(=O)₂(Q₃₁), and -P(=O)(Q₃₁)(Q₃₂),
wherein Q₃₁ to Q₃₃ may each independently be the same as described herein.

In some embodiments, the host may comprise an alkaline earth metal complex. For example, the host may be selected from a beryllium (Be) complex (e.g., Compound H₅₅), and a magnesium (Mg) complex. In one or more embodiments, the host may comprise a zinc (Zn) complex.

The host may comprise at least one selected from 9,10-di(2-naphthyl)anthracene (ADN), 2-methyl-9,10-bis(naphthalen-2-yl)anthracene (MADN), 9,10-di-(2-naphthyl)-2-*t*-butyl-anthracene (TBADN), 4,4'-bis(*N*-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the present disclosure are not limited thereto:

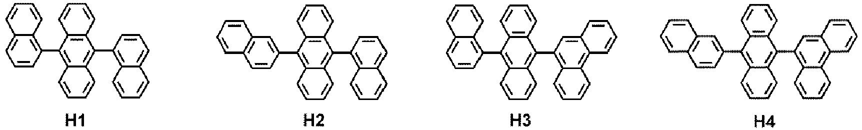

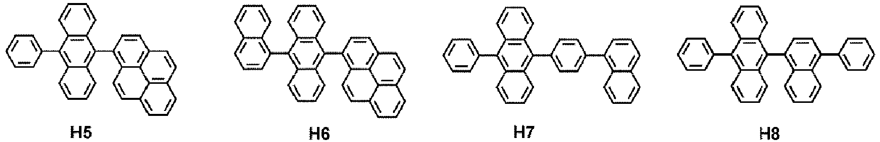

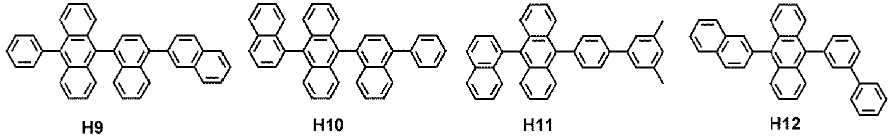

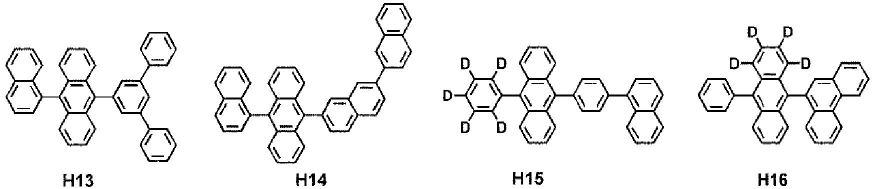

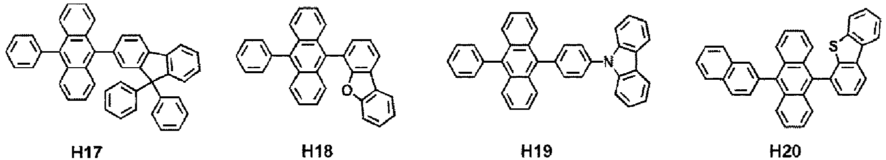

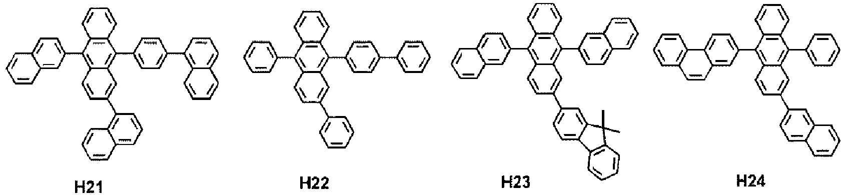

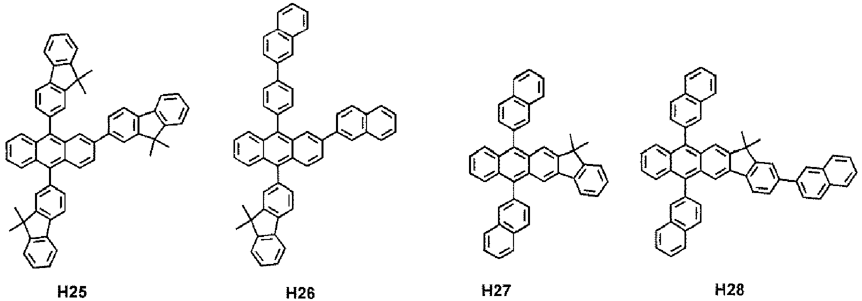

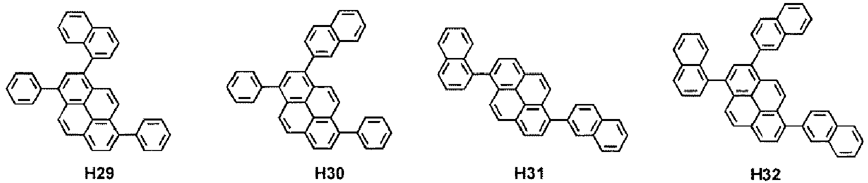

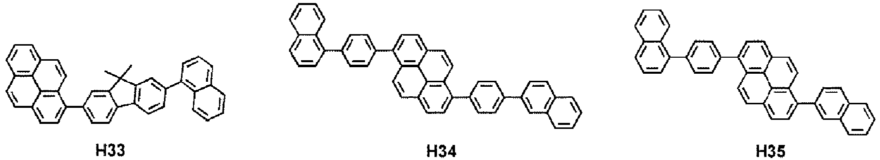

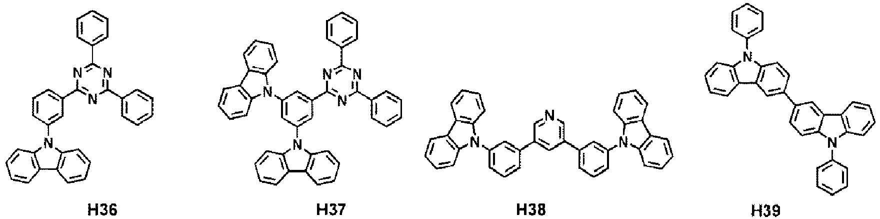

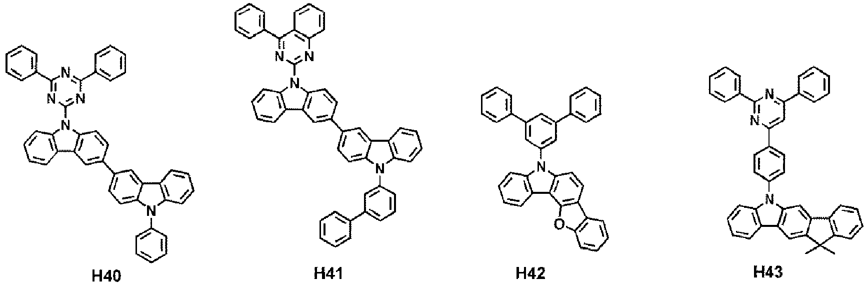

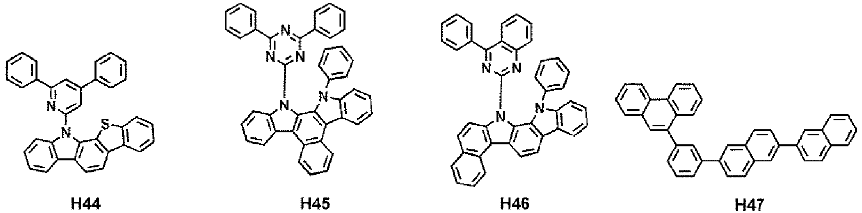

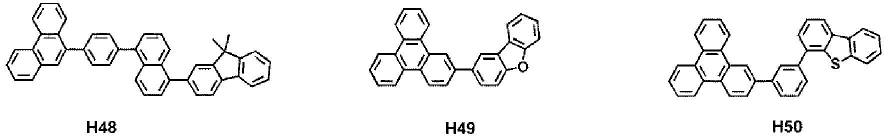

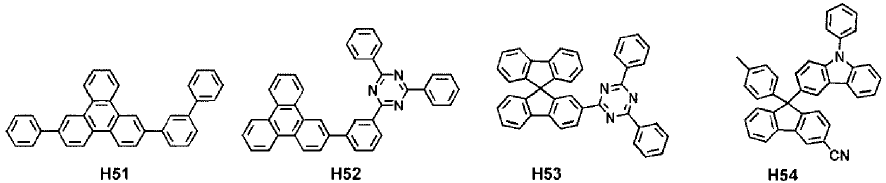

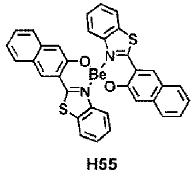

### Phosphorescent dopant included in an emission layer of the organic layer 150

The phosphorescent dopant may further comprise a phosphorescent dopant, and the phosphorescent dopant may comprise an organometallic compound comprising iridium (Ir), platinum (Pt), palladium (Pd), osmium (Os), titanium (Ti), zirconium (Zr), hafnium (Hf), europium (Eu), terbium (Tb), rhodium (Rh), and/or thulium (Tm).

In some embodiments, the phosphorescent dopant may comprise an organometallic complex represented by Formula 401:

**Formula 401** M(L₄₀₁)_{xc1}(L₄₀₂)_{xc2},

wherein L₄₀₁ may be selected from ligands represented by Formula 402,

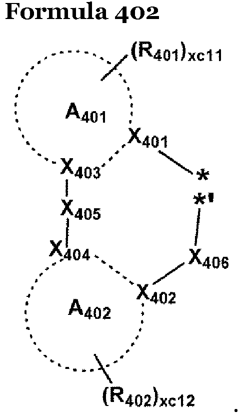

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3; when xc1 is 2 or greater, a plurality of L₄₀₁(s) may be identical to or different from each other,
L₄₀₂ may be an organic ligand, and xc2 may be 0, 1, 2, 3, or 4; when xc2 is 2 or greater, a plurality of L₄₀₂(s) may be identical to or different from each other,
X₄₀₁ to X₄₀₄ may each independently be nitrogen or carbon,
X₄₀₁ and X₄₀₃ may be bound (e.g., coupled) via a single bond or a double bond; X₄₀₂ and X₄₀₄ may be bound (e.g., coupled) via a single bond or a double bond,
A₄₀₁ and A₄₀₂ may each independently be a C₅-C₆₀ carbocyclic group or a C₁-C₆₀ heterocyclic group,
X₄₀₅ may be a single bond, -O-, -S-, -C(=O)-, -N(Q₄₁₁)-, -C(Q₄₁₁)(Q₄₁₂)-,-C(Q₄₁₁)=C(Q₄₁₂)-, -C(Q₄₁₁)=, or =C(Q₄₁₁)=, wherein Q₄₁₁ and Q₄₁₂ may each independently be selected from hydrogen, deuterium, a C₁-C₂₀ alkyl group, a C₁-C₂₀ alkoxy group, a phenyl group, a biphenyl group, a terphenyl group, and a naphthyl group,
X₄₀₆ may be a single bond, O, or S,
R₄₀₁ and R₄₀₂ may each independently be selected from hydrogen, deuterium,-F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group,-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and-P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer selected from 0 to 10, and
* and *' in Formula 402 may each independently indicate a binding site to M in Formula 401.

In one embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ and X₄₀₂ may both (e.g., simultaneously) be nitrogen.

In one or more embodiments, R₄₀₁ and R₄₀₂ in Formula 402 may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantyl group, a norbornanyl group, and a norbornenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is 2 or greater, two A₄₀₁(s) in a plurality of L₄₀₁(s) may optionally be bound (e.g., coupled) via X₄₀₇ as a linking group, and two A₄₀₂(s) may optionally be bound (e.g., coupled) via X₄₀₈ as a linking group (see Compounds PD1 to PD4 and PD7). X₄₀₇ and X₄₀₈ may each independently be selected from a single bond, -O-, -S-, -C(=O)-, -N(Q₄₁₃)-,-C(Q₄₁₃)(Q₄₁₄)-, and -C(Q₄₁₃)=C(Q₄₁₄)-, wherein Q₄₁₃ and Q₄₁₄ may each independently be selected from hydrogen, deuterium, a C₁-C₂₀ alkyl group, a C₁-C₂₀ alkoxy group, a phenyl group, a biphenyl group, a terphenyl group, and a naphthyl group, but embodiments of the present disclosure are not limited thereto.

In Formula 401, L₄₀₂ may be any suitable monovalent, divalent, or trivalent organic ligand. In some embodiments, L₄₀₂ may be selected from halogen, diketone (e.g., acetylacetonate), a carboxylic acid (e.g., picolinate), -C(=O), isonitrile, -CN, and a phosphorus-based ligand (e.g., phosphine and/or phosphite), but embodiments of the present disclosure are not limited thereto.

The phosphorescent dopant may be, for example, selected from Compounds PD1 to PD25, but embodiments of the present disclosure are not limited thereto:

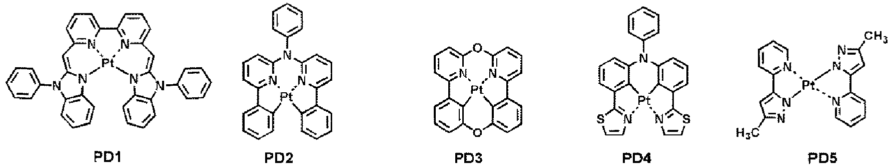

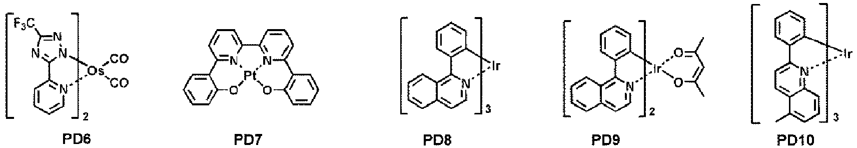

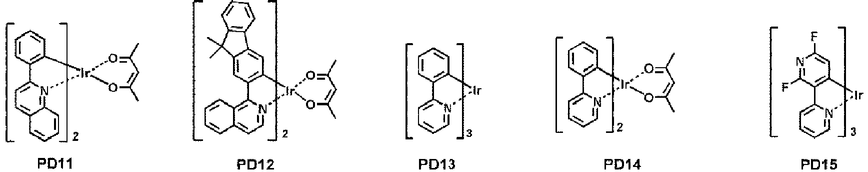

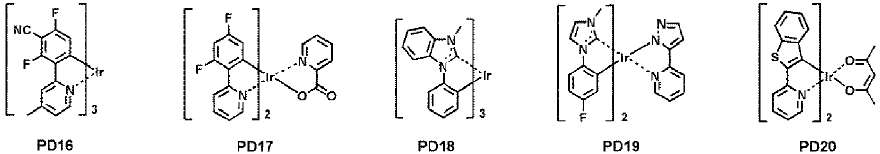

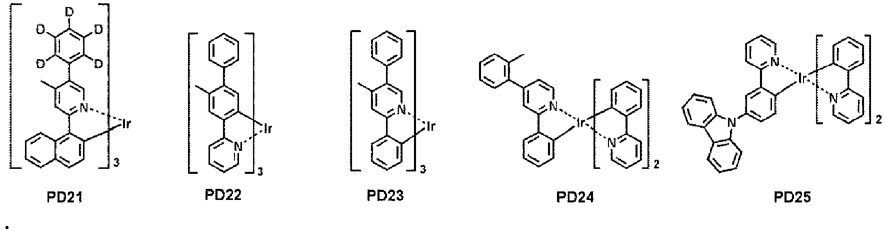

### Fluorescent dopant in emission layer

The fluorescent dopant may comprise an arylamine compound or a styrylamine compound.

In one or more embodiments, the fluorescent dopant may comprise a compound represented by Formula 501:

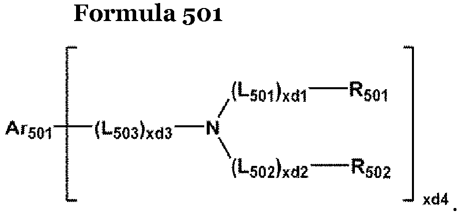

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer selected from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, and
xd4 may be an integer selected from 1 to 6.

In some embodiments, Ar₅₀₁ in Formula 501 may be selected from the group consisting of:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and-Si(Q₃₁)(Q₃₂)(Q₃₃),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

In some embodiments, the fluorescent dopant may be selected from Compounds FD1 to FD22:

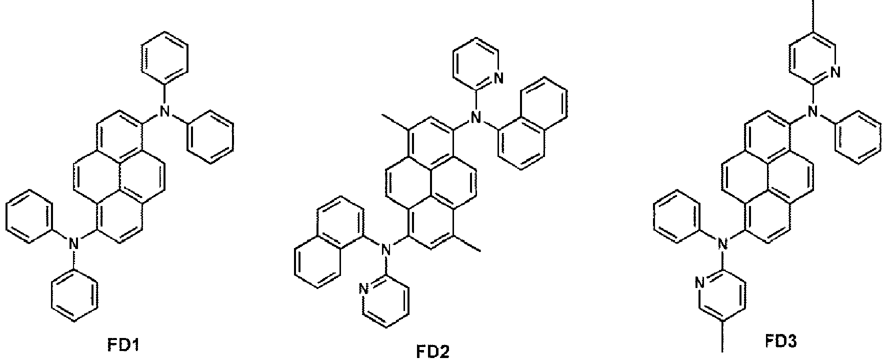

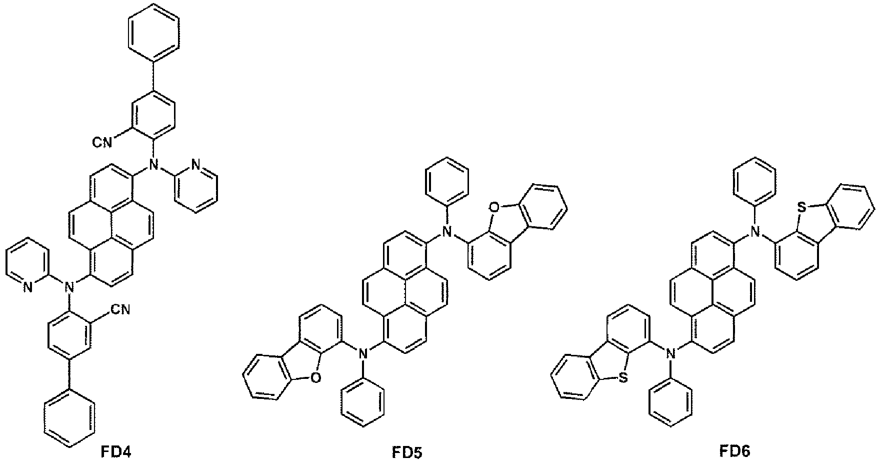

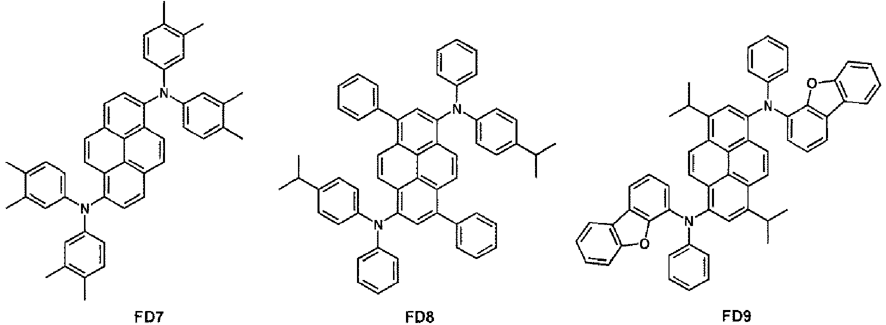

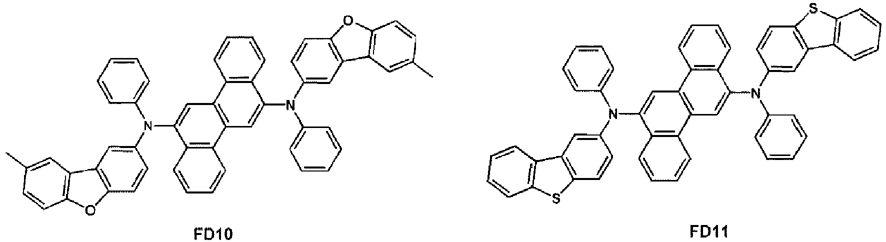

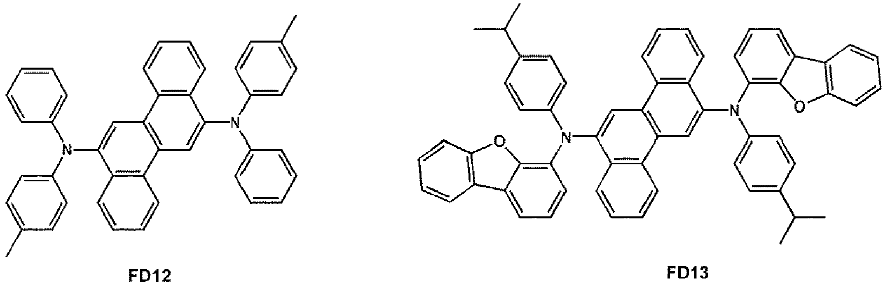

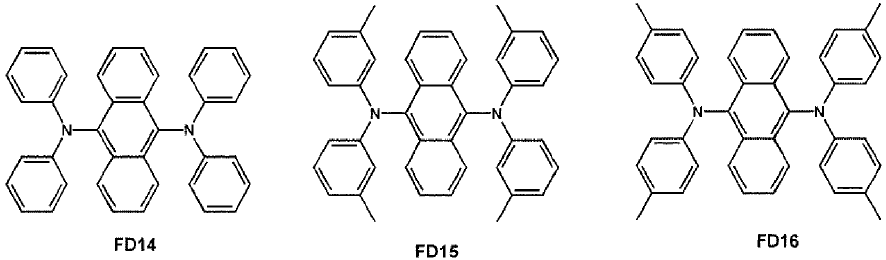

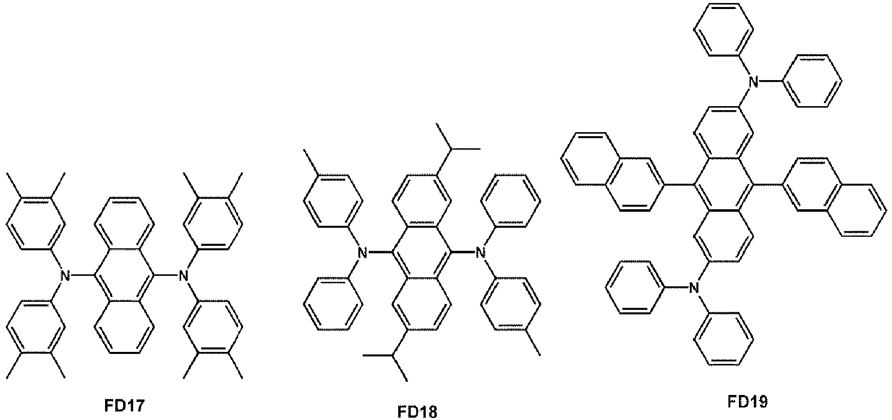

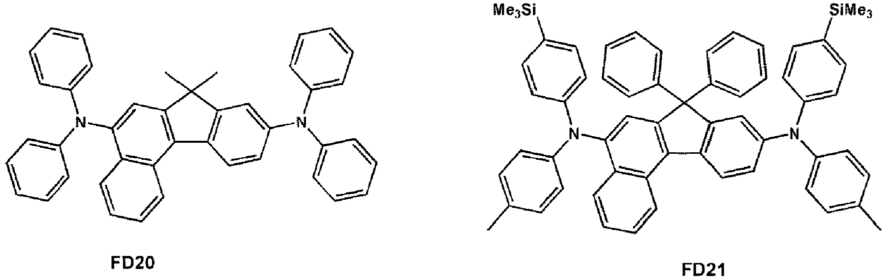

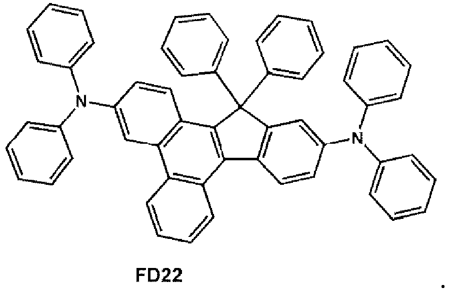

Alternatively, the fluorescent dopant may be selected from the compounds below, but embodiments of the present disclosure are not limited thereto:

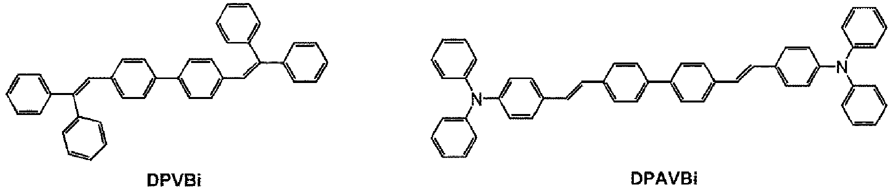

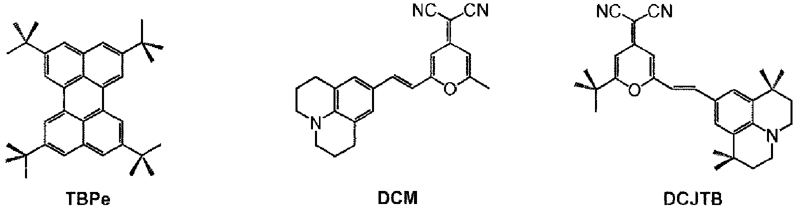

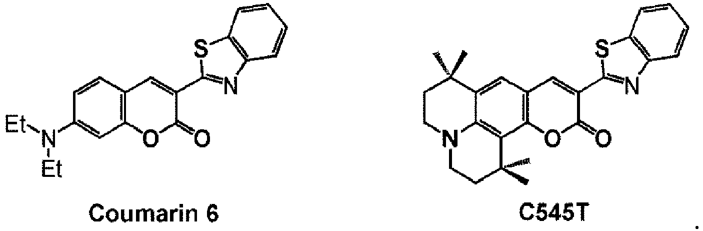

### Electron transport region in organic layer 150

The electron transport region may have i) a single-layered structure including (e.g., consisting of) a single layer including (e.g., consisting of) a single material, ii) a single-layered structure including (e.g., consisting of) a single layer comprising a plurality of different materials, or iii) a multi-layered structure having a plurality of layers comprising a plurality of different materials.

The electron transport region may comprise a buffer layer, a hole blocking layer, an electron control layer, an electron transport layer, an electron injection layer, or a combination thereof, but embodiments of the present disclosure are not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein layers of each structure are sequentially stacked on the emission layer in each stated order. However, embodiments of the structure of the electron transport region are not limited thereto.

The electron transport region comprises the second compound represented by Formula 2A or 2B as described above.

In one embodiment, the electron transport region may comprise a buffer layer. The buffer layer may directly contact the emission layer and comprise the second compound represented by Formula 2A or 2B.

In one or more embodiments, the electron transport region may comprise a buffer layer, an electron transport layer, and an electron injection layer, which may be stacked in this stated order on the emission layer, and the buffer layer may comprise the second compound represented by Formula 2A or 2B.

The electron transport region (for example, a hole blocking layer, an electron control layer, and/or an electron transport layer in the electron transport region) may comprise a metal-free compound containing at least one π electron-depleted nitrogen-containing ring.

As used herein, the term "π electron-depleted nitrogen-containing ring" indicates a C₁-C₆₀ heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed (e.g., fused), or iii) a heteropolycyclic group in which at least one 5-membered to 7-membered heteromonocyclic group having at least one *-N=*' moiety is condensed (e.g., fused) with at least one C₅-C₆₀ carbocyclic group.

Non-limiting examples of the π electron-depleted nitrogen-containing ring may include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazole, an imidazopyridine, an imidazopyrimidine, and an azacarbazole, but embodiments of the present disclosure are not limited thereto.

In some embodiments, the electron transport region may comprise a compound represented by Formula 601:

**Formula 601** [Ar₆₀₁]ₓₑ₁₁-[(L₆₀₁)ₓₑ₁-R₆₀ᵢ]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group,-Si(Q₆₀₁)(Q₆₀₁)(Q₆₀₃), -C(=O)(Q₆₀₁), -S(=O)₂(Q₆₀₁), and -P(=O)(Q₆₀₁)(Q₆₀₂),
wherein Q₆₀₁ to Q₆₀₃ may each independently be selected from a C₁-C₁₀ alkyl group, a C₁-C₁₀ alkoxy group, a phenyl group, a biphenyl group, a terphenyl group, and a naphthyl group, and
xe21 may be an integer selected from 1 to 5.

In some embodiments, at least one selected from the xen Ar₆₀₁(s) and the xe21 R₆₀₁(s) may comprise a π electron-depleted nitrogen-containing ring.

In some embodiments, ring Ar₆₀₁ in Formula 601 may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group,-Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or greater, a plurality of Ar₆₀₁(s) may be bound (e.g., coupled) via one or more single bonds.

In one embodiment, Ar₆₀₁ in Formula 601 may be an anthracene group.

In some embodiments, the compound represented by Formula 601 may be represented by Formula 601-1:

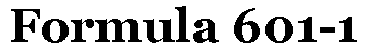

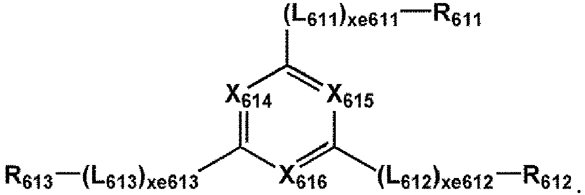

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ may each independently be the same as described herein in connection with L₆₀₁,
xe611 to xe613 may each independently be the same as described herein in connection with xe1,
R₆₁₁ to R₆₁₃ may each independently be substantially the same as described herein in connection with R₆₀₁, and
R₆₁₄ to R₆₁₆ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one embodiment, L₆₀₁ and L₆₁₁ to L₆₁₃ in Formulae 601 and 601-1 may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but embodiments of the present disclosure are not limited thereto.

In one or more embodiments, xe1 and xe611 to xe613 in Formulae 601 and 601-1 may each independently be selected from 0, 1, and 2.

In some embodiments, R₆₀₁ and R₆₁₁ to R₆₁₃ in Formulae 601 and 601-1 may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ may each independently be the same as described herein.

The electron transport region may comprise at least one compound selected from Compounds ET1 to ET36, but embodiments of the present disclosure are not limited thereto:

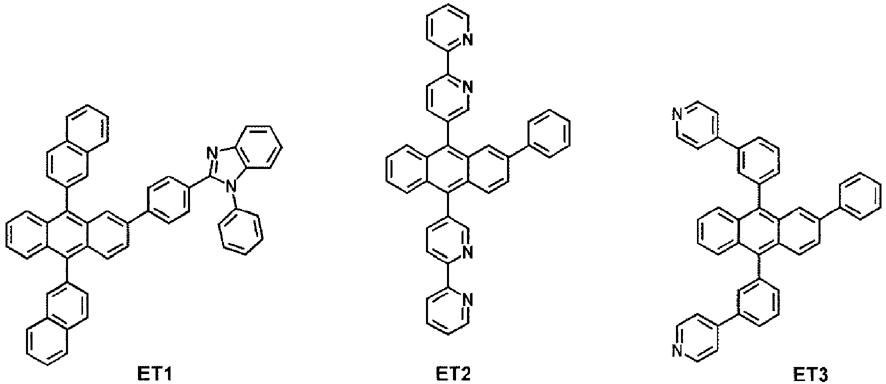

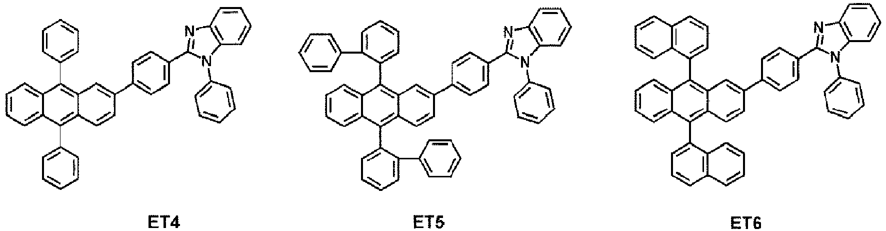

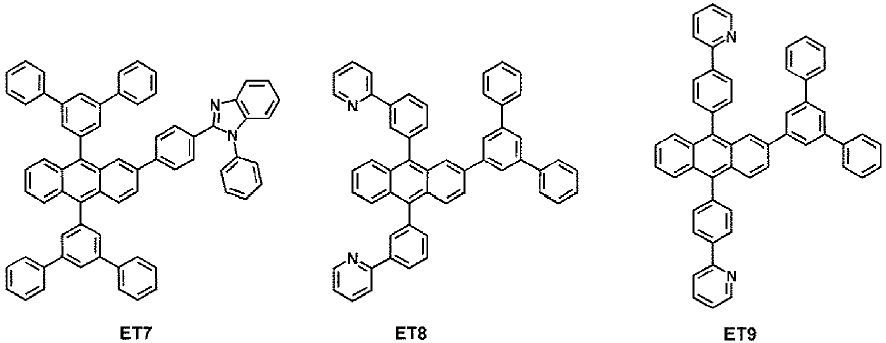

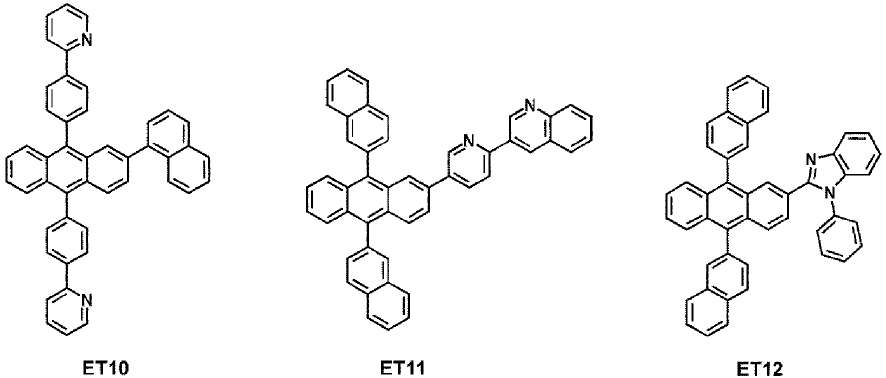

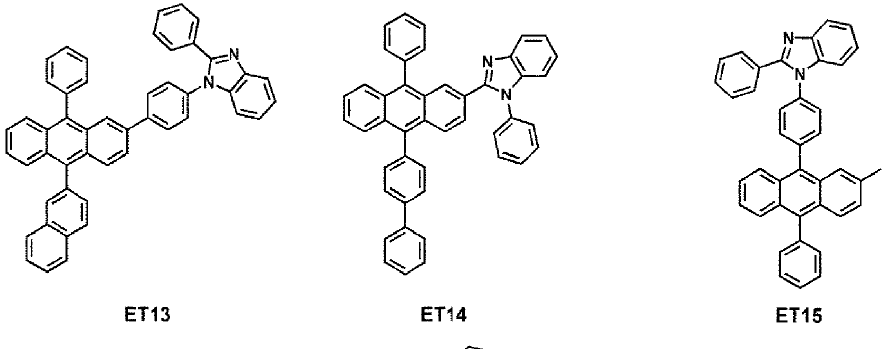

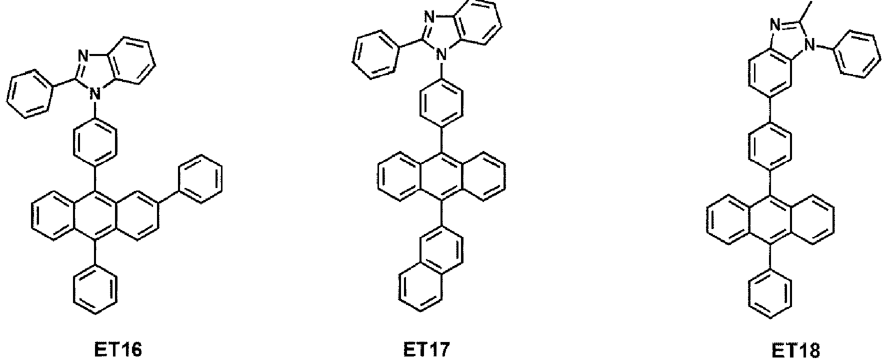

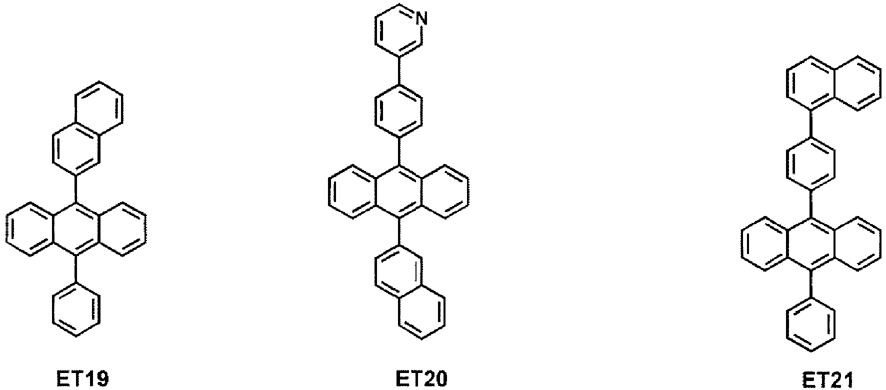

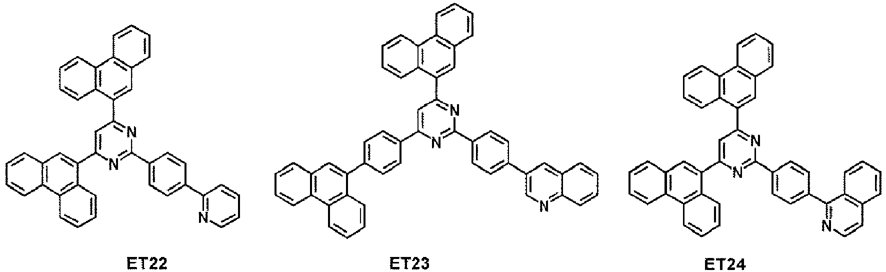

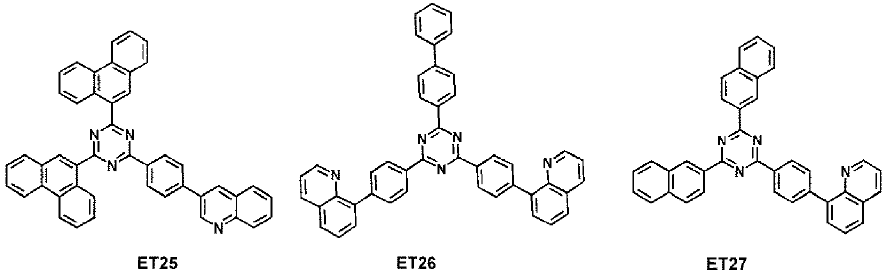

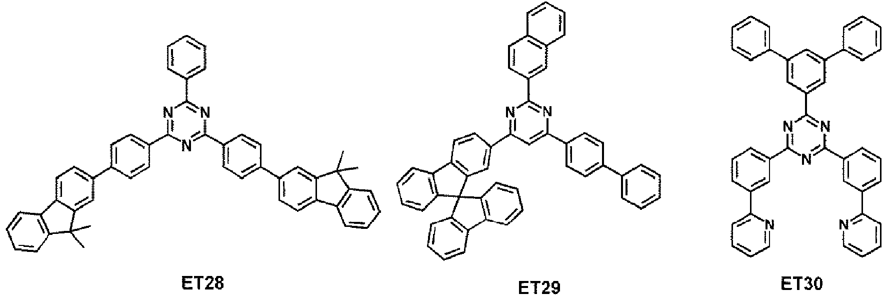

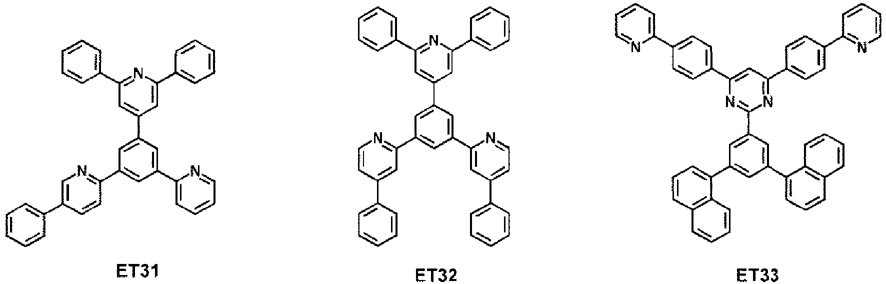

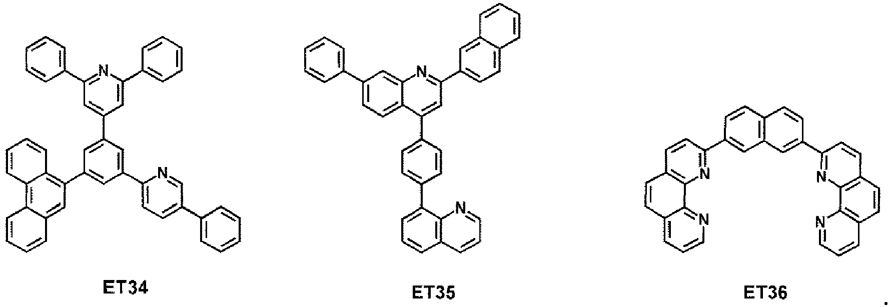

In one or more embodiments, the electron transport region may comprise at least one selected from 2,9-dimethyl-4,7-diphenyl-1,10-phenanthroline (BCP), 4,7-diphenyl-1,10-phenanthroline (Bphen), Alq3, BAlq, 3-(biphenyl-4-yl)-5-(4-tert-butylphenyl)-4-phenyl-4H-1,2,4-triazole (TAZ), and NTAZ:

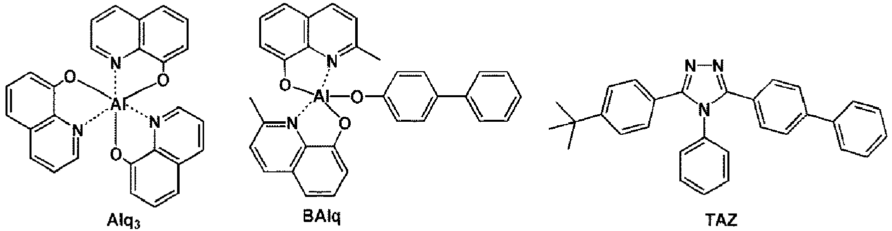

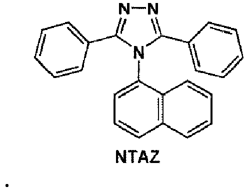

The thickness of the buffer layer, the hole blocking layer, and the electron control layer may each independently be about 20 Å to about 1,000 Å, and in some embodiments, about 30 Å to about 300 Å. When the thicknesses of the buffer layer, the hole blocking layer, and the electron control layer are each within these ranges, the electron blocking layer may have excellent electron blocking characteristics and/or electron control characteristics without a substantial increase in driving voltage.

The thickness of the electron transport layer may be about 100 Å to about 1,000 Å, and in some embodiments, about 150 Å to about 500 Å. When the thickness of the electron transport layer is within these ranges, the electron transport layer may have satisfactory electron transport characteristics without a substantial increase in driving voltage.

The electron transport region (e.g., the electron transport layer in the electron transport region) may further comprise, in addition to the materials described above, a metal-containing material.

The metal-containing material may comprise an alkali metal complex, alkaline earth metal complex, or a combination thereof. The alkali metal complex may comprise a metal ion selected from an Li ion, a sodium (Na) ion, a potassium (K) ion, a rubidium (Rb) ion, and a cesium (Cs) ion, and the alkaline earth-metal complex may comprise a metal ion selected from a beryllium (Be) ion, a magnesium (Mg) ion, a calcium (Ca) ion, a strontium (Sr) ion, and a barium (Ba) ion. Each ligand coordinated with the metal ion of the alkali metal complex or the alkaline earth-metal complex may be independently selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments of the present disclosure are not limited thereto.

In some embodiments, the metal-containing material may comprise a Li complex. The Li complex may comprise, for example, Compound ET-D1 (8-hydroxyquinolinolato-lithium, LiQ) and/or ET-D2:

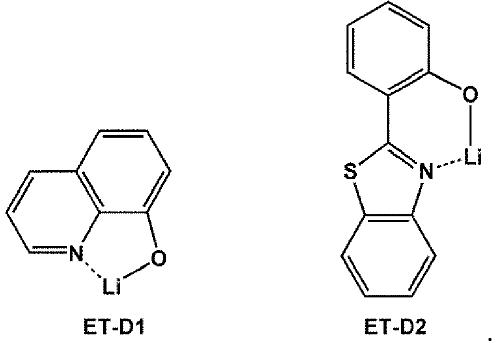

The electron transport region may comprise an electron injection layer that facilitates injection of electrons from the second electrode 190. The electron injection layer may directly contact the second electrode 190.

The electron injection layer may have i) a single-layered structure including (e.g., consisting of) a single layer including (e.g., consisting of) a single material, ii) a single-layered structure including (e.g., consisting of) a single layer comprising a plurality of different materials, or iii) a multi-layered structure having a plurality of layers comprising a plurality of different materials.

The electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

In one or more embodiments, the electron injection layer may comprise Li, Na, K, Rb, Cs, Mg, Ca, erbium (Er), thulium (Tm), ytterbium (Yb) or a combination thereof. However, embodiments of the material comprised in the electron injection layer are not limited thereto.

The alkali metal may be selected from Li, Na, K, Rb, and Cs. In one embodiment, the alkali metal may be selected from Li, Na, and Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from scandium (Sc), yttrium (Y), cerium (Ce), ytterbium (Yb), gadolinium (Gd), and terbium (Tb).

The alkali metal compound, the alkaline earth metal compound, and the rare earth metal compound may be selected from oxides and halides (e.g., fluorides, chlorides, bromides, and/or iodines) of the alkali metal, the alkaline earth metal, and the rare earth metal, respectively.

The alkali metal compound may be selected from alkali metal oxides (such as Li₂O, Cs₂O, and/or K₂O) and alkali metal halides (such as LiF, NaF, CsF, KF, LiI, NaI, CsI, and/or KI). In one embodiment, the alkali metal compound may be selected from LiF, Li₂O, NaF, LiI, NaI, CsI, and KI, but embodiments of the present disclosure are not limited thereto.

The alkaline earth metal compound may be selected from alkaline earth metal compounds (such as BaO, SrO, CaO, BaₓSr₁₋ₓO (wherein 0<x<1), and/or BaₓCa₁₋ₓO (wherein o<x<i)). In one embodiment, the alkaline earth-metal compound may be selected from BaO, SrO, and CaO, but embodiments of the present disclosure are not limited thereto.

The rare-earth metal compound may be selected from YbF₃, ScF₃, ScO₃, Y₂O₃, Ce₂O₃, GdF₃, and TbF₃. In one embodiment, the rare-earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may comprise an alkali metal ion, an alkaline earth metal ion, and a rare earth metal ion, respectively, as described above, and each ligand coordinated with the metal ion of the alkali metal complex, the alkaline earth metal complex, and the rare earth metal complex may independently be selected from hydroxyquinoline, hydroxyisoquinoline, hydroxybenzoquinoline, hydroxyacridine, hydroxyphenanthridine, hydroxyphenyl oxazole, hydroxyphenyl thiazole, hydroxydiphenyl oxadiazole, hydroxydiphenyl thiadiazole, hydroxyphenyl pyridine, hydroxyphenyl benzimidazole, hydroxyphenyl benzothiazole, bipyridine, phenanthroline, and cyclopentadiene, but embodiments of the present disclosure are not limited thereto.

The electron injection layer may comprise (e.g., consist of) an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In one or more embodiments, the electron injection layer may further comprise an organic material. When the electron injection layer further comprises an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or the combination thereof may be homogeneously or non-homogeneously dispersed in a matrix comprising the organic material.

The thickness of the electron injection layer may be about 1 Å to about 100 Å, and in some embodiments, about 3 Å to about 90 Å. When the thickness of the electron injection layer is within these ranges, the electron injection layer may have satisfactory electron injection characteristics without a substantial increase in driving voltage.

In one embodiment, the electron transport region in the organic light-emitting device 10 may comprise a buffer layer, an electron transport layer, and an electron injection layer, and
at least one layer selected from the electron transport layer and the electron injection layer may comprise an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

### Second electrode 190

The second electrode 190 may be on the organic layer 150. The second electrode 190 may be a cathode which is an electron injection electrode, and in this regard, a material for forming the second electrode 190 may be selected from a metal, an alloy, an electrically conductive compound, and mixtures thereof, each having a relatively low work function.

The second electrode 190 may comprise at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layer structure, or a multi-layer structure comprising two or more layers.

### Description of FIGS. 2 to 6

An organic light-emitting device 20 represented by FIG. 2 comprises a first capping layer 210, a first electrode 110, an organic layer 150, and a second electrode 190 sequentially stacked in this stated order. An organic light-emitting device 30 represented by FIG. 3 comprises a first electrode 110, an organic layer 150, a second electrode 190, and a second capping layer 220 sequentially stacked in this stated order. An organic light-emitting device 40 represented by FIG. 4 comprises a first capping layer 210, a first electrode 110, an organic layer 150, a second electrode 190, and a second capping layer 220 sequentially stacked in this stated order.

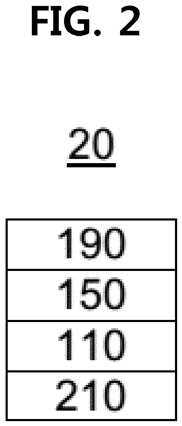

Regarding FIGS. 2 to 4, the first electrode 110, the organic layer 150, and the second electrode 190 may each independently be the same as described herein in connection with FIG. 1.

In the organic layer 150 of each of the organic light-emitting devices 20 and 40, light generated in an emission layer may pass through the first electrode 110 (which is a semi-transmissive electrode or a transmissive electrode) and the first capping layer 210 toward the outside, and in the organic layer 150 of each of the organic light-emitting devices 30 and 40, light generated in an emission layer may pass through the second electrode 190 (which is a semi-transmissive electrode or a transmissive electrode) and the second capping layer 220 toward the outside.

The first capping layer 210 and the second capping layer 220 may increase the external luminescent efficiency of the device according to the principle of constructive interference.

The first capping layer 210 and the second capping layer 220 may each independently be a capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from carbocyclic compounds, heterocyclic compounds, amine-based compounds, porphyrin derivatives, phthalocyanine derivatives, naphthalocyanine derivatives, alkali metal-based complexes, and alkaline earth metal-based complexes. The carbocyclic compound, the heterocyclic compound, and the amine-based compound may be optionally substituted with a substituent containing at least one element selected from O, N, S, selenium (Se), silicon (Si), fluorine (F), chlorine (Cl), bromine (Br), and iodine (I). In one embodiment, at least one selected from the first capping layer 210 and the second capping layer 220 may comprise an amine-based compound.

In one embodiment, at least one selected from the first capping layer 210 and the second capping layer 220 may comprise the compound represented by Formula 201 and/or the compound represented by Formula 202.

In one or more embodiments, at least one selected from the first capping layer 210 and the second capping layer 220 may comprise a compound selected from Compounds HT28 to HT33 and Compounds CP1 to CP5, but embodiments of the present disclosure are not limited thereto:

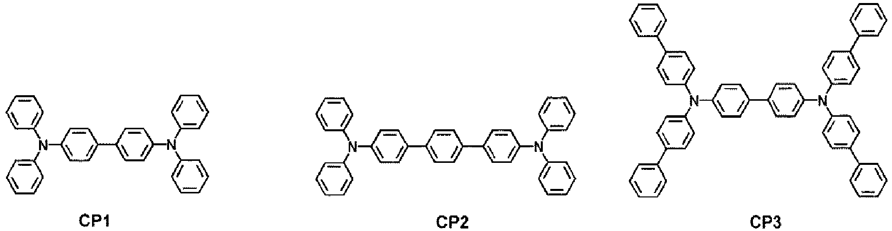

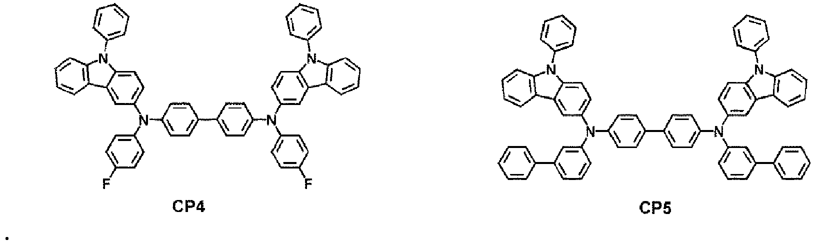

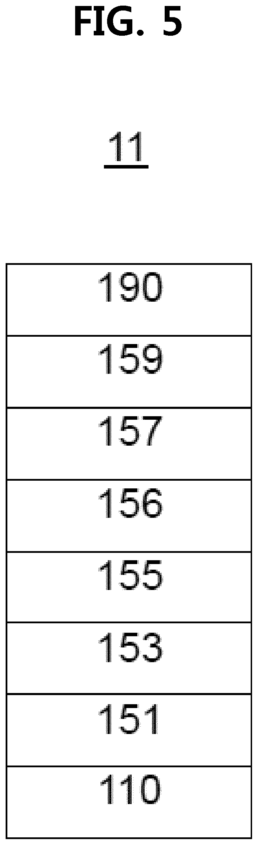

FIG. 5 is a schematic view of an organic light-emitting device 11 according to an embodiment of the present disclosure. The organic light-emitting device 11 may comprise a first electrode 110, a hole injection layer 151, a hole transport layer 153, an emission layer 155, a buffer layer 156, an electron transport layer 157, an electron injection layer 159, and a second electrode 190, which are sequentially stacked in this stated order.

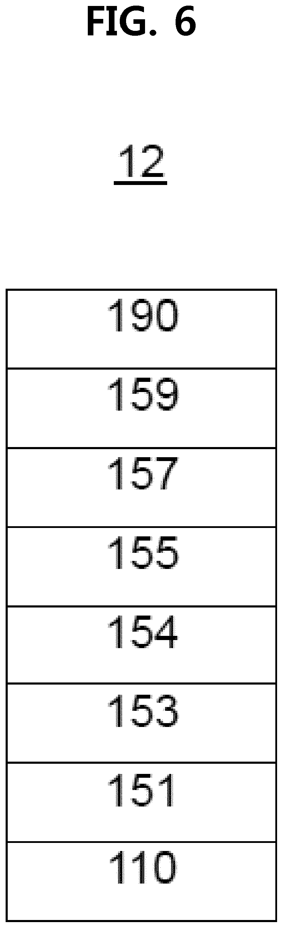

FIG. 6 is a schematic view of an organic light-emitting device 12 according to another embodiment of the present disclosure. The organic light-emitting device 12 may comprise a first electrode 110, a hole injection layer 151, a hole transport layer 153, an emission auxiliary layer 154, an emission layer 155, an electron transport layer 157, an electron injection layer 159, and a second electrode 190, which are sequentially stacked in this stated order.

The layers constituting the organic light-emitting devices 11 and 12 of FIGS. 5 and 6 may each independently be the same as described above.

Hereinbefore, the organic light-emitting device according to an embodiment of the present disclosure has been described in connection with FIGS. 1 to 6. However, embodiments of the present disclosure are not limited thereto.

The layers constituting the hole transport region, the emission layer, and the layers constituting the electron transport region may be formed in a specific region using one or more suitable methods selected from vacuum deposition, spin coating, casting, Langmuir-Blodgett (LB) deposition, ink-jet printing, laser-printing, and laser-induced thermal imaging (LITI).

When the layers constituting the hole transport region, the emission layer, and the layers constituting the electron transport region are each formed by vacuum deposition, the vacuum deposition may be performed at a deposition temperature of about 100 to about 500°(, at a vacuum degree of about 10⁻⁸ to about 10⁻³ torr, and at a deposition rate of about 0.01 to about 100 Å/sec, depending on the compound to be comprised in each layer, and the structure of each layer to be formed.

When the layers constituting the hole transport region, the emission layer, and the layers constituting the electron transport region are each formed by spin coating, the spin coating may be performed at a coating speed of about 2,000 rpm to about 5,000 rpm and at a heat treatment temperature of about 80°C to 200°C, depending on the compound to be comprised in each layer, and the structure of each layer to be formed.

### General definition of substituents

The term "C₁-C₆₀ alkyl group", as used herein, refers to a linear or branched aliphatic saturated hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. N on-limiting examples thereof may include a methyl group, an ethyl group, a propyl group, an isobutyl group, a see-butyl group, a tert-butyl group, a pentyl group, an iso-amyl group, and a hexyl group. The term "C₁-C₆₀ alkylene group", as used herein, refers to a divalent group having the same structure as the C₁-C₆₀ alkyl group.

The term "C₂-C₆₀ alkenyl group", as used herein, refers to a hydrocarbon group having at least one carbon-carbon double bond in the body (e.g., middle) or at the terminus of the C₂-C₆₀ alkyl group, and non-limiting examples thereof may include an ethenyl group, a propenyl group, and a butenyl group. The term "C₂-C₆₀ alkenylene group", as used herein, refers to a divalent group having substantially the same structure as the C₂-C₆₀ alkenyl group.

The term "C₂-C₆₀ alkynyl group", as used herein, refers to a hydrocarbon group having at least one carbon-carbon triple bond in the body (e.g., middle) or at the terminus of the C₂-C₆₀ alkyl group, and non-limiting examples thereof may include an ethynyl group and a propynyl group. The term "C₂-C₆₀ alkynylene group", as used herein, refers to a divalent group having substantially the same structure as the C₂-C₆₀ alkynyl group.

The term "C₁-C₆₀ alkoxy group", as used herein, refers to a monovalent group represented by -O-A₁₀₁ (wherein A₁₀₁ is a C₁-C₆₀ alkyl group), and non-limiting examples thereof may include a methoxy group, an ethoxy group, and an isopropyloxy group.

The term "C₃-C₁₀ cycloalkyl group", as used herein, refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, and a cycloheptyl group. The term "C₃-C₁₀ cycloalkylene group", as used herein, refers to a divalent group having substantially the same structure as the C₃-C₁₀ cycloalkyl group.

The term "C₁-C₁₀ heterocycloalkyl group", as used herein, refers to a monovalent monocyclic group having at least one heteroatom (e.g. 1, 2, 3, 4 or 5 hereoatoms) selected from N, O, Si, P, and S as a ring-forming atom and 1 to 10 carbon atomse.g. 1, 2, 3, 4 or 5 ring carbon atoms. Non-limiting examples thereof may include a 1,2,3,4-oxatriazolidinyl group, a tetrahydrofuranyl group, and a tetrahydrothiophenyl group. The term "C₁-C₁₀ heterocycloalkylene group", as used herein, refers to a divalent group having substantially the same structure as the C₁-C₁₀ heterocycloalkyl group.

The term "C₃-C₁₀ cycloalkenyl group", as used herein, refers to a monovalent monocyclic group that has 3 to 10 carbon atoms and at least one carbon-carbon double bond in the ring thereof and does not have aromaticity, and non-limiting examples thereof may include a cyclopentenyl group, a cyclohexenyl group, and a cycloheptenyl group. The term "C₃-C₁₀ cycloalkenylene group", as used herein, refers to a divalent group having substantially the same structure as the C₃-C₁₀ cycloalkenyl group.

The term "C₁-C₁₀ heterocycloalkenyl group", as used herein, refers to a monovalent monocyclic group that has at least one heteroatom (e.g. 1, 2, 3, 4 or 5 hereoatoms) selected from N, O, Si, P, and S as a ring-forming atom, 1 to 10 carbon atoms, and at least one double bond in its ring. Non-limiting examples of the C₁-C₁₀ heterocycloalkenyl group may include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group", as used herein, refers to a divalent group having substantially the same structure as the C₁-C₁₀ heterocycloalkenyl group.

The term "C₆-C₆₀ aryl group", as used herein, refers to an aromatic monovalent group having 6 to 60 carbon atoms e.g. 6 to 20 ring carbon atoms, 6 to 14 ring cabon atoms or 6 to 10 ring carbon atoms. The term "C₆-C₆₀ arylene group", as used herein, refers to an aromatic divalent group having 6 to 60 carbon atoms e.g. 6 to 20 ring carbon atoms, 6 to 14 ring cabon atoms or 6 to 10 ring carbon atoms. Non-limiting examples of the C₆-C₆₀ aryl group may include a phenyl group, a naphthyl group, an anthracenyl group, a phenanthrenyl group, a pyrenyl group, and a chrysenyl group. When the C₆-C₆₀ aryl group and the C₆-C₆₀ arylene group each comprise two or more rings, the rings may be fused (e.g., coupled).

The term "C₁-C₆₀ heteroaryl group", as used herein, refers to a monovalent group having an heterocyclic aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. The term "C₁-C₆₀ heteroarylene group", as used herein, refers to a divalent group having an heterocyclic aromatic system that has at least one heteroatom (e.g. 1, 2, 3, 4 or 5 hereoatoms) selected from N, O, Si, P, and S as a ring-forming atom, and 1 to 60 carbon atoms e.g. 1 to 19 ring carbon atoms, 1 to 13 ring cabon atoms or 1 to 9 ring carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each comprise two or more rings, the rings may be fused (e.g., coupled).

The term "C₆-C₆₀ aryloxy group", as used herein, refers to -O-A₁₀₂ (wherein A₁₀₂ is a C₆-C₆₀ aryl group), and the term "C₆-C₆₀ arylthio group", as used herein, indicates-S-A₁₀₃ (wherein A₁₀₃ is a C₆-C₆₀ aryl group).

The term "monovalent non-aromatic condensed polycyclic group", as used herein, refers to a monovalent group that has two or more rings condensed with each other, 8 to 60 carbon atoms (e.g., 8 to 20, 8 to 14 or 8 to 10 ring carbon atoms) as the only ring forming atoms, and non-aromaticity in the entire molecular structure. Non-limiting examples of a monovalent non-aromatic condensed polycyclic group include a fluorenyl group and a spiro-bifluorenyl group. The term "divalent non-aromatic condensed polycyclic group", as used herein, refers to a divalent group having substantially the same structure as the monovalent non-aromatic condensed polycyclic group.

The term "monovalent non-aromatic condensed heteropolycyclic group", as used herein, refers to a monovalent group having 8- to 60- ring-forming atoms, two or more rings condensed to each other, at least one heteroatom (e.g. 1, 2, 3, 4 or 5 hereoatoms) selected from N, O, Si, P, and S, other than carbon atoms (for example, 1 to 59, 2 to 59, 2 to 19, 2 to 13 or 2 to 9 ring carbon atoms), as a ring forming atom, and has non-aromaticity in the entire molecular structure. A non-limiting example of a monovalent non-aromatic condensed heteropolycyclic group may be a carbazolyl group. The term "divalent non-aromatic condensed heteropolycyclic group", as used herein, refers to a divalent group having substantially the same structure as the monovalent non-aromatic condensed heteropolycyclic group.

The term "C₅-C₆₀ carbocyclic group", as used herein, refers to a monocyclic or polycyclic group having 5 to 60 carbon atoms, e.g. 5 to 20 ring carbon atoms, 5 to 14 ring cabon atoms or 5 to 10 ring carbon atoms, and only carbon atoms as ring-forming atoms. The C₅-C₆₀ carbocyclic group may be a saturated carbocyclic group or an unsaturated carbocyclic group. The term "C₅-C₆₀ carbocyclic group", as used herein, refers to an aromatic carbocyclic group or a non-aromatic carbocyclic group. The term "C₅-C₆₀ carbocyclic group", as used herein, refers to a ring (such as a benzene group), a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group.

The term "C₁-C₆₀ heterocyclic group", as used herein, refers to a group having substantially the same structure as the C₁-C₆₀ carbocyclic group, except that as a ring-forming atom, at least one heteroatom selected from N, O, Si, P, Sand Se is used in addition to 1 to 60 ring carbon atoms (e.g., 1 to 20 ring carbon atoms, 1 to 14 ring cabon atoms or 1 to 10 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br,-I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁),-S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁),-S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed polycyclic group, and a monovalent non-aromatic condensed heteropolycyclic group.

The term "Ph" as used herein represents a phenyl group, the term "Me" as used herein represents a methyl group, the term "Et" as used herein represents an ethyl group, the term "ter-Bu" or "Bu^{t}" as used herein represents a tert-butyl group, and the term "OMe" as used herein represents a methoxy group.

The term "biphenyl group", as used herein, represents "a phenyl group substituted with a phenyl group". In other words, a "biphenyl group" is a substituted phenyl group having a C₆-C₆₀ aryl group as a substituent.

The term "terphenyl group", as used herein, refers to "a phenyl group substituted with a biphenyl group". In other words, a "terphenyl group" is a substituted phenyl group having a C₆-C₆₀ aryl group substituted with a C₆-C₆₀ aryl group as a substituent.

The symbols * and *' used herein, unless defined otherwise, each independently refer to a binding site to a neighboring atom in a corresponding formula.

Hereinafter, a compound according to an embodiment of the present disclosure and an organic light-emitting device according to an embodiment of the present disclosure will be described in more detail with reference to Synthesis Examples and Examples. The wording "B was used instead of A" used in describing the Synthesis Examples refers to that an identical number of molar equivalents of B was used in place of A.

### Example

### Example 1-1 Red phosphorescence

As a substrate and an anode, a Corning 15 Ohms per square centimeter (Ω/cm²) (120 nanometers (nm)) ITO glass substrate was cut to a size of 50 millimeters (mm) × 50 mm × 0.5mm, sonicated using acetone, isopropyl alcohol, and deionized water for 15 minutes each, and cleaned by exposure to ultraviolet rays with ozone. Then, the glass substrate was mounted on a vacuum deposition device.

m-MTDATA was vacuum-deposited on the ITO anode to form a hole injection layer having a thickness of about 70 nm. Compound 1-3A was then vacuum-deposited on the hole injection layer to form a hole transport layer having a thickness of about 10 nm.

CBP (as a host) and Compound PD11 (as a dopant) were co-deposited on the hole transport layer (wherein the content of the dopant was about 2 wt%) to form an emission layer having a thickness of about 30 nm.

Compound 2-2 was vacuum deposited on the emission layer to form a buffer layer having a thickness of 10 nm, Alq₃ was vacuum-deposited on the buffer layer to form an electron transport layer having a thickness of 20 nm, LiF was deposited on the electron transport layer to form an electron injection layer having a thickness of 1 nm, and Al was vacuum-deposited on the electron injection layer to form a second electrode (cathode) having a thickness of 200 nm, thereby completing the manufacture of an organic light-emitting device.

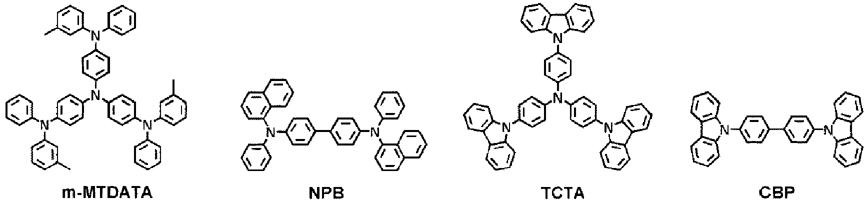

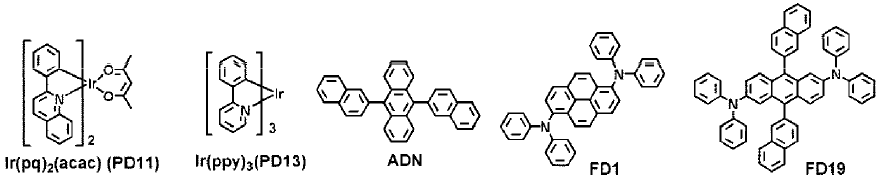

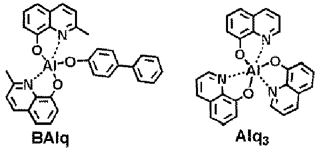

### Examples 1-2 to 1-5 and Comparative Examples 1-1 to 1-3 Red phosphorescence (Example 1-2 does not form part of the claimed invention)

Additional organic light-emitting devices of Examples 1-2 to 1-5 and Comparative Examples 1-1 to 1-3 were manufactured in substantially the same manner as in Example 1-1, except that the materials shown in Table 5 were used as the hole transport layer materials and buffer layer materials.

### Evaluation Example 1 Red phosphorescence

The driving voltage (V) and efficiency (cd/A) at 5 mA/cm² of each of the organic light-emitting devices of Examples 1-1 to 1-5 and Comparative Examples 1-1 to 1-3 were measured using a Keithley SMU 236 and a PR650 luminance meter. The results thereof are shown in Table 5.

**Table 5**

| | Hole transport layer | Buffer layer | Electron transport layer | Driving voltage (V) | Efficiency (cd/A) |
|---|---|---|---|---|---|
| Example 1-1 | 1-3A | 2-2 | Alq₃ | 5.3 | 23.7 |
| Example 1-2 | 1-84A | 2-19 | Alq₃ | 5.4 | 22.3 |
| Example 1-3 | 1-1B | 2-49 | Alq₃ | 5.3 | 23.0 |
| Example 1-4 | 1-10B | 2-117 | Alq₃ | 5.6 | 22.4 |
| Example 1-5 | 1-44B | 2-74 | Alq₃ | 5.5 | 22.6 |
| Comparative Example 1-1 | TCTA | **2-2** | Alq₃ | 5.9 | 22.9 |
| Comparative Example 1-2 | 1-3A | BAlq | Alq₃ | 6.0 | 22.3 |
| Comparative Example 1-3 | TCTA | BAlq | Alq₃ | 6.2 | 21.6 |

Referring to Table 5, the organic light-emitting devices of Examples 1-1 to 1-5 were each found to have low driving voltage and high efficiency, as compared with each of the organic light-emitting devices of Comparative Examples 1-1 to 1-3.

### Example 2-1 Green phosphorescence

An organic light-emitting device was manufactured in substantially the same manner as in Example 1-1, except that Compound PD13 (wherein the content of the dopant was about 10 wt%) was used as a dopant in the formation of the emission layer.

### Examples 2-2 to 2-5 and Comparative Examples 2-1 to 2-3 Green phosphorescence (Example 2-2 does not form part of the claimed invention)

Additional organic light-emitting devices of Examples 2-2 to 2-5 and Comparative Examples 2-1 to 2-3 were manufactured in substantially the same manner as in Example 2-1, except that the materials shown in Table 6 were used for hole transport layer materials and buffer layer materials.

### Evaluation Example 2 Green phosphorescence

The driving voltage (V) and efficiency (cd/A) at 5 mA/cm² of each of the organic light-emitting devices of Examples 2-1 to 2-5 and Comparative Examples 2-1 to 2-3 were measured using a Keithley SMU 236 and a PR650 luminance meter. The results thereof are shown in Table 6.

**Table 6**

| | Hole transport layer | Buffer layer | Electron transport layer | Driving voltage (V) | Efficiency (cd/A) |
|---|---|---|---|---|---|
| Example 2-1 | 1-3A | 2-2 | Alq₃ | 5.4 | 42.4 |
| Example 2-2 | 1-84A | 2-19 | Alq₃ | 5.6 | 42.7 |
| Example 2-3 | 1-1B | 2-49 | Alq₃ | 5.6 | 41.0 |
| Example 2-4 | 1-10B | 2-117 | Alq₃ | 5.5 | 41.6 |
| Example 2-5 | 1-44B | 2-174 | Alq₃ | 5.5 | 41.1 |
| Comparative Example 2-1 | TCTA | **2-2** | Alq₃ | 5.9 | 38.2 |
| Comparative Example 2-2 | 1-3A | BAlq | Alq₃ | 5.9 | 37.5 |
| Comparative Example 2-3 | TCTA | BAlq | Alq₃ | 6.2 | 21.6 |

Referring to Table 6, the organic light-emitting devices of Examples 2-1 to 2-5 were each found to have low driving voltage and high efficiency, as compared with each of the organic light-emitting devices of Comparative Examples 2-1 to 2-3.

### Example 2-6 Green fluorescence

An organic light-emitting device was manufactured in substantially the same manner as in Example 1-1, except that ADN was used as a host, and Compound FD19 (wherein the content of the dopant was about 5 wt%) was used as a dopant in the formation of the emission layer.

### Examples 2-7 and 2-8 and Comparative Examples 2-4 to 2-6 Green fluorescence

Additional organic light-emitting devices of Examples 2-7 and 2-8 and Comparative Examples 2-4 to 2-6 were manufactured in substantially the same manner as in Example 2-6, except that the materials shown in Table 7 were used as hole transport layer materials and buffer layer materials.

### Evaluation Example 3 Green fluorescence

The driving voltage (V) and efficiency (cd/A) at 10 mA/cm² of each of the organic light-emitting devices of Examples 2-6 to 2-8 and Comparative Examples 2-4 to 2-6 were measured using a Keithley SMU 236 and a PR650 luminance meter. The results thereof are shown in Table 7.

**Table 7**

| | Hole transport layer | Buffer layer | Electron transport layer | Driving voltage (V) | Efficiency (cd/A) |
|---|---|---|---|---|---|
| Example 2-6 | 1-3A | 2-2 | Alq₃ | 4.6 | 20.7 |
| Example 2-7 | 1-84A | 2-49 | Alq₃ | 4.9 | 19.3 |
| Example 2-8 | 1-10B | 2-174 | Alq₃ | 5.0 | 19.6 |
| Comparative | NPB | **2-2** | Alq₃ | 4.9 | 19.9 |
| Example 2-4 | | | | | |
| Comparative Example 2-5 | 1-2A | Alq₃ | Alq₃ | 4.7 | 17.5 |
| Comparative Example 2-6 | NPB | Alq₃ | Alq₃ | 5.0 | 16.2 |

Referring to Table 7, the organic light-emitting devices of Examples 2-6 to 2-8 were each found to have low driving voltage and high efficiency, as compared with the organic light-emitting devices of Comparative Examples 2-4 to 2-6.

### Example 3-1 Blue fluorescence

An organic light-emitting device was manufactured in substantially the same manner as in Example 1-1, except that ADN was used as a host, and Compound FD1 (wherein the content of the dopant was about 5 wt%) was used as a dopant in the formation of the emission layer.

### Examples 3-2 to 3-5 and Comparative Examples 3-1 to 3-3 Blue fluorescence (Example 3-2 does not form part of the claimed invention)

Additional organic light-emitting devices of Examples 3-2 to 3-5 and Comparative Examples 3-1 to 3-3 were manufactured in substantially the same manner as in Example 3-1, except that the materials shown in Table 8 were used as hole transport layer materials and buffer layer materials.

### Evaluation Example 4 Blue fluorescence

The driving voltage (V) and efficiency (cd/A) at 10 mA/cm² of each of the organic light-emitting devices of Examples 3-1 to 3-5 and Comparative Examples 3-1 to 3-3 were measured using a Keithley SMU 236 and a PR650 luminance meter. The results thereof are shown in Table 8.

**Table 8**

| | Hole transport layer | Buffer layer | Electron transport layer | Driving voltage (V) | Efficiency (cd/A) |
|---|---|---|---|---|---|
| Example 3-1 | 1-3A | 2-2 | Alq₃ | 4.6 | 5.3 |
| Example 3-2 | 1-84A | 2-19 | Alq₃ | 4.7 | 4.8 |
| Example 3-3 | 1-1B | 2-49 | Alq₃ | 4.8 | 4.5 |
| Example 3-4 | 1-10B | 2-117 | Alq₃ | 4.6 | 4.4 |
| Example 3-5 | 1-44B | 2-174 | Alq₃ | 4.9 | 4.1 |
| Comparative Example 3-1 | NPB | 2-2 | Alq₃ | 5.1 | 4.5 |
| Comparative Example 3-2 | 1-2A | Alq₃ | Alq₃ | 4.6 | 4.8 |
| Comparative Example 3-3 | NPB | Alq₃ | Alq₃ | 4.9 | 4.4 |

Referring to Table 8, the organic light-emitting devices of Examples 3-1 to 3-5 were each found to have low driving voltage and high efficiency, as compared with the organic light-emitting devices of Comparative Examples 3-1 to 3-3.

As described above, an organic light-emitting device according to an embodiment of the present disclosure may have a low-driving voltage, improved efficiency, and long lifespan.

It should be understood that the embodiments described herein should be considered in a descriptive sense only and not for purposes of limitation. Descriptions of features or aspects within each embodiment should typically be considered as being available for other similar features or aspects in other embodiments.

As used herein, the terms "use", "using", and "used" may be considered synonymous with the terms "utilize", "utilizing", and "utilized", respectively. Further, the use of "may" when describing embodiments of the present disclosure refers to "one or more embodiments of the present disclosure".

As used herein, the terms "substantially", "about", and similar terms are used as terms of approximation and not as terms of degree, and are intended to account for the inherent deviations in measured or calculated values that would be recognized by those of ordinary skill in the art.

Also, any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

While one or more embodiments have been described with reference to the drawings, it will be understood by those of ordinary skill in the art that various changes in form and details may be made therein without departing from the scope of the present disclosure as defined by the following claims.

## Claims

1. An organic light-emitting device (10) comprising:
a first electrode (no);
a second electrode (190) facing the first electrode (no);
an emission layer between the first electrode (110) and the second electrode (190);
a hole transport region between the first electrode (110) and the emission layer; and
an electron transport region between the emission layer and the second electrode (190),
wherein the hole transport region comprises a first compound
and the electron transport region comprises a second compound,
the first compound is represented by Formula 1A or 1B, and
the second compound is represented by Formula 2A or 2B: 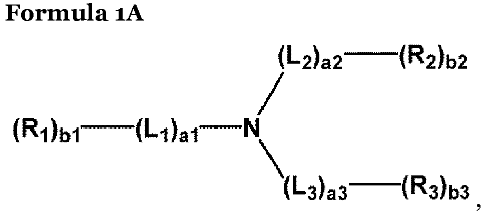 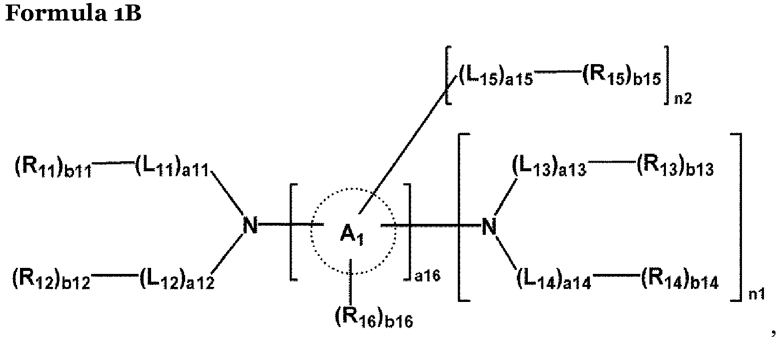 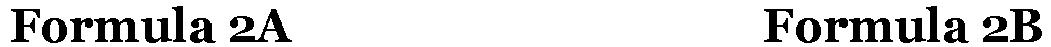 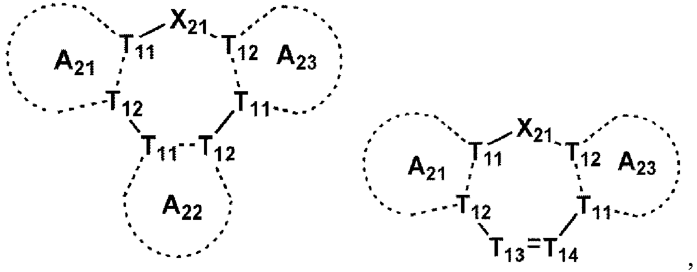
wherein, in Formulae 1A, 1B, 2A, and 2B,
rings A₂₁, A₂₂, and A₂₃ are each independently a C₅-C₃₀ carbocyclic group or a C₁-C₃₀ heterocyclic group, each substituted with at least one *-[(L₂₂)ₐ₂₂-(R₂₂)_{b22}], in which * is a bonding site to the A₂₁, A₂₂, or A₂₃ ring,
each T₁₁ is independently carbon or nitrogen,
each T₁₂ is independently carbon or nitrogen,
T₁₃ is N or C(R₂₇),
T₁₄ is N or C(R₂₈),
each bond between T₁₁ and T₁₂ represented as a dashed line in formulae 2A and 2B is a single bond or a double bond;
the six atoms represented by the three T₁₁(s) and the three T₁₂(s) in Formula 2A are not all nitrogen, and the six atoms represented by the two T₁₁(s), the two T₁₂(s), T₁₃, and T₁₄ in Formula 2B are not all nitrogen,
rings A₂₁, A₂₂, and A₂₃ are each condensed with the central 7-membered ring in Formulae 2A and 2B, such that they each share a T₁₁ and a T₁₂ with the central 7-membered ring,
X₂₁ is selected from S, Se, C(R₂₃)(R₂₄), Si(R₂₃)(R₂₄), and N-[(L₂₁)ₐ₂₁-(R₂₁)_{b21}],
L₁ to L₃, L₁₁ to L₁₅, L₂₁, and L₂₂ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
ring A₁ is a C₅-C₃₀ carbocyclic group or a C₁-C₃₀ heterocyclic group,
a1 to a3, an to a15, a21, and a22 are each independently an integer selected from 0 to 5,
a16 is an integer selected from 1 to 10, and when a16 is 2 or greater, a plurality of ring A₁(s) are bound to each other via one or more single bonds,
R₁ to R₃ and R₁₅ are each independently selected from a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group,
R₁₁ and R₁₂ are are each independently as defined for R₁, or when an and a12 are both 0, may optionally be bound to form a C₁-C₃₀ heterocyclic group together with the nitrogen atom to which they are attached,
R₁₃ and R₁₄ are are each independently as defined for R₁, or when a13 and a14 are both 0, may optionally be bound to form a C₁-C₃₀ heterocyclic group together with the nitrogen atom to which they are attached,
R₁₆, R₂₁ to R₂₄, R₂₇, and R₂₈ are each independently selected from hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂),
b1 to b3, b11 to b15, b21, and b22 are each independently an integer selected from 1 to 5, provided that each of b1 to b3, b11 to b15, b21, and b22 is 1 when each respective a1 to a3, an to a15, a21, a22 or a31 to a33 is zero
b16, is an integer selected from 0 to 5,
n1 is an integer selected from 1 to 4,
n2 is an integer selected from 0 to 4, and
the substituted C₃-C₁₀ cycloalkylene group, substituted C₁-C₁₀ heterocycloalkylene group, substituted C₃-C₁₀ cycloalkenylene group, substituted C₁-C₁₀ heterocycloalkenylene group, substituted C₆-C₆₀ arylene group, substituted C₁-C₆₀ heteroarylene group, substituted divalent non-aromatic condensed polycyclic group, substituted divalent non-aromatic condensed heteropolycyclic group, substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₁-C₆₀ heteroaryl group, substituted monovalent non-aromatic condensed polycyclic group, and substituted monovalent non-aromatic condensed heteropolycyclic group is each independently substituted with one or more substituents selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), -N(Q₁₁)(Q₁₂), -B(Q₁₁)(Q₁₂), -C(=O)(Q₁₁), - S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, a biphenyl group, and a terphenyl group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₁ to Q₃, Q₁₁ to Q₁₃, Q₂₁ to Q₂₃, and Q₃₁ to Q₃₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryl group substituted with a C₁-C₆₀ alkyl group, a C₆-C₆₀ aryl group substituted with a C₆-C₆₀ aryl group, a terphenyl group, a C₁-C₆₀ heteroaryl group, a C₁-C₆₀ heteroaryl group substituted with a C₁-C₆₀ alkyl group, a C₁-C₆₀ heteroaryl group substituted with a C₆-C₆₀ aryl group, a monovalent non-aromatic condensed polycyclic group, and a monovalent non-aromatic condensed heteropolycyclic group,
provided that the first compound is not: 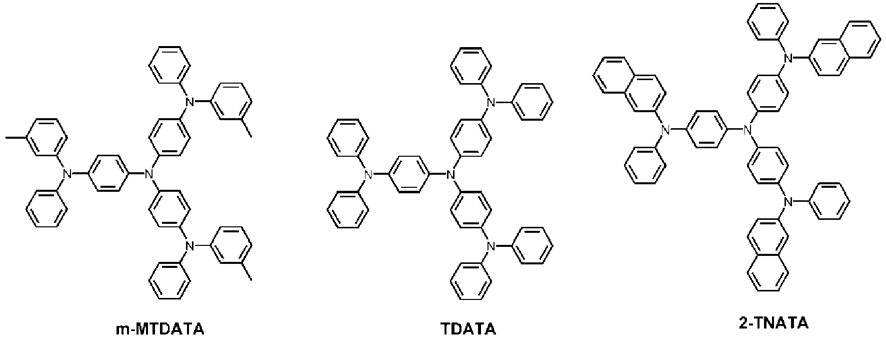 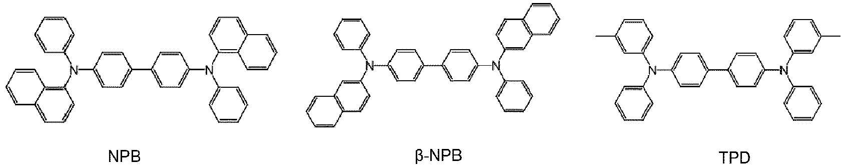 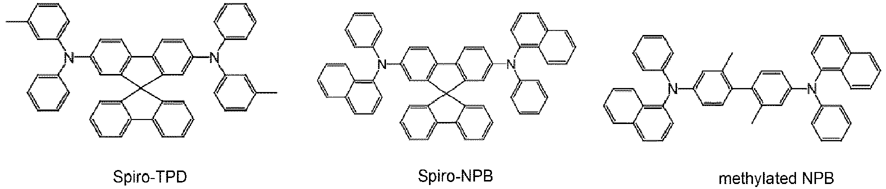 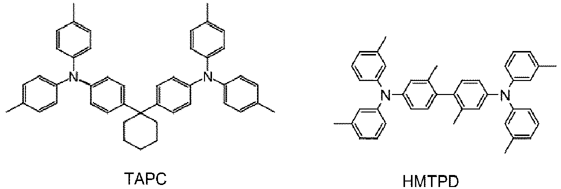 or 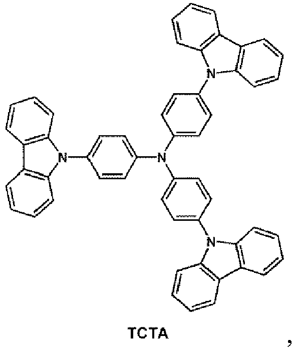
and provided that, in Formula 2A, when
i) ring A₂₂ is a benzofuran group, a benzothiophene group, a benzoselenophene group, an indene group, a benzosilole group, or an indole group, each substituted with at least one *-[(L₂₂)ₐ₂₂-(R₂₂)_{b22}],
ii) a 5-membered ring of the benzofuran group, the benzothiophene group, the benzoselenophene group, the indene group, the benzosilole group, and the indole group is condensed to the central 7-membered ring in Formula 2A, and
iii) all of T₁₁ and T₁₂ are carbon,
then rings A₂₁ and A₂₃ in Formula 2A are not simultaneously benzene groups.

2. The organic light-emitting device (10) of claim 1, wherein:
rings A₂₁, A₂₂, and A₂₃ in Formulae 2A and 2B are each independently selected from a benzene group, a naphthalene group, an anthracene group, an indene group, a fluorene group, a pyridine group, a pyrimidine group, a pyrazine group, a pyridazine group, a quinoline group, an isoquinoline group, a pyrrole group, a pyrazole group, an imidazole group, an oxazole group, a thiazole group, a cyclopentadiene group, a silole group, a selenophene group, a furan group, a thiophene group, an indole group, a benzimidazole group, a benzoxazole group, a benzothiazole group, an indene group, a benzosilole group, a benzoselenophene group, a benzofuran group, a benzothiophene group, a carbazole group, a fluorene group, a dibenzosilole group, a dibenzoselenophene group, a dibenzofuran group, a dibenzothiophene group, a pyrrolopyridine group, a cyclopentapyridine group, a silolopyridine group, a selenophenopyridine group, a furopyridine group, a thienopyridine group, a pyrrolopyrimidine group, a cyclopentapyrimidine group, a silolopyrimidine group, a selenophenopyrimidine group, a furopyrimidine group, a thienopyrimidine group, a pyrrolopyrazine group, a cyclopentapyrazine group, a silolopyrazine group, a selenophenopyrazine group, a furopyrazine group, a thienopyrazine group, a naphthopyrrole group, a cyclopentanaphthalene group, a naphthosilole group, a naphthoselenophene group, a naphthofuran group, a naphthothiophene group, a pyrroloquinoline group, a cyclopentaquinoline group, a siloloquinoline group, a selenophenoquinoline group, a furoquinoline group, a thienoquinoline group, an pyrroloisoquinoline group, an cyclopentaisoquinoline group, an siloloisoquinoline group, an selenophenoisoquinoline group, an furoisoquinoline group, an thienoisoquinoline group, an azacarbazole group, an azafluorene group, an azadibenzosilole group, an azadibenzoselenophene group, an azadibenzofuran group, an azadibenzothiophene group, an indenoquinoline group, an isoindenoquinoline group, an indenoquinoxaline group, a phenanthroline group, and an naphthoindole group, each substituted with at least one *-[(L₂₂)ₐ₂₂-(R₂₂)_{b22}].

3. The organic light-emitting device (10) of claim 1, wherein rings A₂₁, A₂₂, and A₂₃ in Formulae 2A and 2B are each independently selected from groups represented by Formulae 2-1 to 2-36, each substituted with at least one *-[(L₂₂)ₐ₂₂-(R₂₂)_{b22}], in which * is a bonding site to the A₂₁, A₂₂, or A₂₃ ring: 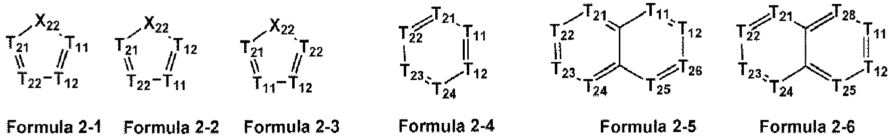 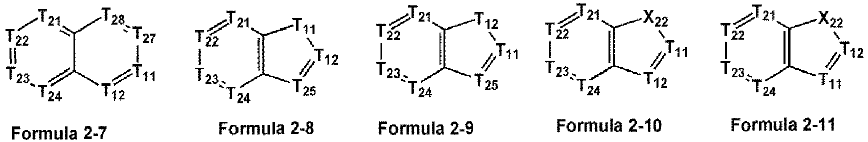 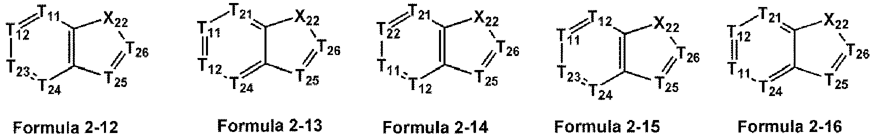 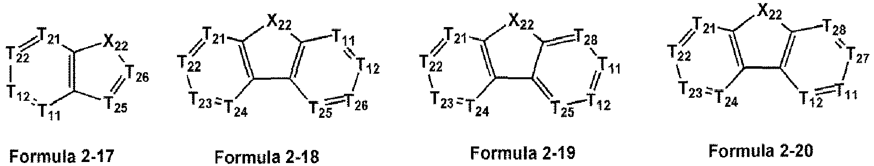 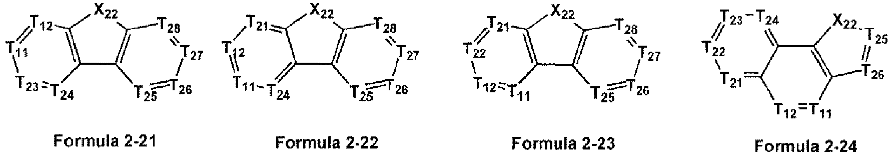 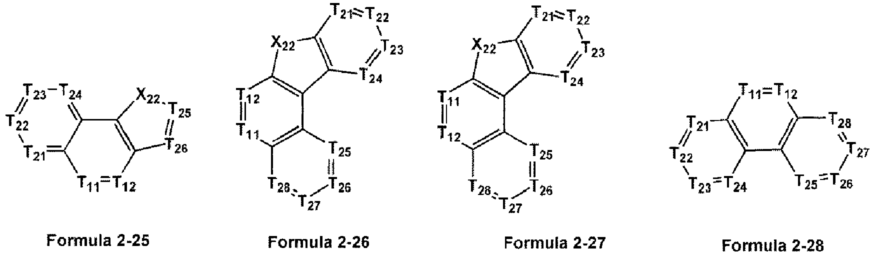 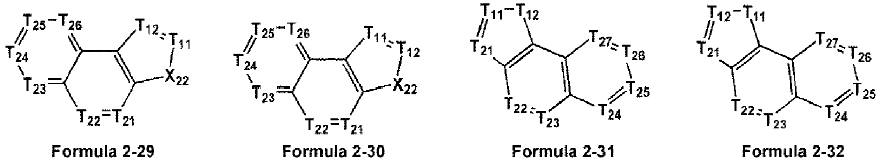 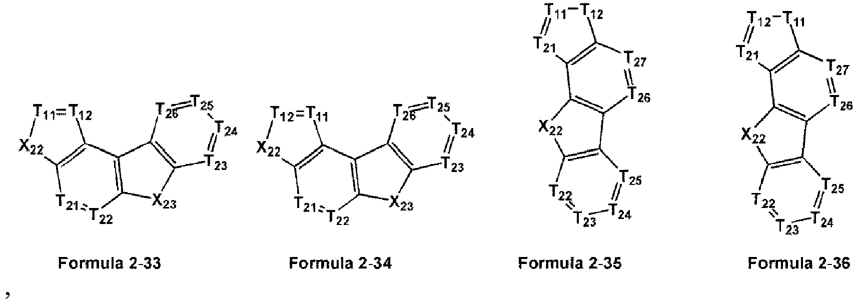
wherein, in Formulae 2-1 to 2-36,
T₁₁ and T₁₂ are each independently the same as described herein in connection with Formulae 2A and 2B,
X₂₂ and X₂₃ are each independently selected from O, S, Se, and a moiety comprising C, N, and/or Si, and
T₂₁ to T₂₈ are each independently N or a moiety comprising C.

4. The organic light-emitting device (10) of any one of the preceding claims, wherein X₂₁ in Formulae 2A and 2B is N[(L₂₁)ₐ₂₁-(R₂₁)_{b21}].

5. The organic light-emitting device (10) of claim 3, wherein:
X₂₁ in Formulae 2A and 2B is S, Se, C(R₂₃)(R₂₄), or Si(R₂₃)(R₂₄),
at least one selected from rings A₂₁, A₂₂, and A₂₃ in Formula 2A and at least one selected from rings A₂₁ and A₂₃ in Formula 2B are each independently selected from groups represented by Formulae 2-1 to 2-3, 2-10 to 2-27, and 2-33 to 2-36, and
at least one of X₂₂ and X₂₃ in Formulae 2-1 to 2-3, 2-10 to 2-27, and 2-33 to 2-36 is N-[(L₂₂)ₐ₂₂-(R₂₂)_{b22}].

6. The organic light-emitting device (10) of any one of the preceding claims, wherein L₁ to L₃, L₁₁ to L₁₅, and ring A₁ in Formulae 1A and 1B are each independently selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, a pyridinylene group, an indolylene group, an isoindolylene group, a purinylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, and a dibenzocarbazolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, a pyridinylene group, an indolylene group, an isoindolylene group, a purinylene group, a benzofuranylene group, a benzothiophenylene group, a benzosilolylene group, a dibenzofuranylene group, a dibenzothiophenylene group, a dibenzosilolylene group, a carbazolylene group, a benzocarbazolylene group, and a dibenzocarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), - N(Q₃₁)(Q₃₂), and -B(Q₃₁)(Q₃₂), and
L₂₁ and L₂₂ in Formulae 2A and 2B are each independently selected from the group consisting of:
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group; and
a phenylene group, a pentalenylene group, an indenylene group, a naphthylene group, an azulenylene group, an indacenylene group, an acenaphthylene group, a fluorenylene group, a spiro-bifluorenylene group, a spiro-benzofluorene-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a perylenylene group, a pentaphenylene group, a pyrrolylene group, a thiophenylene group, a furanylene group, a silolylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an indolylene group, an isoindolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, a benzofuranylene group, a benzothiophenylene group, a benzosilolylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosilolylene group, a carbazolylene group, a benzocarbazolylene group, a dibenzocarbazolylene group, a thiadiazolylene group, an imidazopyridinylene group, an imidazopyrimidinylene group, an oxazolopyridinylene group, a thiazolopyridinylene group, a benzonaphthyridinylene group, an azafluorenylene group, an azaspiro-bifluorenylene group, an azacarbazolylene group, an azadibenzofuranylene group, an azadibenzothiophenylene group, and an azadibenzosilolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=o)₂(Q₃₁), and -P(=O)(Q₃₁)(Q₃₂),
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

7. The organic light-emitting device (10) of any one of the preceding claims, wherein:
a16 in Formula 1B is 1, ring A₁ is a benzene group, and n2 is 1 or 2; or
a16 in Formula 1B is 3, 4, 5, or 6.

8. The organic light-emitting device (10) of any one of the preceding claims, wherein R₁ to R₃ and R₁₁ to R₁₅ in Formulae 1A and 1B are each independently selected from the group consisting of:
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, and a dibenzocarbazolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, and a dibenzocarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, a pyridinyl group, an indolyl group, an isoindolyl group, a purinyl group, a benzofuranyl group, a benzothiophenyl group, a benzosilolyl group, a dibenzofuranyl group, a dibenzothiophenyl group, a dibenzosilolyl group, a carbazolyl group, a benzocarbazolyl group, a dibenzocarbazolyl group, -Si(Q₃₁)(Q₃₂)(Q₃₃), - N(Q₃₁)(Q₃₂), and -B(Q₃₁)(Q₃₂), and
R₂₁ in Formulae 2A and 2B are each independently selected from the group consisting of:
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group; and
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a spiro-benzofluorene-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, and an azadibenzosilolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a biphenyl group, a terphenyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and
R₂₂ is selected from the groups defined for R₂₁, hydrogen, deuterium, -F, -Cl, - Br, -I, a hydroxyl group, a cyano group, a nitro group, an amidino group, a hydrazino group, a hydrazono group, a C₁-C₂₀ alkyl group, a C₁-C₂₀ alkoxy group, -Si(Q₁)(Q₂)(Q₃), - S(=O)₂(Q₁), and -P(=O)(Q₁)(Q₂),
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group.

9. The organic light-emitting device (10) of claim 1, wherein:
R₁ to R₃ and R₁₁ to R₁₅ in Formulae 1A and 1B are each independently selected from groups represented by Formulae 5-1 to 5-45,
R₂₁ in Formulae 2A and 2B is selected from groups represented by Formulae 5-1 to 5-45 and 6-1 to 6-124, and
R₂₂ in Formulae 2A and 2B is selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a group represented by any of Formulae 5-1 to 5-45 and 6-1 to 6-124, -Si(Q₁)(Q₂)(Q₃), -S(=O)₂(Q₁), and - P(=O)(Q₁)(Q₂): 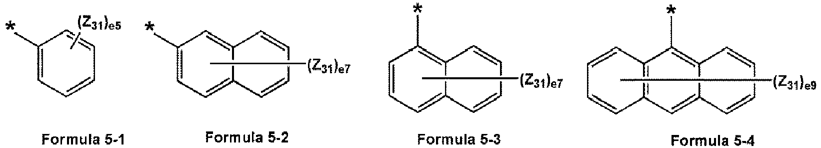 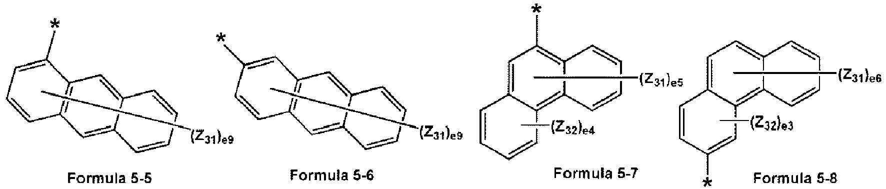 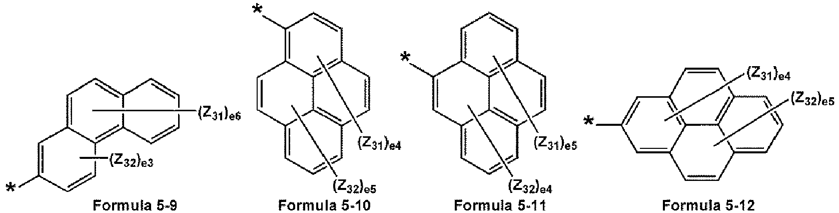 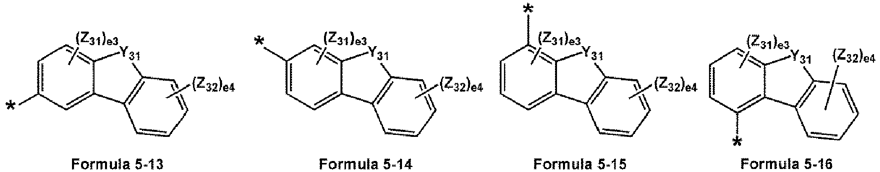 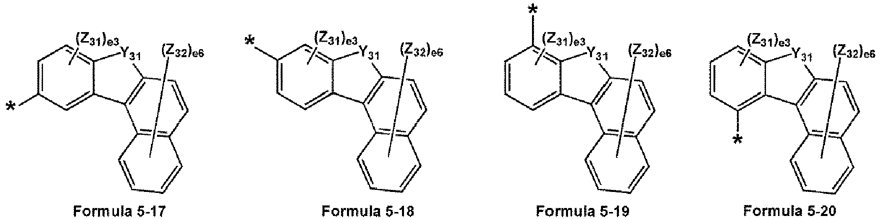 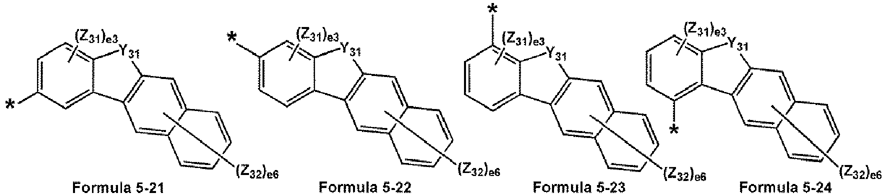 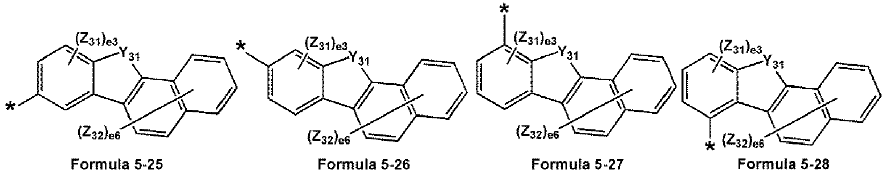 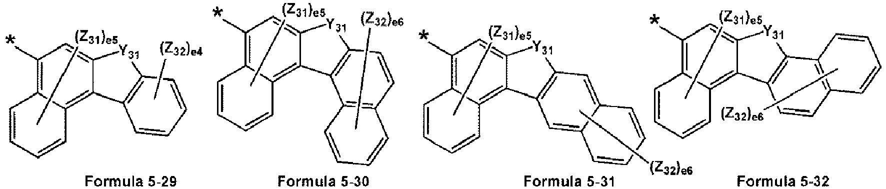 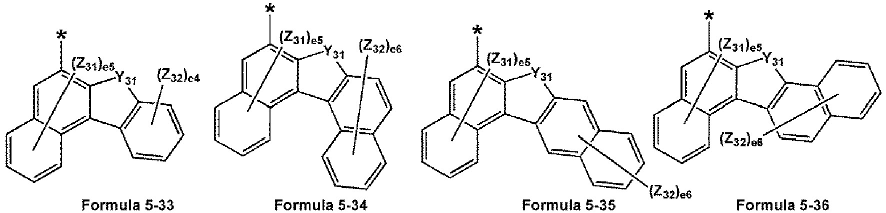 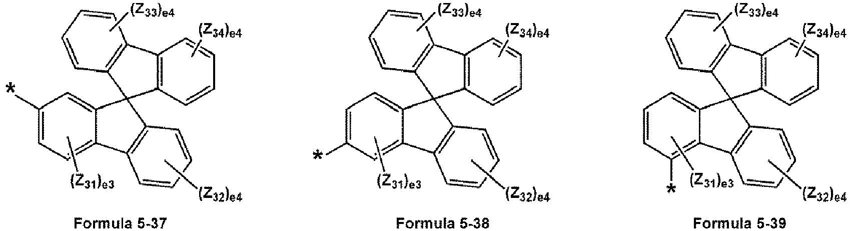 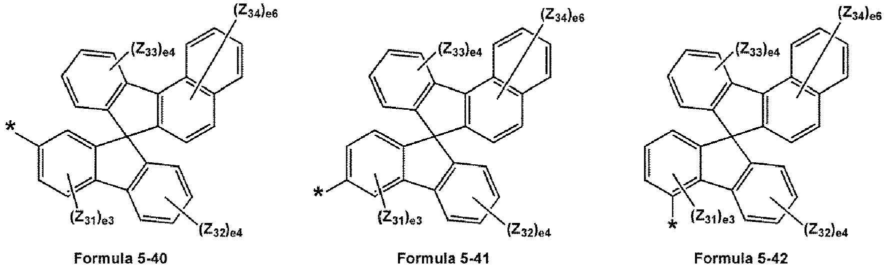 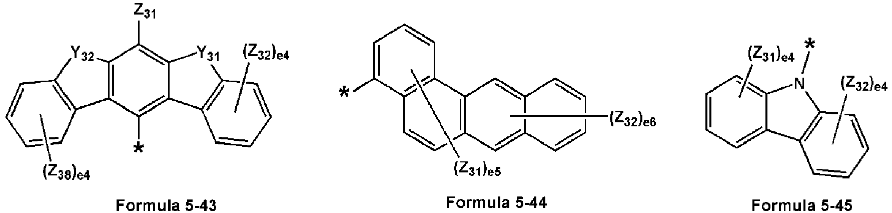 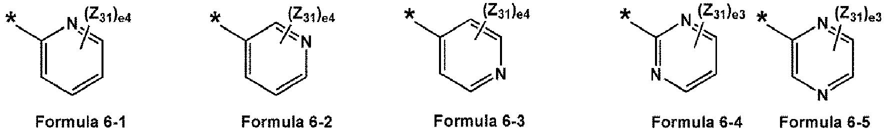 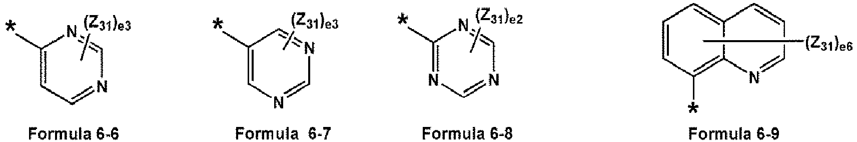 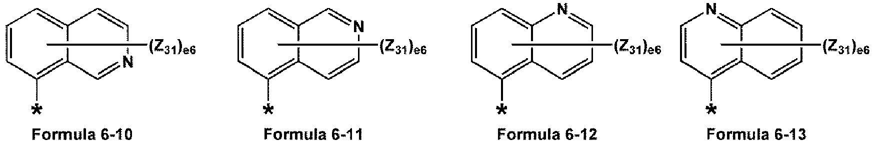 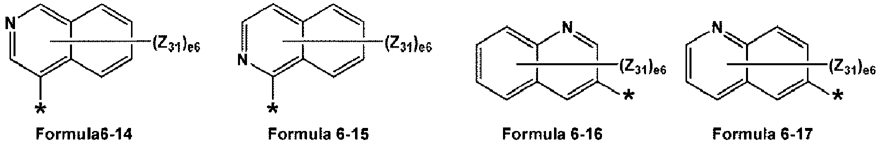 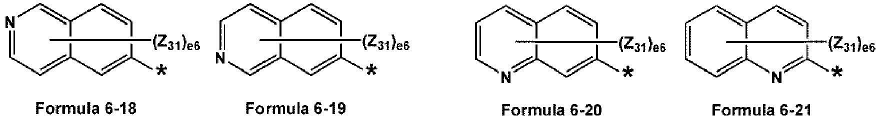 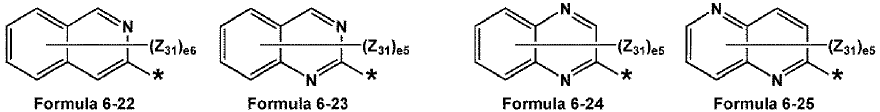 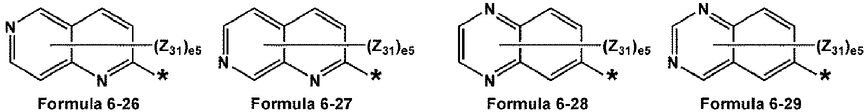 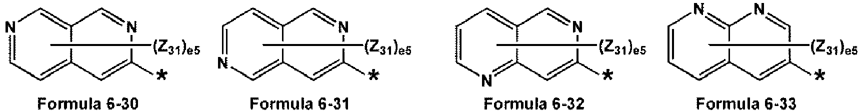 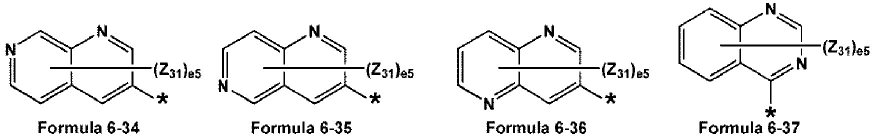 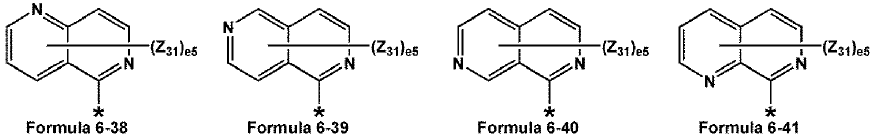 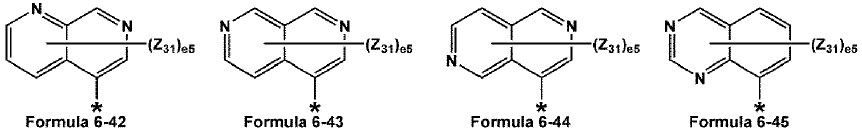 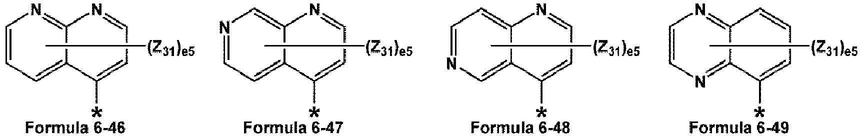 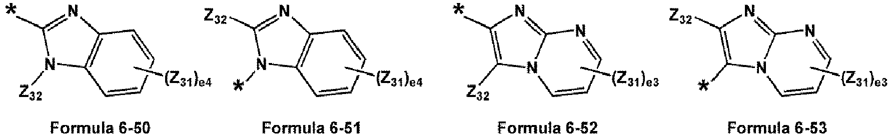 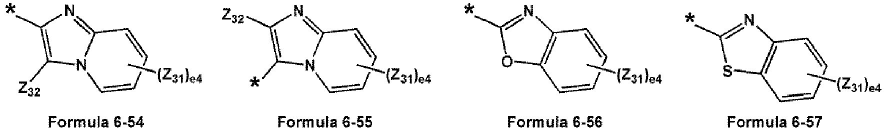 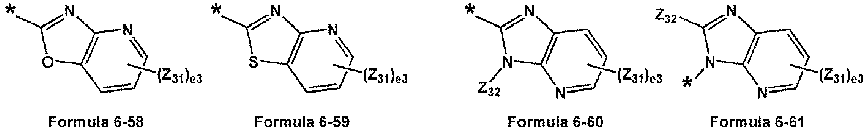 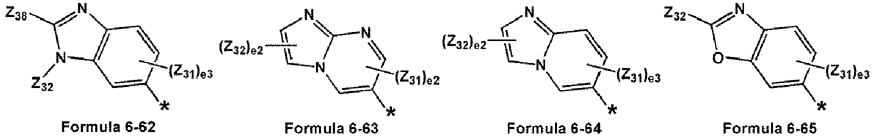 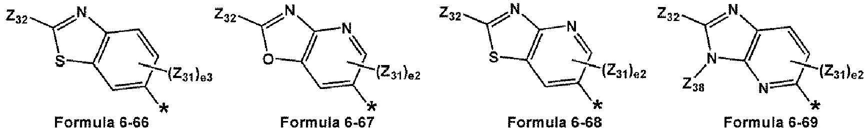 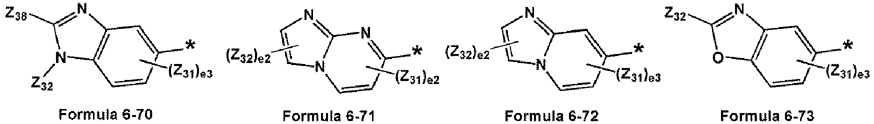 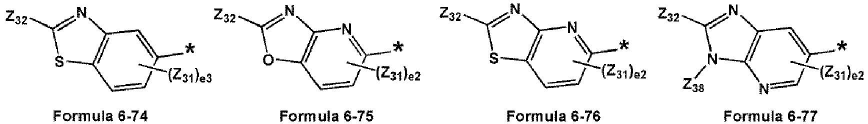 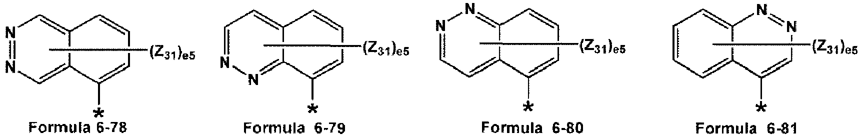 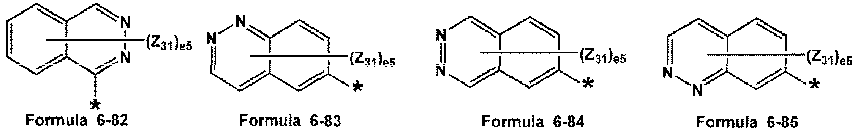 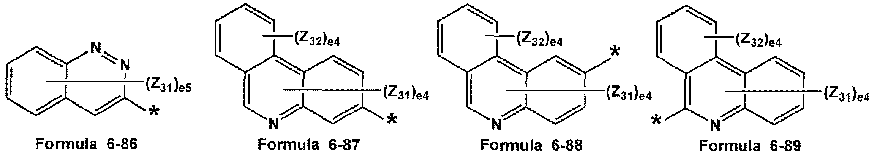 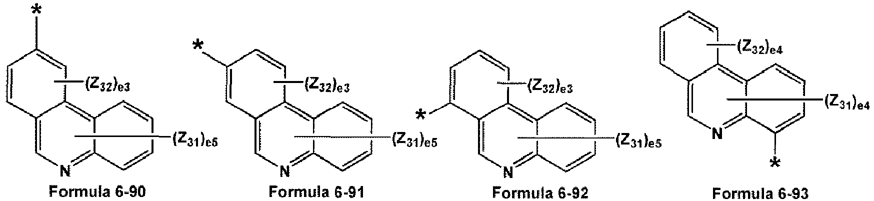 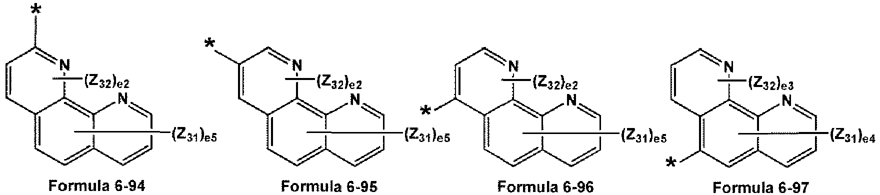 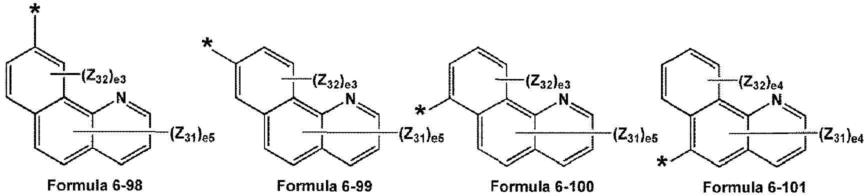 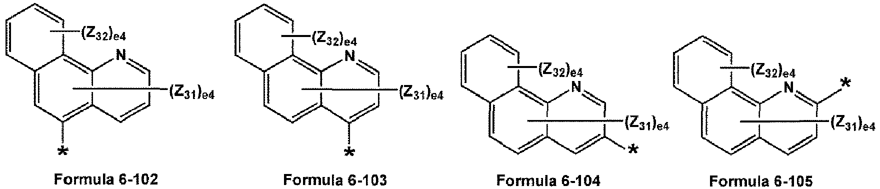 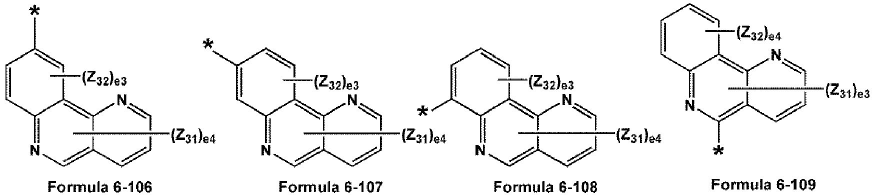 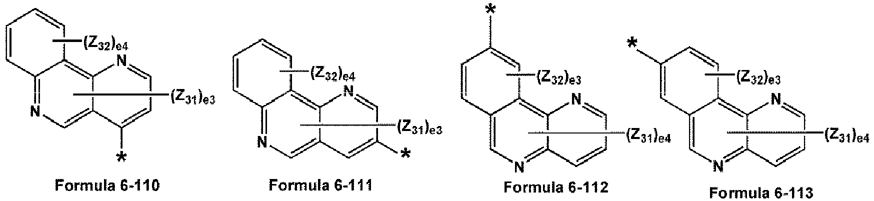 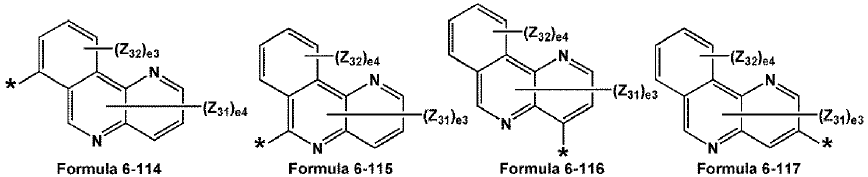 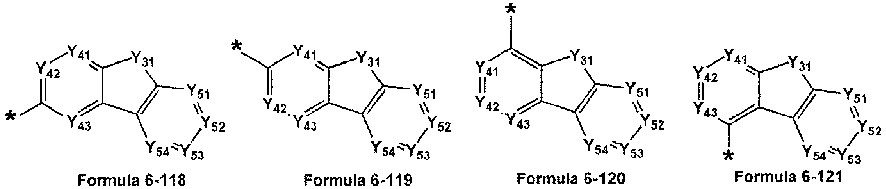 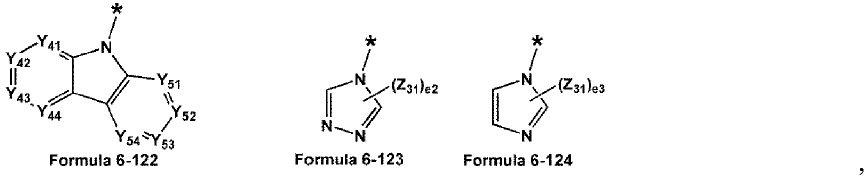
wherein, in Formulae 5-1 to 5-45 and 6-1 to 6-124,
Y₃₁ and Y₃₂ are each independently selected from O, S, C(Z₃₃)(Z₃₄), N(Z₃₅), and Si(Z₃₆)(Z₃₇),
Y₄₁ is N or C(Z₄₁, Y₄₂ is N or C(Z₄₂), Y₄₃ is N or C(Z₄₃), Y₄₄ is N or C(Z₄₄), Y₅₁ is N or C(Z₅₁), Y₅₂ is N or C(Z₅₂), Y₅₃ is N or C(Z₅₃), Y₅₄ is N or C(Z₅₄), at least one selected from Y₄₁ to Y₄₃ and Y₅₁ to Y₅₄ in Formulae 6-118 to 6-121 is N, and at least one selected from Y₄₁ to Y₄₄ and Y₅₁ to Y₅₄ in Formula 6-122 is N,
Z₃₁ to Z₃₈, Z₄₁ to Z₄₄, and Z₅₁ to Z₅₄ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a carbazolyl group, a benzocarbazolyl group, a dibenzocarbazolyl group, a thiadiazolyl group, an imidazopyridinyl group, an imidazopyrimidinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, and -Si(Q₃₁)(Q₃₂)(Q₃₃),
wherein Q₁ to Q₃ and Q₃₁ to Q₃₃ are each independently selected from the group consisting of:
a C₁-C₁₀ alkyl group, a C₁-C₁₀ alkoxy group, a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group; and
a phenyl group, a biphenyl group, a terphenyl group, a naphthyl group, a pyridinyl group, a pyrimidinyl group, a pyrazinyl group, a quinolinyl group, an isoquinolinyl group, a quinoxalinyl group, and a quinazolinyl group, each substituted with at least one selected from a C₁-C₁₀ alkyl group, a C₁-C₁₀ alkoxy group, and a phenyl group,
e2 is an integer selected from 0 to 2,
e3 is an integer selected from 0 to 3,
e4 is an integer selected from 0 to 4,
e5 is an integer selected from 0 to 5,
e6 is an integer selected from 0 to 6,
e7 is an integer selected from 0 to 7,
e9 is an integer selected from 0 to 9, and
* indicates a binding site to an adjacent atom.

10. The organic light-emitting device (10) of claim 9, wherein at least one selected from R₁ to R₃ in Formula 1A and at least one selected from R₁₁ to R₁₄ in Formula 1B are each independently represented by one selected from Formulae 5-13 to 5-42 and 5-45.

11. The organic light-emitting device (10) of claim 9, wherein:
R₁ in Formula 1A is represented by one selected from Formulae 5-13 to 5-36 and 5-45, provided that Y₃₁ in Formulae 5-13 to 5-36 is N(Z₃₅), and
R₂ in Formula 1A is represented by one selected from Formulae 5-13 to 5-42, provided that Y₃₁ in Formulae 5-13 to 5-36 is C(Z₃₃)(Z₃₄).

12. The organic light-emitting device (10) of any one of the preceding claims, wherein:
(a) the hole transport region comprises a hole injection layer and a hole transport layer, wherein the hole transport layer is between the hole injection layer and the emission layer, and the hole transport layer comprises the first compound; and/or
(b) the hole transport region comprises an emission auxiliary layer, the emission auxiliary layer directly contacts the emission layer, and the emission auxiliary layer comprises the second compound; and/or
(c) the electron transport region comprises a buffer layer, the buffer layer directly contacts the emission layer, and the buffer layer comprises the second compound; and/or
(d) the emission layer further comprises a fluorescent dopant or a phosphorescent dopant, wherein the fluorescent dopant comprises an arylamine compound or a styrylamine compound; and the phosphorescent dopant comprises an organometallic compound comprising iridium (Ir), platinum (Pt), palladium (Pd), osmium (Os), titanium (Ti), zirconium (Zr), hafnium (Hf), europium (Eu), terbium (Tb), rhodium (Rh), or thulium (Tm).

13. The organic light-emitting device (10) of any one of the preceding claims, wherein:
the electron transport region comprises a buffer layer, an electron transport layer, and an electron injection layer,
wherein at least one selected from the electron transport layer and the electron injection layer comprises an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof;
preferably wherein the electron injection layer comprises lithium (Li), sodium (Na), potassium (K), rubidium (Rb), cesium (Cs), magnesium (Mg), calcium (Ca), erbium (Er), thulium (Tm), ytterbium (Yb), or a combination thereof.

14. The organic light-emitting device (10) of any one of the preceding claims, wherein the hole transport region comprises a p-dopant selected from a quinone derivative, a metal oxide, and a cyano group-containing compound;
preferably wherein the p-dopant comprises a cyano group-containing compound.

15. The organic light-emitting device (10) of any one of the preceding claims, wherein the emission layer is a first-color-light emission layer,
the organic light-emitting device further comprises i) at least one second-color-light emission layer or ii) at least one second-color-light emission layer and at least one third-color-light emission layer, each between the first electrode (110) and the second electrode (190),
a maximum emission wavelength of the first-color-light emission layer, a maximum emission wavelength of the second-color-light emission layer, and a maximum emission wavelength of the third-color-light emission layer are identical to or different from each other, and
the organic light-emitting device emits a mixed light comprising a first-color-light and a second-color-light, or the organic light-emitting device emits a mixed light comprising the first-color-light, the second-color-light, and a third-color-light.

## Patentansprüche

1. Organische lichtemittierende Vorrichtung (10), umfassend:
eine erste Elektrode (110);
eine zweite Elektrode (190), die der ersten Elektrode (110) zugewandt ist;
eine Emissionsschicht zwischen der ersten Elektrode (110) und der zweiten Elektrode (190);
eine Lochtransportregion zwischen der ersten Elektrode (110) und der Emissionsschicht; und
eine Elektronentransportregion zwischen der Emissionsschicht und der zweiten Elektrode (190),
wobei die Lochtransportregion eine erste Verbindung umfasst
und die Elektronentransportregion eine zweite Verbindung umfasst,
die erste Verbindung durch Formel 1A oder 1B dargestellt ist und
die zweite Verbindung durch Formel 2A oder 2B dargestellt ist: 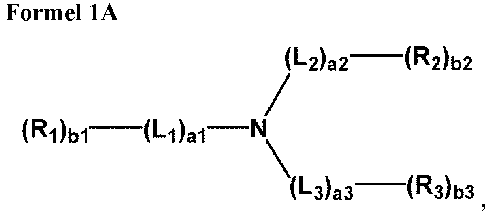 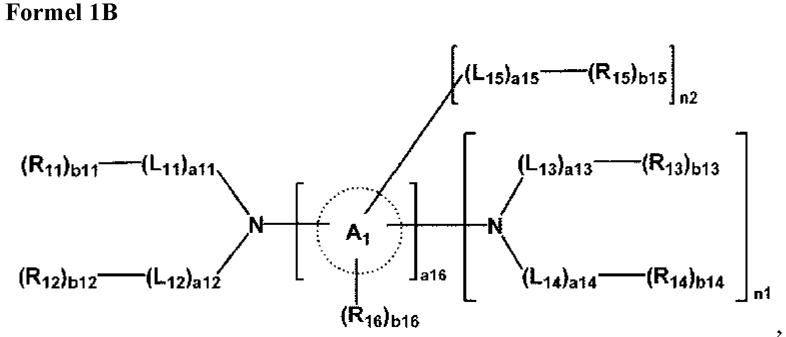 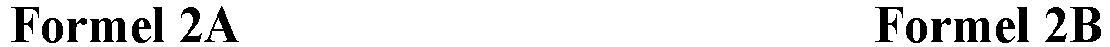 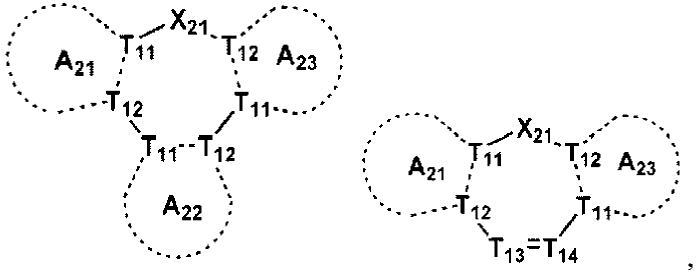
wobei in Formel 1A, 1B, 2A und 2B
die Ringe A₂₁, A₂₂ und A₂₃ jeweils unabhängig eine carbocyclische C₅-C₃₀-Gruppe oder eine heterocyclische C₁-C₃₀-Gruppe sind, jeweils substituiert mit mindestens einem *-[(L₂₂)ₐ₂₂-(R₂₂)_{b22}], in dem * eine Bindungsstelle an den A₂₁-, A₂₂- oder A₂₃-Ring ist,
jedes T₁₁ unabhängig Kohlenstoff oder Stickstoff ist,
jedes T₁₂ unabhängig Kohlenstoff oder Stickstoff ist,
T₁₃ N oder C(R₂₇) ist,
T₁₄ N oder C(R₂₈) ist,
jede Bindung zwischen T₁₁ und T₁₂, die in Formel 2A und 2B als gestrichelte Linie dargestellt ist, eine Einfachbindung oder eine Doppelbindung ist;
die sechs Atome, die durch die drei T₁₁(s) und die drei T₁₂(s) in Formel 2A dargestellt sind, nicht alle Stickstoff sind und die sechs Atome, die durch die zwei T₁₁(s), die zwei T₁₂(s), T₁₃ und T₁₄ in Formel 2B dargestellt sind, nicht alle Stickstoff sind,
die Ringe A₂₁, A₂₂ und A₂₃ jeweils mit dem zentralen 7-gliedrigen Ring in Formel 2A und 2B kondensiert sind, sodass sie jeweils ein T₁₁ und ein T₁₂ mit dem zentralen 7-gliedrigen Ring gemeinsam haben,
X₂₁ ausgewählt ist aus S, Se, C(R₂₃)(R₂₄), Si(R₂₃)(R₂₄) und N-[(L₂₁)ₐ₂₁-(R₂₁)_{b21}],
L₁ bis L₃, L₁₁ bis L₁₅, L₂₁ und L₂₂ jeweils unabhängig ausgewählt sind aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten divalenten nicht aromatischen kondensierten polycyclischen Gruppe und einer substituierten oder unsubstituierten divalenten nicht aromatischen kondensierten heteropolycyclischen Gruppe,
der Ring A₁ eine carbocyclische C₅-C₃₀-Gruppe oder eine heterocyclische C₁-C₃₀-Gruppe ist,
a1 bis a3, a11 bis a15, a21 und a22 jeweils unabhängig eine ganze Zahl sind, ausgewählt aus 0 bis 5,
a16 eine ganze Zahl ist, ausgewählt aus 1 bis 10, und wenn a16 2 oder größer ist, eine Vielzahl von Ringen Ai(s) über eine oder mehrere Einfachbindungen aneinander gebunden ist,
R₁ bis R₃ und R₁₅ jeweils unabhängig ausgewählt sind aus einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht aromatischen kondensierten polycyclischen Gruppe und einer substituierten oder unsubstituierten monovalenten nicht aromatischen kondensierten heteropolycyclischen Gruppe,
R₁₁ und R₁₂ jeweils unabhängig wie für R₁ definiert sind, oder wenn a11 und a12 beide 0 sind, optional gebunden sein können, um zusammen mit dem Stickstoffatom, an das sie angelagert sind, eine heterocyclische C₁-C₃₀-Gruppe zu bilden,
R₁₃ und R₁₄ jeweils unabhängig wie für R₁ definiert sind, oder wenn a13 und a14 beide 0 sind, optional gebunden sein können, um zusammen mit dem Stickstoffatom, an das sie angelagert sind, eine heterocyclische C₁-C₃₀-Gruppe zu bilden,
R₁₆, R₂₁ bis R₂₄, R₂₇ und R₂₈ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkinylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten monovalenten nicht aromatischen kondensierten polycyclischen Gruppe, einer substituierten oder unsubstituierten monovalenten nicht aromatischen kondensierten heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂),
b1 bis b3, b11 bis b15, b21 und b22 jeweils unabhängig eine ganze Zahl sind, ausgewählt aus 1 bis 5, vorausgesetzt, dass jedes von b1 bis b3, b11 bis b15, b21 und b22 1 ist, wenn jedes jeweilige a1 bis a3, a11 bis a15, a21, a22 oder a31 bis a33 null ist,
b16 eine ganze Zahl ist, ausgewählt aus 0 bis 5,
n1 eine ganze Zahl ist, ausgewählt aus 1 bis 4,
n2 eine ganze Zahl ist, ausgewählt aus 0 bis 4, und
die substituierte C₃-C₁₀-Cycloalkylengruppe, substituierte C₁-C₁₀-Heterocycloalkylengruppe, substituierte C₃-C₁₀-Cycloalkenylengruppe, substituierte C₁-C₁₀-Heterocycloalkenylengruppe, substituierte C₆-C₆₀-Arylengruppe, substituierte C₁-C₆₀-Heteroarylengruppe, substituierte divalente nicht aromatische kondensierte polycyclische Gruppe, substituierte divalente nicht aromatische kondensierte heteropolycyclische Gruppe, substituierte C₁-C₆₀-Alkylgruppe, substituierte C₂-C₆₀-Alkenylgruppe, substituierte C₂-C₆₀-Alkinylgruppe, substituierte C₁-C₆₀-Alkoxygruppe, substituierte C₃-C₁₀-Cycloalkylgruppe, substituierte C₁-C₁₀-Heterocycloalkylgruppe, substituierte C₃-C₁₀-Cycloalkenylgruppe, substituierte C₁-C₁₀-Heterocycloalkenylgruppe, substituierte C₆-C₆₀-Arylgruppe, substituierte C₆-C₆₀-Aryloxygruppe, substituierte C₆-C₆₀-Arylthiogruppe, substituierte C₁-C₆₀-Heteroarylgruppe, substituierte monovalente nicht aromatische kondensierte polycyclische Gruppe und substituierte monovalente nicht aromatische kondensierte heteropolycyclische Gruppe jeweils unabhängig substituiert ist mit einem oder mehreren Substituenten, ausgewählt aus der Gruppe bestehend aus:
Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe und einer C₁-C₆₀-Alkoxygruppe;
einer C₁-C₆₀-Alkylgruppe, einer C₂-C₆₀-Alkenylgruppe, einer C₂-C₆₀-Alkinylgruppe und einer C₁-C₆₀-Alkoxygruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁) und -P(=O)(Q₁₁)(Q₁₂);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe und einer Terphenylgruppe,
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe und einer monovalenten nicht aromatischen kondensierten heteropolycyclischen Gruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁) und -P(=O)(Q₂₁)(Q₂₂); und
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und - P(=O)(Q₃₁)(Q₃₂),
wobei Q₁ bis Q₃, Q₁₁ bis Q₁₃, Q₂₁ bis Q₂₃ und Q₃₁ bis Q₃₃ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Arylgruppe substituiert mit einer C₁-C₆₀-Alkylgruppe, einer C₆-C₆₀-Arylgruppe substituiert mit einer C₆-C₆₀-Arylgruppe, einer Terphenylgruppe, einer C₁-C₆₀-Heteroarylgruppe, einer C₁-C₆₀-Heteroarylgruppe substituiert mit einer C₁-C₆₀-Alkylgruppe, einer C₁-C₆₀-Heteroarylgruppe substituiert mit einer C₆-C₆₀-Arylgruppe, einer monovalenten nicht aromatischen kondensierten polycyclischen Gruppe und einer monovalenten nicht aromatischen kondensierten heteropolycyclischen Gruppe,
vorausgesetzt, dass die erste Verbindung nicht Folgendes ist: 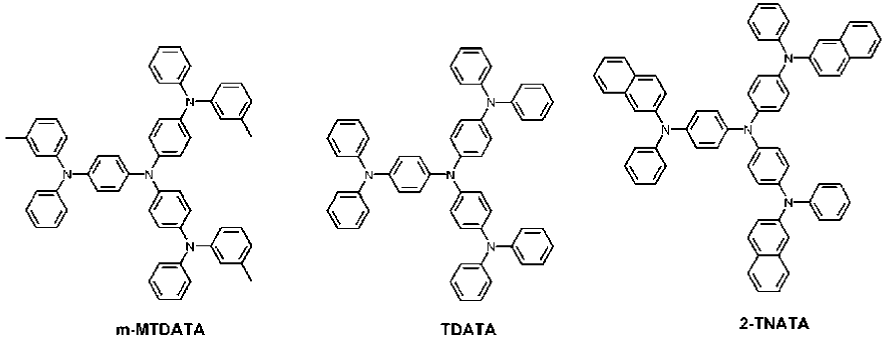 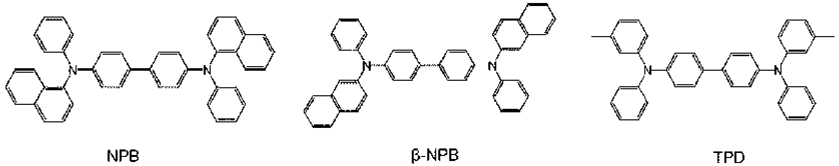 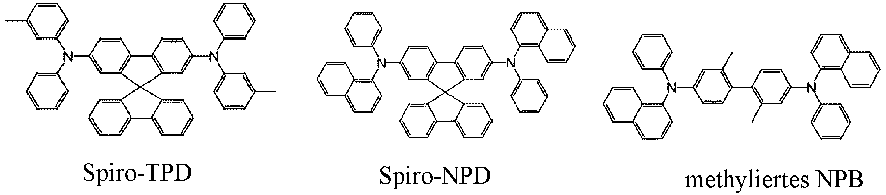 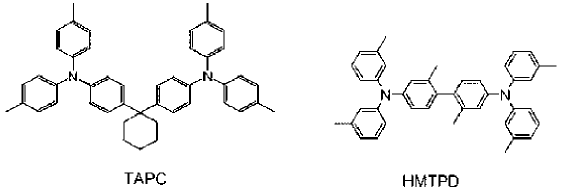 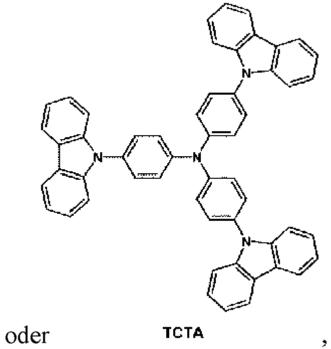
und vorausgesetzt, dass in Formel 2A, wenn
i) der Ring A₂₂ eine Benzofurangruppe, eine Benzothiophengruppe, eine Benzoselenophengruppe, eine Indengruppe, eine Benzosilolgruppe oder eine Indolgruppe ist, jeweils substituiert mit mindestens einem *-[(L₂₂)ₐ₂₂-(R₂₂)_{b22}],
ii) ein 5-gliedriger Ring der Benzofurangruppe, der Benzothiophengruppe, der Benzoselenophengruppe, der Indengruppe, der Benzosilolgruppe und der Indolgruppe an den zentralen 7-gliedrigen Ring in Formel 2A kondensiert ist und
iii) T₁₁ und T₁₂ alle Kohlenstoff sind,
dann die Ringe A₂₁ und A₂₃ in Formel 2A nicht gleichzeitig Benzolgruppen sind.

2. Organische lichtemittierende Vorrichtung (10) nach Anspruch 1, wobei:
die Ringe A₂₁, A₂₂ und A₂₃ in Formel 2A und 2B jeweils unabhängig ausgewählt sind aus einer Benzolgruppe, einer Naphthalengruppe, einer Anthracengruppe, einer Indengruppe, einer Fluorengruppe, einer Pyridingruppe, einer Pyrimidingruppe, einer Pyrazingruppe, einer Pyridazingruppe, einer Chinolingruppe, einer Isochinolingruppe, einer Pyrrolgruppe, einer Pyrazolgruppe, einer Imidazolgruppe, einer Oxazolgruppe, einer Thiazolgruppe, einer Cyclopentadiengruppe, einer Silolgruppe, einer Selenophengruppe, einer Furangruppe, einer Thiophengruppe, einer Indolgruppe, einer Benzimidazolgruppe, einer Benzoxazolgruppe, einer Benzothiazolgruppe, einer Indengruppe, einer Benzosilolgruppe, einer Benzoselenophengruppe, einer Benzofurangruppe, einer Benzothiophengruppe, einer Carbazolgruppe, einer Fluorengruppe, einer Dibenzosilolgruppe, einer Dibenzoselenophengruppe, einer Dibenzofurangruppe, einer Dibenzothiophengruppe, einer Pyrrolopyridingruppe, einer Cyclopentapyridingruppe, einer Silolopyridingruppe, einer Selenophenopyridingruppe, einer Furopyridingruppe, einer Thienopyridingruppe, einer Pyrrolopyrimidingruppe, einer Cyclopentapyrimidingruppe, einer Silolopyrimidingruppe, einer Selenophenopyrimidingruppe, einer Furopyrimidingruppe, einer Thienopyrimidingruppe, einer Pyrrolopyrazingruppe, einer Cyclopentapyrazingruppe, einer Silolopyrazingruppe, einer Selenophenopyrazingruppe, einer Furopyrazingruppe, einer Thienopyrazingruppe, einer Naphthopyrrolgruppe, einer Cyclopentanaphthalengruppe, einer Naphthosilolgruppe, einer Naphthoselenophengruppe, einer Naphthofurangruppe, einer Naphthothiophengruppe, einer Pyrrolochinolingruppe, einer Cyclopentachinolingruppe, einer Silolochinolingruppe, einer Selenophenochinolingruppe, einer Furochinolingruppe, einer Thienochinolingruppe, einer Pyrroloisochinolingruppe, einer Cyclopentaisochinolingruppe, einer Siloloisochinolingruppe, einer Selenophenoisochinolingruppe, einer Furoisochinolingruppe, einer Thienoisochinolingruppe, einer Azacarbazolgruppe, einer Azafluorengruppe, einer Azadibenzosilolgruppe, einer Azadibenzoselenophengruppe, einer Azadibenzofurangruppe, einer Azadibenzothiophengruppe, einer Indenochinolingruppe, einer Isoindenochinolingruppe, einer Indenochinoxalingruppe, einer Phenanthrolingruppe und einer Naphthoindolgruppe, jeweils substituiert mit mindestens einem *-[(L₂₂)ₐ₂₂-(R₂₂)_{b22}].

3. Organische lichtemittierende Vorrichtung (10) nach Anspruch 1, wobei die Ringe A₂₁, A₂₂ und A₂₃ in Formel 2A und 2B jeweils unabhängig ausgewählt sind aus Gruppen, die durch Formel 2-1 bis 2-36 dargestellt sind, jeweils substituiert mit mindestens einem *-[(L₂₂)ₐ₂₂-(R₂₂)_{b22}], in dem * eine Bindungsstelle an den A₂₁-, A₂₂- oder A₂₃-Ring ist: 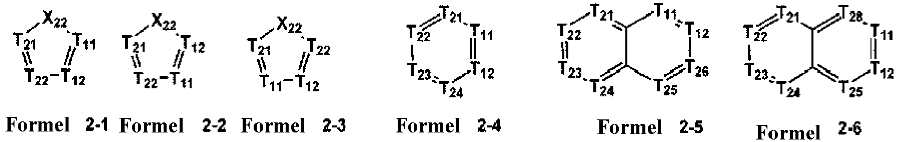 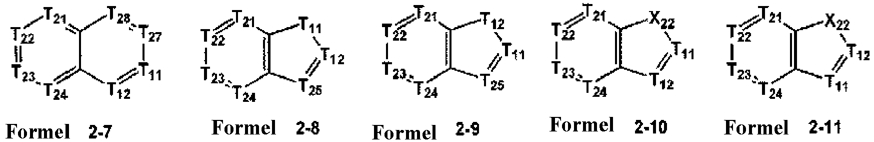 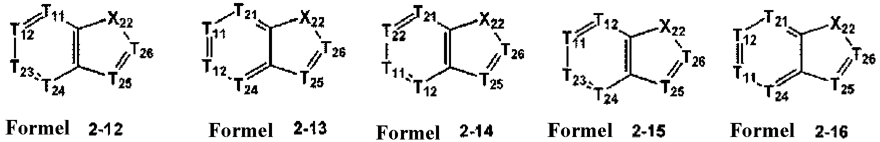 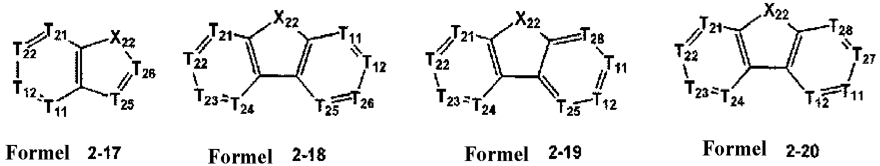 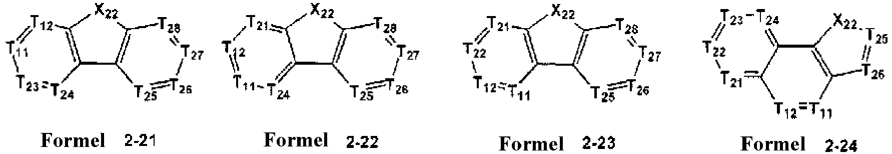 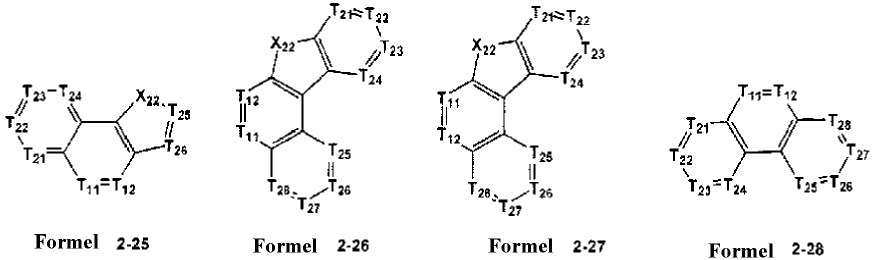 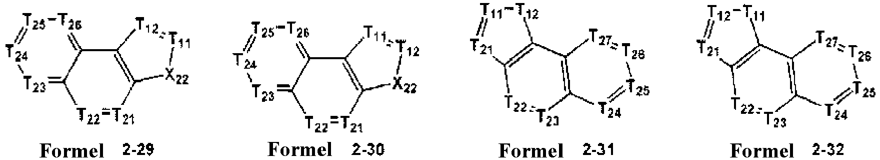 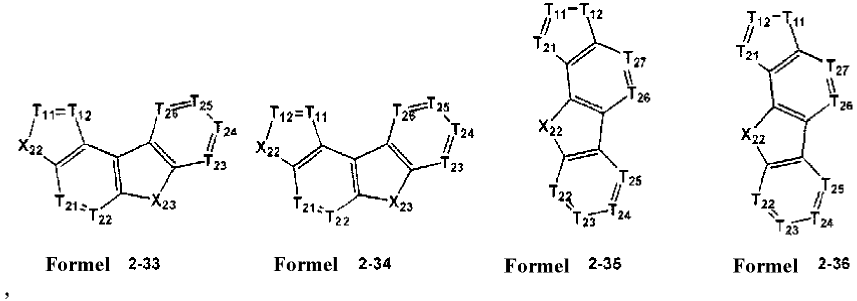
wobei in Formel 2-1 bis 2-36
T₁₁ und T₁₂ jeweils unabhängig die gleichen wie hierin im Zusammenhang mit Formel 2A und 2B beschrieben sind,
X₂₂ und X₂₃ jeweils unabhängig ausgewählt sind aus O, S, Se und einer Einheit, die C, N und/oder Si umfasst, und
T₂₁ bis T₂₈ jeweils unabhängig N oder eine Einheit, die C umfasst, sind.

4. Organische lichtemittierende Vorrichtung (10) nach einem der vorhergehenden Ansprüche, wobei X₂₁ in Formel 2A und 2B N[(L₂₁)ₐ₂₁-(R₂₁)_{b21}] ist.

5. Organische lichtemittierende Vorrichtung (10) nach Anspruch 3, wobei:
X₂₁ in Formel 2A und 2B S, Se, C(R₂₃)(R₂₄) oder Si(R₂₃)(R₂₄) ist,
mindestens einer, ausgewählt aus den Ringen A₂₁, A₂₂ und A₂₃ in Formel 2A, und mindestens einer, ausgewählt aus den Ringen A₂₁ und A₂₃ in Formel 2B, jeweils unabhängig ausgewählt sind aus Gruppen, die durch Formel 2-1 bis 2-3, 2-10 bis 2-27 und 2-33 bis 2-36 dargestellt sind, und
mindestens eines von X₂₂ und X₂₃ in Formel 2-1 bis 2-3, 2-10 bis 2-27 und 2-33 bis 2-36 N-[(L₂₂)ₐ₂₂-(R₂₂)_{b22}] ist.

6. Organische lichtemittierende Vorrichtung (10) nach einem der vorhergehenden Ansprüche, wobei L₁ bis L₃, L₁₁ bis L₁₅ und der Ring A₁ in Formel 1A und 1B jeweils unabhängig ausgewählt sind aus der Gruppe bestehend aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Pyridinylengruppe, einer Indolylengruppe, einer Isoindolylengruppe, einer Purinylengruppe, einer Benzofuranylengruppe, einer Benzothiophenylengruppe, einer Benzosilolylengruppe, einer Dibenzofuranylengruppe, einer Dibenzothiophenylengruppe, einer Dibenzosilolylengruppe, einer Carbazolylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Pyridinylengruppe, einer Indolylengruppe, einer Isoindolylengruppe, einer Purinylengruppe, einer Benzofuranylengruppe, einer Benzothiophenylengruppe, einer Benzosilolylengruppe, einer Dibenzofuranylengruppe, einer Dibenzothiophenylengruppe, einer Dibenzosilolylengruppe, einer Carbazolylengruppe, einer Benzocarbazolylengruppe und einer Dibenzocarbazolylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Pyridinylgruppe, einer Indolylgruppe, einer Isoindolylgruppe, einer Purinylgruppe, einer Benzofuranylgruppe, einer Benzothiophenylgruppe, einer Benzosilolylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, -Si(Q₃₁)(Q₃₂)(Q₃₃), -N(Q₃₁)(Q₃₂) und -B(Q₃₁)(Q₃₂), und
L₂₁ und L₂₂ in Formel 2A und 2B jeweils unabhängig ausgewählt sind aus der Gruppe bestehend aus:
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe; und
einer Phenylengruppe, einer Pentalenylengruppe, einer Indenylengruppe, einer Naphthylengruppe, einer Azulenylengruppe, einer Indacenylengruppe, einer Acenaphthylengruppe, einer Fluorenylengruppe, einer Spiro-bifluorenylengruppe, einer Spiro-benzofluoren-fluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Perylenylengruppe, einer Pentaphenylengruppe, einer Pyrrolylengruppe, einer Thiophenylengruppe, einer Furanylengruppe, einer Silolylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Indolylengruppe, einer Isoindolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Benzosilolylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Carbazolylengruppe, einer Benzocarbazolylengruppe, einer Dibenzocarbazolylengruppe, einer Thiadiazolylengruppe, einer Imidazopyridinylengruppe, einer Imidazopyrimidinylengruppe, einer Oxazolopyridinylengruppe, einer Thiazolopyridinylengruppe, einer Benzonaphthyridinylengruppe, einer Azafluorenylengruppe, einer Azaspirobifluorenylengruppe, einer Azacarbazolylengruppe, einer Azadibenzofuranylengruppe, einer Azadibenzothiophenylengruppe und einer Azadibenzosilolylengruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), - C(=O)(Q₃₁), -S(=O)₂(Q₃₁) und -P(=O)(Q₃₁)(Q₃₂),
wobei Q₁ bis Q₃ und Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe.

7. Organische lichtemittierende Vorrichtung (10) nach einem der vorhergehenden Ansprüche, wobei:
a16 in Formel 1B 1 ist, der Ring A₁ eine Benzolgruppe ist und n2 1 oder 2 ist; oder
a16 in Formel 1B 3, 4, 5 oder 6 ist.

8. Organische lichtemittierende Vorrichtung (10) nach einem der vorhergehenden Ansprüche, wobei R₁ bis R₃ und R₁₁ bis R₁₅ in Formel 1A und 1B jeweils unabhängig ausgewählt sind aus der Gruppe bestehend aus:
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Pyridinylgruppe, einer Indolylgruppe, einer Isoindolylgruppe, einer Purinylgruppe, einer Benzofuranylgruppe, einer Benzothiophenylgruppe, einer Benzosilolylgruppe, einer Dibenzofuranylgruppe, einer Dibenzothiophenylgruppe, einer Dibenzosilolylgruppe, einer Carbazolylgruppe, einer Benzocarbazolylgruppe und einer Dibenzocarbazolylgruppe; und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Pyridinylgruppe, einer Indolylgruppe, einer Isoindolylgruppe, einer Purinylgruppe, einer Benzofuranylgruppe, einer Benzothiophenylgruppe, einer Benzosilolylgruppe, einer Dibenzofuranylgruppe, einer Dibenzothiophenylgruppe, einer Dibenzosilolylgruppe, einer Carbazolylgruppe, einer Benzocarbazolylgruppe und einer Dibenzocarbazolylgruppe, jeweils substituiert mit mindestens einem, ausgewählt aus Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Pyridinylgruppe, einer Indolylgruppe, einer Isoindolylgruppe, einer Purinylgruppe, einer Benzofuranylgruppe, einer Benzothiophenylgruppe, einer Benzosilolylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, -Si(Q₃₁)(Q₃₂)(Q₃₃), -N(Q₃₁)(Q₃₂) und - B(Q₃₁)(Q₃₂), und
R₂₁ in Formel 2A und 2B jeweils unabhängig ausgewählt sind aus der Gruppe bestehend aus:
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe und einer Azadibenzosilolylgruppe; und
einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Indacenylgruppe, einer Acenaphthylgruppe, einer Fluorenylgruppe, einer Spiro-bifluorenylgruppe, einer Spiro-benzofluoren-fluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Perylenylgruppe, einer Pentaphenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Oxazolopyridinylgruppe, einer Thiazolopyridinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe und einer Azadibenzosilolylgruppe, jeweils substituiert mit mindestens einem, ausgewählt aus Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer monovalenten nicht aromatischen kondensierten polycyclischen Gruppe, einer monovalenten nicht aromatischen kondensierten heteropolycyclischen Gruppe, einer Biphenylgruppe, einer Terphenylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
R₂₂ ausgewählt ist aus den Gruppen, die für R₂₁ definiert sind, Wasserstoff, Deuterium, - F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, -Si(Q₁)(Q₂)(Q₃), -S(=O)₂(Q₁) und -P(=O)(Q₁)(Q₂),
wobei Q₁ bis Q₃ und Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe.

9. Organische lichtemittierende Vorrichtung (10) nach Anspruch 1, wobei:
R₁ bis R₃ und R₁₁ bis R₁₅ in Formel 1A und 1B jeweils unabhängig ausgewählt sind aus Gruppen, die durch Formel 5-1 bis 5-45 dargestellt sind,
R₂₁ in Formel 2A und 2B ausgewählt ist aus Gruppen, die durch Formel 5-1 bis 5-45 und 6-1 bis 6-124 dargestellt sind, und
R₂₂ in Formel 2A und 2B ausgewählt ist aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Gruppe, die durch eine von Formel 5-1 bis 5-45 und 6-1 bis 6-124 dargestellt ist, -Si(Q₁)(Q₂)(Q₃), -S(=O)₂(Q₁) und -P(=O)(Q₁)(Q₂): 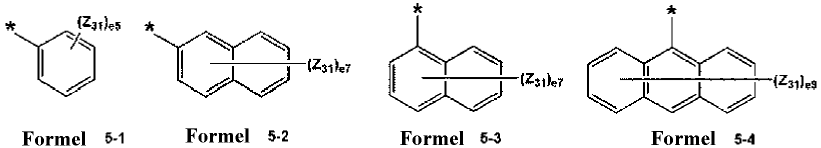 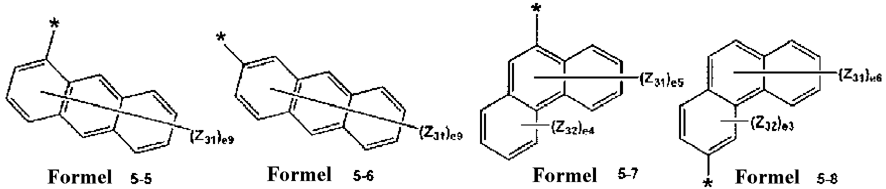 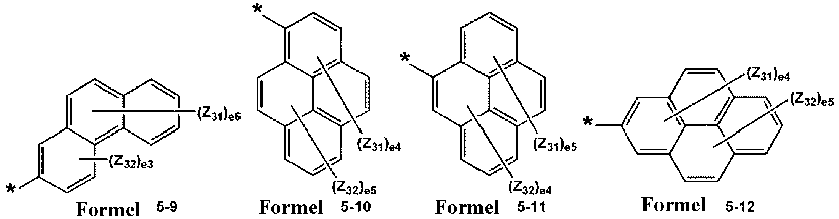 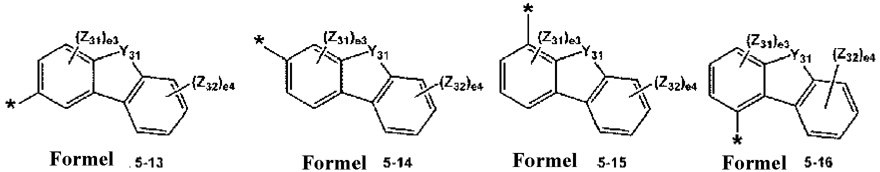 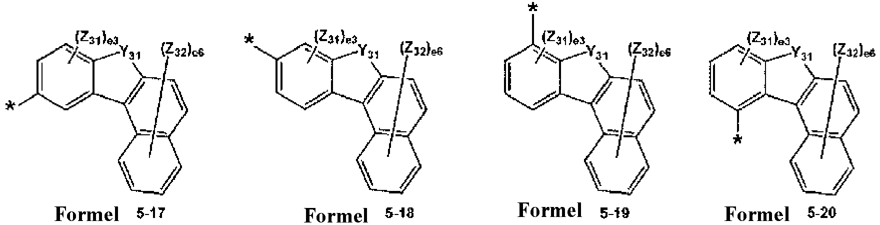 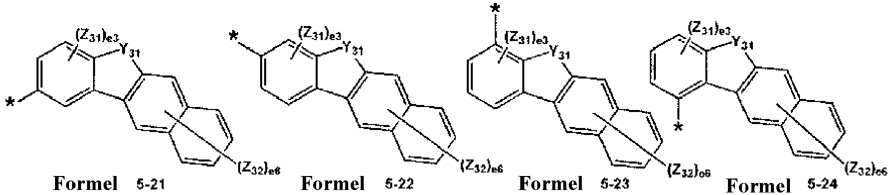 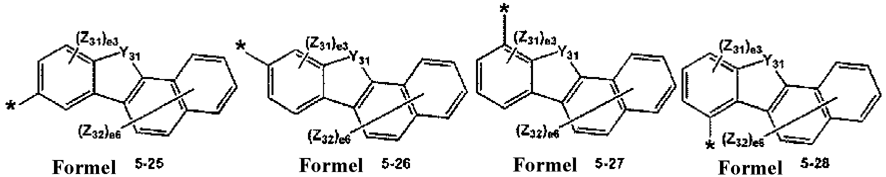 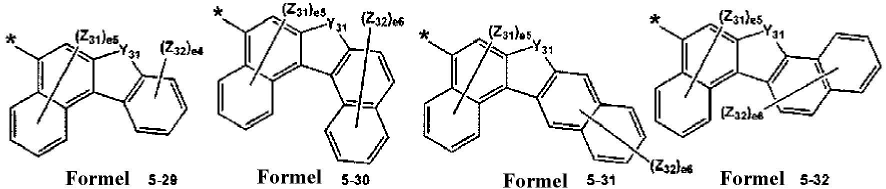 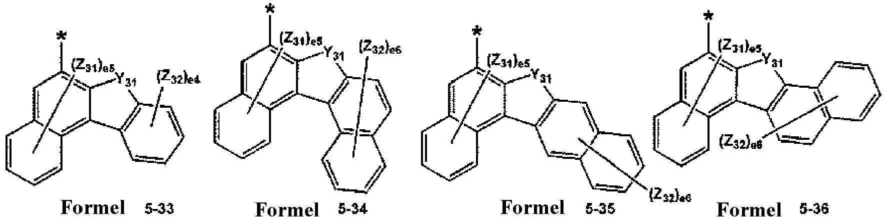 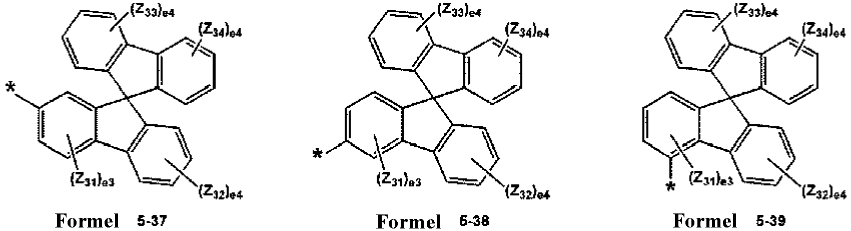 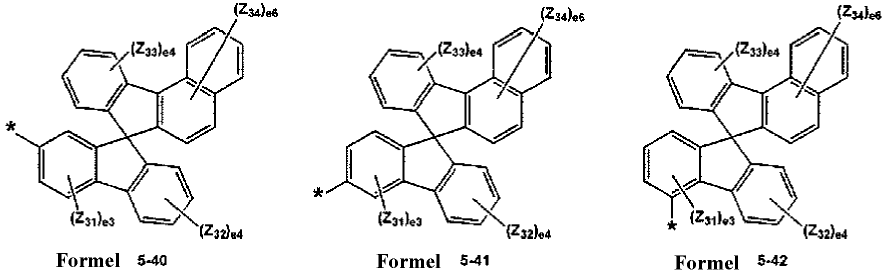 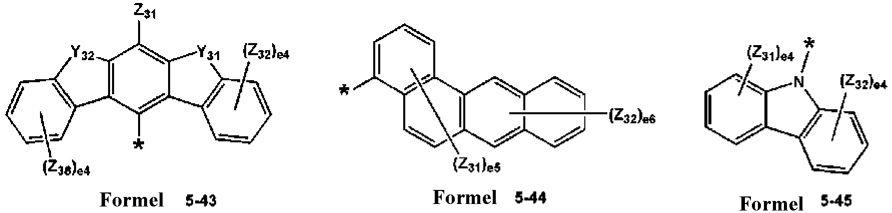 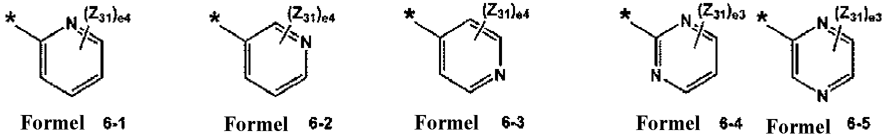 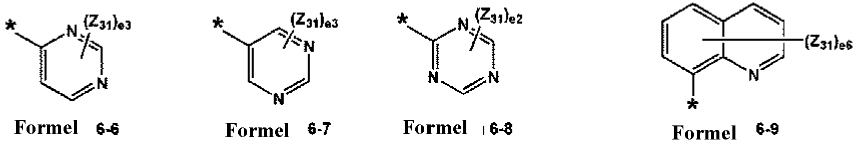 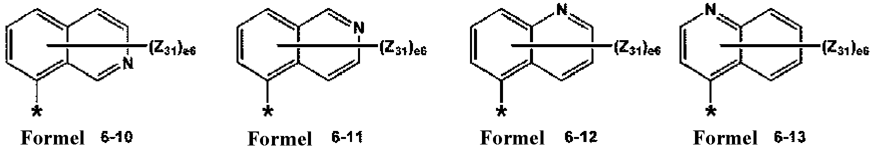 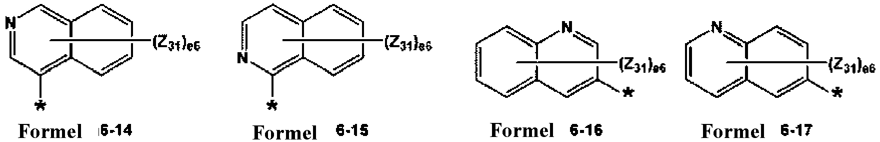 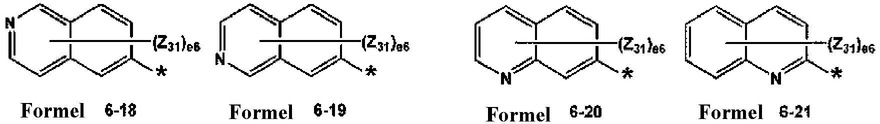 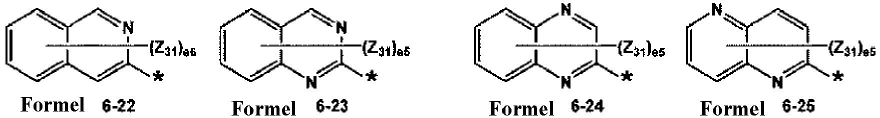 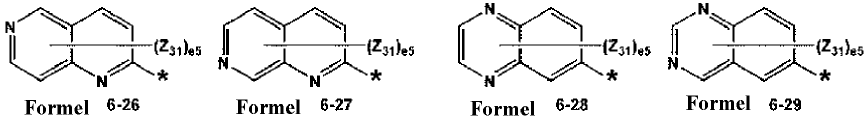 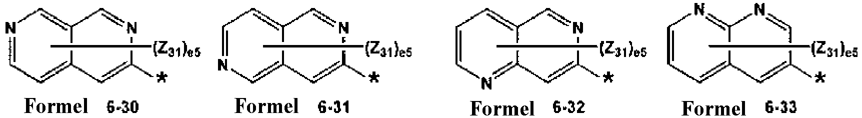 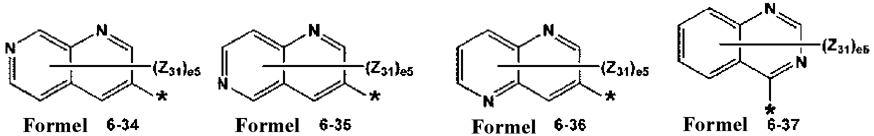 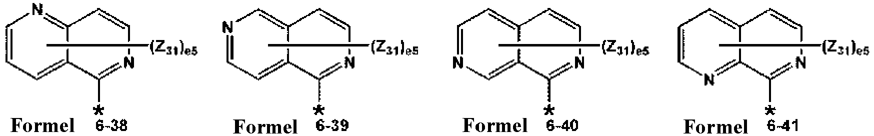 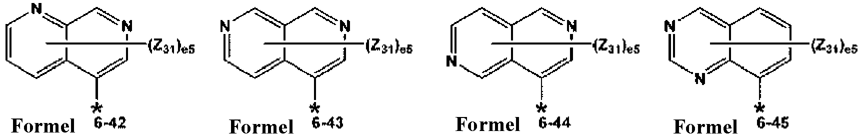 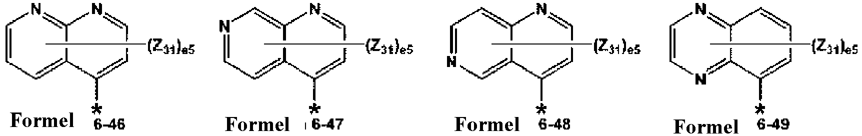 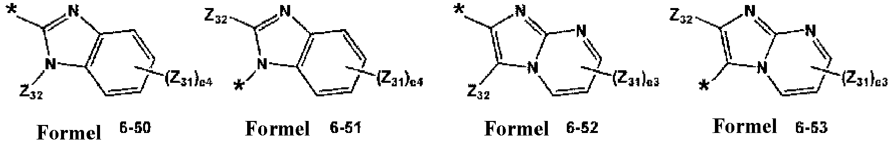 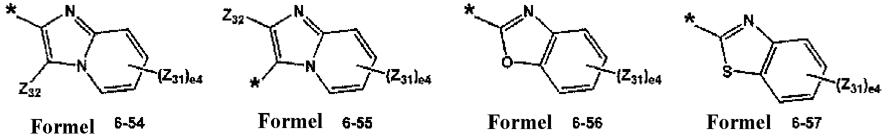 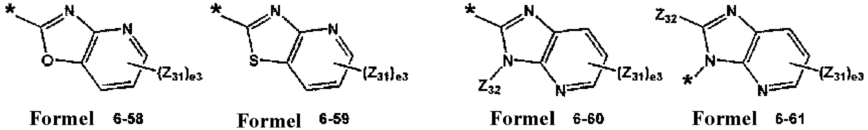 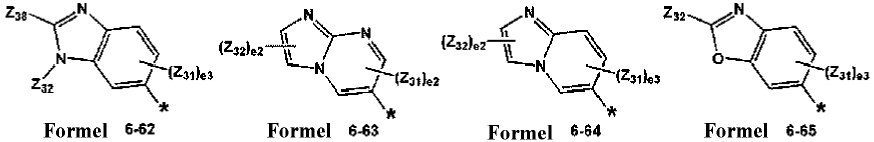 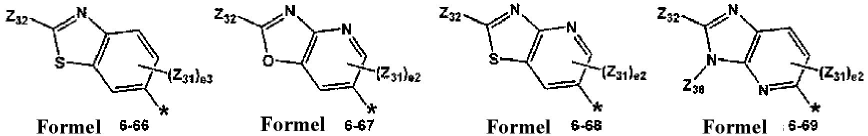 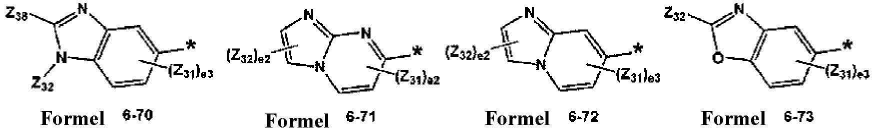 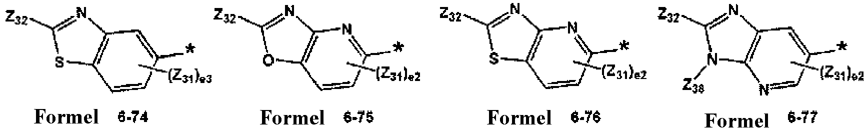 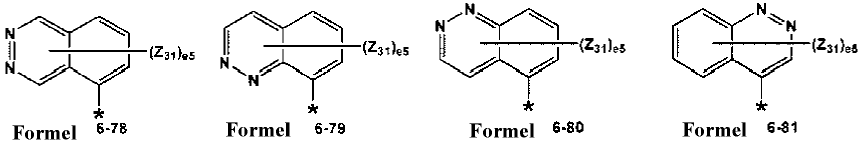 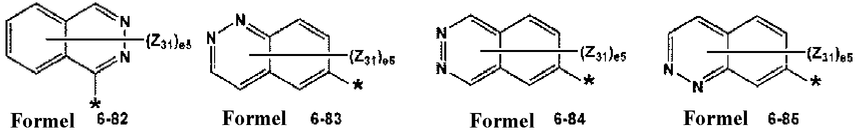 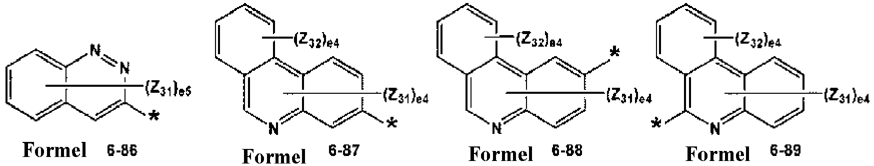 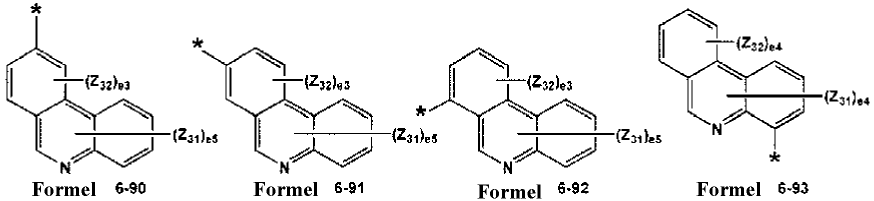 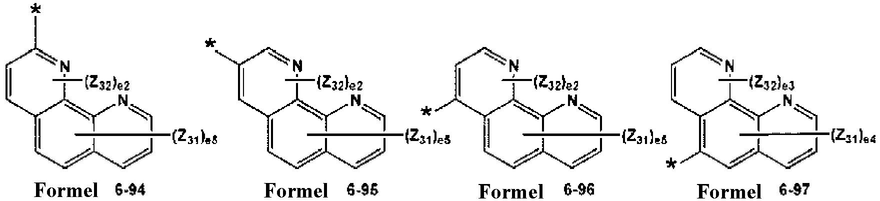 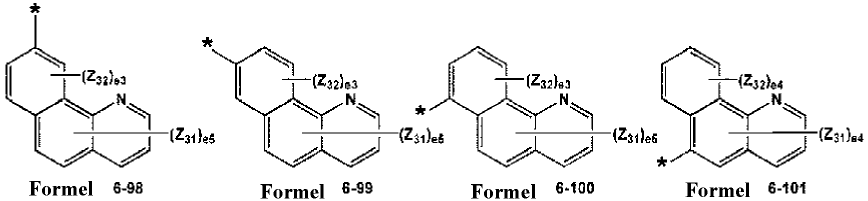 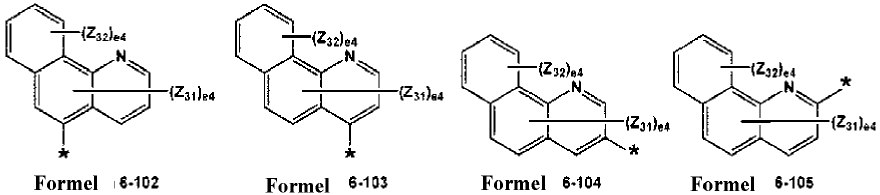 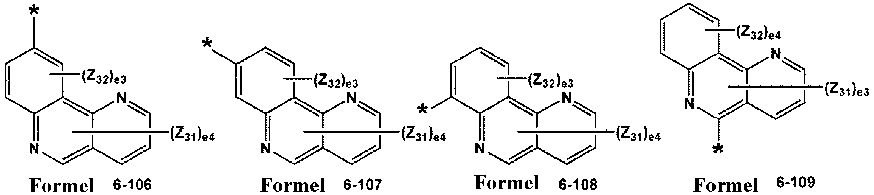 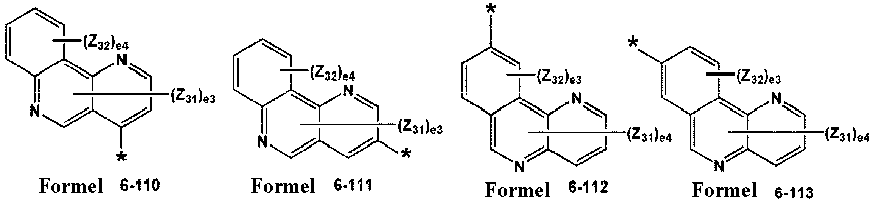 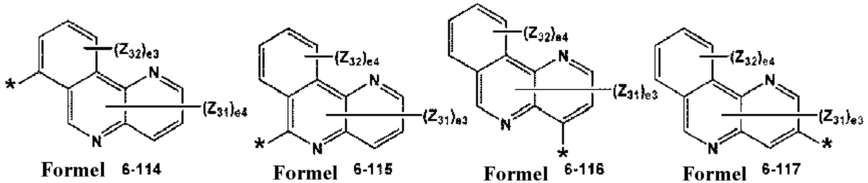 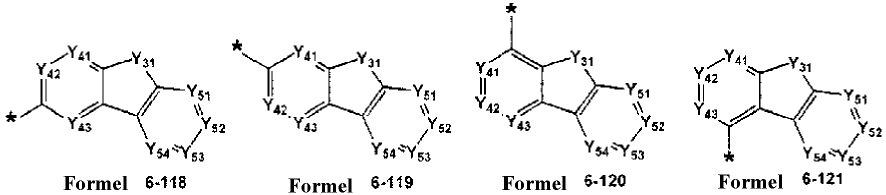 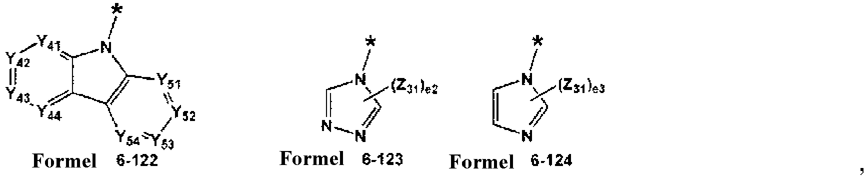
wobei in Formel 5-1 bis 5-45 und 6-1 bis 6-124
Y₃₁ und Y₃₂ jeweils unabhängig ausgewählt sind aus O, S, C(Z₃₃)(Z₃₄), N(Z₃₅) und Si(Z₃₆)(Z₃₇),
Y₄₁ N oder C(Z₄₁) ist, Y₄₂ N oder C(Z₄₂) ist, Y₄₃ N oder C(Z₄₃) ist, Y₄₄ N oder C(Z₄₄) ist, Y₅₁ N oder C(Z₅₁) ist, Y₅₂ N oder C(Z₅₂) ist, Y₅₃ N oder C(Z₅₃) ist, Y₅₄ N oder C(Z₅₄) ist, mindestens eines, ausgewählt aus Y₄₁ bis Y₄₃ und Y₅₁ bis Y₅₄ in Formel 6-118 bis 6-121, N ist und mindestens eines, ausgewählt aus Y₄₁ bis Y₄₄ und Y₅₁ bis Y₅₄ in Formel 6-122, N ist,
Z₃₁ bis Z₃₈, Z₄₁ bis Z₄₄ und Z₅₁ bis Z₅₄ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazinogruppe, einer Hydrazonogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spiro-bifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Silolylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Indolylgruppe, einer Isoindolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Benzosilolylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Carbazolylgruppe, einer Benzocarbazolylgruppe, einer Dibenzocarbazolylgruppe, einer Thiadiazolylgruppe, einer Imidazopyridinylgruppe, einer Imidazopyrimidinylgruppe, einer Benzonaphthyridinylgruppe, einer Azafluorenylgruppe, einer Azaspiro-bifluorenylgruppe, einer Azacarbazolylgruppe, einer Azadibenzofuranylgruppe, einer Azadibenzothiophenylgruppe, einer Azadibenzosilolylgruppe und -Si(Q₃₁)(Q₃₂)(Q₃₃),
wobei Q₁ bis Q₃ und Q₃₁ bis Q₃₃ jeweils unabhängig ausgewählt sind aus der Gruppe bestehend aus:
einer C₁-C₁₀-Alkylgruppe, einer C₁-C₁₀-Alkoxygruppe, einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe; und
einer Phenylgruppe, einer Biphenylgruppe, einer Terphenylgruppe, einer Naphthylgruppe, einer Pyridinylgruppe, einer Pyrimidinylgruppe, einer Pyrazinylgruppe, einer Chinolinylgruppe, einer Isochinolinylgruppe, einer Chinoxalinylgruppe und einer Chinazolinylgruppe, jeweils substituiert mit mindestens einer, ausgewählt aus einer C₁-C₁₀-Alkylgruppe, einer C₁-C₁₀-Alkoxygruppe und einer Phenylgruppe,
e2 eine ganze Zahl ist, ausgewählt aus 0 bis 2,
e3 eine ganze Zahl ist, ausgewählt aus 0 bis 3,
e4 eine ganze Zahl ist, ausgewählt aus 0 bis 4,
e5 eine ganze Zahl ist, ausgewählt aus 0 bis 5,
e6 eine ganze Zahl ist, ausgewählt aus 0 bis 6,
e7 eine ganze Zahl ist, ausgewählt aus 0 bis 7,
e9 eine ganze Zahl ist, ausgewählt aus 0 bis 9, und
* eine Bindungsstelle zu einem benachbarten Atom angibt.

10. Organische lichtemittierende Vorrichtung (10) nach Anspruch 9, wobei mindestens eines, ausgewählt aus R₁ bis R₃ in Formel 1A, und mindestens eines, ausgewählt aus R₁₁ bis R₁₄ in Formel 1B, jeweils unabhängig durch eine, ausgewählt aus Formel 5-13 bis 5-42 und 5-45, dargestellt sind.

11. Organische lichtemittierende Vorrichtung (10) nach Anspruch 9, wobei:
R₁ in Formel 1A durch eine, ausgewählt aus Formel 5-13 bis 5-36 und 5-45, dargestellt ist, vorausgesetzt, dass Y₃₁ in Formel 5-13 bis 5-36 N(Z₃₅) ist, und
R₂ in Formel 1A durch eine, ausgewählt aus Formel 5-13 bis 5-42, dargestellt ist, vorausgesetzt, dass Y₃₁ in Formel 5-13 bis 5-36 C(Z₃₃)(Z₃₄) ist.

12. Organische lichtemittierende Vorrichtung (10) nach einem der vorhergehenden Ansprüche, wobei:
(a) die Lochtransportregion eine Lochinjektionsschicht und eine Lochtransportschicht umfasst, wobei die Lochtransportschicht zwischen der Lochinjektionsschicht und der Emissionsschicht liegt und die Lochtransportschicht die erste Verbindung umfasst; und/oder
(b) die Lochtransportregion eine Emissionshilfsschicht umfasst, die Emissionshilfsschicht die Emissionsschicht direkt berührt und die Emissionshilfsschicht die zweite Verbindung umfasst; und/oder
(c) die Elektronentransportregion eine Pufferschicht umfasst, die Pufferschicht die Emissionsschicht direkt berührt und die Pufferschicht die zweite Verbindung umfasst; und/oder
(d) die Emissionsschicht ferner einen fluoreszierenden Dotierstoff oder einen phosphoreszierenden Dotierstoff umfasst, wobei der fluoreszierende Dotierstoff eine Arylaminverbindung oder eine Styrylaminverbindung umfasst; und der phosphoreszierende Dotierstoff eine metallorganische Verbindung umfasst, die Iridium (Ir), Platin (Pt), Palladium (Pd), Osmium (Os), Titan (Ti), Zirconium (Zr), Hafnium (Hf), Europium (Eu), Terbium (Tb), Rhodium (Rh) oder Thulium (Tm) umfasst.

13. Organische lichtemittierende Vorrichtung (10) nach einem der vorhergehenden Ansprüche, wobei:
die Elektronentransportregion eine Pufferschicht, eine Elektronentransportschicht und eine Elektroneninj ektionsschicht umfasst,
wobei mindestens eine, ausgewählt aus der Elektronentransportschicht und der Elektroneninjektionsschicht, ein Alkalimetall, ein Erdalkalimetall, ein Seltenerdmetall, eine Alkalimetallverbindung, eine Erdalkalimetallverbindung, eine Seltenerdmetallverbindung, einen Alkalimetallkomplex, einen Erdalkalimetallkomplex, einen Seltenerdmetallkomplex oder eine Kombination davon umfasst;
wobei die Elektroneninj ektionsschicht bevorzugt Lithium (Li), Natrium (Na), Kalium (K), Rubidium (Rb), Caesium (Cs), Magnesium (Mg), Calcium (Ca), Erbium (Er), Thulium (Tm), Ytterbium (Yb) oder eine Kombination davon umfasst.

14. Organische lichtemittierende Vorrichtung (10) nach einem der vorhergehenden Ansprüche, wobei die Lochtransportregion einen p-Dotierstoff umfasst, ausgewählt aus einem Chinonderivat, einem Metalloxid und einer Cyanogruppen-haltigen Verbindung;
wobei der p-Dotierstoff bevorzugt eine Cyanogruppen-haltige Verbindung umfasst.

15. Organische lichtemittierende Vorrichtung (10) nach einem der vorhergehenden Ansprüche, wobei die Emissionsschicht eine Emissionsschicht von Licht mit einer ersten Farbe ist,
die organische lichtemittierende Vorrichtung ferner i) mindestens eine Emissionsschicht von Licht mit einer zweiten Farbe oder ii) mindestens eine Emissionsschicht von Licht mit einer zweiten Farbe und mindestens eine Emissionsschicht von Licht mit einer dritten Farbe, jeweils zwischen der ersten Elektrode (110) und der zweiten Elektrode (190), umfasst,
eine maximale Emissionswellenlänge der Emissionsschicht von Licht mit einer ersten Farbe, eine maximale Emissionswellenlänge der Emissionsschicht von Licht mit einer zweiten Farbe und eine maximale Emissionswellenlänge der Emissionsschicht von Licht mit einer dritten Farbe miteinander identisch oder voneinander unterschiedlich sind und
die organische lichtemittierende Vorrichtung ein Mischlicht emittiert, das ein Licht mit einer ersten Farbe und ein Licht mit einer zweiten Farbe umfasst, oder die organische lichtemittierende Vorrichtung ein Mischlicht emittiert, das das Licht mit einer ersten Farbe, das Licht mit einer zweiten Farbe und ein Licht mit einer dritten Farbe umfasst.

## Revendications

1. Dispositif électroluminescent organique (10), comprenant :
une première électrode (110) ;
une seconde électrode (190) faisant face à la première électrode (110) ;
une couche d'émission entre la première électrode (110) et la seconde électrode (190) ;
une couche de transport de trous entre la première électrode (110) et la couche d'émission ; et
une région de transport d'électrons entre la couche d'émission et la seconde électrode (190),
dans lequel la région de transport de trous comprend un premier composé
et la région de transport d'électrons comprend un second composé,
le premier composé est représenté par la Formule 1A ou 1B, et
le second composé est représenté par la Formule 2A ou 2B : 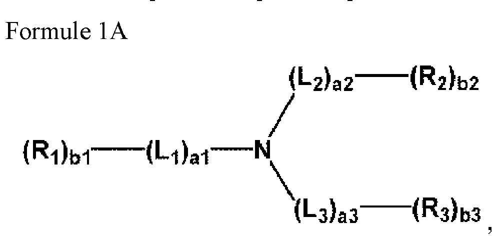 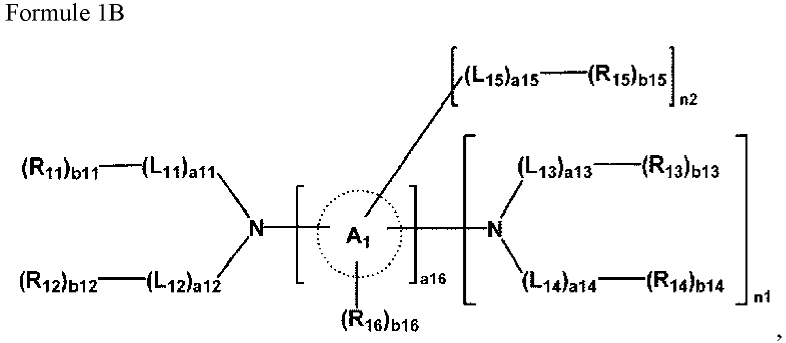 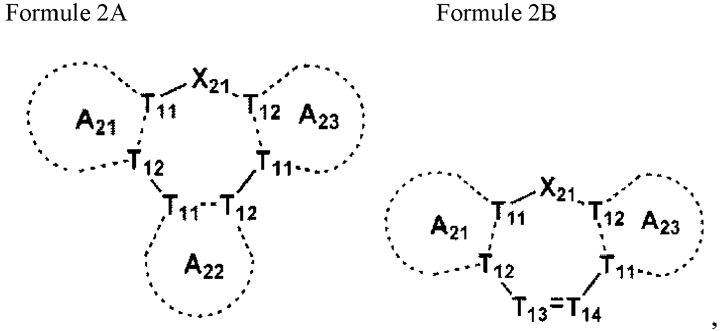
dans lequel, dans les Formules 1A, 1B, 2A et 2B,
les cycles A₂₁, A₂₂ et A₂₃ sont chacun indépendamment un groupe carbocyclique en C₅ à C₃₀ ou un groupe hétérocyclique en C₁ à C₃₀, chacun substitué par au moins un *-[(L₂₂)ₐ₂₂-(R₂₂)_{b22}], dans lequel * est un site de liaison vers le cycle A₂₁, A₂₂ ou A₂₃
chaque T₁₁ est indépendamment du carbone ou de l'azote,
chaque T₁₂ est indépendamment du carbone ou de l'azote,
T₁₃ est N ou C(R₂₇),
T₁₄ est N ou C(R₂₈),
chaque liaison entre T₁₁ et T₁₂ représentée sous forme de ligne pointillée dans les formules 2A et 2B est une simple liaison ou une double liaison ;
les six atomes représentés par les trois T₁₁ et les trois T₁₂ dans la Formule 2A ne sont pas tous de l'azote, et les six atomes représentés par les deux T₁₁, les deux T₁₂, T₁₃ et T₁₄ dans la Formule 2B ne sont pas tous de l'azote,
les cycles A₂₁, A₂₂ et A₂₃ sont chacun condensés avec le cycle central à 7 chaînons dans les Formules 2A et 2B, de telle sorte qu'ils partagent chacun un T₁₁ et un T₁₂ avec le cycle central à 7 chaînons,
X₂₁ est choisi parmi S, Se, C(R₂₃)(R₂₄), Si(R₂₃)(R₂₄), et N-[(L₂₁)ₐ₂₁-(R₂₁)_{b21}],
L₁ à L₃, L₁₁ à L₁₅, L₂₁ et L₂₂ sont chacun indépendamment choisis parmi un groupe cycloalkylène en C₃ à C₁₀ substitué ou non, un groupe hétérocycloalkylène en C₁ à C₁₀ substitué ou non, un groupe cycloalcénylène en C₃ à C₁₀ substitué ou non, un groupe hétérocycloalcénylène en C₁ à C₁₀ substitué ou non, un groupe arylène en C₆ à C₆₀ substitué ou non, un groupe hétéroarylène en C₁ à C₆₀ substitué ou non, un groupe polycyclique condensé non aromatique divalent substitué ou non et un groupe hétéropolycyclique condensé non aromatique divalent substitué ou non,
le cycle A₁ est un groupe carbocyclique en Cs à C₃₀ ou un groupe hétérocyclique en C₁ à C₃₀,
a1 à a3, a11 à a15, a21 et a22 sont chacun indépendamment un nombre entier choisi entre 0 et 5,
a16 est un nombre entier choisi entre 1 et 10, et lorsque a16 est égal ou supérieur à 2, une pluralité de cycles A₁ sont liés les uns aux autres via une ou plusieurs liaisons simples,
R₁ à R₃ et R₁₅ sont chacun sélectionnés indépendamment dans un groupe alkyle en C₁ à C₆₀ substitué ou non, un groupe alcényle en C₂ à C₆₀ substitué ou non, un groupe alcynyle en C₂ à C₆₀ substitué ou non, un groupe alcoxy en C₁ à C₆₀ substitué ou non, un groupe cycloalkyle en C₃ à C₁₀ substitué ou non, un groupe hétérocycloalkyle en C₁ à C₁₀ substitué ou non, un groupe cycloalcényle en C₃ à C₁₀ substitué ou non, un groupe hétérocycloalcényle en C₁ à C₁₀ substitué ou non, un groupe aryle en C₆ à C₆₀ substitué ou non, un groupe aryloxy en C₆ à C₆₀ substitué ou non, un groupe arylthio en C₆ à C₆₀ substitué ou non, un groupe hétéroaryle en C₁ à C₆₀ substitué ou non, un groupe polycyclique condensé non aromatique monovalent substitué ou non, et un groupe hétéropolycyclique condensé non aromatique monovalent substitué ou non,
R₁₁ et R₁₂ sont chacun indépendamment tels que définis pour R₁, ou lorsque a11 et a12 valent tous deux 0, peuvent éventuellement être liés pour former un groupe hétérocyclique en C₁ à C₃₀ avec l'atome d'azote auquel ils sont attachés,
R₁₃ et R₁₄ sont chacun indépendamment tels que définis pour R₁, ou lorsque a13 et a14 valent tous deux 0, peuvent éventuellement être liés pour former un groupe hétérocyclique en C₁ à C₃₀ avec l'atome d'azote auquel ils sont attachés,
R₁₆, R₂₁ à R₂₄, R₂₇ et R₂₈ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non, un groupe alcényle en C₂ à C₆₀ substitué ou non, un groupe alcynyle en C₂ à C₆₀ substitué ou non, un groupe alcoxy en C₁ à C₆₀ substitué ou non, un groupe cycloalkyle en C₃ à C₁₀ substitué ou non, un groupe hétérocycloalkyle en C₁ à C₁₀ substitué ou non, un groupe cycloalcényle en C₃ à C₁₀ substitué ou non, un groupe hétérocycloalcényle en C₁ à C₁₀ substitué ou non, un groupe aryle en C₆ à C₆₀ substitué ou non, un groupe aryloxy en C₆ à C₆₀ substitué ou non, un groupe arylthio en C₆ à C₆₀ substitué ou non, un groupe hétéroaryle en C₁ à C₆₀ substitué ou non, un groupe polycyclique condensé non aromatique monovalent substitué ou non, un groupe hétéropolycyclique condensé non aromatique monovalent substitué ou non, -Si(Q₁)(Q₂)(Q₃), - N(Q₁)(Q₂), -B(Q₁)(Q₂), -C(=O)(Q₁), -S(=O)₂(Q₁), et -P(=O)(Q₁)(Q₂),
b1 à b3, b11 à b15, b21 et b22 sont chacun indépendamment un nombre entier choisi entre 1 et 5, à condition que chacun de b1 à b3, b11 à b15, b21 et b22 soit 1 lorsque chaque a1 à a3, a11 à a15, a21, a22 ou a31 à a33 est zéro
b16, est un nombre entier choisi entre 0 et 5,
n1 est un nombre entier choisi entre 1 et 4,
n2 est un nombre entier choisi entre 0 et 4, et
le groupe cycloalkylène en C₃ à C₁₀ substitué, le groupe hétérocycloalkylène en C₁ à C₁₀ substitué, le groupe cycloalcénylène en C₃ à C₁₀ substitué, le groupe hétérocycloalcénylène en C₁ à C₁₀ substitué, le groupe arylène en C₆ à C₆₀ substitué, le groupe hétéroarylène en C₁ à C₆₀ substitué, le groupe polycyclique condensé non aromatique divalent substitué, le groupe hétéropolycyclique condensé non aromatique divalent substitué, le groupe alkyle en C₁ à C₆₀ substitué, groupe alcényle en C₂ à C₆₀ substitué, le groupe alcynyle en C₂ à C₆₀ substitué, le groupe alcoxy en C₁ à C₆₀ substitué, le groupe cycloalkyle en C₃ à C₁₀ substitué, le groupe hétérocycloalkyle en C₁ à C₁₀ substitué, le groupe cycloalcényle en C₃ à C₁₀ substitué, le groupe hétérocycloalcényle en C₁ à C₁₀ substitué, le groupe aryle en C₆ à C₆₀ substitué, le groupe aryloxy en C₆ à C₆₀ substitué, le groupe arylthio en C₆ à C₆₀ substitué, le groupe hétéroaryle en C₁ à C₆₀ substitué, le groupe polycyclique condensé non aromatique monovalent substitué et le groupe hétéropolycyclique condensé non aromatique monovalent substitué sont chacun indépendamment substitués par un ou plusieurs substituants sélectionnés dans le groupe constitué de :
deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀ et un groupe alcoxy en C₁ à C₆₀ ;
un groupe alkyle en C₁ à C₆₀, un groupe alcényle en C₂ à C₆₀, un groupe alcynyle en C₂ à C₆₀ et un groupe alcoxy en C₁ à C₆₀, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), et -P(=O)(Q₁₁)(Q₁₂) ;
un groupe cycloalkyle en C₃ à C₁₀, un groupe hétérocycloalkyle en C₁à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, un groupe biphényle et un groupe terphényle ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent et un groupe hétéropolycyclique condensé non aromatique monovalent, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₆₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique condensé non aromatique monovalent, un groupe hétéropolycyclique condensé non aromatique monovalent, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), et - P(=O)(Q₂₁)(Q₂₂) ; et
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et - P(=O)(Q₃₁)(Q₃₂),
dans lequel Q₁ à Q₃, Q₁₁ à Q₁₃, Q₂₁ à Q₂₃ et Q₃₁ à Q₃₃ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryle en C₆ à C₆₀ substitué par un groupe alkyle en C₁ à C₆₀, un groupe aryle en C₆ à C₆₀ substitué par un groupe aryle en C₆ à C₆₀, un groupe terphényle, un groupe hétéroaryle en C₁ à C₆₀, un groupe hétéroaryle en C₁ à C₆₀ substitué par un groupe alkyle en C₁ à C₆₀, un groupe hétéroaryle en C₁ à C₆₀ substitué par un groupe aryle en C₆ à C₆₀, un groupe polycyclique condensé non aromatique monovalent, et un groupe hétéropolycyclique condensé non aromatique monovalent,
à condition que le premier composé ne soit pas : 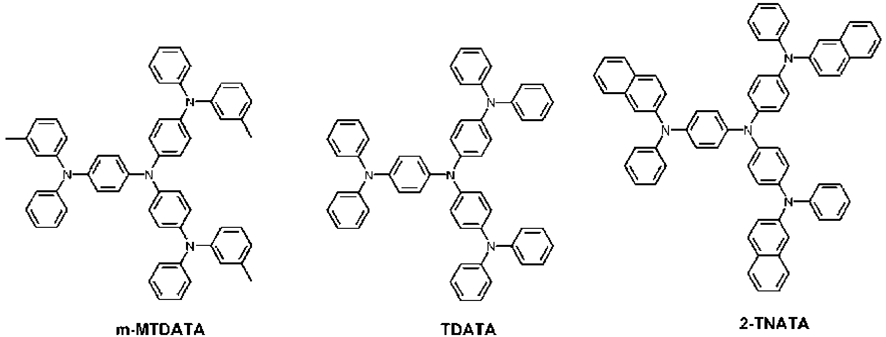 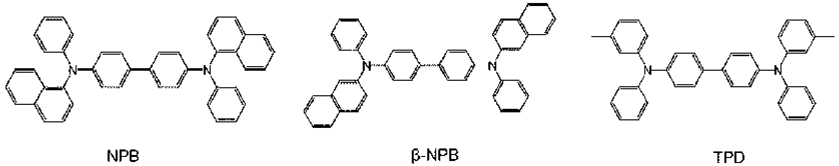 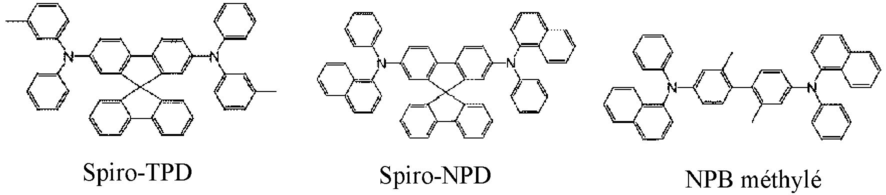 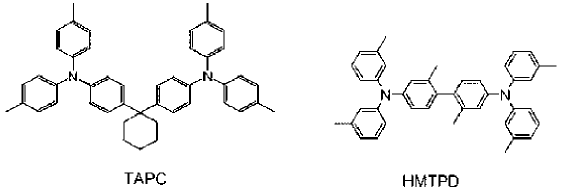 ou 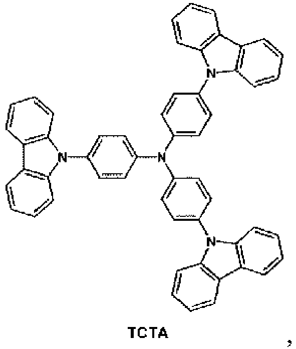
et à condition que, dans la Formule 2A, lorsque
i) le cycle A₂₂ est un groupe benzofurane, un groupe benzothiophène, un groupe benzosélénophène, un groupe indène, un groupe benzosilole ou un groupe indole, chacun substitué par au moins un *-[(L₂₂)ₐ₂₂-(R₂₂)_{b22}],
ii) un cycle à 5 chaînons du groupe benzofurane, du groupe benzothiophène, du groupe benzosélénophène, du groupe indène, du groupe benzosilole et du groupe indole est condensé en le cycle central à 7 chaînons dans la Formule 2A, et
iii) tous les T₁₁ et T₁₂ sont du carbone,
alors les cycles A₂₁ et A₂₃ dans la Formule 2A ne sont pas simultanément des groupes benzène.

2. Dispositif électroluminescent organique (10) selon la revendication 1, dans lequel :
les cycles A₂₁, A₂₂ et A₂₃ dans les Formules 2A et 2B sont chacun indépendamment sélectionnés parmi un groupe benzène, un groupe naphtalène, un groupe anthracène, un groupe indène, un groupe fluorène, un groupe pyridine, un groupe pyrimidine, un groupe pyrazine, un groupe pyridazine, un groupe quinoléine, un groupe isoquinoléine, un groupe pyrrole, un groupe pyrazole, un groupe imidazole, un groupe oxazole, un groupe thiazole, un groupe cyclopentadiène, un groupe silole, un groupe sélénophène, un groupe furane, un groupe thiophène, un groupe indole, un groupe benzimidazole, un groupe benzoxazole, un groupe benzothiazole, un groupe indène, un groupe benzosilole, un groupe benzosélénophène, un groupe benzofurane, un groupe benzothiophène, un groupe carbazole, un groupe fluorène, un groupe dibenzosilole, un groupe dibenzosélénophène, un groupe dibenzofurane, un groupe dibenzothiophène, un groupe pyrrolopyridine, un groupe cyclopentapyridine, un groupe silolopyridine, un groupe sélénophénopyridine, un groupe furopyridine, un groupe thiénopyridine, un groupe pyrrolopyrimidine, un groupe cyclopentapyrimidine, un groupe silolopyrimidine, un groupe sélénopyrimidine, un groupe furopyrimidine, un groupe thiénopyrimidine, un groupe pyrrolopyrazine, un groupe cyclopentapyrazine, un groupe silolopyrazine, un groupe sélénophénopyrazine, un groupe furopyrazine, un groupe thiénopyrazine, un groupe naphtopyrrole, un groupe cyclopentanaphtalène, un groupe naphtosilole, un groupe naphtosélénophène, un groupe naphtofurane, un groupe naphtothiophène, un groupe pyrroloquinoléine, un groupe cyclopentaquinoléine, un groupe siloloquinoléine, un groupe sélénophénoquinoléine, un groupe furoquinoléine, un groupe thiénoquinoléine, un groupe pyrroloisoquinoléine, un groupe cyclopentaisoquinoléine, un groupe siloloisoquinoléine, un groupe sélénoisoquinoléine, un groupe furoisoquinoléine, un groupe thiénoisoquinoléine, un groupe azacarbazole, un groupe azafluorène, un groupe azadibenzosilole, un groupe azadibenzoselénophène, un groupe azadibenzofurane, un groupe azadibenzothiophène, un groupe indénoquinoline, un groupe isoindénoquinoline, un groupe indénoquinoxaline, un groupe phénanthroline et un groupe naphtoindole, chacun étant substitué par au moins un *-[(L₂₂)ₐ₂₂-(R₂₂)_{b22}].

3. Dispositif électroluminescent organique (10) selon la revendication 1, dans lequel les cycles A₂₁, A₂₂, et A₂₃ dans les Formules 2A et 2B sont chacun indépendamment sélectionnés parmi les groupes représentés par les Formules 2-1 à 2-36, chacun substitué par au moins un *-[(L₂₂)ₐ₂₂-(R₂₂)_{b22}], dans lequel * est un site de liaison au cycle A₂₁, A₂₂ ou A₂₃ : 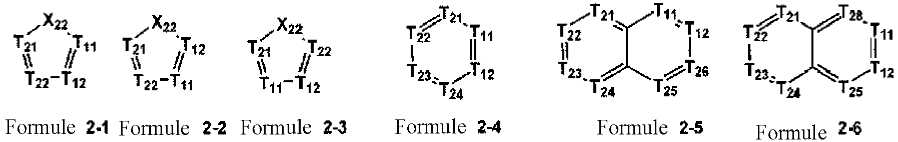 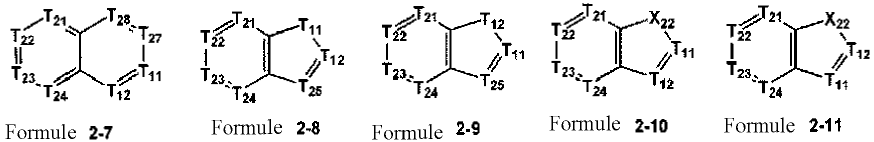 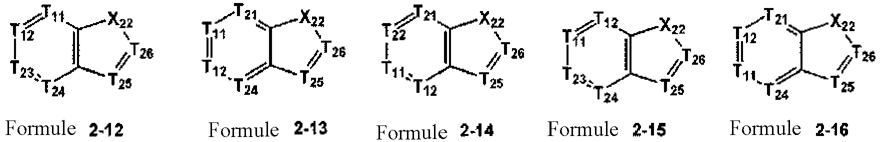 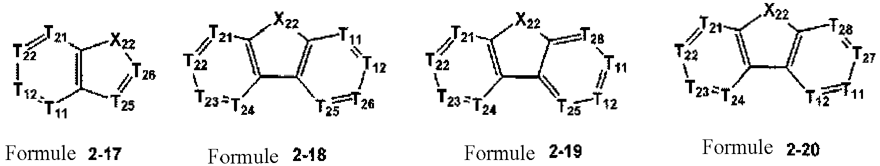 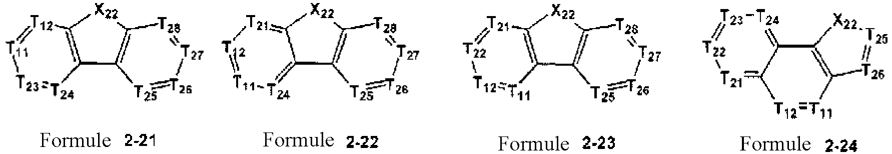 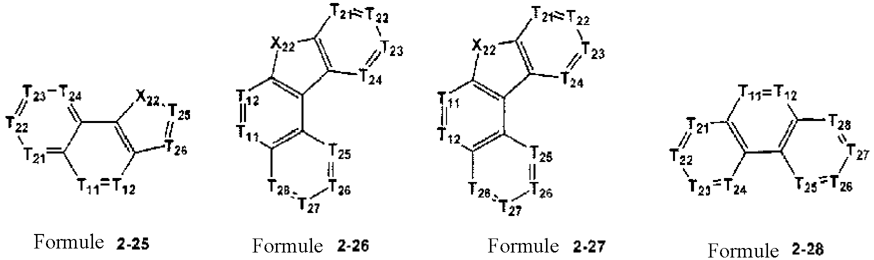 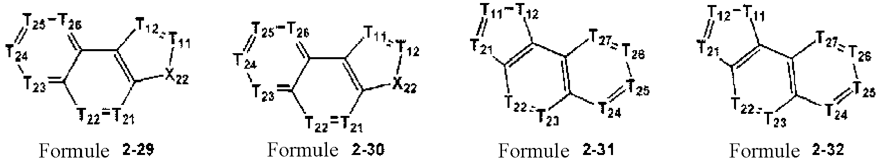 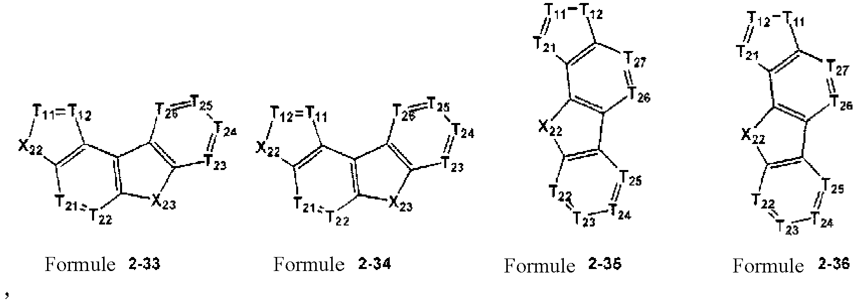
dans lequel, dans les Formules 2-1 à 2-36,
T₁₁ et T₁₂ sont chacun indépendamment les mêmes que ceux décrits ici en relation avec les Formules 2A et 2B,
X₂₂ et X₂₃ sont chacun indépendamment sélectionnés parmi O, S, Se et un fragment comprenant C, N et/ou Si, et
T₂₁ à T₂₈ sont chacun indépendamment N ou un fragment comprenant C.

4. Dispositif électroluminescent organique (10) selon l'une quelconque des revendications précédentes, dans lequel X₂₁ dans les Formules 2A et 2B est N[(L₂₁)ₐ₂₁-(R₂₁)_{b21}].

5. Dispositif électroluminescent organique (10) selon la revendication 3, dans lequel :
X₂₁ dans les Formules 2A et 2B est S, Se, C(R₂₃)(R₂₄), ou Si(R₂₃)(R₂₄),
au moins l'un sélectionné parmi les cycles A₂₁, A₂₂, et A₂₃ dans la Formule 2A et au moins l'un sélectionné parmi les cycles A₂₁ et A₂₃ dans la Formule 2B sont chacun indépendamment sélectionnés parmi les groupes représentés par les Formules 2-1 à 2-3, 2-10 à 2-27, et 2-33 à 2-36, et
au moins l'un parmi X₂₂ et X₂₃ dans les Formules 2-1 à 2-3, 2-10 à 2-27 et 2-33 à 2-36 est N-[(L₂₂)ₐ₂₂-(R₂₂)_{b22}].

6. Dispositif électroluminescent organique (10) selon l'une quelconque des revendications précédentes, dans lequel L₁ à L₃, L₁₁ à L₁₅ et le cycle A₁ dans les Formules 1A et 1B sont chacun indépendamment sélectionnés dans le groupe constitué de :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène un groupe silolylène, un groupe pyridinylène, un groupe indolylène, un groupe isoindolylène, un groupe purinylène, un groupe benzofuranylène, un groupe benzothiophénylène, un groupe benzosilolylène, un groupe dibenzofuranylène, un groupe dibenzothiophénylène, un groupe dibenzosilolylène, un groupe carbazolylène, un groupe benzocarbazolylène et un groupe dibenzocarbazolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe pyridinylène, un groupe indolylène, un groupe isoindolylène, un groupe purinylène, un groupe benzofuranylène, un groupe benzothiophénylène, un groupe benzosilolylène, un groupe dibenzofuranylène, un groupe dibenzothiophénylène, un groupe dibenzosilolylène, un groupe carbazolylène, un groupe benzocarbazolylène et un groupe dibenzocarbazolylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe pyridinyle, un groupe indolyle, un groupe isoindolyle, un groupe purinyle, un groupe benzofuranyle, un groupe benzothiophényle, un groupe benzosilolyle, un groupe dibenzofuranyle, un groupe dibenzothiophényle, un groupe dibenzosilolyle, un groupe carbazolyle, un groupe benzocarbazolyle, un groupe dibenzocarbazolyle, -Si(Q₃₁)(Q₃₂)(Q₃₃), - N(Q₃₁)(Q₃₂), et -B(Q₃₁)(Q₃₂), et
L₂₁ et L₂₂ dans les Formules 2A et 2B sont chacun indépendamment choisis dans le groupe constitué de :
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzophthyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène ; et
un groupe phénylène, un groupe pentalénylène, un groupe indénylène, un groupe naphtylène, un groupe azulénylène, un groupe indacénylène, un groupe acénaphtylène, un groupe fluorénylène, un groupe spiro-bifluorénylène, un groupe spiro-benzofluorène-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe pérylénylène, un groupe pentaphénylène, un groupe pyrrolylène, un groupe thiophénylène, un groupe furanylène, un groupe silolylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe indolylène, un groupe isoindolylène, un groupe indazolylène, un groupe purinylène, un groupe quinolinylène, un groupe isoquinolinylène, un groupe benzoquinolinylène, un groupe phtalazinylène, un groupe naphthyridinylène, un groupe quinoxalinylène, un groupe quinazolinylène, un groupe cinnolinylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe benzosilolylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosilolylène, un groupe carbazolylène, un groupe benzocarbazolylène, un groupe dibenzocarbazolylène, un groupe thiadiazolylène, un groupe imidazopyridinylène, un groupe imidazopyrimidinylène, un groupe oxazolopyridinylène, un groupe thiazolopyridinylène, un groupe benzophthyridinylène, un groupe azafluorénylène, un groupe azaspiro-bifluorénylène, un groupe azacarbazolylène, un groupe azadibenzofuranylène, un groupe azadibenzothiophénylène et un groupe azadibenzosilolylène, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé non aromatique monovalent, un groupe hétéropolycyclique condensé non aromatique monovalent, un groupe biphényle, un groupe terphényle, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂),
dans lequel Q₁ à Q₃ et Q₃₁ à Q₃₃ sont chacun indépendamment choisis dans le groupe constitué de :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins l'un choisi parmi un groupe alkyle en C₁ à C₁₀, un groupe alcoxy en C₁ à C₁₀ et un groupe phényle.

7. Dispositif électroluminescent organique (10) selon l'une quelconque des revendications précédentes, dans lequel :
a16 dans la Formule 1B est 1, le cycle A₁ est un groupe benzène et n2 est 1 ou 2 ; ou
a16 dans la Formule 1B est 3, 4, 5 ou 6.

8. Dispositif électroluminescent organique (10) selon l'une quelconque des revendications précédentes, dans lequel R₁ à R₃ et R₁₁ à R₁₅ dans les Formules 1A et 1B sont chacun indépendamment choisis dans le groupe constitué de :
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe pyridinyle, un groupe indolyle, un groupe isoindolyle, un groupe purinyle, un groupe benzofuranyle, un groupe benzothiophényle, un groupe benzosilolyle, un groupe dibenzofuranyle, un groupe dibenzothiophényle, un groupe dibenzosilolyle, un groupe carbazolyle, un groupe benzocarbazolyle et un groupe dibenzocarbazolyle ; et
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe pyridinyle, un groupe indolyle, un groupe isoindolyle, un groupe purinyle, un groupe benzofuranyle, un groupe benzothiophényle, un groupe benzosilolyle, un groupe dibenzofuranyle, un groupe dibenzothiophényle, un groupe dibenzosilolyle, un groupe carbazolyle, un groupe benzocarbazolyle et un groupe dibenzocarbazolyle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe pérylényle, un groupe pentaphényle, un groupe pyrrolyle, un groupe thiophényle, un groupe furanyle, un groupe silolyle, un groupe pyridinyle, un groupe indolyle, un groupe isoindolyle, un groupe purinyle, un groupe benzofuranyle, un groupe benzothiophényle, un groupe benzosilolyle, un groupe dibenzofuranyle, un groupe dibenzothiophényle, un groupe dibenzosilolyle, un groupe carbazolyle, un groupe benzocarbazolyle, un groupe dibenzocarbazolyle, Si(Q₃₁)(Q₃₂)(Q₃₃), - N(Q₃₁)(Q₃₂), et -B(Q₃₁)(Q₃₂), et
R₂₁ dans les Formules 2A et 2B sont chacun indépendamment sélectionnés dans le groupe constitué de :
un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro-benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylenyl, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphthyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tetrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorenyle, un groupe azaspiro-bifluorényle, un groupe azacarbazolyle, un groupe azadibenzofuranyle, un groupe azadibenzothiophényle, et un groupe azadibenzosilolyle ; et
un groupe cyclopentyle, un groupe cyclohexyle, un groupe cycloheptyle, un groupe cyclopentenyle, un groupe cyclohexényle, un groupe phényle, un groupe biphényle, un groupe terphényle, un groupe pentalényle, un groupe indényle, un groupe naphtyle, un groupe azulényle, un groupe indacényle, un groupe acénaphtyle, un groupe fluorényle, un groupe spiro-bifluorényle, un groupe spiro- benzofluorène-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe perylényle, un groupe pentaphényle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tetrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe oxazolopyridinyle, un groupe thiazolopyridinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle et un groupe azadibenzosilolyle, chacun substitué par au moins l'un choisi parmi le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cycloalkyle C₃ à C₁₀ , un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique condensé non aromatique monovalent, un groupe hétéropolycyclique condensé non aromatique monovalent , un groupe biphényle, un groupe terphényle, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂), et
R₂₂ est choisi parmi les groupes définis pour R₂₁, l'hydrogène, le deutérium, -F, -Cl, -Br, - I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, - Si(Q₁)(Q₂)(Q₃), -S(=O)₂(Q₁) et -P(=O)(Q₁)(Q₂),
dans lequel Q₁ à Q₃ et Q₃₁ à Q₃₃ sont chacun indépendamment sélectionnés dans le groupe constitué de :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué par au moins l'un choisi parmi un groupe alkyle en C₁ à C₁₀, un groupe alcoxy en C₁ à C₁₀ et un groupe phényle.

9. Dispositif électroluminescent organique (10) selon la revendication 1, dans lequel :
R₁ à R₃ et R₁₁ à R₁₅ dans les Formules 1A et 1B sont chacun indépendamment sélectionnés parmi les groupes représentés par les Formules 5-1 à 5-45,
R₂₁ dans les Formules 2A et 2B est choisi parmi les groupes représentés par les Formules 5-1 à 5-45 et 6-1 à 6-124, et
R₂₂ dans les Formules 2A et 2B est choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe représenté par l'une des Formules 5-1 à 5-45 et 6-1 à 6-124, -Si(Q₁)(Q₂)(Q₃), -S(=O)₂(Q₁), et - P(=O)(Q₁)(Q₂) : 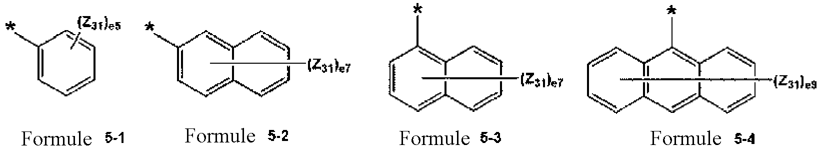 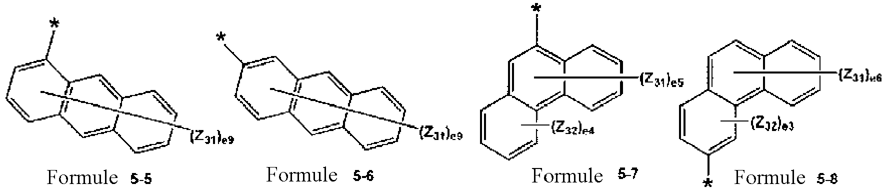 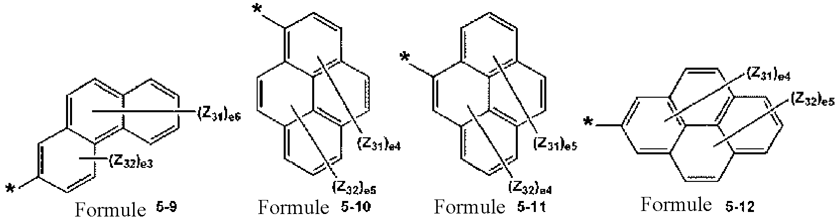 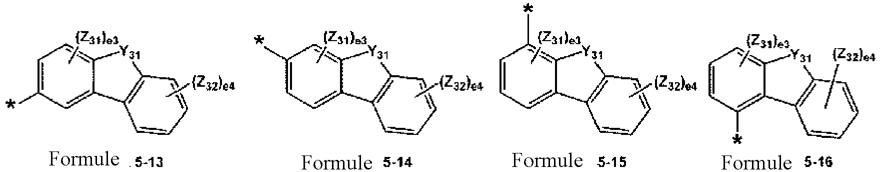 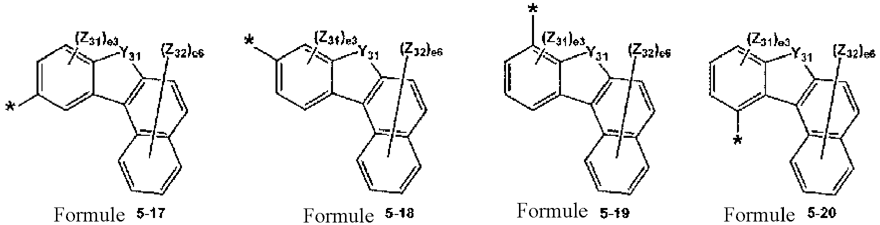 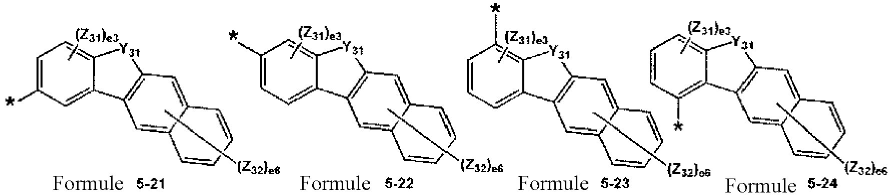 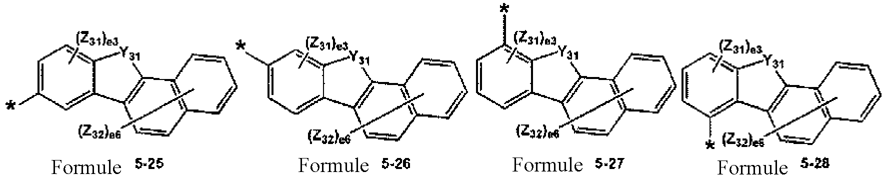 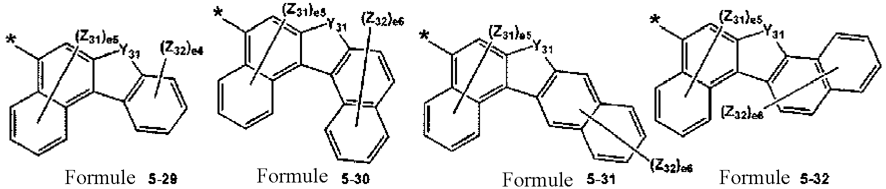 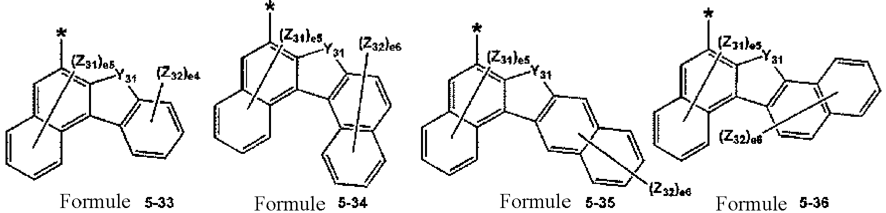 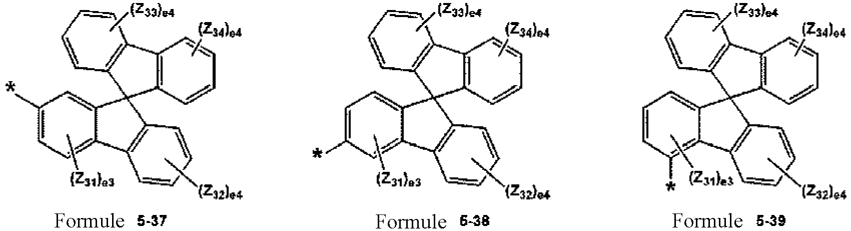 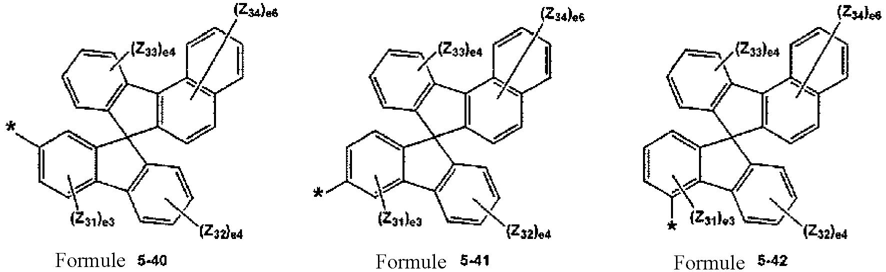 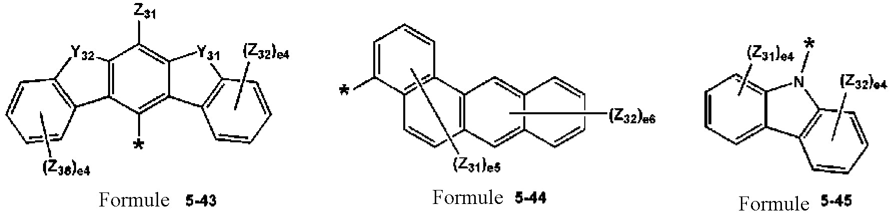 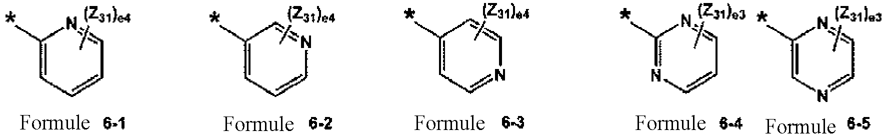 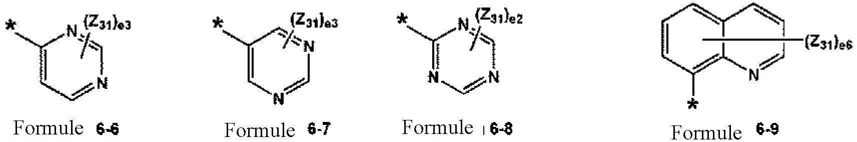 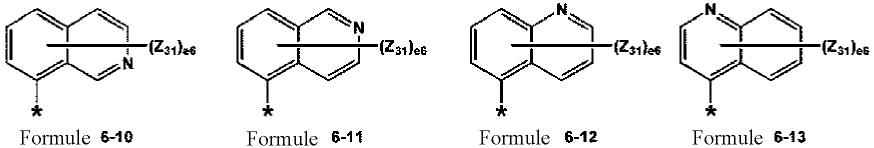 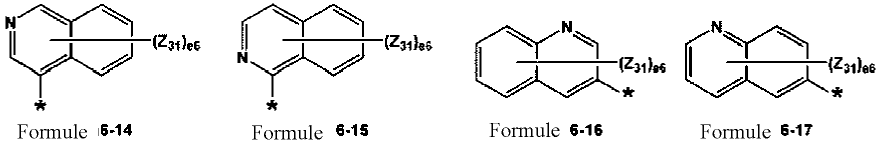 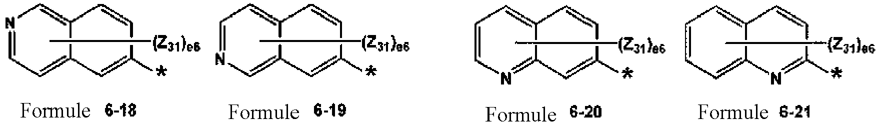 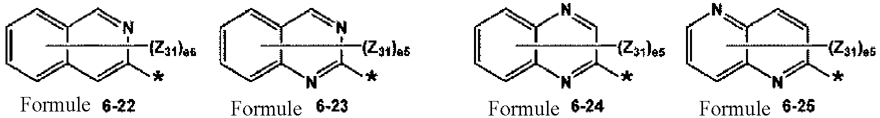 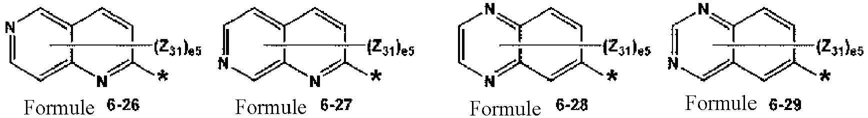 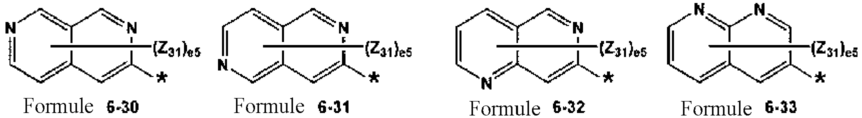 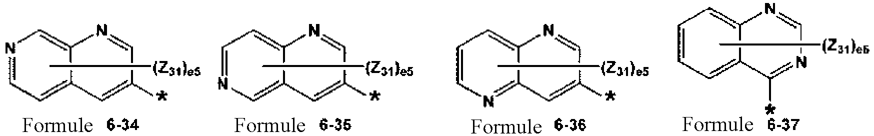 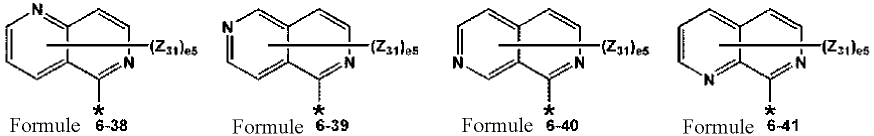 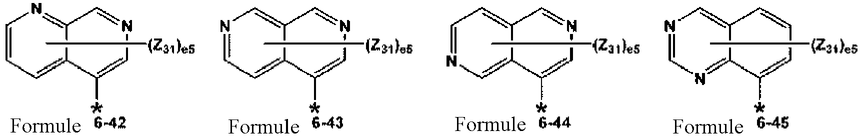 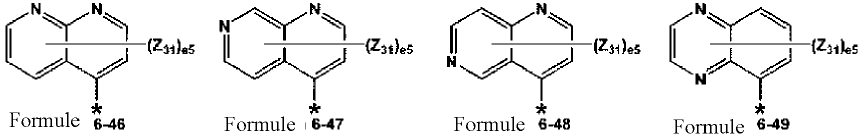 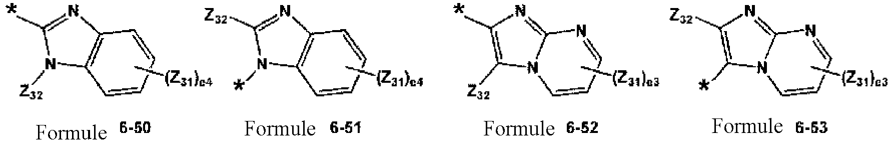 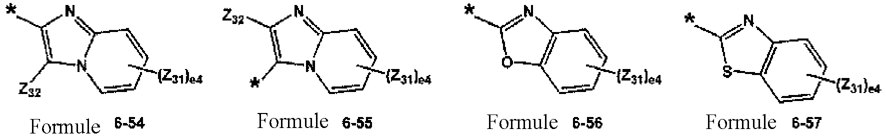 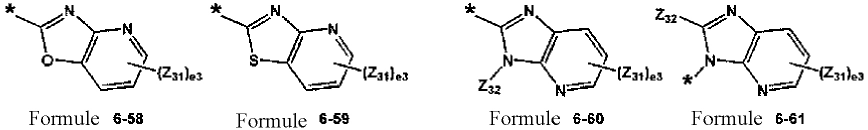 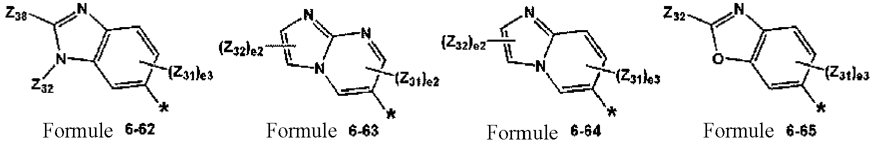 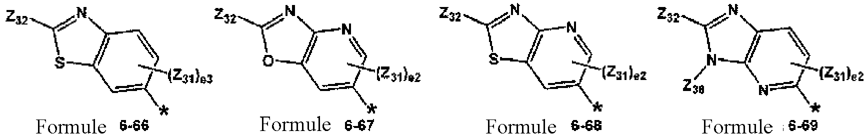 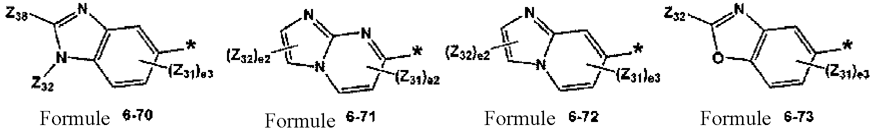 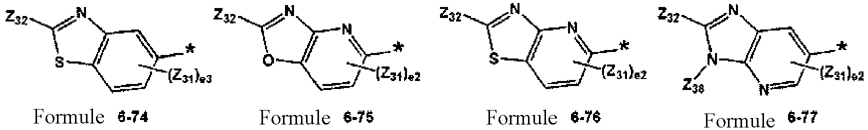 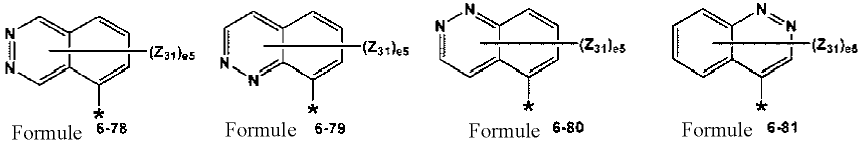 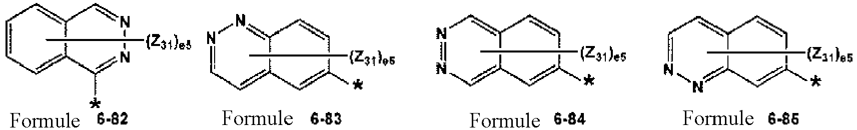 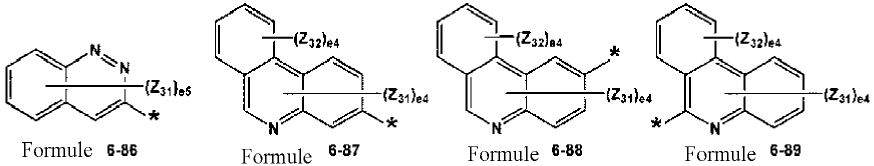 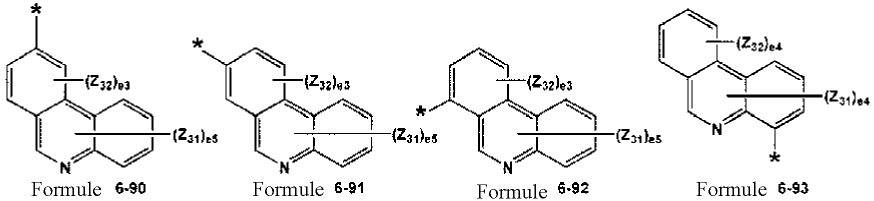 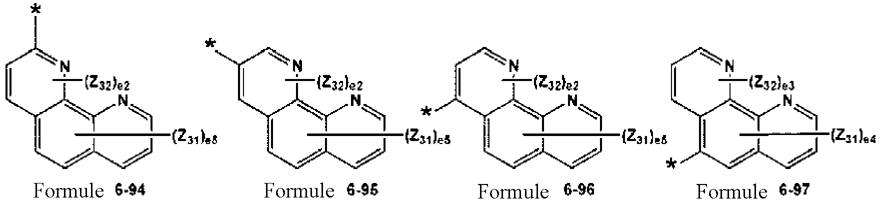 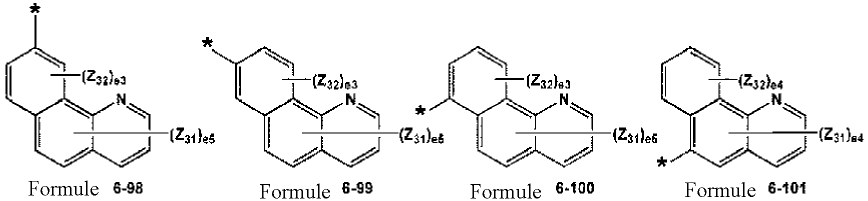 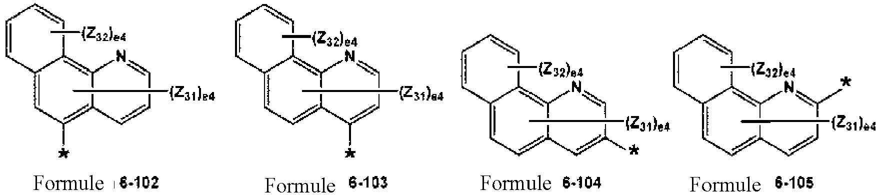 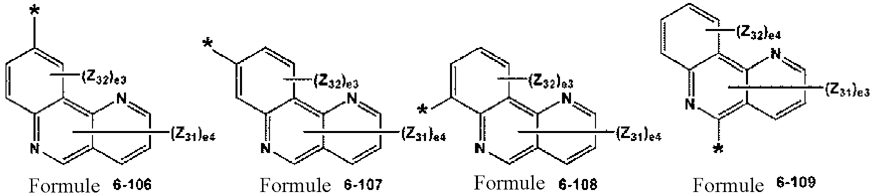 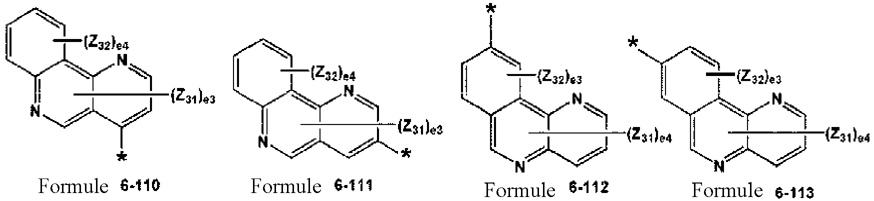 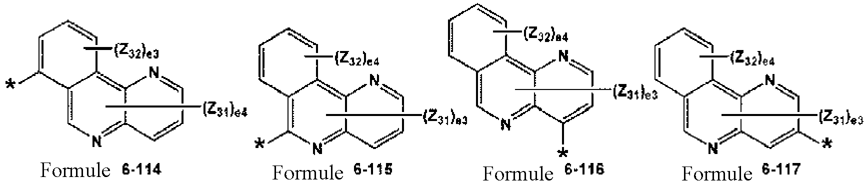 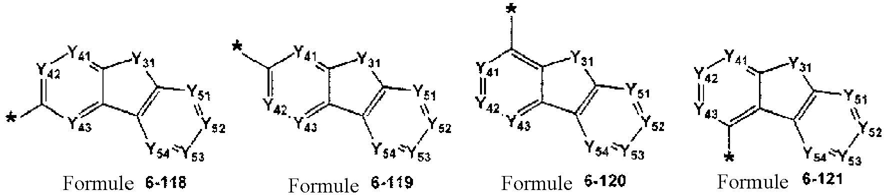 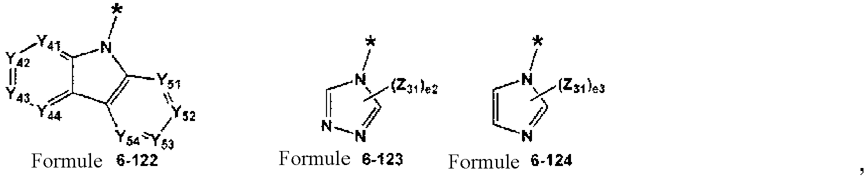
dans lequel, dans les Formules 5-1 à 5-45 et 6-1 à 6-124,
Y₃₁ et Y₃₂ sont chacun indépendamment choisis parmi O, S, C(Z₃₃)(Z₃₄), N(Z₃₅), et Si(Z₃₆)(Z₃₇),
Y₄₁ est N ou C(Z₄₁), Y₄₂ est N ou C(Z₄₂), Y₄₃ est N ou C(Z₄₃), Y₄₄ est N ou C(Z₄₄), Y₅₁ est N ou C(Z₅₁), Y₅₂ est N ou C(Z₅₂), Y₅₃ est N ou C(Z₅₃), Y₅₄ est N ou C(Z₅₄), au moins l'un choisi parmi Y₄₁ à Y₄₃ et Y₅₁ à Y₅₄ dans les Formules 6-118 à 6-121 est N, et au moins l'un choisi parmi Y₄₁ à Y₄₄ et Y₅₁ à Y₅₄ dans la Formule 6-122 est N,
Z₃₁ à Z₃₈, Z₄₁ à Z₄₄ et Z₅₁ à Z₅₄ sont chacun indépendamment choisis parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₂₀, un groupe alcoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalenyle, un groupe pyrrolyle, un groupe thiophényle, un groupe furanyle, un groupe silolyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe indolyle, un groupe isoindolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe benzosilolyle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe carbazolyle, un groupe benzocarbazolyle, un groupe dibenzocarbazolyle, un groupe thiadiazolyle, un groupe imidazopyridinyle, un groupe imidazopyrimidinyle, un groupe benzonaphthyridinyle, un groupe azafluorényle, un groupe azaspiro-bifluorényle, un groupe azacarbazolyle, un groupe azadibenzofuranyle, un groupe azadibenzothiophényle, un groupe azadibenzosilolyle et Si(Q₃₁)(Q₃₂)(Q₃₃),
dans lequel Q₁ à Q₃ et Q₃₁ à Q₃₃ sont chacun indépendamment choisis dans le groupe constitué de :
un groupe alkyle en C₁ à C₁₀, un groupe alcoxy en C₁ à C₁₀, un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle ; et
un groupe phényle, un groupe biphényle, un groupe terphényle, un groupe naphtyle, un groupe pyridinyle, un groupe pyrimidinyle, un groupe pyrazinyle, un groupe quinolinyle, un groupe isoquinolinyle, un groupe quinoxalinyle et un groupe quinazolinyle, chacun substitué
par au moins l'un choisi parmi un groupe alkyle en C₁ à C₁₀, un groupe alcoxy en C₁ à C₁₀ et un groupe phényle,
e2 est un nombre entier choisi entre 0 et 2,
e3 est un nombre entier choisi entre 0 et 3,
e4 est un nombre entier choisi entre 0 et 4,
e5 est un nombre entier choisi entre 0 et 5,
e6 est un nombre entier choisi entre 0 et 6,
e7 est un nombre entier choisi entre 0 et 7,
e9 est un nombre entier choisi entre 0 et 9, et
* indique un site de liaison à un atome adjacent.

10. Dispositif électroluminescent organique (10) selon la revendication 9, dans lequel au moins l'un choisi parmi R₁ à R₃ dans la Formule 1A et au moins l'un choisi parmi R₁₁ à R₁₄ dans la Formule 1B sont chacun représentés indépendamment par l'une choisie parmi les Formules 5-13 à 5-42 et 5-45.

11. Dispositif électroluminescent organique (10) selon la revendication 9, dans lequel :
R₁ dans la Formule 1A est représenté par l'une choisie parmi les Formules 5-13 à 5-36 et 5-45, à condition que Y₃₁ dans les Formules 5-13 à 5-36 soit N(Z₃₅), et
R₂ dans la Formule 1A est représenté par l'une choisie parmi les Formules 5-13 à 5-42, à condition que Y₃₁ dans les Formules 5-13 à 5-36 soit C(Z₃₃)(Z₃₄).

12. Dispositif électroluminescent organique (10) selon l'une quelconque des revendications précédentes, dans lequel :
(a) la région de transport de trous comprend une couche d'injection de trous et une couche de transport de trous, dans lequel la couche de transport de trous se trouve entre la couche d'injection de trous et la couche d'émission, et la couche de transport de trous comprend le premier composé ; et/ou
(b) la région de transport de trous comprend une couche auxiliaire d'émission, la couche auxiliaire d'émission est directement en contact avec la couche d'émission, et la couche auxiliaire d'émission comprend le second composé ; et/ou
(c) la région de transport d'électrons comprend une couche tampon, la couche tampon est directement en contact avec la couche d'émission, et la couche tampon comprend le second composé ; et/ou
(d) la couche d'émission comprend en outre un dopant fluorescent ou un dopant phosphorescent, dans lequel le dopant fluorescent comprend un composé arylamine ou un composé styrylamine ; et le dopant phosphorescent comprend un composé organométallique comprenant l'iridium (Ir), platine (Pt), palladium (Pd), osmium (Os), titane (Ti), zirconium (Zr), hafnium (Hf), europium (Eu), terbium (Tb), rhodium (Rh) ou thulium (Tm).

13. Dispositif électroluminescent organique (10) selon l'une quelconque des revendications précédentes, dans lequel :
la région de transport d'électrons comprend une couche tampon, une couche de transport d'électrons et une couche d'injection d'électrons,
dans lequel au moins l'une choisie parmi la couche de transport d'électrons et la couche d'injection d'électrons comprend un métal alcalin, un métal alcalino-terreux, un métal de terre rare, un composé de métal alcalin, un composé de métal alcalino-terreux, un composé de métal de terre rare, un métal alcalin complexe, un complexe de métal alcalino-terreux, un complexe de métal de terre rare, ou une combinaison de ceux-ci ;
de préférence, dans lequel la couche d'injection d'électrons comprend du lithium (Li), sodium (Na), potassium (K), rubidium (Rb), césium (Cs), magnésium (Mg), calcium (Ca), erbium (Er), thulium (Tm), ytterbium (Yb), ou une combinaison de ceux-ci.

14. Dispositif électroluminescent organique (10) selon l'une quelconque des revendications précédentes, dans lequel la région de transport de trous comprend un dopant p choisi parmi un dérivé de quinone, un oxyde métallique et un composé contenant un groupe cyano ;
de préférence, dans lequel le dopant p comprenant un composé contenant un groupe cyano.

15. Dispositif électroluminescent organique (10) selon l'une quelconque des revendications précédentes, dans lequel la couche d'émission est une couche d'émission de lumière de première couleur,
le dispositif électroluminescent organique comprend en outre i) au moins une couche d'émission de lumière de deuxième couleur ou ii) au moins une couche d'émission de lumière de deuxième couleur et au moins une couche d'émission de lumière de troisième couleur, chacune entre la première électrode (110) et la seconde électrode (190),
une longueur d'onde d'émission maximale de la couche d'émission de lumière de première couleur, une longueur d'onde d'émission maximale de la couche d'émission de lumière de deuxième couleur et une longueur d'onde d'émission maximale de la couche d'émission de lumière de troisième couleur sont identiques ou différentes les unes des autres, et
le dispositif électroluminescent organique émet une lumière mixte comprenant une lumière de première couleur et une lumière de deuxième couleur, ou le dispositif électroluminescent organique émet une lumière mixte comprenant la lumière de première couleur, la lumière de deuxième couleur, et une lumière de troisième couleur.
